(19) Europäisches Patentamt
European Patent Office
Office européen des brevets

(11) EP 4 485 074 A1

(12) **EUROPEAN PATENT APPLICATION**
published in accordance with Art. 153(4) EPC

(43) Date of publication:
**01.01.2025 Bulletin 2025/01**

(21) Application number: **23759691.1**

(22) Date of filing: **08.02.2023**

(51) International Patent Classification (IPC):
***G03F 7/004*** *(2006.01)* ***C08F 290/14*** *(2006.01)*
***C08G 73/10*** *(2006.01)* ***C08K 5/56*** *(2006.01)*
***C08L 79/08*** *(2006.01)* ***C08L 101/00*** *(2006.01)*
***G03F 7/027*** *(2006.01)* ***G03F 7/029*** *(2006.01)*
***G03F 7/031*** *(2006.01)* ***G03F 7/037*** *(2006.01)*
***G03F 7/20*** *(2006.01)* ***G03F 7/40*** *(2006.01)*
***H01L 21/312*** *(2006.01)*

(52) Cooperative Patent Classification (CPC):
**G03F 7/037; C08F 290/14; C08G 73/10; C08K 5/56; C08L 79/08; C08L 101/00; G03F 7/004; G03F 7/027; G03F 7/029; G03F 7/031; G03F 7/0388; G03F 7/20; G03F 7/40; H01L 21/31**

(86) International application number:
**PCT/JP2023/004117**

(87) International publication number:
**WO 2023/162687 (31.08.2023 Gazette 2023/35)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **24.02.2022 JP 2022026541**
**28.07.2022 JP 2022120608**

(71) Applicant: **FUJIFILM Corporation**
**Tokyo 106-8620 (JP)**

(72) Inventors:
- **DAIKUHARA, Kenji**
  **Haibara-gun, Shizuoka 421-0396 (JP)**
- **AOSHIMA, Toshihide**
  **Haibara-gun, Shizuoka 421-0396 (JP)**
- **ASAKAWA, Daisuke**
  **Haibara-gun, Shizuoka 421-0396 (JP)**
- **OOTA, Kazuya**
  **Haibara-gun, Shizuoka 421-0396 (JP)**

(74) Representative: **HGF**
**HGF Limited**
**1 City Walk**
**Leeds LS11 9DX (GB)**

# (54) RESIN COMPOSITION, CURED ARTICLE, LAMINATE, METHOD FOR PRODUCING CURED ARTICLE, METHOD FOR PRODUCING LAMINATE, METHOD FOR PRODUCING SEMICONDUCTOR DEVICE, AND SEMICONDUCTOR DEVICE

(57) There are provided a resin composition having excellent storage stability and excellent chemical resistance of a cured substance to be obtained, a cured substance obtained by curing the resin composition, a laminate including the cured substance, a manufacturing method for the cured substance, a manufacturing method for the laminate, a manufacturing method for a semiconductor device including the manufacturing method for the laminate, and a semiconductor device including the cured substance or the laminate.

The resin composition contains a resin and a metal complex which has one or more π-conjugated moieties containing a nitrogen atom.

EP 4 485 074 A1

## Description

BACKGROUND OF THE INVENTION

1. Field of the Invention

The present invention relates to a resin composition, a cured substance, a laminate, a manufacturing method for a cured substance, a manufacturing method for a laminate, a manufacturing method for a semiconductor device, and a semiconductor device.

2. Description of the Related Art

In recent years, in various fields, a resin material has been utilized by using a resin composition containing a resin.
For example, a cyclization resin such as polyimide is applied to various use applications since it has excellent heat resistance and excellent insulating properties. The above-described use applications are not particularly limited, and examples thereof in a semiconductor device for mounting include the use as a material of an insulating film or sealing material, or as a protective film. In addition, such a resin can also be used as a base film or a cover lay for a flexible substrate.
For example, in the above-described use applications, a cyclization resin such as polyimide is used in the form of a resin composition containing a precursor of the cyclization resin such as a polyimide precursor.
Such a resin composition is applied onto a base material by coating or the like to form a photosensitive film, and then, as necessary, subjected to exposure, development, or heating, whereby a cured substance can be formed on the base material.
The precursor of the cyclization resin such as a polyimide precursor is cyclized by, for example, heating, and becomes a cyclization resin such as polyimide in the cured substance.
Since the resin composition can be applied by a publicly known coating method or the like, it can be said that the resin composition is excellent in the manufacturing adaptability, for example, a high degree of freedom in designing the shape, size, application position of the resin composition to be applied. From the viewpoint of such excellent manufacturing adaptability in addition to the high performance of the cyclization resin such as polyimide, the industrial application and development of the above-described resin composition are expected increasingly.
For example, JP2014-122279A discloses a resin composition that contains a polyimide precursor having a specific structural unit and a metal complex compound having a specific structure.
In addition, WO2017/170600A discloses a negative-tone photosensitive resin composition that contains a polyimide precursor which is a blend of resins having specific structures, and a photosensitizer.

SUMMARY OF THE INVENTION

In a resin composition for obtaining a cured substance, it is required that the resin composition itself has excellent storage stability and a cured substance to be obtained has excellent chemical resistance.
An object of the present invention is to provide a resin composition having excellent storage stability and excellent chemical resistance of a cured substance to be obtained, a cured substance obtained by curing the resin composition, a laminate including the cured substance, a manufacturing method for the cured substance, a manufacturing method for the laminate, a manufacturing method for a semiconductor device including the manufacturing method for the laminate, and a semiconductor device including the cured substance or the laminate.
Examples of representative embodiments according to the present invention are described below.

<1> A resin composition comprising:

a resin; and
a metal complex which has one or more $\pi$-conjugated moieties containing a nitrogen atom.

<2> The resin composition according to <1>, in which the metal complex includes a partial structure represented by Formula (1-1) as a structure including the $\pi$-conjugated moiety containing the nitrogen atom,

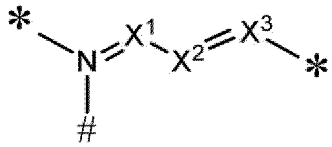 (1-1)

in Formula (1-1), $X^1$ to $X^3$ each independently represent -C(-*)= or -N=, *'s each represent a bonding site to another structure, and # represents a bonding site to a metal atom.

<3> The resin composition according to <1> or <2>, in which the metal complex is a compound having, on the same ligand, the π-conjugated moiety containing the nitrogen atom and at least one group selected from the group consisting of a hydroxy group, a mercapto group, and a carboxy group.

<4> The resin composition according to any one of <1> to <3>, in which the metal complex includes a partial structure represented by Formula (3-1) as a structure including the π-conjugated moiety containing the nitrogen atom,

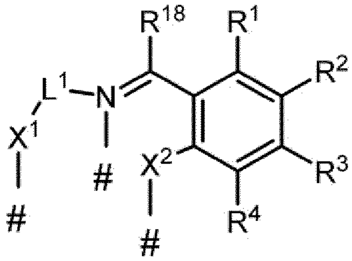

(3-1)

in Formula (3-1), $R^1$ to $R^4$ and $R^{18}$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, $R^{103}$ to $R^{109}$ each independently represent an alkyl group or an aryl group, $X^1$ and $X^2$ each independently represent -O- or -S-, $L^1$ represents a group represented by Formula (L-1) or Formula (L-2), and # represents a bonding site to a metal atom,

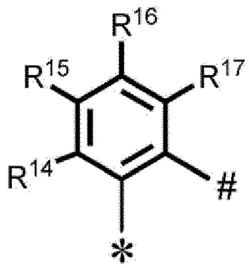 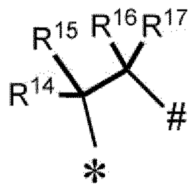

(L-1) (L-2)

in Formula (L-1) and Formula (L-2), $R^{14}$ to $R^{17}$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, $R^{103}$ to $R^{109}$ each independently represent an alkyl group or an aryl group, * represents a bonding site to $X^1$ in Formula (3-1), and # represents a bonding site to a nitrogen atom in Formula (3-1).

<5> The resin composition according to <4>, in which $L^1$ is a group represented by Formula (L-2), $R^{18}$ is a hydrogen atom, at least one of $R^1$, $R^2$, $R^3$, $R^4$, $R^{14}$, $R^{15}$, $R^{16}$, or $R^{17}$ represents a methyl group, an alkoxy group, an aryloxy group, a phenyl group, an acyloxy group, an acyl group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, and $R^{103}$ to $R^{109}$ each independently represent an alkyl group or an aryl group.

<6> The resin composition according to any one of <1> to <5>, in which the metal complex includes a partial structure represented by Formula (4-1) as a structure including the π-conjugated moiety containing the nitrogen atom,

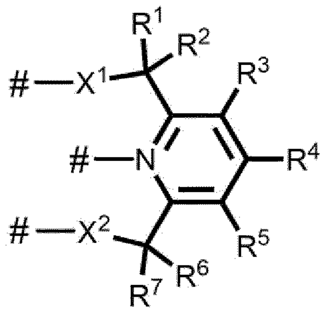

(4-1)

in Formula (4-1), $R^1$ to $R^7$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, $R^{103}$ to $R^{109}$ each independently represent an alkyl group or an aryl group, $X^1$ and $X^2$ each independently represent -O- or -S-, and # represents a bonding site to a metal atom.
<7> The resin composition according to <6>, in which at least one of $R^1$, $R^2$, $R^6$, or $R^7$ is a group other than the hydrogen atom.
<8> A resin composition comprising:

a resin; and
a compound represented by Formula (2-1),

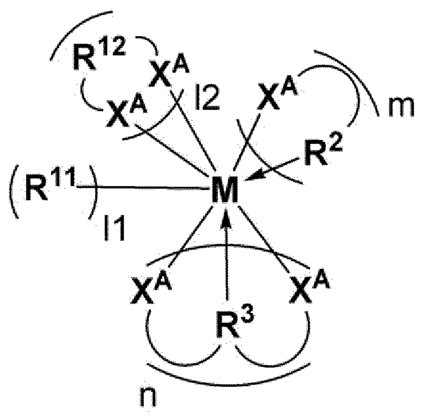

(2-1)

in Formula (2-1), M is titanium, zirconium, or hafnium, 11 is an integer of 0 to 2, 12 is 0 or 1, 11 + l2 × 2 is an integer of 0 to 2, m is an integer of 0 to 4, n is an integer of 0 to 2, 11 + l2 + m + n × 2 = 4 is satisfied, $R^{11}$'s are each independently a substituted or unsubstituted cyclopentadienyl group, a substituted or unsubstituted alkoxy group, or a substituted or unsubstituted phenoxy group, $R^{12}$ is a substituted or unsubstituted hydrocarbon group, $R^2$'s are each independently a group including a structure represented by Formula (2-2), $R^3$'s are each independently a group including a structure represented by Formula (2-2), and $X^A$'s are each independently an oxygen atom or a sulfur atom,

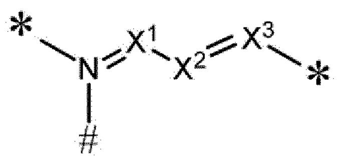

(2-2)

in Formula (2-2), $X^1$ to $X^3$ each independently represent -C(-*)= or -N=, *'s each represent a bonding site to

another structure, and # represents a bonding site to a metal atom.

<9> The resin composition according to <8>, in which in Formula (2-1), l1 and l2 are 0, and m is 0, 2, or 4.
<10> The resin composition according to any one of <1> to <9>, in which the resin is at least one resin selected from the group consisting of a cyclization resin and a precursor thereof.
<11> The resin composition according to any one of <1> to <10>, in which the resin is a polyimide or a polyimide precursor.
<12> The resin composition according to any one of <1> to <11>, further comprising a polymerizable compound.
<13> The resin composition according to any one of <1> to <12>, further comprising a photopolymerization initiator.
<14> The resin composition according to any one of <1> to <13>, in which the resin composition contains, as the resin, a cyclization resin or a precursor thereof and is used for forming an interlayer insulating film for a re-distribution layer.
<15> A cured substance that is obtained by curing the resin composition according to any one of <1> to <14>.
<16> A laminate comprising:

two or more layers consisting of the cured substance according to <15>; and
a metal layer provided between any of the layers consisting of the cured substance.

<17> A manufacturing method for a cured substance, comprising: a film forming step of applying the resin composition according to any one of <1> to <14> onto a base material to form a film.
<18> The manufacturing method for a cured substance according to <17>, further comprising:

an exposure step of selectively exposing the film;
a development step of developing the film using a developer to form a pattern; and
a heating step of heating the film at 50° to 450°C.

<19> A manufacturing method for a laminate, comprising:
the manufacturing method for a cured substance according to <17> or <18>.
<20> A manufacturing method for a semiconductor device, comprising:
the manufacturing method for a cured substance according to <17> or <18>.
<21> A semiconductor device comprising:
the cured substance according to <15>.

According to the present invention, there are provided a resin composition having excellent storage stability and excellent chemical resistance of a cured substance to be obtained, a cured substance obtained by curing the resin composition, a laminate including the cured substance, a manufacturing method for the cured substance, a manufacturing method for the laminate, a manufacturing method for a semiconductor device including the manufacturing method for the laminate, and a semiconductor device including the cured substance or the laminate.

## DESCRIPTION OF THE PREFERRED EMBODIMENTS

Hereinafter, the main embodiments according to the present invention will be described. However, the present invention is not limited to the specified embodiments.
In the present specification, a numerical value range described by using "to" means a range including numerical values described before and after the preposition "to" as a lower limit value and an upper limit value, respectively.
In the present specification, the term "step" means not only an independent step but also a step that cannot be clearly distinguished from other steps as long as the desired action of the step can be achieved.
In describing a group (an atomic group) in the present specification, in a case where a description of substitution and non-substitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).
In the present specification, the "exposure" includes not only exposure using light but also exposure using corpuscular beams such as an electron beam and an ion beam, unless otherwise specified. In addition, examples of the light that is used for exposure include an actinic ray such as a bright line spectrum of a mercury lamp, a far ultraviolet ray represented by an excimer laser, an extreme ultraviolet ray (EUV light), an X-ray, or an electron beam, and a radioactive ray.
In the present specification, "(meth)acrylate" means one or both of "acrylate" and "methacrylate", "(meth)acryl" means one or both of "acryl" and "methacryl", and "(meth)acryloyl" means one or both of "acryloyl" and "methacryloyl".

In the structural formulae of the present specification, Me represents a methyl group, Et represents an ethyl group, Bu represents a butyl group, and Ph represents a phenyl group.

In the present specification, the total solid content refers to the total mass of components excluding a solvent from the entire components of the composition. In addition, in the present specification, the concentration of solid contents is a mass percentage of other components excluding a solvent with respect to the total mass of the composition.

In the present specification, weight-average molecular weight (Mw) and number-average molecular weight (Mn) are each a value measured using gel permeation chromatography (GPC) unless otherwise specified, which are defined as a polystyrene equivalent value. In the present specification, the weight-average molecular weight (Mw) and the number-average molecular weight (Mn) can be determined, for example, by using HLC-8220 GPC(manufactured by Tosoh Corporation) and using GUARD COLUMN HZ-L, TSKgel Super HZM-M, TSKgel Super HZ4000, TSKgel Super HZ3000, and TSKgel Super HZ2000 (all of which are manufactured by Tosoh Corporation) as a column connected in series. The measurements of the above molecular weights are carried out using tetrahydrofuran (THF) as an eluent unless otherwise specified. However, N-methyl-2-pyrrolidone (NMP) can also be used in a case where THF is not suitable as the eluent, for example, in a case where the solubility is low. In addition, the detection in GPC measurement is carried out using a detector with an ultraviolet ray (a UV ray) of a wavelength of 254 nm unless otherwise specified.

In the present specification, in a case where the positional relationship of respective layers constituting the laminate is described as "upper" or "lower", it suffices that another layer is on the upper side or the lower side of the reference layer among the plurality of layers of interest. That is, a third layer or element may be further interposed between the reference layer and the other layer, and the reference layer and the other layer need not be in contact with each other. In addition, unless otherwise specified, the direction in which the layers are laminated on the base material is referred to as "upward", or in a case where a resin composition layer is present, the direction from the base material to the resin composition layer is referred to as "upper". The opposite direction thereof is referred to as "downward". Furthermore, such a setting of upward and downward directions is for convenience in the present specification, and in a practical aspect, the "upward" direction in the present specification may be different from a vertically upward direction.

In the present specification, a composition may contain, as each component contained in the composition, two or more compounds corresponding to the component unless otherwise specified. The content of each component in the composition means the total content of all the compounds corresponding to the component unless otherwise specified.

In the present specification, unless otherwise specified, the temperature is 23°C, the atmospheric pressure is 101,325 Pa (1 atm), and the relative humidity is 50%RH.

In addition, in the present specification, a combination of preferred aspects is a more preferred aspect.

(Resin composition)

A resin composition according to a first aspect of the present invention contains a resin and a metal complex which has one or more $\pi$-conjugated moieties containing a nitrogen atom.

A resin composition according to a second aspect of the present invention contains a resin and a compound represented by Formula (2-1).

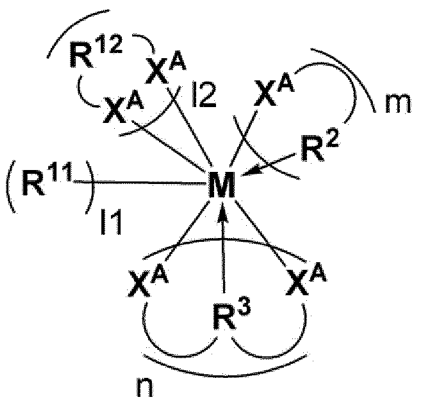

(2-1)

In Formula (2-1), M is titanium, zirconium, or hafnium, 11 is an integer of 0 to 2, 12 is 0 or 1, 11 + l2 $\times$ 2 is an integer of 0 to 2, m is an integer of 0 to 4, n is an integer of 0 to 2, 11 + l2 + m + n $\times$ 2 = 4 is satisfied, $R^{11}$'s are each independently a substituted or unsubstituted cyclopentadienyl group, a substituted or unsubstituted alkoxy group, or a substituted or unsubstituted phenoxy group, $R^{12}$ is a substituted or unsubstituted hydrocarbon group, $R^2$'s are each independently a group including a structure represented by Formula (2-2), $R^3$'s are each independently a group including a structure represented by Formula (2-2), and $X^A$'s are each independently an oxygen atom or a sulfur atom,

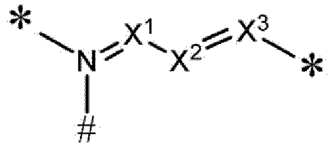

(2-2)

In Formula (2-2), $X^1$ to $X^3$ each independently represent -C(-*)= or -N=, *'s each represent a bonding site to another structure, and # represents a bonding site to a metal atom.

Hereinafter, the resin composition according to the first aspect of the present invention or the resin composition according to the second aspect of the present invention will be also referred to as "the resin composition according to the embodiment of the present invention" or simply "the composition according to the embodiment of the present invention".

The metal complex contained in the resin composition according to the first aspect of the present invention will also be described as a "first specific metal complex".

The compound contained in the resin composition according to the second aspect of the present invention will also be described as a "second specific metal complex".

In addition, the metal complex corresponding to at least one of the first specific metal complex or the second specific metal complex will be also simply referred to as a "specific metal complex".

The resin composition according to the embodiment of the present invention is preferably used for forming a photosensitive film that is subjected to exposure and development, and it is preferably used for forming a film that is subjected to exposure and development using a developer containing an organic solvent.

The resin composition according to the embodiment of the present invention can be used, for example, for forming an insulating film of a semiconductor device, an interlayer insulating film for a re-distribution layer, or a stress buffer film, and it is preferably used for forming an interlayer insulating film for a re-distribution layer.

In particular, one of the preferred aspects of the present invention is that the resin composition according to the embodiment of the present invention contains, as the resin, a cyclization resin or a precursor thereof and is used for forming an interlayer insulating film for a re-distribution layer.

In addition, the resin composition according to the embodiment of the present invention may be used for forming a photosensitive film that is subjected to positive-tone development or may be used for forming a photosensitive film that is subjected to negative-tone development.

In the present invention, the negative-tone development refers to development in which, in exposure and development, a non-exposed portion is removed by the development, and the positive-tone development means a development in which an exposed portion is removed by the development.

As the exposure method, the developer, and the development method, for example, the following ones in the description of the manufacturing method for a cured substance, which will be described later, are used: an exposure method to be described in the exposure step, and a developer and a development method to be described in the development step.

The resin composition according to the embodiment of the present invention is excellent in storage stability and chemical resistance of a cured substance to be obtained.

Although the mechanism by which the above effect is obtained is not revealed, it is presumed as follows.

In various fields, a work of curing a resin composition to obtain a cured substance has been carried out in the related art. Examples thereof include a work of forming a composition film from a resin composition and exposing and heating the composition film to obtain a cured substance.

In the related art, a metal complex having an acetylacetonate ligand or a triethanolamine ligand has been used. However, it was found from the studies by the inventors of the present invention that improvement is necessary in the following viewpoints. In a case where a metal complex having an acetylacetonate ligand is used, the complex formation between resins may increase the viscosity of the composition because the compound is unstable. In addition, in a case where a metal complex having an amino group such as triethanolamine is used, the main chain of the resin may be cut, and the viscosity of the composition may be reduced. As described above, it was found that the composition using the metal complex described in the related art has such poor storage stability of the composition that the viscosity changes during storage. Therefore, any metal complex has room for improvement from the viewpoint of the storage stability of the composition.

In addition, in a case where a composition containing no metal complex was used in order to improve storage stability, it was found that the chemical resistance of a cured substance obtained from the composition is reduced.

In the resin composition according to the first aspect of the present invention, the first specific metal complex has one or more $\pi$-conjugated moieties containing a nitrogen atom, and thus it is possible to achieve both the stability of the metal complex and the low reactivity with respect to the resin. In addition, in the resin composition according to the second aspect of the present invention, the compound (the second specific metal complex) having a specific structure represented by Formula (2-1) is used, and thus it is possible to achieve both the stability of the compound and the low reactivity with

respect to the resin. As a result, the resin composition according to the embodiment of the present invention has excellent storage stability and excellent chemical resistance of the cured substance to be obtained.

Further, since the π-conjugated moiety containing a nitrogen atom in the first specific metal complex is decomposed to generate a base during the heating treatment, it can also play a role as a neutral base generator. Similarly, since a moiety in the second specific metal complex, which includes the structure represented by Formula (2-2) is decomposed to generate a base during the heating treatment, it can also play a role as a neutral base generator. This is presumed to be because, for example, the π-conjugated moiety containing the nitrogen atom or the moiety including the structure represented by Formula (2-2) has a reduced basicity due to the coordination to a metal atom, and thus it acts as a base or further undergoes hydrolysis like an imine compound to generate a stronger base in a case where the metal complex is decomposed by heat.

Here, for example, in a case where the resin composition contains, as the resin, a precursor of a cyclization resin such as a polyimide precursor, it is considered that the breaking elongation also increases due to the base generated from the metal complex. As described above, by containing a metal complex having a coordinate bond due to a conjugated amino group, there is an unexpected effect that the metal complex also acts as a base generator during heating and the like thereby acting on the resin.

Here, JP2014-122279A or WO2017/170600A does not describe a resin composition containing a specific metal complex.

Hereinafter, the components contained in the resin composition according to the embodiment of the present invention will be described in detail.

<Resin>

The resin composition according to the embodiment of the present invention contains a resin.

The resin is not particularly limited, and examples thereof include a resin that is used in a composition for pattern formation in the related art. However, it is preferable to contain at least one resin (specific resin) selected from the group consisting of a cyclization resin and a precursor thereof, and more preferable to contain a precursor of a cyclization resin.

In addition, the acid value of the resin (particularly, the acid values of the cyclization resin and the precursor thereof) is preferably 0 to 0.8 mmol/g, more preferably 0.05 to 0.5 mmol/g, and still more preferably 0.1 to 0.3 mmol/g.

The specific metal complex in the present invention has high stability. Therefore, even in a case where it is used concurrently with a resin having such an acid value, it is presumed that a composition having excellent storage stability can be obtained.

The acid value is measured by a publicly known method, for example, by the method described in JIS K0070: 1992.

In addition, the acid group contained in the resin is preferably an acid group having a pKa of 0 to 10 and more preferably an acid group having a pKa of 3 to 8 from the viewpoint of achieving both storage stability and developability.

The "pKa" is represented by the negative common logarithm pKa of the equilibrium constant Ka of a dissociation reaction, in a case of assuming that hydrogen ions are released from the acid in the dissociation reaction. In the present specification, unless otherwise specified, pKa is a value calculated by ACD/ChemSketch (registered trade name). Alternatively, the values published in "Handbook of Chemistry, Pure Chemistry, 5th Edition" edited by the Chemical Society of Japan may be referred to.

In addition, in a case where the acid group is a polyvalent acid such as phosphoric acid, the pKa is the first dissociation constant.

As such an acid group, the resin preferably contains at least one selected from the group consisting of a carboxy group and a phenolic hydroxy group, and more preferably contains a carboxy group or a phenolic hydroxy group.

The cyclization resin is preferably a resin containing an imide ring structure or an oxazole ring structure in the main chain structure.

In the present invention, the main chain indicates the relatively longest bonding chain in the resin molecule.

Examples of the cyclization resin include polyimide, polybenzoxazole, and polyamideimide.

The precursor of the cyclization resin refers to a resin in which the chemical structure changes by an external stimulus, thereby becoming a cyclization resin. It is preferably a resin of which the chemical structure changes by heat, thereby becoming a cyclization resin, and it is more preferably a resin which undergoes a ring closure reaction by heat to form a ring structure, thereby becoming a cyclization resin.

Examples of the precursor of the cyclization resin include a polyimide precursor, a polybenzoxazole precursor, and a polyamideimide precursor.

That is, the resin composition according to the embodiment of the present invention preferably contains, as the specific resin, at least one resin (specific resin) selected from the group consisting of a polyimide, a polyimide precursor, a polybenzoxazole, a polybenzoxazole precursor, a polyamideimide, and a polyamideimide precursor.

The resin composition according to the embodiment of the present invention preferably contains a polyimide or a

polyimide precursor as the specific resin.

In addition, the specific resin preferably has a polymerizable group and more preferably contains a radically polymerizable group.

In a case where the specific resin has a radically polymerizable group, the resin composition according to the embodiment of the present invention preferably contains a radical polymerization initiator described later, and it more preferably contains a radical polymerization initiator described later and a radical crosslinking agent described later. Further, a sensitizing agent described later can be contained as necessary. From such a resin composition according to the embodiment of the present invention, for example, a negative-tone photosensitive film is formed.

In addition, the specific resin may have a polarity converting group such as an acid-decomposable group.

In a case where the specific resin has an acid-decomposable group, it is preferable that the resin composition according to the embodiment of the present invention contains a photoacid generator described later. From such a resin composition according to the embodiment of the present invention, for example, a positive-tone photosensitive film or a negative-tone photosensitive film, which is a chemical amplification type photosensitive film, is formed.

[Polyimide precursor]

The kind or the like of the polyimide precursor that is used in the present invention is not particularly set; however, it is preferable that the polyimide precursor contains a repeating unit represented by Formula (2).

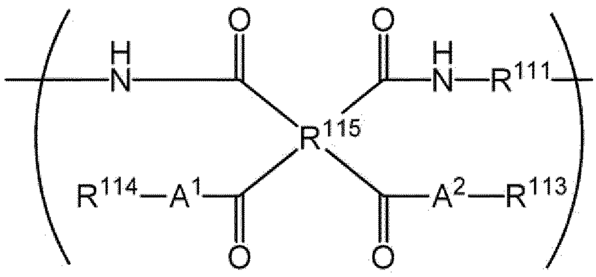

(2)

In Formula (2), $A^1$ and $A^2$ each independently represent an oxygen atom or -NH-, $R^{111}$ represents a divalent organic group, $R^{115}$ represents a tetravalent organic group, and $R^{113}$ and $R^{114}$ each independently represent a hydrogen atom or a monovalent organic group.

$A^1$ and $A^2$ in Formula (2) each independently represent an oxygen atom or -NH-, and an oxygen atom is preferable.

$R^{111}$ in Formula (2) represents a divalent organic group. Examples of the divalent organic group include a group having a linear or branched aliphatic group, a cyclic aliphatic group, or an aromatic group. A linear or branched aliphatic group having 2 to 20 carbon atoms, a cyclic aliphatic group having 3 to 20 carbon atoms, an aromatic group having 3 to 20 carbon atoms, or a group consisting of a combination of these groups is preferable, and a group containing an aromatic group having 6 to 20 carbon atoms is more preferable. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of the preferred embodiment of the present invention include groups respectively represented by -Ar- and -Ar-L-Ar-, and where a group represented by -Ar-L-Ar- is particularly preferable. However, Ar's are each independently an aromatic group, and L is a single bond or an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. The preferred ranges thereof are as described above.

$R^{111}$ is preferably derived from a diamine. Examples of the diamine that is used for producing the polyimide precursor include a linear aliphatic or branched aliphatic diamine, a cyclic aliphatic diamine, or an aromatic diamine. One kind of diamine may be used alone, or two or more kinds thereof may be used.

Specifically, the diamine is preferably a diamine containing a linear or branched aliphatic group having 2 to 20 carbon atoms, a cyclic aliphatic group having 3 to 20 carbon atoms, an aromatic group having 3 to 20 carbon atoms, or a group consisting of a combination thereof, and more preferably a diamine containing an aromatic group having 6 to 20 carbon atoms. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of the group containing an aromatic group include the following groups.

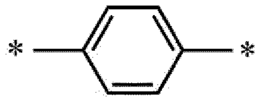
AR-1
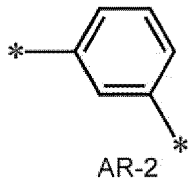
AR-2
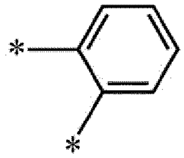
AR-3
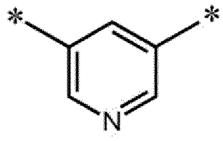
AR-4

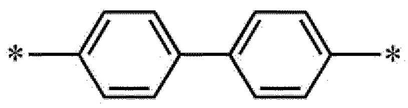
AR-5
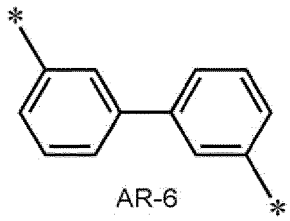
AR-6
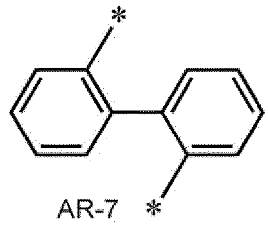
AR-7

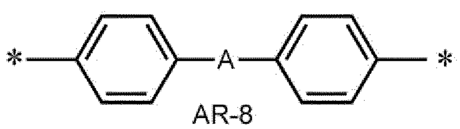
AR-8
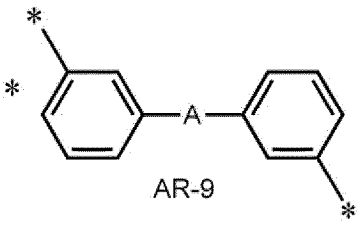
AR-9
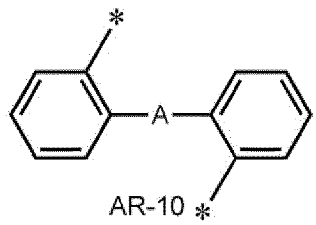
AR-10

In the formulae, A represents a single bond or a divalent linking group. It is preferably a single bond, or an aliphatic hydrocarbon group having 1 to 10 carbon atoms, which may be substituted with a fluorine atom, -O-, -C(=O)-, -S-, $-SO_2-$, -NHCO-, or a group selected from combinations thereof, more preferably a single bond or a group selected from an alkylene group having 1 to 3 carbon atoms, which may be substituted with a fluorine atom, -O-, -C(=O)-, -S-, or $-SO_2-$, and still more preferably $-CH_2-$, -O-, -S-, $-SO_2-$, $-C(CF_3)_2-$, or $-C(CH_3)_2-$.

In the formulae, * represents a bonding site to another structure.

Specific examples of the diamine include at least one diamine selected from 1,2-diaminoethane, 1,2-diaminopropane, 1,3-diaminopropane, 1,4-diaminobutane, or 1,6-diaminohexane; 1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, or isophorone diamine; m- or p-phenylene diamine, diaminotoluene, 4,4'- or 3,3'-diaminobiphenyl, 4,4'-diaminodiphenyl ether, 3,3-diaminodiphenyl ether, 4,4'- or 3,3'-diaminodiphenylmethane, 4,4'- or 3,3'-diaminodiphenyl sulfone, 4,4'- or 3,3'-diaminodiphenyl sulfide, 4,4'- or 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, bis(3-amino-4-hydroxyphenyl)sulfone, bis(4-amino-3-hydroxyphenyl)sulfone, 4,4'-diaminoparaterphenyl, 4,4-bis(4-aminophenoxy)biphenyl, bis[4-(4-aminophenoxy)phenyl]sulfone, bis[4-(3-aminophenoxy)phenyl]sulfone, bis[4-(2-aminophenoxy)phenyl]sulfone, 1,4-bis(4-aminophenoxy)benzene, 9,10-bis(4-aminophenyl)anthracene, 3,3'-dimethyl-4,4'-diaminodiphenyl sulfone, 1,3-bis(4-aminophenoxy)benzene, 1,3-bis(3-aminophenoxy)benzene, 1,3-bis(4-aminophenyl)benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl)fluorene, 4,4'-dimethyl-3,3'-diaminodiphenyl sulfone, 3,3',5,5'-tetramethyl-4,4'-diaminodiphenylmethane, 2,4- or, 2,5-diaminocumene, 2,5-dimethyl-p-phenylene diamine, acetoguanamine, 2,3,5,6-tetramethyl-p-phenylene diamine, 2,4,6-trimethyl-m-phenylene diamine, bis(3-aminopropyl)tetramethyldisiloxane, bis(p-aminophenyl)octamethylpentasiloxane, 2,7-diaminofluorene, 2,5-diaminopyridine, 1,2-bis(4-aminophenyl)ethane, diaminobenzanilide, esters of diaminobenzoic acid, 1,5-diaminonaphthalene, diaminobenzotrifluoride, 1,3-bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis[4-(4-aminophenoxy)-3,5-dimethylphenyl]hexafluoropropane, 2,2-bis[4-(4-aminophenoxy)-3,5-bis(trifluoromethyl)phenyl]hexafluoropropane, p-bis(4-amino-2-trifluoromethylphenoxy)benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone, 2,2-bis[4-(4-amino-3-trifluoromethylphenoxy)phenyl]hexafluoropropane, 3,3',5,5'-tetramethyl-4,4'-diaminobiphenyl, 4,4'-diamino-2,2'-bis(trifluoromethyl)biphenyl, 2,2',5,5',6,6'-hexafluorotolidine, or 4,4'-diaminoquaterphenyl.

Further, the diamines (DA-1) to (DA-18) described in paragraphs 0030 to 0031 of WO2017/038598A are also preferable.

Further, the diamine having two or more alkylene glycol units in the main chain, described in paragraphs 0032 to 0034 of WO2017/038598A, is also preferably used.

$R^{111}$ is preferably represented by -Ar-L-Ar- from the viewpoint of the flexibility of the organic film to be obtained. However, Ar's are each independently an aromatic group, and L is an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. Ar is preferably a phenylene group, and L is preferably an aliphatic hydrocarbon group having 1 or 2 carbon atoms, which may be substituted with a fluorine atom, -O-, -CO-, -S-, or $-SO_2-$. The aliphatic hydrocarbon group here is preferably an alkylene group.

In addition, from the viewpoint of the i-line transmittance, $R^{111}$ is preferably a divalent organic group represented by Formula (51) or Formula (61) below. In particular, from the viewpoint of the i-line transmittance and ease of availability, a divalent organic group represented by Formula (61) is more preferable.

Formula (51)

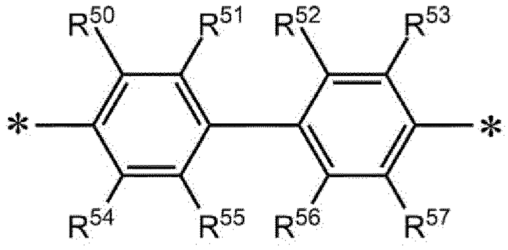
(51)

In Formula (51), $R^{50}$ to $R^{57}$ each independently represent a hydrogen atom, a fluorine atom, or a monovalent organic group, and at least one of $R^{50}$, ..., or $R^{57}$ represents a fluorine atom, a methyl group, or a trifluoromethyl group, and *'s each independently represent a bonding site to the nitrogen atom in Formula (2).

Examples of the monovalent organic group as $R^{50}$ to $R^{57}$ include an unsubstituted alkyl group having 1 to 10 (preferably 1 to 6) carbon atoms and a fluorinated alkyl group having 1 to 10 (preferably 1 to 6) carbon atoms.

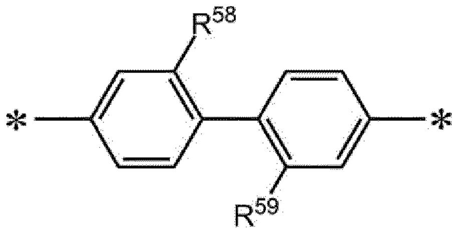
(61)

In Formula (61), $R^{58}$ and $R^{59}$ each independently represent a fluorine atom, a methyl group, or a trifluoromethyl group, and *'s each independently represent a bonding site to the nitrogen atom in Formula (2).

Examples of the diamine that provides a structure of Formula (51) or Formula (61), 2,2'-dimethylbenzidine, 2,2'-bis(trifluoromethyl)-4,4'-diaminobiphenyl, 2,2'-bis(fluoro)-4,4'-diaminobiphenyl, and 4,4'-diaminooctafluorobiphenyl. These may be used alone or in a combination of two or more thereof.

$R^{115}$ in Formula (2) represents a tetravalent organic group. The tetravalent organic group is preferably a tetravalent organic group containing an aromatic ring and more preferably a group represented by Formula (5) or Formula (6).

In Formula (5) or Formula (6), *'s each independently represent a bonding site to another structure.

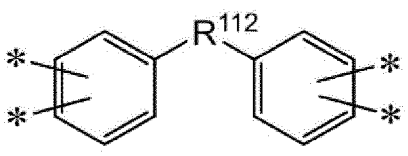
(5)
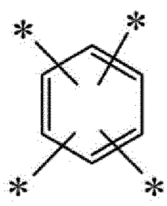
(6)

In Formula (5), $R^{112}$ is a single bond or a divalent linking group. It is preferably a single bond or a group selected from an aliphatic hydrocarbon group having 1 to 10 carbon atoms, which may be substituted with a fluorine atom, -O-, -CO-, -S-, $-SO_2-$, -NHCO-, or a combination thereof, more preferably a single bond or a group selected from an alkylene group having 1 to 3 carbon atoms, which may be substituted with a fluorine atom, -O-, -CO-, -S-, or - $SO_2$-, and still more preferably a divalent group selected from the group consisting of $-CH_2-$, - $C(CF_3)_2$-, $-C(CH_3)_2-$, -O-, -CO-, -S-, and $-SO_2-$.

Specific examples of $R^{115}$ include a tetracarboxylic acid residue that remains after the removal of the anhydride group from the tetracarboxylic acid dianhydride. The polyimide precursor may contain only one kind of tetracarboxylic acid dianhydride residue or may contain two or more kinds thereof, as a structure corresponding to $R^{115}$.

The tetracarboxylic acid dianhydride is preferably represented by Formula (O).

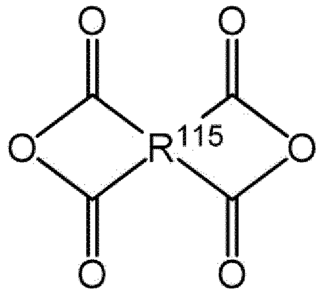

(O)

In Formula (O), $R^{115}$ represents a tetravalent organic group. The preferred range of $R^{115}$ has the same meaning as $R^{115}$ in Formula (2), and the same applies to the preferred range thereof.

Specific examples of the tetracarboxylic acid dianhydride include pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride, 3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1-bis(2,3-dicarboxyphenyl)ethane dianhydride, 1,1-bis(3,4-dicarboxyphenyl)ethane dianhydride, 1,2,3,4-benzene tetracarboxylic acid dianhydride, and alkyl derivatives having 1 to 6 carbon atoms thereof as well as alkoxy derivatives having 1 to 6 carbon atoms thereof.

In addition, preferred examples thereof include the tetracarboxylic acid dianhydrides (DAA-1) to (DAA-5) described in paragraph 0038 of WO2017/038598A.

In Formula (2), it is also possible that at least one of $R^{111}$ or $R^{115}$ has an OH group. More specifically, examples of $R^{111}$ include a residue of a bisaminophenol derivative.

$R^{113}$ and $R^{114}$ in Formula (2) each independently represent a hydrogen atom or a monovalent organic group. The monovalent organic group preferably includes a linear or branched alkyl group, a cyclic alkyl group, an aromatic group, or a polyalkyleneoxy group. In addition, at least one of $R^{113}$ or $R^{114}$ preferably contains a polymerizable group, and more preferably both of them contain a polymerizable group. It is also preferable that at least one of $R^{113}$ or $R^{114}$ contains two or more polymerizable groups. The polymerizable group is preferably a group capable of undergoing a crosslinking reaction under the action of heat, a radical, or the like, where the group is a radically polymerizable group. Specific examples of the polymerizable group include a group having an ethylenically unsaturated bond, an alkoxymethyl group, a hydroxymethyl group, an acyloxymethyl group, an epoxy group, an oxetanyl group, a benzoxazolyl group, a blocked isocyanate group, and an amino group. The radically polymerizable group contained in the polyimide precursor is preferably a group having an ethylenically unsaturated bond.

Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, a (meth)acrylamide group, a (meth)acryloyloxy group, and a group represented by Formula (III), where a group represented by Formula (III) is preferable.

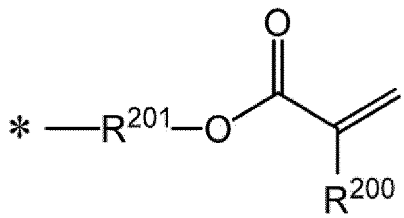

(III)

In Formula (III), $R^{200}$ represents a hydrogen atom, a methyl group, an ethyl group, or a methylol group, where a hydrogen atom or a methyl group is preferable.

In Formula (III), * represents a bonding site to another structure.

In Formula (III), $R^{201}$ represents an alkylene group having 2 to 12 carbon atoms, - $CH_2CH(OH)CH_2$-, a cycloalkylene group, or a polyalkyleneoxy group.

Suitable examples of $R^{201}$ include an alkylene group such as an ethylene group, a propylene group, a trimethylene group, a tetramethylene group, a pentamethylene group, a hexamethylene group, an octamethylene group, or a dodecamethylene group, a 1,2-butanediyl group, a 1,3-butanediyl group, -$CH_2CH(OH)CH_2$-, and a polyalkyleneoxy group, where an alkylene group such as an ethylene group or a propylene group, -$CH_2CH(OH)CH_2$-, a cyclohexyl group, or a polyalkyleneoxy group is more preferable, and an alkylene group such as an ethylene group or a propylene group, or a polyalkyleneoxy group is still more preferable.

In the present invention, the polyalkyleneoxy group refers to a group to which two or more alkyleneoxy groups are directly bonded. The alkylene group in the plurality of alkyleneoxy groups contained in the polyalkyleneoxy group may be the same or different from each other.

In a case where the polyalkyleneoxy group contains a plurality of kinds of alkyleneoxy groups having different alkylene groups, the sequence of the alkyleneoxy groups in the polyalkyleneoxy group may be a randomly arranged sequence, may be a sequence arranged to have a block, or may be a sequence arranged to have an alternating pattern or the like.

The number of carbon atoms of the alkylene group (including the number of carbon atoms of the substituent in a case where the alkylene group has a substituent) is preferably 2 or more, more preferably 2 to 10, still more preferably 2 to 6, even still more preferably 2 to 5, even further still more preferably 2 to 4, particularly preferably 2 or 3, and most preferably 2.

In addition, the alkylene group may have a substituent. Examples of the preferred substituent include an alkyl group, an aryl group, and a halogen atom.

In addition, the number of alkyleneoxy groups contained in the polyalkyleneoxy group (the number of repetitions of the polyalkyleneoxy group) is preferably 2 to 20, more preferably 2 to 10, and still more preferably 2 to 6.

The polyalkyleneoxy group is preferably a polyethyleneoxy group, a polypropyleneoxy group, a polytrimethyleneoxy group, a polytetramethyleneoxy group, or a group obtained by bonding a plurality of ethyleneoxy groups with a plurality of propyleneoxy groups, more preferably a polyethyleneoxy group or a polypropyleneoxy group, and still more preferably a polyethyleneoxy group, from the viewpoint of solubility in a solvent and solvent resistance. In the group obtained by bonding a plurality of ethyleneoxy groups with a plurality of propyleneoxy groups, the ethyleneoxy groups and the propyleneoxy groups may be randomly arranged, may be arranged by forming a block, or may be arranged in an alternately patterned manner or the like. The preferred aspect of the number of repetitions of the ethyleneoxy group and the like in these groups is as described above.

In Formula (2), in a case where $R^{113}$ is a hydrogen atom, or in a case where $R^{114}$ is a hydrogen atom, the polyimide precursor may form a conjugate salt together with a tertiary amine compound having an ethylenically unsaturated bond. Examples of the tertiary amine compound having such an ethylenically unsaturated bond include N,N-dimethylaminopropyl methacrylate.

In Formula (2), at least one of $R^{113}$ or $R^{114}$ may be a polarity converting group such as an acid-decomposable group. The acid-decomposable group is not particularly limited as long as it decomposes by the action of the acid to generate an alkali-soluble group such as a phenolic hydroxy group or a carboxy group; however, it is preferably an acetal group, a ketal group, a silyl group, a silyl ether group, a tertiary alkyl ester group, or the like, and from the viewpoint of exposure sensitivity, it is more preferably an acetal group or a ketal group.

Specific examples of the acid-decomposable group include a tert-butoxycarbonyl group, an isopropoxycarbonyl group, a tetrahydropyranyl group, a tetrahydrofuranyl group, an ethoxyethyl group, a methoxyethyl group, an ethoxymethyl group, a trimethylsilyl group, a tert-butoxycarbonylmethyl group, and a trimethylsilyl ether group. From the viewpoint of exposure sensitivity, an ethoxyethyl group or a tetrahydrofuranyl group is preferable.

In addition, the polyimide precursor preferably has a fluorine atom in the structure thereof. The content of fluorine atoms in the polyimide precursor is preferably 10% by mass or more, and it is preferably 20% by mass or less.

In addition, for the purpose of improving adhesiveness to a substrate, the polyimide precursor may be

copolymerized with an aliphatic group having a siloxane structure. Specifically, an aspect in which bis(3-aminopropyl) tetramethyldisiloxane, bis(p-aminophenyl)octamethylpentasiloxane, or the like is used as the diamine can be mentioned.

The repeating unit represented by Formula (2) is preferably a repeating unit represented by Formula (2-A). That is, at least one polyimide precursor that is used in the present invention is preferably a precursor having a repeating unit represented by Formula (2-A). In a case where the polyimide precursor contains a repeating unit represented by Formula (2-A), it is possible to further widen the width of the exposure latitude.

Formula (2-A)

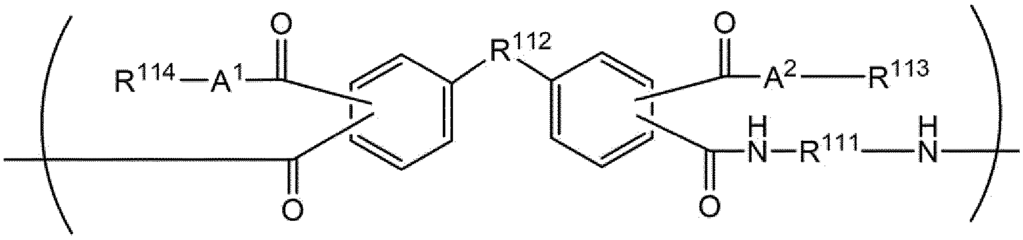

In Formula (2-A), $A^1$ and $A^2$ represent an oxygen atom, $R^{111}$ and $R^{112}$ each independently represent a divalent organic group, $R^{113}$ and $R^{114}$ each independently represent a hydrogen atom or a monovalent organic group, and at least one of $R^{113}$ or $R^{114}$ is a group containing a polymerizable group, where both of them are preferably a group containing a polymerizable group.

$A^1$, $A^2$, $R^{111}$, $R^{113}$, and $R^{114}$ are each independently have the same meaning as $A^1$, $A^2$, $R^{111}$, $R^{113}$, and $R^{114}$ in Formula (2), respectively, and the same applies to the preferred ranges thereof.

$R^{112}$ has the same meaning as $R^{112}$ in Formula (5), and the same applies to the preferred range thereof.

The polyimide precursor may contain one kind of repeating unit represented by Formula (2) or may contain two or more kinds thereof. In addition, the polyimide precursor may contain structural isomers of the repeating unit represented by Formula (2). The polyimide precursor may also contain another kind of repeating unit in addition to the above repeating unit represented by Formula (2).

One embodiment of the polyimide precursor in the present invention includes an aspect in which the content of the repeating unit represented by Formula (2) is 50% by mole or more of all the repeating units. The above-described total content is more preferably 70% by mole or more, still more preferably 90% by mole or more, and particularly preferably more than 90% by mole. The upper limit of the total content is not particularly limited, and all the repeating units in the polyimide precursor excluding the terminal may be the repeating unit represented by Formula (2).

The weight-average molecular weight (Mw) of the polyimide precursor is preferably 5,000 to 100,000, more preferably 5,000 to 50,000, still more preferably 10,000 to 50,000, and particularly preferably 15,000 to 40,000. In addition, the number-average molecular weight (Mn) thereof is preferably 2,000 to 40,000, more preferably 3,000 to 30,000, and still more preferably 4,000 to 20,000.

The dispersity of the molecular weight of the polyimide precursor is preferably 1.5 or more, more preferably 1.8 or more, and still more preferably 2.0 or more. The upper limit value of the dispersity of the molecular weight of the polyimide precursor is not particularly set; however, it is, for example, preferably 7.0 or less, more preferably 6.5 or less, and still more preferably 6.0 or less.

In the present specification, the dispersity of the molecular weight is a value obtained by calculating "weight-average molecular weight/number-average molecular weight".

In addition, in a case where the resin composition contains a plurality of kinds of polyimide precursors as the specific resin, it is preferable that the weight-average molecular weight, the number-average molecular weight, and the dispersity of at least one kind of polyimide precursor are in the above ranges. Further, it is also preferable that the weight-average molecular weight, the number-average molecular weight, and the dispersity, calculated by using the plurality of kinds of polyimide precursors as one resin, are within the above ranges.

[Polyimide]

The polyimide that is used in the present invention may be an alkali-soluble polyimide or may be a polyimide soluble in a developer containing an organic solvent as a main component.

In the present specification, the alkali-soluble polyimide refers to a polyimide, 0.1 g or more of which is dissolved in 100 g of an aqueous solution of 2.38% by mass of tetramethylammonium at 23°C, and from the viewpoint of pattern formation properties, it is preferably a polyimide, 0.5 g or more of which is dissolved therein and still more preferably a polyimide, 1.0 g or more of which is dissolved therein. The upper limit of the dissolution amount is not particularly limited;

however, it is preferably 100 g or less.

In addition, the polyimide is preferably a polyimide having a plurality of imide structures in the main chain from the viewpoint of the film hardness and the insulating properties of the organic film to be obtained.

In the present specification, the "main chain" refers to the relatively longest bonding chain in the molecule of the polymer compound that constitutes the resin, and the "side chain" refers to other bonding chains other than the main chain.

- Fluorine atom -

From the viewpoint of the film hardness of the organic film to be obtained, the polyimide preferably has a fluorine atom.

The fluorine atom is preferably contained in, for example, $R^{132}$ in a repeating unit represented by Formula (4) described later or $R^{131}$ in a repeating unit represented by Formula (4) described later, and it is more preferably contained, as a fluorinated alkyl group, in $R^{132}$ in a repeating unit represented by Formula (4) described later or $R^{131}$ in a repeating unit represented by Formula (4) described later.

The amount of fluorine atoms with respect to the total mass of the polyimide is preferably 5% by mass or more, and it is preferably 20% by mass or less.

- Silicon atom -

From the viewpoint of the film hardness of the organic film to be obtained, it is also preferable that the polyimide has a silicon atom.

The silicon atom is preferably contained in, for example, $R^{131}$ in a repeating unit represented by Formula (4) described later, and more preferably contained in $R^{131}$ in a repeating unit represented by Formula (4) described later as an organically modified (poly)siloxane structure.

In addition, the silicon atom or the organically modified (poly)siloxane structure may be contained in the side chain of the polyimide; however, it is preferably contained in the main chain of the polyimide.

The amount of silicon atoms with respect to the total mass of the polyimide is preferably 1% by mass or more and more preferably 20% by mass or less.

- Ethylenically unsaturated bond -

From the viewpoint of the film hardness of the organic film to be obtained, the polyimide preferably has an ethylenically unsaturated bond.

The polyimide may have an ethylenically unsaturated bond at the terminal of the main chain or the side chain; however, it preferably has an ethylenically unsaturated bond at the side chain.

The ethylenically unsaturated bond preferably has radical polymerizability.

The ethylenically unsaturated bond is preferably contained in $R^{132}$ in a repeating unit represented by Formula (4) described later or $R^{131}$ in a repeating unit represented by Formula (4) described later, and it is more preferably contained, as a group having an ethylenically unsaturated bond, in $R^{132}$ in a repeating unit represented by Formula (4) described later or $R^{131}$ in a repeating unit represented by Formula (4) described later.

Among the above, the ethylenically unsaturated bond is preferably contained in $R^{131}$ in a repeating unit represented by Formula (4) described later, and it is more preferably contained, as a group having an ethylenically unsaturated bond, in $R^{131}$ in a repeating unit represented by Formula (4) described later.

Examples of the group having an ethylenically unsaturated bond include a group having a vinyl group which may be substituted, which is directly bonded to an aromatic ring such as a vinyl group, an allyl group, or a vinylphenyl group, a (meth)acrylamide group, a (meth)acryloyloxy group, and a group represented by Formula (IV).

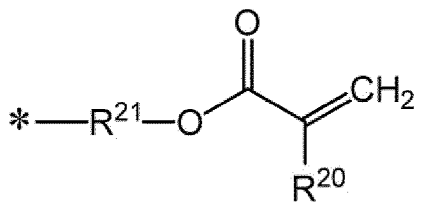

(IV)

In Formula (IV), $R^{20}$ represents a hydrogen atom, a methyl group, an ethyl group, or a methylol group, where a hydrogen atom or a methyl group is preferable.

In Formula (IV), $R^{21}$ represents an alkylene group having 2 to 12 carbon atoms, $-O-CH_2CH(OH)CH_2-$, $-C(=O)O-$,

-O(C=O)NH-, a (poly)alkyleneoxy group having 2 to 30 carbon atoms (the alkylene group preferably has 2 to 12 carbon atoms, more preferably 2 to 6 carbon atoms, and particularly preferably 2 or 3 carbon atoms; the number of repetitions thereof is preferably 1 to 12, more preferably 1 to 6, and particularly preferably 1 to 3), or a group obtained by combining two or more of these.

In addition, the alkylene group having 2 to 12 carbon atoms may be a linear one, a branched one, or a cyclic one, or may be any an alkylene group represented by a combination of these.

The alkylene group having 2 to 12 carbon atoms is preferably an alkylene group having 2 to 8 carbon atoms and more preferably an alkylene group having 2 to 4 carbon atoms.

Among the above, $R^{21}$ is preferably a group represented by any one of Formulae (R1) to (R3) and more preferably a group represented by Formula (R1).

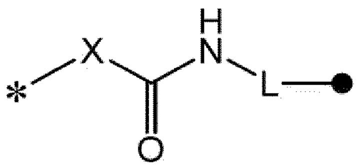

(R1)

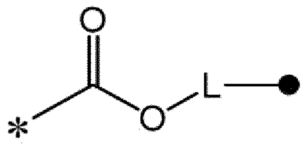

(R2)

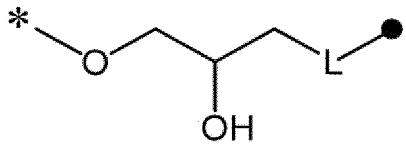

(R3)

In Formulae (R1) to (R3), L represents a single bond, an alkylene group having 2 to 12 carbon atoms, a (poly) alkyleneoxy group having 2 to 30 carbon atoms, or a group obtained by bonding two or more of these, X represents an oxygen atom or a sulfur atom, * represents a bonding site to another structure, and ● represents a bonding site to an oxygen atom to which $R^{21}$ in Formula (IV) is bonded.

In Formulae (R1) to (R3), a preferred aspect of the alkylene group having 2 to 12 carbon atoms in L or the (poly) alkyleneoxy group having 2 to 30 carbon atoms is the same as the preferred aspect of the alkylene group having 2 to 12 carbon atoms or the (poly)alkyleneoxy group having 2 to 30 carbon atoms as $R^{21}$ described above.

In Formula (R1), X is preferably an oxygen atom.

In Formulae (R1) to (R3), * has the same meaning as * in Formula (IV), and the same applies to the preferred aspect thereof.

The structure represented by Formula (R1) is obtained, for example, by reacting a polyimide having a hydroxy group such as a phenolic hydroxy group with a compound (for example, 2-isocyanatoethyl methacrylate) having an isocyanato group and an ethylenically unsaturated bond.

The structure represented by Formula (R2) is obtained, for example, by reacting a polyimide having a carboxy group with a compound (for example, 2-hydroxyethyl methacrylate) having a hydroxy group and an ethylenically unsaturated bond.

The structure represented by Formula (R3) is obtained, for example, by reacting a polyimide having a hydroxy group such as a phenolic hydroxy group with a compound (for example, glycidyl methacrylate) having a glycidyl group and an ethylenically unsaturated bond.

In Formula (IV), * represents a bonding site to another structure, and it is preferably a bonding site to the main chain of the polyimide.

The amount of the ethylenically unsaturated bond with respect to the total mass of the polyimide is preferably 0.0001 to 0.1 mol/g and more preferably 0.0005 to 0.05 mol/g.

- Polymerizable group other than group having ethylenically unsaturated bond -

The polyimide may have a polymerizable group other than the group having an ethylenically unsaturated bond.

Examples of the polymerizable group other than the group having an ethylenically unsaturated bond include a cyclic ether group such as an epoxy group or an oxetanyl group, an alkoxymethyl group such as a methoxymethyl group, and a methylol group.

The polymerizable group other than the group having an ethylenically unsaturated bond is preferably contained in, for example, $R^{131}$ in a repeating unit represented by Formula (4) described later.

The amount of the polymerizable group other than the group having an ethylenically unsaturated bond with respect to the total mass of the polyimide is preferably 0.0001 to 0.1 mol/g and more preferably 0.001 to 0.05 mol/g.

- Polarity converting group -

The polyimide may have a polarity converting group such as an acid-decomposable group. The acid-decomposable group in the polyimide is the same as the acid-decomposable group described in $R^{113}$ and $R^{114}$ in Formula (2) described above, and the same applies to the preferred aspect thereof.

The polarity converting group is contained, for example, in $R^{131}$ or $R^{132}$ in the repeating unit represented by Formula (4) described later, or a terminal of the polyimide.

- Acid value -

In a case where the polyimide is subjected to alkaline development, the acid value of the polyimide is preferably 30 mgKOH/g or more, more preferably 50 mgKOH/g or more, and still more preferably 70 mgKOH/g or more, from the viewpoint of improving developability.

In addition, the acid value thereof is preferably 500 mgKOH/g or less, more preferably 400 mgKOH/g or less, and still more preferably 200 mgKOH/g or less.

Further, in a case where the polyimide is subjected to the development (for example, the "solvent development" described later) using a developer containing an organic solvent as a main component, the acid value of the polyimide is preferably 1 to 35 mgKOH/g, more preferably 2 to 30 mgKOH/g, and still more preferably 5 to 20 mgKOH/g.

The acid value is measured by a publicly known method, for example, by the method described in JIS K0070: 1992.

In addition, the acid group contained in the polyimide is preferably an acid group having a pKa of 0 to 10 and more preferably an acid group having a pKa of 3 to 8 from the viewpoint of achieving both storage stability and developability.

As such an acid group, the polyimide preferably contains at least one selected from the group consisting of a carboxy group and a phenolic hydroxy group and more preferably contains a phenolic hydroxy group.

- Phenolic hydroxy group -

From the viewpoint of allowing the speed of development with an alkali developer to be proper, the polyimide preferably has a phenolic hydroxy group.

The polyimide may have a phenolic hydroxy group at the terminal of the main chain or the side chain.

The phenolic hydroxy group is preferably contained in, for example, $R^{132}$ in a repeating unit represented by Formula (4) described later or $R^{131}$ in a repeating unit represented by Formula (4) described later.

The amount of the phenolic hydroxy group with respect to the total mass of the polyimide is preferably 0.1 to 30 mol/g and more preferably 1 to 20 mol/g.

The polyimide that is used in the present invention is not particularly limited as long as it is a polymer compound having an imide structure; however, it is preferable that the polyimide contains a repeating unit represented by Formula (4).

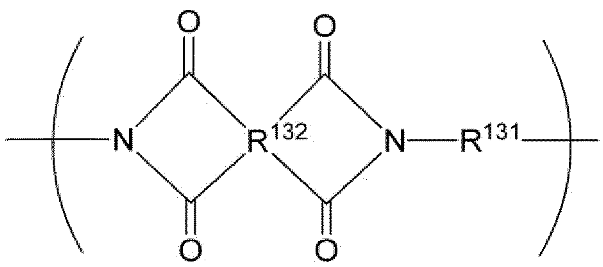

(4)

In Formula (4), $R^{131}$ represents a divalent organic group, and $R^{132}$ represents a tetravalent organic group.

In a case where a polymerizable group is contained, the polymerizable group may be located at at least one of $R^{131}$ or $R^{132}$ or may be located at the terminal of the polyimide as shown in Formula (4-1) or Formula (4-2).

Formula (4-1)

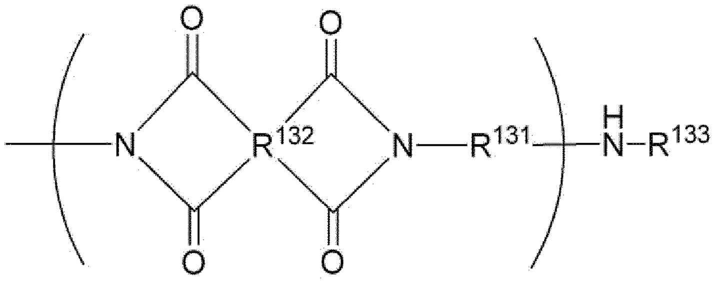

In Formula (4-1), $R^{133}$ is a polymerizable group, and the other groups respectively have the same meanings as those in Formula (4).

Formula (4-2)

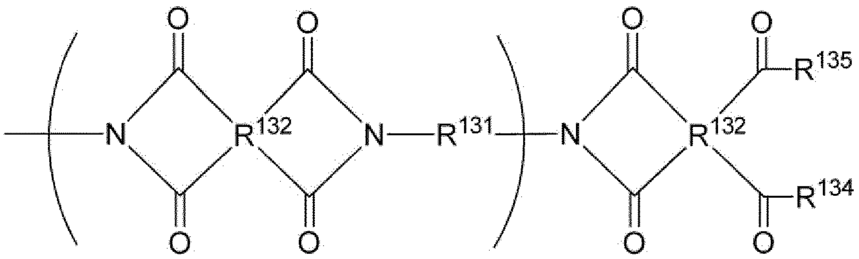

At least one of $R^{134}$ or $R^{135}$ is a polymerizable group, where it is an organic group in a case of not being a polymerizable group, and the other groups respectively have the same meanings as those in Formula (4).

Examples of the polymerizable group include the above-described group having an ethylenically unsaturated bond or a crosslinkable group other than the above-described group having an ethylenically unsaturated bond.

$R^{131}$ represents a divalent organic group. Examples of the divalent organic group include the same one as $R^{111}$ in Formula (2), and the same applies to the preferred range thereof.

In addition, examples of $R^{131}$ include a diamine residue that remains after the removal of an amino group of a diamine. Examples of the diamine include an aliphatic, a cyclic aliphatic, and an aromatic diamine. Specific examples thereof include the example of $R^{111}$ in Formula (2) which is contained in the polyimide precursor.

It is preferable that $R^{131}$ is a diamine residue having at least two alkylene glycol units in the main chain from the viewpoint of more effectively suppressing the occurrence of warping during baking. It is more preferably a diamine residue containing, in one molecule, a total of two or more chains of any one or both of the ethylene glycol chain and the propylene glycol chain, and it is still more preferably the above-described diamine which is a diamine residue containing no aromatic ring.

Examples of the diamine containing, in one molecule, a total of two or more chains of any one or both of the ethylene glycol chain and the propylene glycol chain include JEFFAMINE (registered trade name) KH-511, ED-600, ED-900, ED-2003, EDR-148, EDR-176, D-200, D-400, D-2000, D-4000 (all of which are product names, manufactured by HUNTSMAN Corporation), 1-(2-(2-(2-aminopropoxy)ethoxy)propoxy)propane-2-amine, and 1-(1-(1-(2-aminopropoxy)propan-2-yl)oxy)propane-2-amine, which are not limited thereto.

$R^{132}$ represents a tetravalent organic group. Examples of the tetravalent organic group include the same one as $R^{115}$ in Formula (2), and the same applies to the preferred range thereof.

For example, four bonding partners of the tetravalent organic group exemplified as $R^{115}$ are bonded to four -C(=O)- moieties in Formula (4) to form a fused ring.

In addition, examples of $R^{132}$ include a tetracarboxylic acid residue that remains after the removal of the anhydride group from the tetracarboxylic acid dianhydride. Specific examples thereof include the example of $R^{115}$ in Formula (2) which is contained in the polyimide precursor. From the viewpoint of the hardness of the organic film, $R^{132}$ is preferably an aromatic diamine residue having 1 to 4 aromatic rings.

It is also preferable that an OH group is contained in at least one of $R^{131}$ or $R^{132}$. More specifically, preferred examples of $R^{131}$ include 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, and the above (DA-1) to (DA-18), and more preferred examples of $R^{132}$ include the above (DAA-1) to (DAA-5).

In addition, the polyimide preferably has a fluorine atom in the structure thereof. The content of fluorine atoms in

the polyimide is preferably 10% by mass or more, and it is more preferably 20% by mass or less.

In addition, for intended the purpose of improving adhesiveness to a substrate, an aliphatic group having a siloxane structure may be copolymerized with the polyimide. Specific examples of the diamine component include bis(3-aminopropyl)tetramethyldisiloxane, and bis(p-aminophenyl)octamethylpentasiloxane.

In addition, in order to improve the storage stability of the resin composition, the terminal of the main chain of the polyimide is preferably blocked with a terminal blocking agent such as a monoamine, an acid anhydride, a monocarboxylic acid, a monoacid chloride compound, or a monoactive ester compound. Among these, it is more preferable to use monoamine. Examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

- Imidization rate (ring closure rate) -

The imidization rate (also referred to as the "ring closure rate") of the polyimide is preferably 70% or more, more preferably 80% or more, and still more preferably 90% or more, from the viewpoint of the film hardness, the insulating properties, or the like of the organic film to be obtained.

The upper limit of the imidization rate is not particularly limited, and it may be any imidization rate of 100% or less.

The imidization rate is measured by, for example, the following method.

The infrared absorption spectrum of polyimide is measured, and a peak intensity P1 in the vicinity of 1,377 $cm^{-1}$, which is the absorption peak derived from the imide structure, is obtained. Next, the polyimide is subjected to a heat treatment at 350°C for 1 hour, and then the infrared absorption spectrum is measured again to obtain a peak intensity P2 in the vicinity of 1,377 $cm^{-1}$. Using the obtained peak intensities P1 and P2, the imidization rate of the polyimide can be determined based on the following expression.

$$\text{Imidization rate (\%)} = (\text{peak intensity P1}/\text{peak intensity P2}) \times 100$$

The polyimide may contain the repeating unit represented by Formula (4), in which $R^{131}$ or $R^{132}$ contained therein is one kind, or may contain the repeating unit represented by Formula (4), in which $R^{131}$ or $R^{132}$ contained therein is two or more kinds different from each other. In addition, the polyimide may also contain another kind of repeating unit in addition to the above repeating unit represented by Formula (4). Examples of the other kind of repeating unit include the repeating unit represented by Formula (2) described above.

The polyimide can be synthesized by using, for example, a method in which a tetracarboxylic acid dianhydride is reacted with a diamine (a part thereof is substituted with a terminal blocking agent which is a monoamine) at a low temperature, a method in which a tetracarboxylic acid dianhydride (a part thereof is substituted with a terminal blocking agent which is an acid anhydride, a monoacid chloride compound, or a monoactive ester compound) is reacted with a diamine at a low temperature, a method in which a diester is obtained from a tetracarboxylic acid dianhydride and alcohol and then reacted with a diamine (a part thereof is substituted with a terminal blocking agent which is a monoamine) in the presence of a condensing agent, a method in which a polyimide precursor is obtained, for example, by using a method in which a diester is obtained from a tetracarboxylic acid dianhydride and an alcohol, the remaining dicarboxylic acid is subjected to acid chloride modification and reacted with a diamine (a part thereof is substituted with a terminal blocking agent which is a monoamine), and the polyimide precursor is subjected to full imidization using a known imidization reaction method, or, a method in which the imidization reaction is stopped in the middle of the reaction and the imide structure is partially introduced, or furthermore a method in which a fully imidized polymer is blended with the polyimide precursor, whereby the imide structure is partially introduced. In addition, another publicly known method for synthesizing polyimide can also be applied.

The weight-average molecular weight (Mw) of the polyimide is preferably 5,000 to 100,000, more preferably 5,000 to 50,000, still more preferably 10,000 to 50,000, and particularly preferably 15,000 to 40,000. In a case where the weight-average molecular weight is set to 5,000 or more, it is possible to improve the breakage resistance of the film after curing. In order to obtain an organic film having excellent mechanical characteristics (for example, breaking elongation), the weight-average molecular weight is particularly preferably 15,000 or more.

In addition, the number-average molecular weight (Mn) of the polyimide is preferably 2,000 to 40,000, more preferably 3,000 to 30,000, and still more preferably 4,000 to 20,000.

The dispersity of the molecular weight of the polyimide is preferably 1.5 or more, more preferably 1.8 or more, and still more preferably 2.0 or more. The upper limit value of the dispersity of the molecular weight of the polyimide is not particularly set; however, it is, for example, preferably 7.0 or less, more preferably 6.5 or less, and still more preferably 6.0 or less.

In addition, in a case where the resin composition contains a plurality of kinds of polyimides as the specific resin, it is preferable that the weight-average molecular weight, the number-average molecular weight, and the dispersity of at least one kind of polyimide are in the above ranges. Further, it is also preferable that the weight-average molecular weight, the number-average molecular weight, and the dispersity, calculated by using the plurality of kinds of polyimides as one resin, are within the above ranges.

[Polybenzoxazole precursor]

The structure or the like of the polybenzoxazole precursor that is used in the present invention is not particularly set; however, it preferably includes a repeating unit represented by Formula (3).

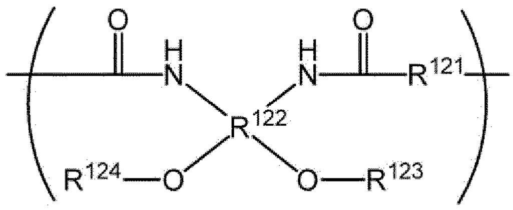 (3)

In Formula (3), $R^{121}$ represents a divalent organic group, $R^{122}$ represents a tetravalent organic group, and $R^{123}$ and $R^{124}$ each independently represent a hydrogen atom or a monovalent organic group.

In Formula (3), $R^{123}$ and $R^{124}$ have the same meanings as $R^{113}$ in Formula (2), and the same applies to the preferred ranges thereof. That is, it is preferable that at least one of them is a polymerizable group.

In Formula (3), $R^{121}$ represents a divalent organic group. The divalent organic group is preferably a group containing at least one of an aliphatic group or an aromatic group. The aliphatic group is preferably a linear aliphatic group. $R^{121}$ is preferably a dicarboxylic acid residue. One kind of dicarboxylic acid residue may be used alone, or two or more kinds thereof may be used.

The dicarboxylic acid residue is preferably a dicarboxylic acid containing an aliphatic group or a dicarboxylic acid residue containing an aromatic group, and more preferably a dicarboxylic acid residue containing an aromatic group.

The dicarboxylic acid containing an aliphatic group is preferably a dicarboxylic acid containing a linear or branched (preferably linear) aliphatic group, and more preferably a dicarboxylic acid consisting of a linear or branched (preferably linear) aliphatic group and two -COOH. The linear or branched (preferably linear) aliphatic group preferably has 2 to 30 carbon atoms, more preferably 2 to 25 carbon atoms, still more preferably 3 to 20 carbon atoms, even still more preferably 4 to 15 carbon atoms, particularly preferably 5 to 10 carbon atoms. The linear aliphatic group is preferably an alkylene group.

Examples of the dicarboxylic acid containing a linear aliphatic group include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, and furthermore, dicarboxylic acids represented by the following formulae.

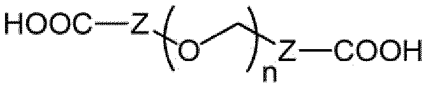 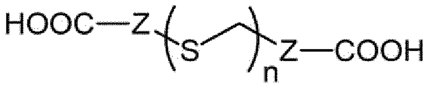

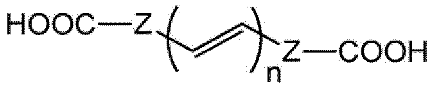 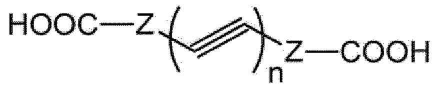

(In the formulae, Z is a hydrocarbon group having 1 to 6 carbon atoms, and n is an integer of 1 to 6).

The dicarboxylic acid containing an aromatic group is preferably a dicarboxylic acid having the following aromatic group and more preferably a dicarboxylic acid consisting of only the following group having an aromatic group and two pieces of -COOH.

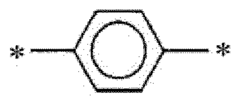 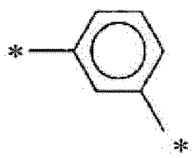 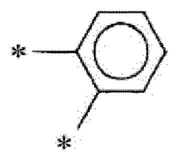 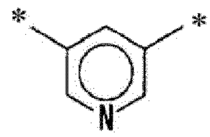

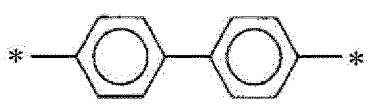 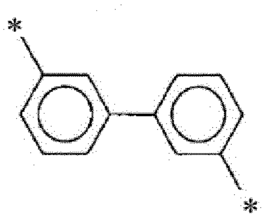 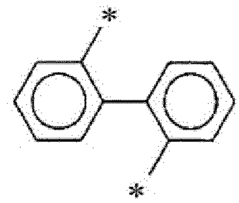

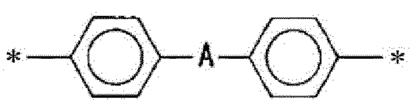 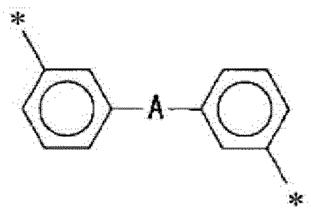 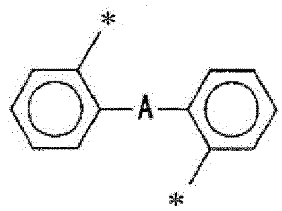

In the formulae, A represents a divalent group selected from the group consisting of - $CH_2$-, -O-, -S-, -$SO_2$-, -CO-, -NHCO-, -$C(CF_3)_2$-, and -$C(CH_3)_2$-, and *'s each independently represent a bonding site to another structure.

Specific examples of the dicarboxylic acid containing an aromatic group include 4,4'-carbonyldibenzoic acid, 4,4'-dicarboxydiphenyl ether, and terephthalic acid.

In Formula (3), $R^{122}$ represents a tetravalent organic group. The tetravalent organic group has the same meaning as $R^{115}$ in Formula (2) described above, and the same applies to the preferred range thereof.

In addition, $R^{122}$ is preferably a group derived from a bisaminophenol derivative. Examples of the group derived from the bisaminophenol derivative include 3,3'-diamino-4,4'-dihydroxybiphenyl, 4,4'-diamino-3,3'-dihydroxybiphenyl, 3,3'-diamino-4,4'-dihydroxydiphenylsulfone, 4,4'-diamino-3,3'-dihydroxydiphenylsulfone, bis-(3-amino-4-hydroxyphenyl)methane, 2,2-bis(3-amino-4-hydroxyphenyl)propane, 2,2-bis-(3-amino-4-hydroxyphenyl)hexafluoropropane, 2,2-bis-(4-amino-3-hydroxyphenyl)hexafluoropropane, bis-(4-amino-3-hydroxyphenyl)methane, 2,2-bis-(4-amino-3-hydroxyphenyl)propane, 4,4'-diamino-3,3'-dihydroxybenzophenone, 3,3'-diamino-4,4'-dihydroxybenzophenone, 4,4'-diamino-3,3'-dihydroxydiphenyl ether, 3,3'-diamino-4,4'-dihydroxydiphenyl ether, 1,4-diamino-2,5-dihydroxybenzene, 1,3-diamino-2,4-dihydroxybenzene, and 1,3-diamino-4,6-dihydroxybenzene. These bisaminophenols may be used alone or may be mixedly used.

Among the bisaminophenol derivatives, the bisaminophenol derivative having the following aromatic group is preferable.

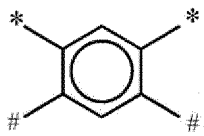 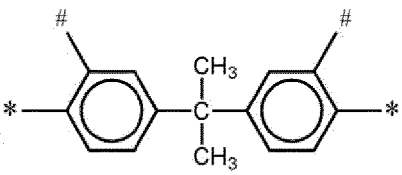 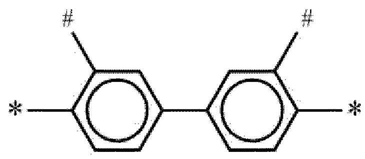

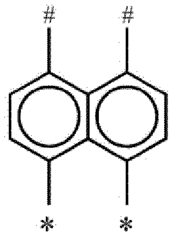
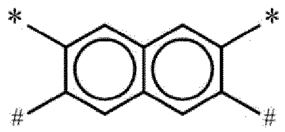
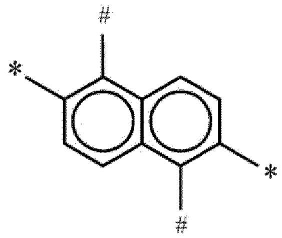

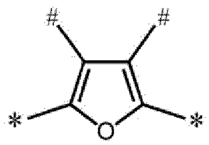
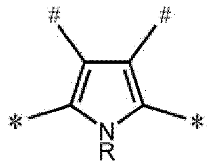
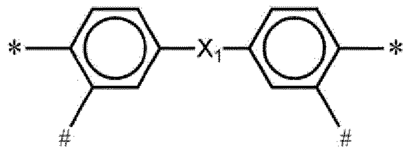

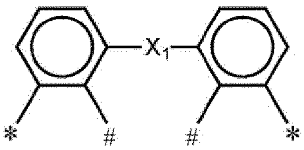

In the formulae, $X_1$ represents -O-, -S-, $-C(CF_3)_2-$, $-CH_2-$, $-SO_2-$, or -NHCO-, and * and # each represent a bonding site to another structure. R represents a hydrogen atom or a monovalent substituent, where a hydrogen atom or a hydrocarbon group is preferable, and a hydrogen atom or an alkyl group is more preferable. In addition, it is also preferable that $R^{122}$ has a structure represented by the above formula. In a case where $R^{122}$ has a structure represented by the above formula, it is preferable that any two of a total of four of *'s and #'s are bonding sites to the nitrogen atom to which $R^{122}$ in Formula (3) is bonded and the other two are bonding sites to the oxygen atom to which $R^{122}$ Formula (3) is bonded, it is more preferable that two *'s are bonding sites to the oxygen atom to which $R^{122}$ in Formula (3) is bonded and two #'s are bonding sites to the nitrogen atom to which $R^{122}$ Formula (3) is bonded or that two *'s are bonding sites to the nitrogen atom to which $R^{122}$ in Formula (3) is bonded and two #'s are bonding sites to the oxygen atom to which $R^{122}$ Formula (3) is bonded, and it is still more preferable that two *'s are bonding sites to the oxygen atom to which $R^{122}$ in Formula (3) is bonded and two #'s are bonding sites to the nitrogen atom to which $R^{122}$ Formula (3) is bonded.

The bisaminophenol derivative is also preferably a compound represented by Formula (A-s).

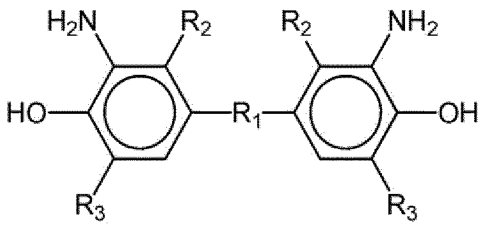
(A-s)

In Formula (A-s), $R_1$ is a hydrogen atom, an alkylene, a substituted alkylene, -O-, -S-, - $SO_2$-, -CO-, -NHCO-, a single bond, or an organic group selected from the group of Formula (A-sc). $R_2$'s are any one of a hydrogen atom, an alkyl group, an alkoxy group, an acyloxy group, or a cyclic alkyl group, and may be the same or different from each other. $R^3$'s are any one of a hydrogen atom, a linear or branched alkyl group, an alkoxy group, an acyloxy group, or a cyclic alkyl group, and may be the same or different from each other.

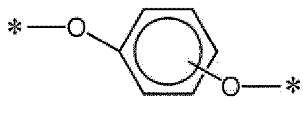
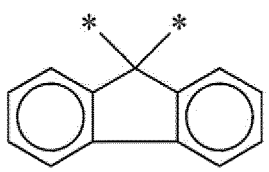
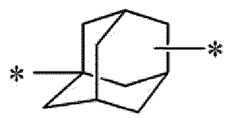

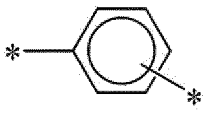 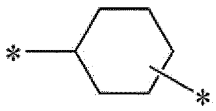 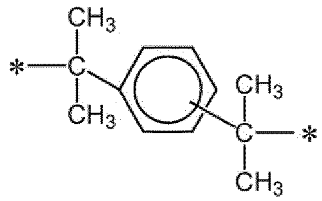

(A－sc)

(In Formula (A-sc), * indicates bonding to the aromatic ring of the aminophenol group of the bisaminophenol derivative represented by Formula (A-s).)

In Formula (A-s), it is conceived that in a case where a substituent is also provided at the ortho position of the phenolic hydroxy group, that is, $R_3$, the distance between the carbonyl carbon of the amide bond and the hydroxy group becomes closer, and such a case is particularly preferable since the effect that the cyclization rate becomes high in a case where curing is carried out at a low temperature is further enhanced.

In addition, in Formula (A-s), in a case where $R_2$ is an alkyl group and $R_3$ is an alkyl group, it is possible to maintain the high transparency to the i-line and the effect that the cyclization rate is high in a case where curing is carried out at a low temperature, which is preferable.

In addition, in Formula (A-s), it is still more preferable that $R_1$ is an alkylene or a substituted alkylene. Specific examples of the alkylene and the substituted alkylene, which is involved in $R_1$ include linear or branched alkyl groups having 1 to 8 carbon atoms. However, among them, $-CH_2-$, $-CH(CH_3)-$, or $-C(CH_3)_2-$ is more preferable since it is possible to obtain a polybenzoxazole precursor excellent in balance in terms of having sufficient solubility in a solvent while maintaining the high transparency to the i-line and the effect that the cyclization rate is high in a case where curing is carried out at a low temperature.

As a method of producing the bisaminophenol derivative represented by Formula (A-s), for example, paragraph Nos. 0085 to 0094 and Example 1 (paragraph Nos. 0189 to 0190) of JP2013-256506A can be referenced, the content of which is incorporated in the present specification.

Specific examples of the structure of the bisaminophenol derivative represented by Formula (A-s) include those described in paragraph Nos. 0070 to 0080 of JP2013-256506A, the content of which is incorporated in the present specification. Of course, the specific examples thereof are not limited thereto.

The polybenzoxazole precursor may contain another kind of repeating structural unit in addition to the repeating unit of Formula (3).

From the viewpoint that the occurrence of warping associated with ring closure can be suppressed, the polybenzoxazole precursor preferably contains a diamine residue represented by Formula (SL) as another kind of repeating unit.

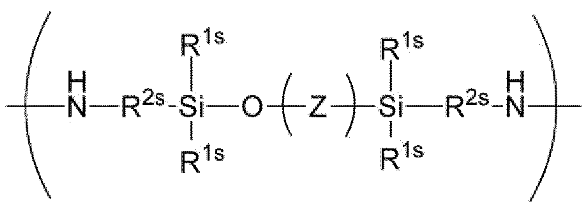

(SL)

a: 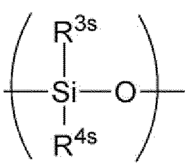 b: 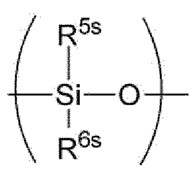

In Formula (SL), Z has a structure and a b structure, $R^{1s}$ is a hydrogen atom or a hydrocarbon group having 1 to 10 carbon atoms, $R^{2s}$ is a hydrocarbon group having 1 to 10 carbon atoms, and at least one of $R^{3s}$, $R^{4s}$, $R^{5s}$, or $R^{6s}$ is an aromatic group, where the rest are a hydrogen atom or an organic group having 1 to 30 carbon atoms and may be the same or different from each other. The polymerization of the a structure and the b structure may be block polymerization or random polymerization. Regarding the contents of the structures in the Z portion in terms of "% by mole", the content of the a structure is 5% to 95% by mole and the content of the b structure is 95% to 5% by mole, the sum (the content of the a structure + the content of the b structure) is 100% by mole.

In Formula (SL), examples of the preferred Z include one in which $R^{5s}$ and $R^{6s}$ in the b structure are a phenyl group. In addition, the molecular weight of the a structure represented by Formula (SL) is preferably 400 to 4,000 and more

preferably 500 to 3,000. In a case where the molecular weight is within the above-described range, it is possible to more effectively decrease an elastic modulus of a polybenzoxazole precursor after the dehydration ring closure and to achieve both effects of suppressing warping and improving solubility in a solvent.

In a case where a diamine residue represented by Formula (SL) is contained as another kind of repeating unit, it is also preferable that a tetracarboxylic acid residue that has remained after removing an anhydride group from the tetracarboxylic acid dianhydride is further contained as a repeating unit. Examples of such a tetracarboxylic acid residue include the examples of $R^{115}$ in Formula (2).

The weight-average molecular weight (Mw) of the polybenzoxazole precursor is preferably 18,000 to 30,000, more preferably 20,000 to 29,000, and still more preferably 22,000 to 28,000. In addition, the number-average molecular weight (Mn) thereof is preferably 7,200 to 14,000, more preferably 8,000 to 12,000, and still more preferably 9,200 to 11,200.

The dispersity of the molecular weight of the polybenzoxazole precursor is preferably 1.4 or more, more preferably 1.5 or more, and still more preferably 1.6 or more. The upper limit value of the dispersity of the molecular weight of the polybenzoxazole precursor is not particularly set; however, it is, for example, preferably 2.6 or less, more preferably 2.5 or less, still more preferably 2.4 or less, even still more preferably 2.3 or less, and even further still more preferably 2.2 or less.

In addition, in a case where the resin composition contains a plurality of kinds of polybenzoxazole precursors as the specific resin, it is preferable that the weight-average molecular weight, the number-average molecular weight, and the dispersity of at least one kind of polybenzoxazole precursor are in the above ranges. Further, it is also preferable that the weight-average molecular weight, the number-average molecular weight, and the dispersity, calculated by using the plurality of kinds of polybenzoxazole precursors as one resin, are within the above ranges.

[Polybenzoxazole]

The polybenzoxazole is not particularly limited as long as it is a polymer compound having a benzoxazole ring; however, it is preferably a compound represented by Formula (X), and it is more preferably a compound represented by Formula (X), which is a compound having a polymerizable group. The polymerizable group is preferably a radically polymerizable group. In addition, it may be a compound represented by Formula (X), which is a compound having a polarity converting group such as an acid-decomposable group.

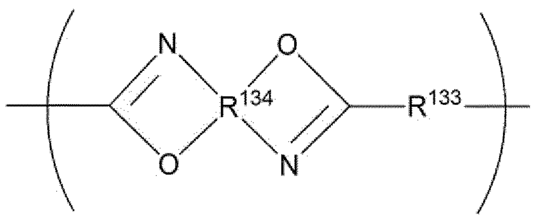

(X)

In Formula (X), $R^{133}$ represents a divalent organic group, and $R^{134}$ represents a tetravalent organic group.

In a case where the polymerizable group or the polarity converting group such as an acid-decomposable group is contained, the polymerizable group or the polarity converting group such as an acid-decomposable group may be located at at least one of $R^{133}$ or $R^{134}$, or may be located at a terminal of polybenzoxazole as shown in Formula (X-1) or Formula (X-2).

Formula (X-1)

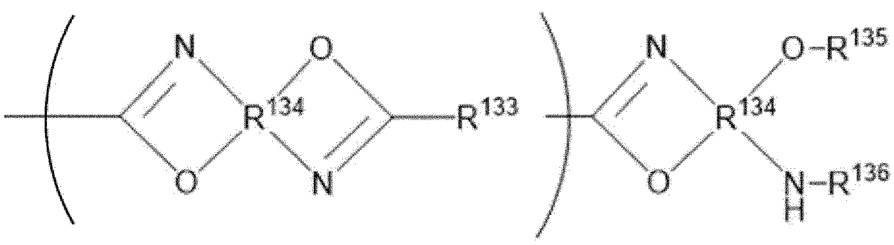

In Formula (X-1), at least one of $R^{135}$ or $R^{136}$ is a polymerizable group or a polarity converting group such as an acid-decomposable group, or it is an organic group in a case where it is not a polymerizable group or a polarity converting group such as an acid-decomposable group, and other groups are the same as those in Formula (X).

Formula (X-2)

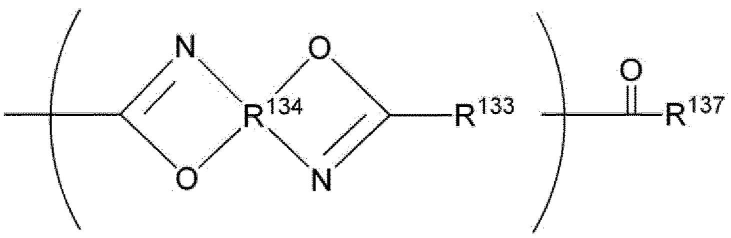

In Formula (X-2), $R^{137}$ is a polymerizable group or a polarity converting group such as an acid-decomposable group, others are substituents, and other groups are the same as those in Formula (X).

The polymerizable group or the polarity converting group such as an acid-decomposable group has the same meaning as the polymerizable group described above for the polymerizable group contained in the polyimide precursor.

$R^{133}$ represents a divalent organic group. Examples of the divalent organic group include an aliphatic group and an aromatic group. Specific examples thereof include the example of $R^{121}$ in Formula (3) in the polybenzoxazole precursor. In addition, the preferred example thereof is the same as that of $R^{121}$.

$R^{134}$ represents a tetravalent organic group. Examples of the tetravalent organic group include the example of $R^{122}$ in Formula (3) in the polybenzoxazole precursor. In addition, the preferred example thereof is the same as that of $R^{122}$.

For example, four bonding partners of the tetravalent organic group exemplified as $R^{122}$ are bonded to the nitrogen atom and the oxygen atom in Formula (X) to form a fused ring. For example, in a case where $R^{134}$ is the following organic group, the following structure is formed. In the following structure, *'s each represent a bonding site to a nitrogen atom or an oxygen atom in Formula (X).

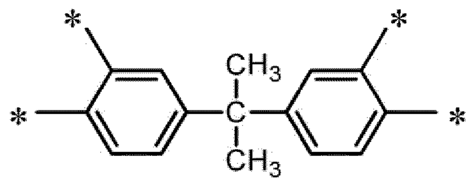

The oxazole modification rate of the polybenzoxazole is preferably 85% or more and more preferably 90% or more. The upper limit thereof is not particularly limited and may be 100%. In a case where the oxazole modification rate is 85% or more, the film shrinkage based on the ring closure, which occurs when oxazole modification occurs due to heating, is reduced, and thus the occurrence of warping can be more effectively suppressed.

The oxazole modification rate is measured, for example, according to the following method.

An infrared absorption spectrum of polybenzoxazole is measured, and a peak intensity Q1 in the vicinity of 1,650 $cm^{-1}$, which is an absorption peak derived from the amide structure of the precursor, is determined. Next, the absorption intensity of the aromatic ring observed in the vicinity of 1,490 $cm^{-1}$ is standardized. The polybenzoxazole is subj ected to a heat treatment at 350°C for 1 hour, and then the infrared absorption spectrum is measured again to determine a peak intensity Q2 in the vicinity of 1,650 $cm^{-1}$, followed by standardization with the absorption intensity of the aromatic ring observed in the vicinity of 1,490 $cm^{-1}$. Using the obtained standard values of the peak intensities Q1 and Q2, it is possible to determine the oxazole modification rate of the polybenzoxazole based on the following expression.

Oxazole modification rate (%) = (standard value of peak intensity Q1/standard value of peak intensity Q2) $\times$ 100

The polybenzoxazole may contain the repeating unit of Formula (X), in which $R^{133}$ or $R^{134}$ contained therein is one kind, or may contain the repeating unit represented of (X), in which $R^{133}$ or $R^{134}$ contained therein is two or more kinds different from each other. In addition, the polybenzoxazole may contain another kind of repeating unit in addition to the repeating unit of Formula (X).

The polybenzoxazole can be obtained by, for example, reacting a bisaminophenol derivative with a compound selected from a dicarboxylic acid dichloride, a dicarboxylic acid derivative, and the like of a dicarboxylic acid containing $R^{133}$ or the above dicarboxylic acid, to obtain a polybenzoxazole precursor, and subjecting it to the oxazole modification with a known oxazole reaction method.

In a case of a dicarboxylic acid, an active ester-type dicarboxylic acid derivative subjected to reaction in advance with 1-hydroxy-1,2,3-benzotriazole or the like may be used in order to increase the reaction yield or the like.

The weight-average molecular weight(Mw) of polybenzoxazole is preferably 5,000 to 70,000, more preferably 8,000 to 50,000, and still more preferably 10,000 to 30,000. In a case where the weight-average molecular weight is set to 5,000 or more, it is possible to improve the breakage resistance of the film after curing. In order to obtain an organic film

having excellent mechanical characteristics, the weight-average molecular weight is particularly preferably 20,000 or more. In a case where two or more kinds of polybenzoxazole are contained, it is preferable that the weight-average molecular weight of at least one kind of polybenzoxazole is in the above range.

In addition, the number-average molecular weight (Mn) of the polybenzoxazole is preferably 7,200 to 14,000, more preferably 8,000 to 12,000, and still more preferably 9,200 to 11,200.

The dispersity of the molecular weight of the polybenzoxazole is preferably 1.4 or more, more preferably 1.5 or more, and still more preferably 1.6 or more. The upper limit value of the dispersity of the molecular weight of the polybenzoxazole is not particularly set; however, it is, for example, preferably 2.6 or less, more preferably 2.5 or less, still more preferably 2.4 or less, even still more preferably 2.3 or less, and even further still more preferably 2.2 or less.

In addition, in a case where the resin composition contains a plurality of kinds of polybenzoxazoles as the specific resin, it is preferable that the weight-average molecular weight, the number-average molecular weight, and the dispersity of at least one kind of polybenzoxazole are in the above ranges. Further, it is also preferable that the weight-average molecular weight, the number-average molecular weight, and the dispersity, calculated by using the plurality of kinds of polybenzoxazoles as one resin, are within the above ranges.

[Polyamideimide precursor]

The polyamideimide precursor preferably contains a repeating unit represented by Formula (PAI-2).

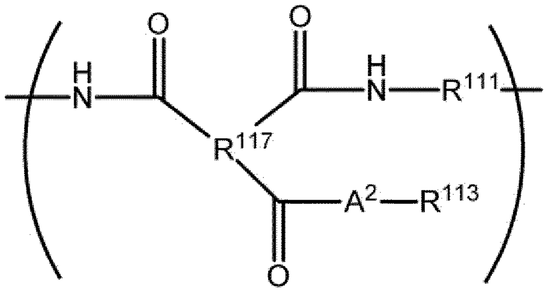

(PAI-2)

In Formula (PAI-2), $R^{117}$ represents a trivalent organic group, $R^{111}$ represents a divalent organic group, $A^2$ represents an oxygen atom or -NH-, and $R^{113}$ represents a hydrogen atom or a monovalent organic group.

In Formula (PAI-2), examples of $R^{117}$ include a linear or branched aliphatic group, a cyclic aliphatic group, an aromatic group, a heteroaromatic group, and a group obtained by linking two or more of these groups through a single bond or a linking group, where $R^{117}$ is preferably a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and $R^{117}$ is more preferably an aromatic group having 6 to 20 carbon atoms or a group obtained by combining two or more aromatic groups having 6 to 20 carbon atoms through a single bond or a linking group.

The linking group is preferably -O-, -S-, -C(=O)-, $-S(=O)_2-$, an alkylene group, a halogenated alkylene group, an arylene group, or a linking group obtained by bonding two or more these, and it is more preferably -O-, -S-, an alkylene group, a halogenated alkylene group, an arylene group, or a linking group obtained by bonding two or more these.

The alkylene group is preferably an alkylene group having 1 to 20 carbon atoms, more preferably an alkylene group having 1 to 10 carbon atoms, and still more preferably an alkylene group having 1 to 4 carbon atoms.

The halogenated alkylene group is preferably a halogenated alkylene group having 1 to 20 carbon atoms, more preferably a halogenated alkylene group having 1 to 10 carbon atoms, and still more preferably a halogenated alkylene group having 1 to 4 carbon atoms. In addition, examples of the halogen atom in the halogenated alkylene group include a fluorine atom, a chlorine atom, a bromine atom, and an iodine atom, where a fluorine atom is preferable. The halogenated alkylene group may have a hydrogen atom, or all hydrogen atoms in the halogenated alkylene group may be substituted with a halogen atom. However, it is preferable that all hydrogen atoms are substituted with a halogen atom. Examples of the preferred halogenated alkylene group include a (ditrifluoromethyl)methylene group.

The arylene group is preferably a phenylene group or a naphthylene group, more preferably a phenylene group, and still more preferably a 1,3-phenylene group or a 1,4-phenylene group.

In addition, $R^{117}$ is preferably derived from a tricarboxylic acid compound in which at least one carboxy group may be subjected to halogenation. Here, the halogenation is preferably chlorination.

In the present invention, a compound having three carboxy groups is referred to as a tricarboxylic acid compound.

Two carboxy groups of the three carboxy groups of the tricarboxylic acid compound may be subjected to acid anhydrization.

Examples of the tricarboxylic acid compound which may be halogenated, which is used in the production of the

polyamideimide precursor, include a branched aliphatic, cyclic aliphatic, or aromatic tricarboxylic acid compound.

One kind of these tricarboxylic acid compounds may be used alone, or two or more kinds thereof may be used.

Specifically, the tricarboxylic acid compound is preferably a tricarboxylic acid compound containing a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and more preferably a tricarboxylic acid compound containing an aromatic group having 6 to 20 carbon atoms or a group obtained by combining two or more aromatic groups having 6 to 20 carbon atoms through a single bond or a linking group.

Specific examples of the tricarboxylic acid compound include 1,2,3-propanetricarboxylic acid, 1,3,5-pentanetricarboxylic acid, citric acid, trimellitic acid, 2,3,6-naphthalenetricarboxylic acid, and a compound in which phthalic acid (or phthalic anhydride) and benzoic acid are linked through a single bond, -O-, $-CH_2-$, $-C(CH_3)_2-$, $-C(CF_3)_2-$, $-SO_2-$, or a phenylene group.

These compounds may be a compound (for example, a trimellitic acid anhydride) in which two carboxy groups have been subjected to anhydrization or may be a compound (for example, trimellitic anhydride chloride) in which at least one carboxy group has been halogenated.

In Formula (PAI-2), $R^{111}$, $A^2$, and $R^{113}$ respectively have the same meanings as $R^{111}$, $A^2$, and $R^{113}$ in Formula (2) described above, and the same applies to the preferred aspects thereof.

The polyamideimide precursor may further contain other repeating units.

Examples of the other repeating units include the above-described repeating unit represented by Formula (2) and a repeating unit represented by Formula (PAI-1).

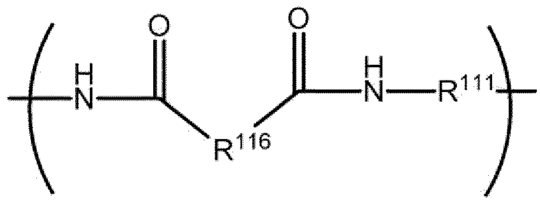

(PAI-1)

In Formula (PAI-1), $R^{116}$ represents a divalent organic group, and $R^{111}$ represents a divalent organic group.

In Formula (PAI-1), examples of $R^{116}$ include a linear or branched aliphatic group, a cyclic aliphatic group, an aromatic group, a heteroaromatic group, and a group obtained by linking two or more of these groups through a single bond or a linking group, where $R^{116}$ is preferably a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and $R^{116}$ is more preferably an aromatic group having 6 to 20 carbon atoms or a group obtained by combining two or more aromatic groups having 6 to 20 carbon atoms through a single bond or a linking group.

The linking group is preferably -O-, -S-, -C(=O)-, $-S(=O)_2-$, an alkylene group, a halogenated alkylene group, an arylene group, or a linking group obtained by bonding two or more these, and it is more preferably -O-, -S-, an alkylene group, a halogenated alkylene group, an arylene group, or a linking group obtained by bonding two or more these.

The alkylene group is preferably an alkylene group having 1 to 20 carbon atoms, more preferably an alkylene group having 1 to 10 carbon atoms, and still more preferably an alkylene group having 1 to 4 carbon atoms.

The halogenated alkylene group is preferably a halogenated alkylene group having 1 to 20 carbon atoms, more preferably a halogenated alkylene group having 1 to 10 carbon atoms, and still more preferably a halogenated alkylene group having 1 to 4 carbon atoms. In addition, examples of the halogen atom in the halogenated alkylene group include a fluorine atom, a chlorine atom, a bromine atom, and an iodine atom, where a fluorine atom is preferable. The halogenated alkylene group may have a hydrogen atom, or all hydrogen atoms in the halogenated alkylene group may be substituted with a halogen atom. However, it is preferable that all hydrogen atoms are substituted with a halogen atom. Examples of the preferred halogenated alkylene group include a (ditrifluoromethyl)methylene group.

The arylene group is preferably a phenylene group or a naphthylene group, more preferably a phenylene group, and still more preferably a 1,3-phenylene group or a 1,4-phenylene group.

In addition, $R^{116}$ is preferably derived from a dicarboxylic acid compound or a dicarboxylic acid dihalide compound.

In the present invention, a compound having two carboxy groups is referred to as a dicarboxylic acid compound, and a compound having two halogenated carboxy groups is referred to as a dicarboxylic acid dihalide compound.

The carboxy group in the dicarboxylic acid dihalide compound may be halogenated; however, it is, for example, preferably chlorinated. That is, the dicarboxylic acid dihalide compound is preferably a dicarboxylic acid dichloride compound.

Examples of the dicarboxylic acid compound which may be halogenated or the dicarboxylic acid dihalide compound, which is used in the production of the polyamideimide precursor, include a linear or branched aliphatic, cyclic aliphatic, or aromatic dicarboxylic acid compound, and a dicarboxylic acid dihalide compound.

One kind of these dicarboxylic acid compounds or dicarboxylic acid dihalide compounds may be used alone, or two or more kinds thereof may be used.

Specifically, the dicarboxylic acid compound or the dicarboxylic acid dihalide compound is preferably a dicarboxylic acid compound or dicarboxylic acid dihalide compound containing a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and more preferably a dicarboxylic acid compound or dicarboxylic acid dihalide compound containing an aromatic group having 6 to 20 carbon atoms or a group obtained by combining two or more aromatic groups having 6 to 20 carbon atoms through a single bond or a linking group.

In addition, specific examples of the dicarboxylic acid compound include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, phthalic acid, isophthalic acid, terephthalic acid, 4,4'-biphenylcarboxylic acid, 4,4'-dicarboxydiphenyl ether, and benzophenone-4,4'-dicarboxylic acid.

Specific examples of the dicarboxylic acid dihalide compound include a compound having a structure in which two carboxy groups in the specific examples of the dicarboxylic acid compound are halogenated.

In Formula (PAI-1), $R^{111}$ has the same meaning as $R^{111}$ in Formula (2) described above, and the same applies to the preferred aspect thereof.

In addition, the polyamideimide precursor preferably has a fluorine atom in the structure thereof. The content of fluorine atoms in the polyamideimide precursor is preferably 10% by mass or more, and it is preferably 20% by mass or less.

In addition, for the purpose of improving adhesiveness to a substrate, the polyamideimide precursor may be copolymerized with an aliphatic group having a siloxane structure. Specifically, an aspect in which bis(3-aminopropyl) tetramethyldisiloxane, bis(p-aminophenyl)octamethylpentasiloxane, or the like is used as the diamine component can be mentioned.

One embodiment of the polyamideimide precursor in the present invention includes an aspect in which the total content of the repeating unit represented by Formula (PAI-2), the repeating unit represented by Formula (PAI-1), and the repeating unit represented by Formula (2) is 50% by mole or more of all the repeating units. The above-described total content is more preferably 70% by mole or more, still more preferably 90% by mole or more, and particularly preferably more than 90% by mole. The upper limit of the total content is not particularly limited, and all the repeating units in the polyamideimide precursor excluding the terminal may be any one of the repeating unit represented by Formula (PAI-2), the repeating unit represented by Formula (PAI-1), or the repeating unit represented by Formula (2).

In addition, another embodiment of the polyamideimide precursor in the present invention includes an embodiment in which the total content of the repeating unit represented by Formula (PAI-2) and the repeating unit represented by Formula (PAI-1) is 50% by mole or more of all the repeating units. The above-described total content is more preferably 70% by mole or more, still more preferably 90% by mole or more, and particularly preferably more than 90% by mole. The upper limit of the total content is not particularly limited, and all the repeating units in the polyamideimide precursor excluding the terminal may be any one of the repeating units represented by Formula (PAI-2) or the repeating unit represented by Formula (PAI-1).

The weight-average molecular weight (Mw) of the polyamideimide precursor is preferably 2,000 to 500,000, more preferably 5,000 to 100,000, and still more preferably 10,000 to 50,000. In addition, the number-average molecular weight (Mn) thereof is preferably 800 to 250,000, more preferably 2,000 to 50,000, and still more preferably 4,000 to 25,000.

The dispersity of the molecular weight of the polyamideimide precursor is preferably 1.5 or more, more preferably 1.8 or more, and still more preferably 2.0 or more. The upper limit value of the dispersity of the molecular weight of the polyamideimide precursor is not particularly set; however, it is, for example, preferably 7.0 or less, more preferably 6.5 or less, and still more preferably 6.0 or less.

In addition, in a case where the resin composition contains a plurality of kinds of polyamideimide precursors as

the specific resin, it is preferable that the weight-average molecular weight, the number-average molecular weight, and the dispersity of at least one kind of polyamideimide precursor are in the above ranges. Further, it is also preferable that the weight-average molecular weight, the number-average molecular weight, and the dispersity, calculated by using the plurality of kinds of polyamideimide precursors as one resin, are within the above ranges.

[Polyamideimide]

The polyamideimide that is used in the present invention may be an alkali-soluble polyamideimide or may be a polyamideimide soluble in a developer containing an organic solvent as a main component.
In the present specification, the alkali-soluble polyamideimide refers to a polyamideimide, 0.1 g or more of which is dissolved in 100 g of an aqueous solution of 2.38% by mass of tetramethylammonium at 23°C, and from the viewpoint of pattern formation properties, it is preferably a polyamideimide, 0.5 g or more of which is dissolved therein and still more preferably a polyamideimide, 1.0 g or more of which is dissolved therein. The upper limit of the dissolution amount is not particularly limited; however, it is preferably 100 g or less.
In addition, the polyamideimide is preferably a polyamideimide having a plurality of amide bonds and a plurality of imide structures in the main chain from the viewpoint of the film hardness and the insulating properties of the organic film to be obtained.

- Fluorine atom -

From the viewpoint of the film hardness of the organic film to be obtained, the polyamideimide preferably has a fluorine atom.
The fluorine atom is preferably contained in, for example, $R^{117}$ or $R^{111}$ in a repeating unit represented by Formula (PAI-3) described later, and it is more preferably contained, as a fluorinated alkyl group, in $R^{117}$ or $R^{111}$ in the repeating unit represented by Formula (PAI-3) described later.
The amount of fluorine atoms with respect to the total mass of the polyamideimide is preferably 5% by mass or more, and it is preferably 20% by mass or less.

- Ethylenically unsaturated bond -

From the viewpoint of the film hardness of the organic film to be obtained, the polyamideimide may have an ethylenically unsaturated bond.
The polyamideimide may have an ethylenically unsaturated bond at the terminal of the main chain or the side chain; however, it preferably has an ethylenically unsaturated bond at the side chain.
The ethylenically unsaturated bond preferably has radical polymerizability.
The ethylenically unsaturated bond is preferably contained in $R^{117}$ or $R^{111}$ in a repeating unit represented by Formula (PAI-3) described later, and it is more preferably contained, as a group having an ethylenically unsaturated bond, in $R^{117}$ or $R^{111}$ in a repeating unit represented by Formula (PAI-3) described later.
The preferred aspect of the group having an ethylenically unsaturated bond is the same as the preferred aspect of the group having an ethylenically unsaturated bond in the above-described polyimide.
The amount of the ethylenically unsaturated bond with respect to the total mass of the polyamideimide is preferably 0.0001 to 0.1 mol/g and more preferably 0.001 to 0.05 mol/g.

- Polymerizable group other than ethylenically unsaturated bond -

The polyamideimide may have a polymerizable group other than the ethylenically unsaturated bond.
Examples of the polymerizable group other than the ethylenically unsaturated bond in the polyamideimide include the same group as the polymerizable group other than the ethylenically unsaturated bond in the above-described polyimide.
The polymerizable group other than the ethylenically unsaturated bond is preferably contained in, for example, $R^{111}$ in a repeating unit represented by Formula (PAI-3) described later.
The amount of the polymerizable group other than the ethylenically unsaturated bond with respect to the total mass of the polyamideimide is preferably 0.05 to 10 mol/g and more preferably 0.1 to 5 mol/g.

- Polarity converting group -

The polyamideimide may have a polarity converting group such as an acid-decomposable group. The acid-decomposable group in the polyamideimide is the same as the acid-decomposable group described in $R^{113}$ and $R^{114}$ in

Formula (2) described above, and the same applies to the preferred aspect thereof.

- Acid value -

In a case where the polyamideimide is subjected to alkaline development, the acid value of the polyamideimide is preferably 30 mgKOH/g or more, more preferably 50 mgKOH/g or more, and still more preferably 70 mgKOH/g or more, from the viewpoint of improving developability.

In addition, the acid value thereof is preferably 500 mgKOH/g or less, more preferably 400 mgKOH/g or less, and still more preferably 200 mgKOH/g or less.

Further, in a case where the polyamideimide is subjected to the development (for example, the "solvent development" described later) using a developer containing an organic solvent as a main component, the acid value of the polyamideimide is preferably 2 to 35 mgKOH/g, more preferably 3 to 30 mgKOH/g, and still more preferably 5 to 20 mgKOH/g.

The acid value is measured by a publicly known method, for example, by the method described in JIS K0070: 1992.

In addition, examples of the acid group contained in the polyamideimide include the same group as the acid group in the above-described polyimide, and the same applies to the preferred aspect thereof.

- Phenolic hydroxy group -

From the viewpoint of allowing the speed of development with an alkali developer to be proper, the polyamideimide preferably has a phenolic hydroxy group.

The polyamideimide may have a phenolic hydroxy group at the terminal of the main chain or the side chain.

The phenolic hydroxy group is preferably contained in, for example, $R^{117}$ or $R^{111}$ in a repeating unit represented by Formula (PAI-3) described later.

The amount of the phenolic hydroxy group with respect to the total mass of the polyamideimide is preferably 0.1 to 30 mol/g and more preferably 1 to 20 mol/g.

The polyamideimide that is used in the present invention is not particularly limited as long as it is a polymer compound having an imide structure and an amide bond; however, it is preferable that the polyamideimide contains a repeating unit represented by Formula (PAI-3).

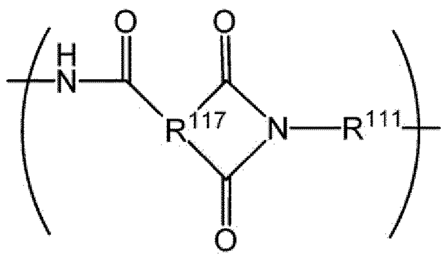

(PAI-3)

In Formula (PAI-3), $R^{111}$ and $R^{117}$ respectively have the same meanings as $R^{111}$ and $R^{117}$ in Formula (PAI-2), and the same applies to the preferred aspects thereof.

In a case where a polymerizable group is contained, the polymerizable group may be located at at least one of $R^{111}$ or $R^{117}$ or may be located at the terminal of the polyamideimide.

In addition, in order to improve the storage stability of the resin composition, the terminal of the main chain of the polyamideimide is preferably blocked with a terminal blocking agent such as a monoamine, an acid anhydride, a monocarboxylic acid, a monoacid chloride compound, or a monoactive ester compound. The preferred aspect of the terminal blocking agent is the same as the preferred aspect of the terminal blocking agent in the above-described polyimide.

- Imidization rate (ring closure rate) -

The imidization rate (also referred to as the "ring closure rate") of the polyamideimide is preferably 70% or more, more preferably 80% or more, and still more preferably 90% or more, from the viewpoint of the film hardness, the insulating properties, or the like of the organic film to be obtained.

The upper limit of the imidization rate is not particularly limited, and it may be any imidization rate of 100% or less.

The imidization rate is measured according to the same method as the above-described ring closure rate of the polyimide.

The polyamideimide may contain the repeating unit represented by Formula (PAI-3), in which $R^{111}$ or $R^{117}$ contained therein is one kind, or may contain the repeating unit represented by Formula (PAI-3), in which $R^{111}$ or $R^{117}$ contained therein is two or more kinds different from each other. In addition, the polyamideimide may also contain another kind of repeating unit in addition to the above repeating unit represented by Formula (PAI-3). Examples of the other kind of repeating unit include the repeating unit represented by Formula (PAI-1) or the repeating unit represented by Formula (PAI-2), which are described above.

The polyamideimide can be synthesized, for example, by using a method in which a polyamideimide precursor is obtained according to a publicly known method, and the obtained polyamideimide precursor is fully imidized by using a known imidization reaction method, or a method in which the imidization reaction is stopped in the middle of the reaction and the imide structure is partially introduced, or furthermore, a method in which a fully imidized polymer is blended with the polyamideimide precursor, whereby the imide structure is partially introduced.

The weight-average molecular weight(Mw) of the polyamideimide is preferably 5,000 to 70,000, more preferably 8,000 to 50,000, and still more preferably 10,000 to 30,000. In a case where the weight-average molecular weight is set to 5,000 or more, it is possible to improve the breakage resistance of the film after curing. In order to obtain an organic film having excellent mechanical characteristics, the weight-average molecular weight is particularly preferably 20,000 or more.

In addition, the number-average molecular weight (Mn) of the polyamideimide is preferably 800 to 250,000, more preferably 2,000 to 50,000, and still more preferably 4,000 to 25,000.

The dispersity of the molecular weight of the polyamideimide is preferably 1.5 or more, more preferably 1.8 or more, and still more preferably 2.0 or more. The upper limit value of the dispersity of the molecular weight of the polyamideimide is not particularly set; however, it is, for example, preferably 7.0 or less, more preferably 6.5 or less, and still more preferably 6.0 or less.

In addition, in a case where the resin composition contains a plurality of kinds of polyamideimides as the specific resin, it is preferable that the weight-average molecular weight, the number-average molecular weight, and the dispersity of at least one kind of polyamideimide are in the above ranges. Further, it is also preferable that the weight-average molecular weight, the number-average molecular weight, and the dispersity, calculated by using the plurality of kinds of polyamideimides as one resin, are within the above ranges.

[Production method for polyimide precursor and like]

The polyimide precursor the like can be obtained, for example, by a method of reacting a tetracarboxylic acid dianhydride with a diamine at a low temperature, a method of reacting a tetracarboxylic acid dianhydride with a diamine at a low temperature to obtain a polyamic acid and subjecting the polyamic acid to esterification by using a condensing agent or an alkylating agent, a method of obtaining a diester with a tetracarboxylic acid dianhydride and alcohol and then reacting the diester with a diamine in the presence of a condensing agent, and a method of obtaining a diester with a tetracarboxylic acid dianhydride and alcohol, subsequently subjecting the rest dicarboxylic acid to acid-halogenation using a halogenating agent, and carrying out reaction with a diamine. Among the above production methods, a method of obtaining a diester with a tetracarboxylic acid dianhydride and alcohol, subsequently subjecting the rest dicarboxylic acid to acid-halogenation using a halogenating agent, and carrying out a reaction with a diamine is more preferable.

Examples of the condensing agent include dicyclohexylcarbodiimide, diisopropylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate, and trifluoroacetic anhydride.

Examples of the alkylating agent include N,N-dimethylformamide dimethyl acetal, N,N-dimethylformamide diethyl acetal, N,N-dialkylformamide dialkyl acetal, trimethyl orthoformate, triethyl orthoformate.

Examples of the halogenating agent include thionyl chloride, oxalyl chloride, and phosphorus oxychloride.

In the production method for a polyimide precursor the like, it is preferable to use an organic solvent in a case of carrying out the reaction. One kind of organic solvent may be used, or two or more kinds thereof may be used.

The organic solvent can be appropriately determined depending on the raw material; however, examples thereof include pyridine, diethylene glycol dimethyl ether (diglyme), N-methylpyrrolidone, N-ethylpyrrolidone, ethyl propionate, dimethylacetamide, dimethylformamide, tetrahydrofuran, and $\gamma$-butyrolactone.

In the production method for a polyimide precursor the like, it is preferable to add a basic compound in a case of carrying out the reaction. One kind of basic compound may be used, or two or more kinds thereof may be used.

The basic compound can be appropriately determined depending on the raw material; however, examples thereof include triethylamine, diisopropylethylamine, pyridine, 1,8-diazabicyclo[5.4.0]undec-7-ene, and N,N-dimethyl-4-aminopyridine.

- Terminal blocking agent -

In the production method for a polyimide precursor the like, it is preferable to block the carboxylic acid anhydride, the acid anhydride derivative, or the amino group, remaining at the terminal of the resin such as the polyimide precursor, in order to further improve the storage stability. In a case of blocking the carboxylic acid anhydride and the acid anhydride derivative, remaining at the resin terminal, examples of the terminal blocking agent include a monoalcohol, phenol, thiol, thiophenol, and a monoamine. It is more preferable to use a monoalcohol, phenols, or a monoamine from the viewpoint of reactivity and film stability. Examples of the preferred monoalcohol compound include primary alcohol such as methanol, ethanol, propanol, butanol, hexanol, octanol, dodecanol, benzyl alcohol, 2-phenylethanol, 2-methoxyethanol, 2-chloromethanol, and furfuryl alcohol; secondary alcohol such as isopropanol, 2-butanol, cyclohexyl alcohol, cyclopentanol, and 1-methoxy-2-propanol; and tertiary alcohol such as t-butyl alcohol and adamantane alcohol. Examples of the preferred compounds of phenols include phenols such as phenol, methoxyphenol, methylphenol, naphthalene-1-ol, naphthalene-2-ol, and hydroxystyrene. In addition, examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid,3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

In addition, in a case of blocking the amino group at the terminal of the resin, it is possible to carry out blocking with a compound having a functional group capable of reacting with the amino group. The preferred blocking agent for the amino group is preferably a carboxylic acid anhydride, a carboxylic acid chloride, a carboxylic acid bromide, a sulfonic acid chloride, sulfonic acid anhydride, or a sulfonic acid carboxylic acid anhydride, and more preferably a carboxylic acid anhydride or a carboxylic acid chloride. Examples of the preferred carboxylic acid anhydride compound include acetic anhydride, propionic anhydride, oxalic anhydride, succinic anhydride, maleic acid anhydride, phthalic anhydride, and benzoic anhydride, 5-norbornen-2,3-dicarboxylic acid anhydride. Examples of the preferred carboxylic acid chloride compound include acetyl chloride, acrylic acid chloride, propionyl chloride, methacrylic acid chloride, pivaloyl chloride, cyclohexanecarbonyl chloride, 2-ethylhexanoyl chloride, cinnamoyl chloride, 1-adamantanecarbonyl chloride, heptafluorobutyryl chloride, stearic acid chloride, and benzoyl chloride.

In addition, in a case where a compound having a structure exhibiting a property of generating a base is used as the terminal blocking agent, it is also possible to introduce a structure exhibiting a property of generating a base at a terminal of the specific resin.

As such a terminal blocking agent, it is possible to use, for example, a compound having a structure exhibiting a property of generating a base, and a reactive group such as a hydroxy group, a thiol group, an amino group, a carboxy group, a carboxylic acid anhydride, a carboxylic acid halide group, a sulfonic acid anhydride group, a sulfonic acid halide group, or a sulfonic acid carboxylic acid anhydride group.

As the terminal blocking agent, it is possible to use, for example, a compound having a structure exhibiting a property of generating one or more bases and one or more of the reactive groups described above.

The preferred aspect of the structure exhibiting a property of generating a base is as described above.

In addition, as the terminal blocking agent, a compound represented by Formula (T-1) may be used. In a case where the terminal is blocked with such a compound, it is possible to introduce a structure in which a base is likely to be generated at the terminal, and it is considered that the breaking elongation is easily improved even in a case where curing is carried out at a low temperature.

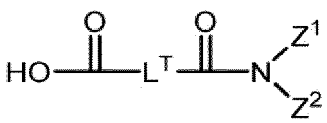

(T-1)

In Formula (T-1), $L^T$ represents a divalent organic group, and $Z^1$ and $Z^2$ each independently represent an organic group, where $Z^1$ and $Z^2$ may be bonded to each other to form a ring structure.

In Formula (T-1), $L^T$ is preferably a hydrocarbon group and may be any of an aromatic hydrocarbon group or an aliphatic hydrocarbon group; however, it is preferably any one of an aromatic hydrocarbon group, an unsaturated aliphatic hydrocarbon group, or a cyclic aliphatic hydrocarbon group.

The linking chain length in $L^T$ (that is, the minimum number of atoms among the numbers of atoms linking two

carbonyl groups that are bonded to $L^T$) is preferably 2 to 4 and more preferably 2.

In Formula (T-1), $Z^1$ and $Z^2$ have the same meanings as $Z^1$ and $Z^2$ in Formula (3-1), and the same applies to the preferred aspects thereof.

In particular, an aspect in which at least one of $Z^1$, $Z^2$, or $L^T$ has a polymerizable group is also one of the preferred aspects of the present invention.

Examples of the polymerizable group include a radically polymerizable group, an epoxy group, an oxetanyl group, a methylol group, and an alkoxymethyl group, where a radically polymerizable group is preferable.

The radically polymerizable group is preferably a group having an ethylenically unsaturated group, and examples thereof include a (meth)acryloxy group, a (meth)acrylamide group, a vinylphenyl group, a maleimide group, a styryl group, a vinyl group, and a (meth)allyl group.

Among these, a (meth)acryloxy group is preferable from the viewpoint of reactivity.

These polymerizable groups may be directly bonded to the nitrogen atom in Formula (T-1) or may be bonded through a linking group such as a hydrocarbon group (for example, an alkylene group).

- Solid precipitation -

In the production method for a polyimide precursor the like, a step of precipitating a solid may be included. Specifically, it is possible to obtain a polyimide precursor by filtering out a water-absorbing by-product of the dehydration condensing agent that is present together in the reaction solution as necessary, subsequently putting the obtained polymer component in a poor solvent such as water, an aliphatic lower alcohol, or a mixed solution thereof, precipitating the polymer component to be precipitated as a solid, and then carrying out drying. In order to improve the degree of purification, operations such as redissolution, reprecipitation, and drying of the polyimide precursor may be repeated. Further, a step of removing ionic impurities using an ion exchange resin may be included.

[Content]

The content of the specific resin in the resin composition according to the embodiment of the present invention is preferably 20% by mass or more, more preferably 30% by mass or more, still more preferably 40% by mass or more, and even still more preferably 50% by mass or more, with respect to the total solid content of the resin composition. In addition, the content of the resin in the resin composition according to the embodiment of the present invention is preferably 99.5% by mass or less, more preferably 99% by mass or less, still more preferably 98% by mass or less, even still more preferably 97% by mass or less, and even further still more preferably 95% by mass or less, with respect to the total solid content of the resin composition.

The resin composition according to the embodiment of the present invention may contain only one kind of specific resin or may contain two or more kinds thereof. In a case where two or more kinds thereof are contained, the total amount thereof is preferably within the above range.

In addition, it is also preferable that the resin composition according to the embodiment of the present invention contains at least two kinds of resins.

Specifically, the resin composition according to the embodiment of the present invention may contain in total two or more kinds of the specific resins and other resins described later or may contain two or more kinds of the specific resins; however, it is preferable to include two or more kinds of the specific resins.

In a case where the resin composition according to the embodiment of the present invention contains two or more kinds of the specific resins, it is preferable to contain, for example, two or more kinds of polyimide precursors which are polyimide precursors in which the structure ($R^{115}$ in Formula (2) described above) derived from the dianhydride is different.

<Another resin>

The resin composition according to the embodiment of the present invention may contain, in addition to the above-described specific resin or instead of the above-described specific resin, another resin (hereinafter, also simply referred to as "the other resin") that is different from the specific resin.

Examples of the other resin include a phenol resin, polyamide, an epoxy resin, polysiloxane, a resin containing a siloxane structure, a (meth)acrylic resin, a (meth)acrylamide resin, a urethane resin, a butyral resin, a styryl resin, a polyether resin, and a polyester resin.

For example, in a case where a (meth)acrylic resin is further added, it is possible to obtain a resin composition having excellent coatability, and it is possible to obtain a pattern (a cured substance) having excellent solvent resistance.

For example, in a case where a (meth)acrylic resin having a high polymerizable group value and having a weight-average molecular weight of 20,000 or less (for example, a molar content amount of a polymerizable group contained in 1 g of a resin is $1 \times 10^{-3}$ mol/g or more) is added to the resin composition instead of a polymerizable compound described later

or in addition to a polymerizable compound described later, it is possible to improve the coatability of the resin composition, the solvent resistance of the pattern (the cured substance).

In a case where the resin composition according to the embodiment of the present invention contains the other resin, the content of the other resin is preferably 0.01% by mass or more, more preferably 0.05% by mass or more, still more preferably 1% by mass or more, even still more preferably 2% by mass or more, even still more preferably 5% by mass or more, and even further still more preferably 10% by mass or more, with respect to the total solid content of the resin composition.

In addition, the content of the other resin in the resin composition according to the embodiment of the present invention is preferably 80% by mass or less, more preferably 75% by mass or less, still more preferably 70% by mass or less, even still more preferably 60% by mass or less, and even further still more preferably 50% by mass or less, with respect to the total solid content of the resin composition.

In addition, as the preferred aspect of the resin composition according to the aspect of the present invention, an aspect in which the content of the other resin is a low content can be adopted. In the above aspect, the content of the other resin is preferably 20% by mass or less, more preferably 15% by mass or less, still more preferably 10% by mass or less, even still more preferably 5% by mass or less, and even further still more preferably 1% by mass or less, with respect to the total solid content of the resin composition. The lower limit of the content is not particularly limited, and it may be any content of 0% by mass or more.

The resin composition according to the embodiment of the present invention may contain only one kind of the other resin or may contain two or more kinds thereof. In a case where two or more kinds thereof are contained, the total amount thereof is preferably within the above range.

<Specific metal complex>

The resin composition according to the embodiment of the present invention contains a specific metal complex.

The specific metal complex (first specific metal complex) contained in the resin composition according to the first aspect of the present invention has one or more π-conjugated moieties containing a nitrogen atom.

[Metal atom]

The kind of the metal atom contained in the specific metal complex is not particularly limited; however, it is preferably a Group IV metal atom, more preferably a titanium atom, a zirconium atom, or a hafnium atom, and from the viewpoint of storage stability, still more preferably a titanium atom. This is presumed to be because the titanium atom has a small atomic radius and thus the stability of the compound is improved.

The number of the metal atoms contained in the specific metal complex is not particularly limited; however, it is sufficient to be 1 or more, preferably 1 to 4, more preferably 1 or 2, and particularly preferably 1.

In addition, in a case where the specific metal complex contains two or more metal atoms, the kinds of the metal atoms may be the same or different from each other. For example, in a case where the specific metal complex contains two metal atoms, the specific metal complex may contain two titanium atoms or may contain a titanium atom and a zirconium atom.

[π-Conjugated moiety containing nitrogen atom]

The first specific metal complex has a π-conjugated moiety containing a nitrogen atom.

Here, it is preferable that the nitrogen atom is directly bonded to a metal atom in the first specific metal complex. The above-described bonding is not particularly limited; however, it is preferably a coordinate bond.

In addition, the π-conjugated moiety may have only one nitrogen atom or may have two or more nitrogen atoms. In a case where two or more nitrogen atoms are contained, it is preferable that one of them is directly bonded to a metal atom in the first specific metal complex.

Here, the first specific metal complex may have only one π-conjugated moiety containing the nitrogen atom or may have two or more thereof; however, it preferably has two or more thereof.

The π-conjugated moiety containing a nitrogen atom is preferably a structure represented by Formula (1-1).

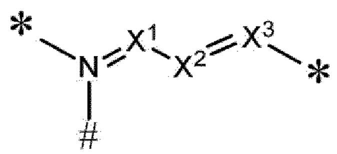

(1-1)

In Formula (1-1), $X^1$ to $X^3$ each independently represent -C(-*)= or -N=, *'s each represents a bonding site to another structure, and # represents a bonding site to a metal atom.

In Formula (1-1), $X^1$ to $X^3$ each independently represent -C(-*)= or -N=. It is preferable that at least one thereof represents -C(-*)=, and it is more preferable that at least two thereof represent -C(-*)=.

In Formula (1-1), a structure to be bonded to at least two *'s may be bonded to form a ring structure. The ring structure may be an aliphatic ring structure or may be an aromatic ring structure; however, it is preferably an aromatic ring structure.

Examples of the aspect of forming such a ring structure include an aspect represented by Formula (1-2) or Formula (1-3).

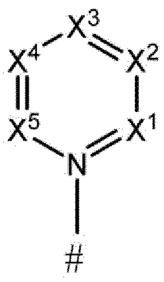

(1-2)

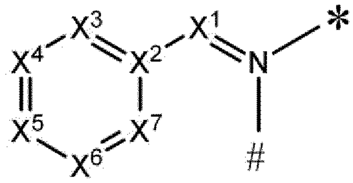

(1-3)

in Formula (1-2), $X^1$ to $X^5$ each independently represent -C(-*)= or -N=, and # represents a bonding site to a metal atom.

In Formula (1-2), it is preferable that at least one of $X^1$ to $X^5$ is -C(-*)=, it is more preferable that at least three thereof are -C(-*)=, and it is still more preferable that at least four thereof are -C(-*)=. In addition, an aspect in which all of them are -C(-*)= is also one of the preferred aspects of the present invention.

In Formula (1-3), $X^1$ to $X^7$ each independently represent -C(-*)= or -N=, and # represents a bonding site to a metal atom.

In Formula (1-3), it is preferable that at least one of $X^1$ to $X^7$ is -C(-*)=, it is more preferable that at least five thereof are -C(-*)=, and it is still more preferable that at least six thereof are -C(-*)=. In addition, an aspect in which all of them are -C(-*)= is also one of the preferred aspects of the present invention.

In addition, it is preferable that a structure including a partial structure represented by Formula (1-1) is bonded to the metal atom even at a portion different from # described above and a bonding site of the bonding in the partial structure is $*^1$-O-$*^2$, $*^1$-S-$*^2$, or $*^1$-C(=O)O-$*^2$. $*^1$ is a bonding site to another structure, and $*^2$ is a bonding site to a metal atom.

In addition, it is preferable that the structure including the partial structure represented by Formula (1-1) has one or two bonding positions to a metal atom at a portion different from # described above.

In such an aspect, the structure including the partial structure represented by Formula (1-1) preferably also includes, for example, a structure represented by Formula (1-4), Formula (1-5), or Formula (1-6).

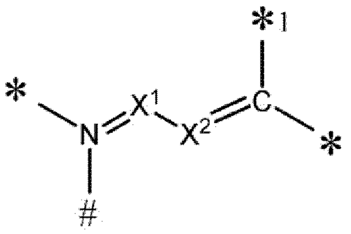

(1-4)

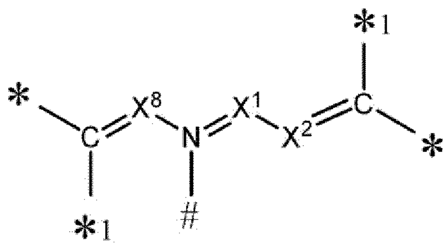

(1-5)

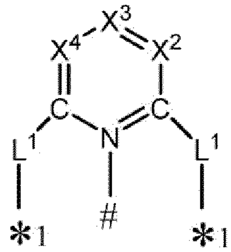

(1-6)

In Formula (1-4), $X^1$ and $X^2$ each independently represent -C(-*)= or -N=, *'s each represents a bonding site to another structure, # represents a bonding site to a metal atom, $*^1$ represents a bonding site to an oxygen atom, a sulfur atom, or a carbon atom in -C(=O)O-, and the oxygen atom, the sulfur atom, or the -C(=O)O- is directly bonded to a metal atom in the first specific metal complex.

In Formula (1-4), a structure to be bonded to at least two *'s may be bonded to form a ring structure. The ring structure to be formed may be an aliphatic ring structure or may be an aromatic ring structure; however, it is preferably an aromatic ring structure and more preferably a benzene ring structure. In addition, the ring structure to be formed is

preferably a 6-membered ring structure.

Examples of such an aspect include an aspect in which $X^2$ in Formula (1-4) is -C(-*)=, and a structure in which * in $X^2$ is bonded to * bonded to the carbon atom to which *1 in Formula (1-4) has been bonded forms a ring structure. Specifically, the aspect is an aspect represented by Formula (1-4-2).

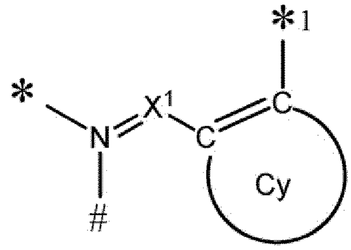

(1-4-2)

In Formula (1-4-2), $X^1$, #, *, and *1 respectively have the same meanings as $X^1$, #, *, and *1 in Formula (1-4), and the same applies to the preferred aspects thereof.

In Formula (1-4-2), Cy represents a ring structure, and it is preferably an aromatic ring structure and more preferably a benzene ring structure. In addition, Cy preferably has a 6-membered ring structure.

In Formula (1-5), $X^1$, $X^2$, and $X^8$ each independently represent -C(-*)= or -N=, *'s each represents a bonding site to another structure, # represents a bonding site to a metal atom, *1 represents a bonding site to an oxygen atom, a sulfur atom, or a carbon atom in -C(=O)O-, and the oxygen atom, the sulfur atom, or the -C(=O)O- is directly bonded to a metal atom in the first specific metal complex.

In Formula (1-5), a structure to be bonded to at least two *'s may be bonded to form a ring structure. The ring structure to be formed may be an aliphatic ring structure or may be an aromatic ring structure; however, it is preferably an aromatic ring structure and preferably a benzene ring structure. In addition, the ring structure to be formed is preferably a 6-membered ring structure.

Examples of such an aspect include an aspect in which $X^2$ in Formula (1-5) is -C(-*)=, and a structure in which * in $X^2$ is bonded to * on a side close to $X^2$ in Formula (1-5) forms a ring structure. Specifically, the aspect is an aspect represented by Formula (1-5-2).

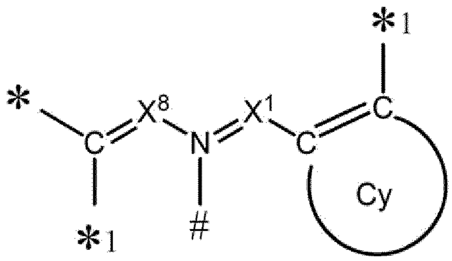

(1-5-2)

In Formula (1-5-2), $X^1$, $X^8$, #, *, and *1 respectively have the same meanings as $X^1$, $X^8$, #, *, and *1 in Formula (1-5), and the same applies to the preferred aspects thereof.

In Formula (1-5-2), Cy represents a ring structure, and it is preferably an aromatic ring structure and more preferably a benzene ring structure. In addition, Cy preferably has a 6-membered ring structure.

In addition, an aspect $X^8$ in which in (1-5-2) is -C(-*)=, and a structure in which * in $X^8$ is bonded to * in Formula (1-5-2) forms a ring structure is exemplified.

Similarly, $X^8$ in Formula (1-5) may be -C(-*)=, and a structure in which * in $X^8$ is bonded to * in Formula (1-5) may form a ring structure.

In Formula (1-6), $X^2$, $X^3$, and $X^4$ each independently represent -C(-*)= or -N=, $L^1$ represents a single bond or a divalent linking group, *'s each represents a bonding site to another structure, # represents a bonding site to a metal atom, *1 represents a bonding site to an oxygen atom, a sulfur atom, or a carbon atom in -C(=O)O-, and the oxygen atom, the sulfur atom, or the -C(=O)O- is directly bonded to a metal atom in the first specific metal complex.

In a case where *1 is bonded to an oxygen atom or a sulfur atom, $L^1$ is preferably a methylene group, and in a case where *1 is bonded to a carbon atom in -C(=O)O-, $L^1$ is preferably a single bond.

In Formula (1-6), a structure to be bonded to at least two *'s may be bonded to form a ring structure. The ring structure to be formed may be an aliphatic ring structure or may be an aromatic ring structure; however, it is preferably an aromatic ring structure and preferably a benzene ring structure. In addition, the ring structure to be formed is preferably a 6-membered ring structure.

Preferred specific examples of the structure including the partial structure represented by Formula (1-1) are the same as the preferred aspects of $R^2$ and $R^3$ in Formula (2-1) described later.

The first specific metal complex is preferably a compound having, on the same ligand, the $\pi$-conjugated moiety containing the nitrogen atom and at least one group selected from the group consisting of a hydroxy group, a mercapto group, and a carboxy group.

Here, it is preferable that the hydroxy group, the mercapto group, and the carboxy group are bonded to a metal atom as -O-, -S-, and -C(=O)-, respectively.

The first specific metal complex preferably includes a partial structure represented by Formula (3-1) as a structure including the $\pi$-conjugated moiety containing the nitrogen atom.

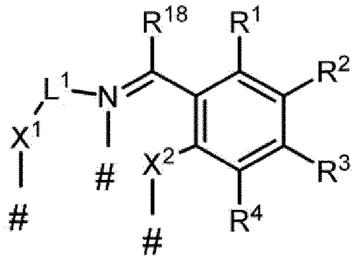

(3-1)

In Formula (3-1), $R^1$ to $R^4$ and $R^{18}$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, $R^{103}$ to $R^{109}$ each independently represent an alkyl group or an aryl group, $L^1$ represents a group represented by Formula (L-1) or Formula (L-2), $X^1$ and $X^2$ each independently represent -O- or -S-, and # represents a bonding site to a metal atom.

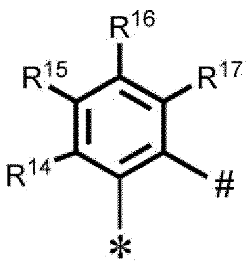

(L-1)

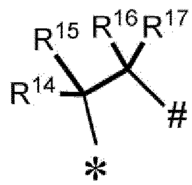

(L-2)

In Formula (L-1) and Formula (L-2), $R^{14}$ to $R^{17}$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, $R^{103}$ to $R^{109}$ each independently represent an alkyl group or an aryl group, * represents a bonding site to $X^1$ in Formula (3-1), and # represents a bonding site to a nitrogen atom in Formula (3-1).

In Formula (3-1), in a case where any one of $R^1$ to $R^4$ and $R^{18}$ represents an alkyl group, an alkyl group having 1 to 10 carbon atoms is preferable, an alkyl group having 1 to 4 carbon atoms is more preferable, and a methyl group is still more preferable.

In Formula (3-1), in a case where any one of $R^1$ to $R^4$ and $R^{18}$ represents an alkoxy group, an alkyl group having 1 to 10 carbon atoms is preferable, an alkyl group having 1 to 4 carbon atoms is more preferable, and an ethoxy group is still more preferable.

In Formula (3-1), in a case where any one of $R^1$ to $R^4$ and $R^{18}$ is an aryloxy group, the aryl group in the aryloxy

group is preferably an aromatic hydrocarbon group, and more preferably a phenyl group. In addition, in a case where the aryl group is an aromatic heterocyclic group, the heteroatom in the heterocyclic ring is preferably a nitrogen atom, an oxygen atom, or a sulfur atom.

In Formula (3-1), in a case where any one of $R^1$ to $R^4$ and $R^{18}$ is an acyl group, -COR or -$SO_2$R is preferable, and -COR is more preferable. R represents a monovalent organic group. R is preferably an alkyl group or an aryl group, and preferred aspects thereof are respectively the same as the preferred aspects of the alkyl group and the aryl group as $R^{101}$ to $R^{109}$ described later.

In Formula (3-1), in a case where any one of $R^1$ to $R^4$ or $R^{18}$ represents an acyloxy group, -OCOR or -$OSO_2$R is preferable, and -OCOR is more preferable. R represents a monovalent organic group. The preferred aspect of R is as described above.

In Formula (3-1), in a case where any one of $R^1$ to $R^4$ and $R^{18}$ represents an ester group, -COOR, -OCOR, -$SO_2$OR, or -$OSO_2$R is preferable, and -COOR is more preferable. R represents a monovalent organic group. The preferred aspect of R is as described above.

In Formula (3-1), in a case where any one of $R^1$ to $R^4$ and $R^{18}$ is a halogen atom, a fluorine atom, a chlorine atom, a bromine atom, or an iodine atom is preferable, and a fluorine atom or a chlorine atom is preferable.

The number of carbon atoms of the alkyl group represented by $R^{101}$ to $R^{109}$ is preferably 1 to 10, more preferably 1 to 5, still more preferably 1 to 3, and particularly preferably 1 or 2. The alkyl group may be linear, branched, or cyclic; however, it is preferably linear or branched and more preferably linear. The alkyl group may have a substituent as long as the effect of the present invention can be obtained. The alkyl group represented by $R^{101}$ to $R^{109}$ is preferably a methyl group or an ethyl group.

The number of carbon atoms in the aryl group represented by $R^{101}$ to $R^{109}$ is preferably 6 to 30, more preferably 6 to 20, and still more preferably 6 to 12. The aryl group may have a substituent as long as the effect of the present invention can be obtained.

$R^{101}$ and $R^{102}$ may be bonded to each other to form a ring. Examples of the ring formed by the bonding of $R^{101}$ and $R^{102}$ include a pyrrolidine ring, a piperidine ring, a piperazine ring, and a morpholine ring.

$R^{101}$ and $R^{102}$ are each independently preferably a hydrogen atom or an alkyl group, and more preferably a hydrogen atom, a methyl group, or an ethyl group. $R^{103}$ to $R^{114}$ are each independently preferably an alkyl group and more preferably a methyl group or an ethyl group.

In Formula (3-1), from the viewpoint of the solubility of the specific metal complex in a solvent and the acceleration of cyclization of the precursor of the cyclization resin in a case where the specific metal complex is decomposed, it is preferable that $L^1$ represents a group represented by Formula (L-2).

In addition, in Formula (3-1), from the viewpoint of the stability of the specific metal complex itself, it is preferable that $L^1$ represents a group represented by Formula (L-1).

In Formula (L-1) and Formula (L-2), preferred aspects of the alkyl group, the alkoxy group, the aryloxy group, the acyl group, the acyloxy group, the ester group, and the halogen atom, as $R^{14}$ to $R^{17}$, and $R^{101}$ to $R^{109}$ are the same as the preferred aspects of those groups as $R^1$ to $R^4$ and $R^{18}$ in Formula (3-1).

At least two of $R^1$ to $R^4$ and $R^{18}$ in Formula (3-1) and $R^{14}$ to $R^{17}$ in Formula (L-1) or Formula (L-2) may be bonded to each other to form a ring structure. In particular, two adjacent to each other, among $R^1$ to $R^4$ and $R^{18}$ in Formula (3-1) and $R^{14}$ to $R^{17}$ in Formula (L-1) or Formula (L-2), may be bonded to each other to form a ring structure.

In Formula (3-1), $X^1$ and $X^2$ each independently represent -O- or -S-, and -O- is preferable.

From the viewpoint of achieving both the solubility of the specific metal complex and the storage stability, an aspect in which $L^1$ is a group represented by Formula (L-2), $R^{18}$ is a hydrogen atom, at least one of $R^1$, $R^2$, $R^3$, $R^4$, $R^{14}$, $R^{15}$, $R^{16}$, or $R^{17}$ represents a methyl group, an alkoxy group, an aryloxy group, a phenyl group, an acyloxy group, an acyl group, an ester group, a halogen atom, a nitro group, a cyano group, -$NR^{101}R^{102}$, -$SR^{103}$, -$SO_2NR^{104}R^{105}$, -$CONR^{106}R^{107}$, or -$NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, and $R^{103}$ to $R^{109}$ each independently represent an alkyl group or an aryl group is also one of the preferred aspects of the present invention.

In a case where $L^1$ in Formula (3-1) is a group represented by Formula (L-1), from the viewpoint of improving the solubility of the specific metal complex in the composition, it is preferable that at least one of $R^1$ to $R^4$ and $R^{18}$ in Formula (3-1) or $R^{14}$ to $R^{17}$ in Formula (L-1) is a substituent other than a hydrogen atom. The substituent is preferably an alkyl group, an aryl group, -$NR^{101}R^{102}$, an alkoxy group, an aryloxy group, -$SR^{103}$, -COOR, -OCOR, -$SO_2$R, - $SO_2NR^{104}R^{105}$, -$SO_2$OR, -$CONR^{106}R^{107}$, or -$NR^{108}COR^{109}$, and more preferably an alkyl group, an aryl group, -$NR^{101}R^{102}$, an alkoxy group, an aryloxy group, -$SR^{103}$, -COOR, or -OCOR. However, $R^{101}$ and $R^{102}$ each independently represent a hydrogen atom, an alkyl group, or an aryl group, $R^{101}$ and $R^{102}$ may be bonded to each other to form a ring, $R^{103}$ to $R^{109}$ each independently represent an alkyl group or an aryl group, and two adjacent to each other, among $R^1$ to $R^4$ in Formula (3-1) and $R^{14}$ to $R^{17}$ in Formula (L-1), may be bonded to each other to form a ring.

In a case where $L^1$ in Formula (3-1) is a group represented by Formula (L-2), it is preferable that at least one of $R^1$ to $R^4$ and $R^{18}$ in Formula (3-1) or $R^{14}$ to $R^{17}$ in Formula (L-2) is a substituent other than a hydrogen atom from the viewpoint

of improving the storage stability of the metal complex.

The improvement of the storage stability of the metal complex is divided into two, that is, the suppression of the liberation of the ligand and the suppression of the hydrolysis of the ligand, and each of them can be independently suppressed by the introduction of a substituent.

For the suppression of the liberation of the ligand, a three-dimensionally bulky substituent is effective, and it is preferable that at least one or more of $R^1$ and $R^4$ in Formula (3-1) and $R^{14}$ to $R^{17}$ in Formula (L-2) are a substituent other than a hydrogen atom. The substituent is preferably an alkyl group, an aryl group, $-NR^{101}R^{102}$, an alkoxy group, an aryloxy group, $-SR^{103}$, -COOR, -OCOR, $-SO_2R$, $-SO_2NR^{104}R^{105}$, $-SO_2OR$, $-CONR^{106}R^{107}$, or - $NR^{108}COR^{109}$, and more preferably an alkyl group, an aryl group, $-NR^{101}R^{102}$, an alkoxy group, an aryloxy group, $-SR^{103}$, -COOR, or -OCOR. Preferred aspects of these groups are as described above.

For the suppression of the hydrolysis of the ligand, a three-dimensionally bulky substituent or an electron withdrawing group is effective.

From the viewpoint of the three-dimensionally bulky substituent, it is preferable that at least one or more of $R^1$ and $R^4$ in Formula (3-1) and $R^{14}$ to $R^{17}$ in Formula (L-2) are a substituent other than a hydrogen atom. The substituent is preferably an alkyl group, an aryl group, - $NR^{101}R^{102}$, an alkoxy group, an aryloxy group, $-SR^{103}$, -COOR, -OCOR, $-SO_2R$, $-SO_2NR^{104}R^{105}$, $-SO_2OR$, $-CONR^{106}R^{107}$, or $-NR^{108}COR^{109}$, and more preferably an alkyl group, an aryl group, $-NR^{101}R^{102}$, an alkoxy group, an aryloxy group, $-SR^{103}$, -COOR, or -OCOR. Preferred aspects of these groups are as described above.

From the viewpoint of the electron withdrawing group, it is preferable that at least one or more of $R^1$ to $R^4$ and $R^{18}$ in Formula (3-1) represent an electron withdrawing group. The electron withdrawing group is still more preferably a halogen, a nitro group, an aryl group, or an ester group.

The first specific metal complex preferably includes a partial structure represented by Formula (4-1) as a structure including the π-conjugated moiety containing the nitrogen atom.

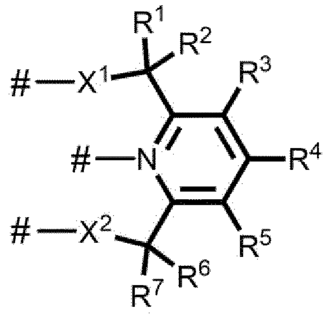

(4-1)

In Formula (4-1), $R^1$ to $R^7$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, - $CONR^{106}R^{107}$, or $-NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, $R^{103}$ to $R^{109}$ each independently represent an alkyl group or an aryl group, $X^1$ and $X^2$ each independently represent -O- or -S-, and # represents a bonding site to a metal atom.

In Formula (4-1), preferred aspects of the alkyl group, the alkoxy group, the aryloxy group, the acyl group, the acyloxy group, the ester group, and the halogen atom, as $R^1$ to $R^7$, and $R^{101}$ to $R^{109}$ are the same as the preferred aspects of those groups as $R^1$ to $R^4$ and $R^{18}$ in Formula (3-1).

In Formula (4-1), from the viewpoint of improving the storage stability of the first specific metal complex, it is preferable that at least one of $R^1$, $R^2$, $R^6$, or $R^7$ represents a substituent other than a hydrogen atom. The substituent is preferably an alkyl group, an aryl group, $-NR^{101}R^{102}$, an alkoxy group, an aryloxy group, $-SR^{103}$, -COOR, -OCOR, $-SO_2R$, - $SO_2NR^{104}R^{105}$, $-SO_2OR$, $-CONR^{106}R^{107}$, or $-NR^{108}COR^{109+}$, and more preferably an alkyl group or an aryl group. Preferred aspects of these groups are as described above.

In addition, from the viewpoint of improving the solubility of the first specific metal complex, it is preferable that at least one of $R^1$, $R^2$, $R^6$, or $R^7$ represents a substituent other than a hydrogen atom.

The first specific metal complex may further have another structure that is different from the π-conjugated moiety containing a nitrogen atom.

The other structure is not particularly limited, and a structure consisting of a publicly known ligand can be used. Examples of the ligand include a monodentate alkoxy ligand, a monodentate aryloxy ligand, a polydentate aryloxy ligand, and a cyclopentadienyl ligand, and these ligands may further have a substituent. From the viewpoint of the stability of the

first specific metal complex, a substituted or unsubstituted cyclopentadienyl ligand is preferable.

The second specific metal complex is a compound represented by Formula (2-1).

The first specific metal complex is preferably a compound represented by Formula (2-1).

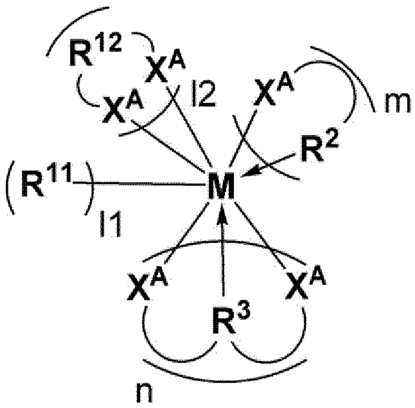

(2-1)

In Formula (2-1), M is titanium, zirconium, or hafnium, 11 is an integer of 0 to 2, 12 is 0 or 1, l1 + l2 × 2 is an integer of 0 to 2, m is an integer of 0 to 4, n is an integer of 0 to 2, 11 + l2 + m + n × 2 = 4 is satisfied, $R^{11}$'s are each independently a substituted or unsubstituted cyclopentadienyl group, a substituted or unsubstituted alkoxy group, or a substituted or unsubstituted phenoxy group, $R^{12}$ is a substituted or unsubstituted hydrocarbon group, $R^2$'s are each independently a group including a structure represented by Formula (2-2), $R^3$'s are each independently a group including a structure represented by Formula (2-2), and $X^A$'s are each independently an oxygen atom or a sulfur atom,

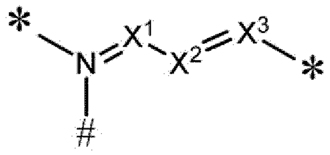

(2-2)

In Formula (2-2), $X^1$ to $X^3$ each independently represent -C(-*)= or -N=, *'s each represent a bonding site to another structure, and # represents a bonding site to a metal atom.

In Formula (2-1), it is preferable that M represents titanium from the viewpoint of the storage stability of the composition.

An aspect in which l1 and l2 in Formula (2-1) are 0 is also one of the preferred aspects of the present invention.

In Formula (2-1), m is preferably 2 or 4, and more preferably 2.

In Formula (2-1), n is preferably 1 or 2, and more preferably 1.

Here, in Formula (2-1), it is also preferable that l1 and l2 are 0 and m is 0, 2, or 4.

In Formula (2-1), $R^{11}$ is preferably a substituted or unsubstituted cyclopentadienyl ligand from the viewpoint of the stability of the specific metal complex.

In addition, the cyclopentadienyl group, the alkoxy group, and the phenoxy group as $R^{11}$ may be substituted; however, an aspect in which these are unsubstituted is also one of the preferred aspects of the present invention.

In Formula (2-1), $R^{12}$ is preferably a hydrocarbon group having 1 to 20 carbon atoms and more preferably a hydrocarbon group having 2 to 10 carbon atoms.

The hydrocarbon group as $R^{12}$ may be any of an aliphatic hydrocarbon group or an aromatic hydrocarbon group; however, it is preferably an aromatic hydrocarbon group.

The aliphatic hydrocarbon group may be a saturated aliphatic hydrocarbon group or an unsaturated aliphatic hydrocarbon group; however, it is preferably a saturated aliphatic hydrocarbon group.

The aromatic hydrocarbon group is preferably an aromatic hydrocarbon group having 6 to 20 carbon atoms, more preferably an aromatic hydrocarbon group having 6 to 10 carbon atoms, and still more preferably a phenylene group.

The substituent as $R^{12}$ is preferably a monovalent substituent, and examples thereof include a halogen atom. In addition, in a case where $R^{12}$ is an aromatic hydrocarbon group, it may have an alkyl group as a substituent.

Among these, in Formula (2-1), $R^{12}$ is preferably an unsubstituted phenylene group. In addition, the phenylene group as $R^{12}$ is preferably a 1,2-phenylene group.

In Formula (2-1), a preferred aspect of the structure represented by Formula (2-2) which is included in $R^2$ and $R^3$ is the same as the preferred aspect of Formula (1-1) described above.

It is also preferable that the structure formed by $R^3$ and $X^A$ in the compound represented by Formula (2-1) is

represented by Formula (3-1) described above. In this case, $X^1$ and $X^2$ in Formula (3-1) each correspond to $X^A$ in Formula (2-1), and the structure other than $X^1$ and $X^2$ in Formula (3-1) corresponds to $R^3$ in Formula (2-1).

It is also preferable that the structure formed by $R^3$ and $X^A$ in the compound represented by Formula (2-1) is represented by Formula (4-1) described above. In this case, $X^1$ and $X^2$ in Formula (3-1) each correspond to $X^A$ in Formula (2-1), and the structure other than $X^1$ and $X^2$ in Formula (4-1) corresponds to $R^3$ in Formula (2-1).

In Formula (2-1), in a case where m is 2 or more and two or more $R^2$'s contained, the structures of the two or more $R^2$'s may be the same or different from each other.

In Formula (2-1), in a case where n is 2 or more and two or more $R^3$'s contained, the structures of the two or more $R^3$'s may be the same or different from each other.

Specific examples of $R^2$ in Formula (2-1) will be described below; however, the specific examples thereof are not limited thereto.

In the following structures, * represents a bonding site to $X^A$ in Formula (2-1), and # represents a bonding site to M in Formula (2-1).

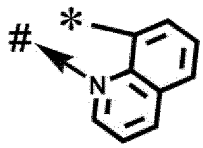
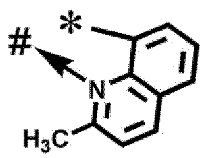

Specific examples of $R^3$ in Formula (2-1) will be described below; however, the specific examples thereof are not limited thereto.

In the following structures, *'s each represent a bonding site to $X^A$ in Formula (2-1), and # represents a bonding site to M in Formula (2-1). It is noted that in the present specification, Me represents a methyl group, Et represents an ethyl group, and n-Bu represents an n-butyl group.

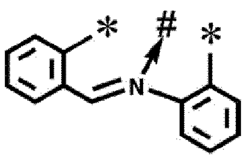
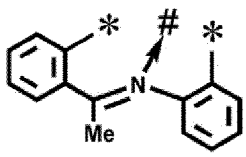
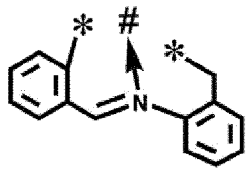
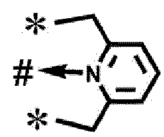

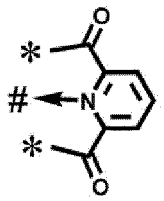
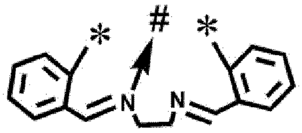
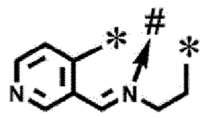
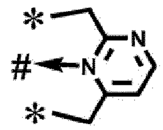

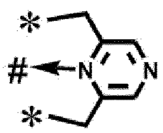
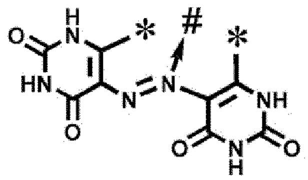
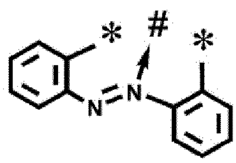
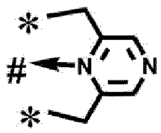

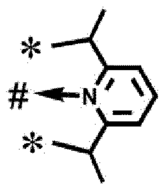
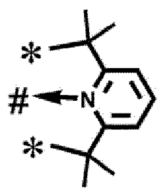
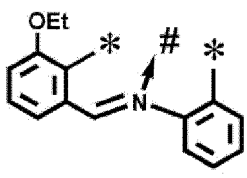
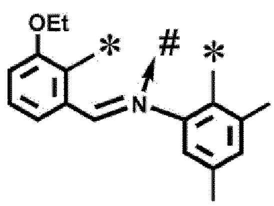

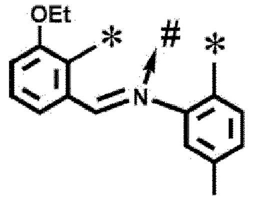
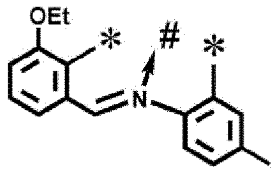
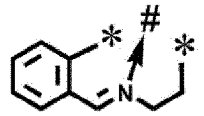
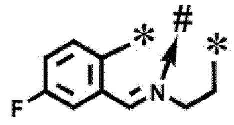

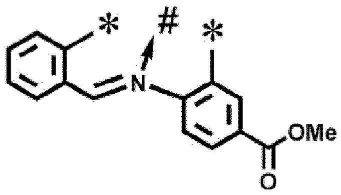
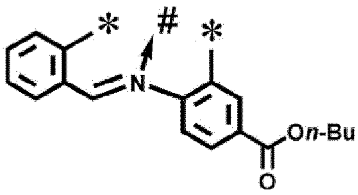

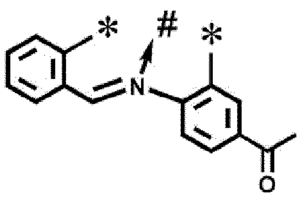
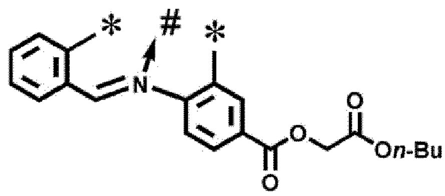

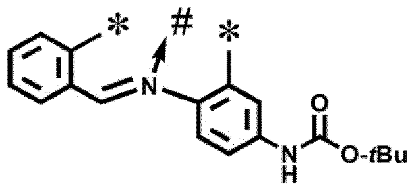
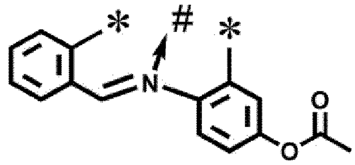

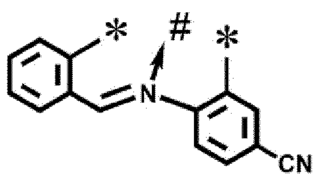
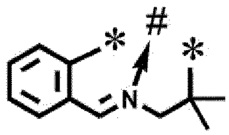

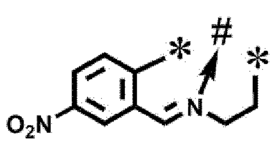
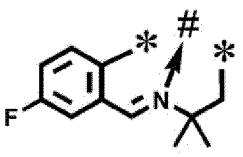
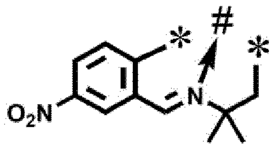
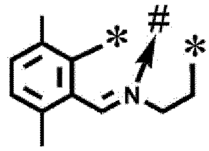

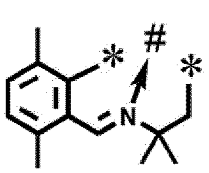
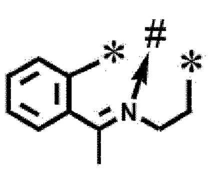
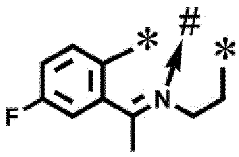
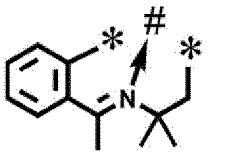

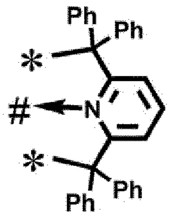 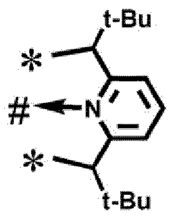 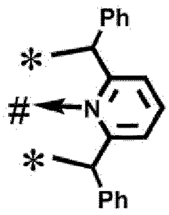 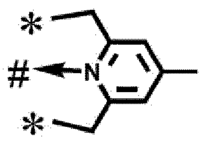

In addition, it is also preferable that the compound represented by Formula (2-1) is a compound represented by Formula (5-1).

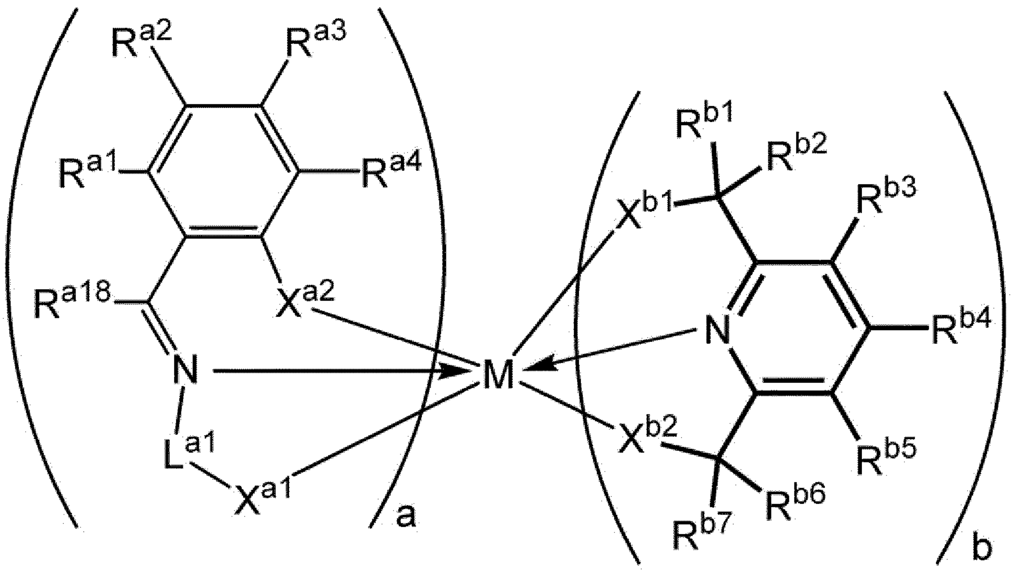

(5-1)

In Formula (2-1), M is titanium, zirconium, or hafnium, $R^{a1}$ to $R^{a4}$ and $R^{a18}$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, $R^{103}$ to $R^{109}$ each independently represent an alkyl group or an aryl group, $L^{a1}$ represents a group represented by Formula (L-1) or Formula (L-2) described later, $X^{a1}$ and $X^{a2}$ each independently represent -O- or -S-, $R^{b1}$ to $R^{b7}$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$, $R^{101}$ and $R^{102}$ each independently represent a hydrogen atom, an alkyl group, or an aryl group, $R^{101}$ and $R^{102}$ may be bonded to each other to form a ring, $R^{103}$ to $R^{109}$ each independently represent an alkyl group or an aryl group, $X^{b1}$ and $X^{b2}$ each independently represent -O- or -S-, a represents an integer of 0 to 2, b represents an integer of 0 to 2, and the total of a and b is 2.

In Formula (5-1), it is preferable that M represents titanium from the viewpoint of the storage stability of the composition.

From the viewpoint of the storage stability of the composition, in Formula (5-1), $R^{a1}$ to $R^{a4}$, $R^{a18}$, $L^{1a}$, $X^{1a}$, and $X^{2a}$ each have the same meanings as $R^1$ to $R^4$, $R^{18}$, $L^1$, $X^1$, and $X^2$ in Formula (3-1), and the same applies to the preferred aspects thereof.

From the viewpoint of the storage stability of the composition, in Formula (5-1), $R^{b1}$ to $R^{b7}$, $X^{1b}$, and $X^{2b}$ respectively have the same meanings as $R^1$ to $R^7$, $X^1$, and $X^2$ in Formula (4-1), and the same applies to the preferred aspects thereof.

In Formula (5-1), in a case where a is set to 1 or 2, it is possible to accelerate the solubility of the specific metal complex in a solvent and the cyclization of the precursor of the cyclization resin in a case where the specific metal complex is decomposed.

In Formula (5-1), in a case where b is set to 1 or 2, it is possible to improve the solubility of the specific metal complex.

In Formula (5-1), in a case where a is 2, $R^{a1}$ to $R^{a4}$, $R^{a18}$, $L^{1a}$, $X^{1a}$, and $X^{2a}$ in two ligands may be respectively the

same or different from each other.

In Formula (5-1), in a case where b is 2, $R^{b1}$ to $R^{b7}$, $X^{1b}$, and $X^{2b}$ in two ligands may be respectively the same or different from each other.

In addition, from the viewpoint of the stability of the specific metal complex, an aspect in which the specific metal complex does not have a monodentate ligand other than cyclopentadienyl is also one of the preferred aspects of the present invention.

The specific metal complex preferably generates an amine by heating at 250°C. The above-described temperature is preferably 230°C, more preferably 200°C, and still more preferably 180°C.

In the present invention, in a case where a solution in which the specific metal complex is dissolved in the same solvent as that of the resin composition according to the embodiment of the present invention at the same concentration as the concentration of the resin composition according to the embodiment of the present invention is prepared and heated at X°C, the specific metal complex is defined as generating an amine at X°C in a case where the amine is generated such that an amount thereof is 10% by mole or more with respect to the total molar amount of the specific metal complex.

In addition, from the viewpoint of the breaking elongation of the cured substance to be obtained, the pKa of the conjugate acid of the amine is preferably 3 or more and more preferably 6 or more. The upper limit of the pKa of the conjugate acid is not particularly limited; however, it is preferably 30 g or less.

Further, from the viewpoint of storage stability, the pKa of the conjugate acid of the specific metal complex itself is preferably less than 3, more preferably -5 or less, and still more preferably -10 or less.

The "pKa" is represented by the negative common logarithm pKa of the equilibrium constant Ka of a dissociation reaction, in a case of assuming that hydrogen ions are released from the acid in the dissociation reaction. In the present specification, unless otherwise specified, pKa is a value calculated by ACD/ChemSketch (registered trade name).

In a case where the conjugate acid has a plurality of pKa values, at least one of them is preferably within the above range.

Regarding the solubility parameter of the specific metal complex, the solubility parameter (SP) value is preferably 9 or more, and more preferably 10 or more. The upper limit of the SP value is not particularly limited and may be, for example, 30 or less.

It is noted that unless otherwise specified, the SP value in the present specification is determined according to the Hoy method (H. L. Hoy, Journal of Painting, 1970, Vol. 42, 76-118). In addition, the SP value is shown with the unit being omitted; however, the unit thereof is $cal^{1/2}$ $cm^{3/2}$.

[Molecular weight]

The molecular weight of the specific metal complex is preferably 200 to 2,000, more preferably 250 to 1,500, and still more preferably 300 to 1,000.

[Synthesis method]

The specific metal complex can be synthesized, for example, by reacting a titanium alkoxide with a compound having an alkoxy group or a carboxyl group. In addition, the compound may be synthesized by using a publicly known synthesis method, and the synthesis method is not particularly limited.

Specific examples of the specific metal complex are not particularly limited; however, examples thereof include A-1 to A-73 used in Examples.

The content of the specific metal complex with respect to the total solid content of the resin composition according to the embodiment of the present invention is preferably 0.05% to 20% by mass. The lower limit thereof is preferably 0.10% by mass or more, more preferably 0.2% by mass or more, particularly preferably 0.5% by mass or more, and most preferably 1% by mass or more. The upper limit thereof is more preferably 15% by mass or less, still more preferably 10% by mass or less, and particularly preferably 8% by mass or less.

The content of the specific metal complex is preferably 0.05% to 20% by mass with respect to 100 parts by mass of the specific resin. The lower limit thereof is preferably 0.10% by mass or more, more preferably 0.2% by mass or more, particularly preferably 0.5% by mass or more, and most preferably 1% by mass or more. The upper limit thereof is more preferably 15% by mass or less, still more preferably 10% by mass or less, and particularly preferably 8% by mass or less.

The specific metal complex may be used alone; however, two or more kinds thereof may be used in combination. In a case where two or more kinds thereof are used in combination, the total amount thereof is preferably in the above range.

In addition, the total amount of the colored specific metal complex and the colored organic metal complex described later with respect to the total solid content of the composition according to the embodiment of the present invention may be determined according to the use application; however, it is preferably more than 0% by mass and 30% by mass or less. The upper limit of the content of the polymerization initiator is more preferably 15% by mass or less and still

more preferably 10% by mass or less. In the present invention, the term "colored" refers to that the molar absorption coefficient at a wavelength of 400 to 800 nm is 10,000 $L \cdot mol^{-1} \cdot cm^{-1}$ or more. The molar absorption coefficient is preferably 15,000 $L \cdot mol^{-1} \cdot cm^{-1}$ or more.

<Organic metal complex>

From the viewpoint of chemical resistance, the resin composition according to the embodiment of the present invention may contain an organic metal complex.

The organic metal complex referred to herein does not include a compound corresponding to the above-described specific metal complex.

The organic metal complex may be any organic complex containing a metal atom; however, it is preferably a complex compound containing a metal atom and an organic group, more preferably a compound in which an organic group is coordinated to a metal atom, and still more preferably a metallocene compound.

In the present invention, the metallocene compound refers to an organic metal complex that has, as $\eta$5-ligands, two cyclopentadienyl anion derivatives which may have a substituent.

The organic group is not particularly limited; however, it is preferably a hydrocarbon group or a group consisting of a combination of a hydrocarbon group and a heteroatom. The heteroatom is preferably an oxygen atom, a sulfur atom, or a nitrogen atom.

In the present invention, it is preferable that at least one of the organic groups is a cyclic group, and it is more preferable that at least two thereof are a cyclic group.

The above-described cyclic group is preferably a cyclic group selected from a cyclic group of a 5-membered ring or a cyclic group of a 6-membered ring, and more preferably a cyclic group of a 5-membered ring.

The above-described cyclic group may be a hydrocarbon ring or a heterocyclic ring; however, it is preferably a hydrocarbon ring.

The 5-membered cyclic group is preferably a cyclopentadienyl group.

In addition, the organic metal complex that is used in the present invention preferably contains two to four cyclic groups in one molecule.

The metal contained in the organic metal complex is not particularly limited; however, it is preferably a metal corresponding to a Group 4 element, more preferably at least one metal selected from the group consisting of titanium, zirconium, and hafnium, still more preferably at least one metal selected from the group consisting of titanium and zirconium, and particularly preferably titanium.

The organic metal complex may contain two or more metal atoms or may contain only one metal atom; however, it preferably contains only one metal atom. In a case where the organic metal complex contains two or more metal atoms, it may contain only one kind of metal atom or may contain two or more kinds of metal atoms.

The organic metal complex is preferably a ferrocene compound, a titanocene compound, a zirconocene compound, or a hafnocene compound, more preferably a titanocene compound, a zirconocene compound, or a hafnocene compound, still more preferably a titanocene compound or a zirconocene compound, and particularly preferably a titanocene compound.

An aspect in which the organic metal complex has a photoradical polymerization initiation ability is also one of the preferred aspects of the present invention.

In the present invention, the phrase "having a photoradical polymerization initiation ability" means it is possible to generate a free radical that can initiate radical polymerization by irradiation with light. For example, in a case where a composition containing a radical crosslinking agent and an organic metal complex is irradiated with light in a wavelength range in which the organic metal complex absorbs light, where the wavelength range is a wavelength range in which the radical crosslinking agent does not absorb light, the presence or absence of the photoradical polymerization initiation ability can be checked by checking the presence or absence of the disappearance of the radical crosslinking agent. In order to check the presence or absence of the disappearance, an appropriate method can be selected depending on the kind of radical crosslinking agent, and for example, the checking may be carried out by an IR measurement (infrared spectrometric measurement) or an HPLC measurement (high performance liquid chromatography).

In a case where the organic metal complex has a photoradical polymerization initiation ability, the organic metal complex is preferably a metallocene compound, more preferably a titanocene compound, a zirconocene compound, or a hafnocene compound, still more preferably a titanocene compound or a zirconocene compound, and particularly preferably a titanocene compound.

In a case where the organic metal complex does not have a photoradical polymerization initiation ability, the organic metal complex is preferably at least one compound selected from the group consisting of a titanocene compound, a tetraalkoxytitanium compound, a titanium acylate compound, a titanium chelate compound, a zirconocene compound, and a hafnocene compound, more preferably at least one compound selected from the group consisting of a titanocene compound, a zirconocene compound, and a hafnocene compound, still more preferably at least one compound selected

from the group consisting of a titanocene compound and a zirconocene compound, and particularly preferably a titanocene compound.

The molecular weight of the organic metal complex is preferably 50 to 2,000 and more preferably 100 to 1,000.

Preferred examples of the organic metal complex include a compound represented by Formula (P).

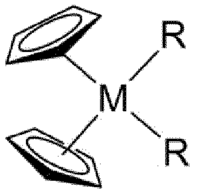

(P)

In Formula (P), M is a metal atom, and R's are each independently a substituent.

R's are each independently preferably selected from an aromatic group, an alkyl group, a halogen atom, and an alkylsulfonyloxy group.

In Formula (P), the metal atom represented by M is preferably an iron atom, a titanium atom, a zirconium atom, or a hafnium atom, more preferably a titanium atom, a zirconium atom, or a hafnium atom, still more preferably a titanium atom or a zirconium atom, and particularly preferably a titanium atom.

Examples of the aromatic group as R in Formula (P) include an aromatic group having 6 to 20 carbon atoms. An aromatic hydrocarbon group having 6 to 20 carbon atoms is preferable, and examples thereof include a phenyl group, a 1-naphthyl group, and a 2-naphthyl group.

The alkyl group as R in Formula (P) is preferably an alkyl group having 1 to 20 carbon atoms, more preferably an alkyl group having 1 to 10 carbon atoms, and examples thereof include a methyl group, an ethyl group, a propyl group, an octyl group, an isopropyl group, a t-butyl group, an isopentyl group, a 2-ethylhexyl group, a 2-methylhexyl group, and a cyclopentyl group.

Examples of the halogen atom as R include F, Cl, Br, and I.

The alkyl group constituting the alkylsulfonyloxy group as R is preferably an alkyl group having 1 to 20 carbon atoms, more preferably an alkyl group having 1 to 10 carbon atoms, and examples thereof include a methyl group, an ethyl group, a propyl group, an octyl group, an isopropyl group, a t-butyl group, an isopentyl group, a 2-ethylhexyl group, a 2-methylhexyl group, and a cyclopentyl group.

R may further have a substituent. Examples of the substituent include a halogen atom (F, Cl, Br, or I), a hydroxy group, a carboxy group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group, and a diarylamino group.

Specific examples of the organic metal complex are not particularly limited; however, examples thereof include tetraisopropoxytitanium, tetrakis(2-ethylhexyloxy)titanium, diisopropoxybis(ethyl acetoacetate)titanium, diisopropoxybis(acetylacetonato)titanium, bis(η5-2,4-cyclopentadien-1-yl)bis(2,6-difluoro-3-(1H-pyrrol-1-yl)phenyl)titanium, pentamethylcyclopentadienyl titanium trimethoxide, bis(η5-2,4-cyclopentadien-1-yl)bis(2,6-difluorophenyl)titanium, and the following compounds.

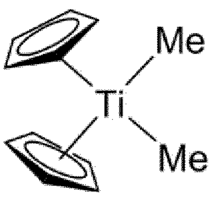
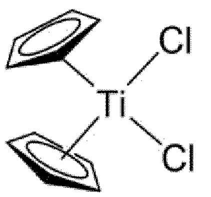
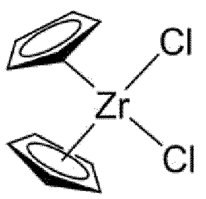
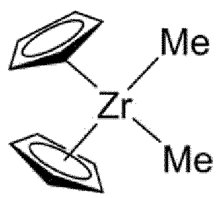
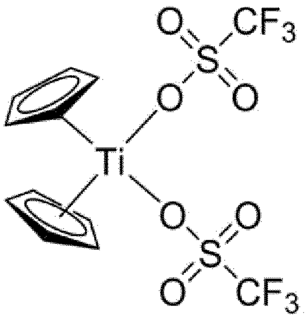
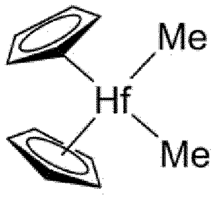
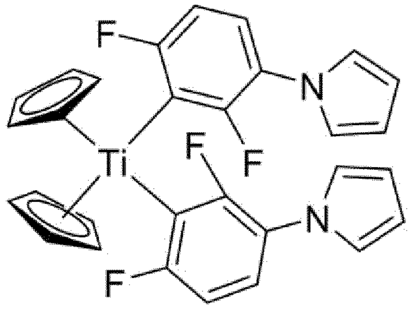

In addition, the compounds described in paragraphs 0078 to 0088 of WO2018/025738A can also be used; however, the compounds are not limited thereto.

The content of the organic metal complex is preferably 0.1% to 30% by mass with respect to the total solid content of the resin composition according to the embodiment of the present invention. The lower limit thereof is more preferably 1.0% by mass or more, still more preferably 1.5% by mass or more, and particularly preferably 3.0% by mass or more. The upper limit thereof is more preferably 25% by mass or less, still more preferably 15% by mass or less, and particularly preferably 10% by mass or less.

One kind or two or more kinds of organic metal complexes can be used. In a case where two or more kinds thereof are used, the total amount is preferably within the above-described range.

<Polymerizable compound>

The resin composition according to the embodiment of the present invention preferably contains a polymerizable compound.

Examples of the polymerizable compound include a radical crosslinking agent and another crosslinking agent.

[Radical crosslinking agent]

The resin composition according to the embodiment of the present invention preferably contains a radical crosslinking agent.

The radical crosslinking agent is a compound having a radically polymerizable group. The radically polymerizable group is preferably a group containing an ethylenically unsaturated bond. Examples of the group containing the ethylenically unsaturated bond include groups having an ethylenically unsaturated bond, such as a vinyl group, an allyl group, a vinylphenyl group, a (meth)acryloyl group, a maleimide group, and a (meth)acrylamide group.

Among these, the group containing an ethylenically unsaturated bond is preferably a (meth)acryloyl group, a (meth)acrylamide group, or a vinylphenyl group, and more preferably a (meth)acryloyl group from the viewpoint of reactivity.

The radical crosslinking agent is preferably a compound having one or more ethylenically unsaturated bonds; however, a compound having two or more ethylenically unsaturated bonds is more preferable. The radical crosslinking agent may have three or more ethylenically unsaturated bonds.

The compound having 2 or more ethylenically unsaturated bonds is preferably a compound having 2 to 15 ethylenically unsaturated bonds, more preferably a compound having 2 to 10 ethylenically unsaturated bonds, and still more preferably a compound having 2 to 6 ethylenically unsaturated bonds.

In addition, from the viewpoint of the film hardness of the pattern (cured substance) to be obtained, the photocurable resin composition according to the embodiment of the present invention preferably contains a compound having two ethylenically unsaturated bonds and a compound having three or more ethylenically unsaturated bonds.

The molecular weight of the radical crosslinking agent is preferably 2,000 or less, more preferably 1,500 or less, and still more preferably 900 or less. The lower limit of the molecular weight of the radical crosslinking agent is preferably 100 or more.

Specific examples of the radical crosslinking agent include unsaturated carboxylic acids (for example, acrylic acid, methacrylic acid, itaconic acid, crotonic acid, isocrotonic acid, and maleic acid), and esters and amides thereof, where esters between unsaturated carboxylic acids and polyhydric alcohol compounds or amides between unsaturated carboxylic acids and polyvalent amine compounds are preferable. In addition, addition reaction products produced by reacting unsaturated carboxylic acid esters or amides, having a nucleophilic substituent such as a hydroxy group, an amino group, or a sulfanyl group, with monofunctional or polyfunctional isocyanates or epoxies, dehydration condensation reaction products produced by reacting the above esters or amides with a monofunctional or polyfunctional carboxylic acid, or the like are also suitably used. In addition, an addition reaction product produced by reacting unsaturated carboxylic acid esters or amides, having an electrophilic substituent such as an isocyanate group or an epoxy group, with monofunctional or polyfunctional alcohols, amines, or thiols, and further, a substitution reaction product produced by reacting unsaturated carboxylic acid esters or amides, having an eliminable substituent such as a halogeno group or a tosyloxy group, with monofunctional or polyfunctional alcohols, amines, or thiols is also suitable. In addition, as other examples, it is also possible to use a group of compounds in which the unsaturated carboxylic acid described above is replaced with an unsaturated phosphonic acid, a vinylbenzene derivative such as styrene, a vinyl ether, an allyl ether, or the like. Regarding the specific examples thereof, reference can be made to the description of paragraphs 0113 to 0122 of JP2016-027357A, the content of which is incorporated in the present specification.

In addition, the radical crosslinking agent is also preferably a compound having a boiling point of 100°C or higher under normal pressure. Examples of the compound having a boiling point of 100°C or higher under normal pressure include the compounds described in paragraph 0203 of WO2021/112189A. The content thereof is incorporated in the

present specification.

Examples of the preferred radical crosslinking agent other than those described above include the radically polymerizable compounds described in paragraphs 0204 to 0208 of WO2021/112189A. The content thereof is incorporated in the present specification.

As the radical crosslinking agent, dipentaerythritol triacrylate (as a commercially available product, KAYARAD D-330 (manufactured by Nippon Kayaku Co., Ltd.), dipentaerythritol tetraacrylate (as a commercially available product, KAYARAD D-320 (manufactured by Nippon Kayaku Co., Ltd.), A-TMMT (manufactured by Shin-Nakamura Chemical Co., Ltd.), dipentaerythritol penta(meth)acrylate (as a commercially available product, KAYARAD D-310 (manufactured by Nippon Kayaku Co., Ltd.), dipentaerythritol hexa(meth)acrylate (as a commercially available product, KAYARAD DPHA (manufactured by Nippon Kayaku Co., Ltd.), A-DPH (manufactured by Shin-Nakamura Chemical Co., Ltd.), or a structure in which a (meth)acryloyl group thereof is bonded through an ethylene glycol residue or a propylene glycol residue is preferable. Oligomer types thereof can also be used.

Examples of the commercially available product of the radical crosslinking agent include SR-494 which is a tetrafunctional acrylate having four ethyleneoxy chains, manufactured by Sartomer Company Inc., SR-209, 231, and 239 which are a difunctional methacrylate having four ethyleneoxy chains, manufactured by Sartomer Company Inc., DPCA-60 which is a hexafunctional acrylate having six pentyleneoxy chains, manufactured by Nippon Kayaku Co., Ltd., TPA-330 which is a trifunctional acrylate having three isobutylene oxy chains, a urethane oligomer UAS-10, UAB-140 (manufactured by Nippon Paper Industries Co., Ltd.), NK Ester M-40G, NK Ester 4G, NK Ester M-9300, NK Ester A-9300, UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, AI-600 (manufactured by KYOEISHA CHEMICAL Co., Ltd.), and Brenmer PME400 (manufactured by NOF Corporation).

As the radical crosslinking agent, the urethane acrylates as described in JP1973-041708B (JP-S48-041708B), JP1976-037193A (JP-S51-037193A), JP1990-032293B (JP-H02-032293B), and JP1990-016765B (JP-H02-016765B), and the urethane compounds having an ethylene oxide-based skeleton described in JP1983-049860B (JP-S58-049860B), JP1981-017654B (JP-S56-017654B), JP1987-039417B (JP-S62-039417B), and JP1987-039418B (JP-S62-039418B) are also suitable. Further, as the radical crosslinking agent, the compounds having an amino structure or a sulfide structure in the molecule as described in JP1988-277653A (JP-S63-277653A), JP1988-260909A (JP-S63-260909A), and JP1989-105238A (JP-H01-105238A) can also be used.

The radical crosslinking agent may be a radical crosslinking agent having an acid group such as a carboxy group or a phosphate group. The radical crosslinking agent having an acid group is preferably an ester between an aliphatic polyhydroxy compound and an unsaturated carboxylic acid and more preferably a radical crosslinking agent obtained by reacting an unreacted hydroxy group of an aliphatic polyhydroxy compound with a non-aromatic carboxylic acid anhydride to have an acid group. The radical crosslinking agent is particularly preferably a compound in which an aliphatic polyhydroxy compound is pentaerythritol or dipentaerythritol in a radical crosslinking agent having an acid group obtained by reacting an unreacted hydroxy group of the aliphatic polyhydroxy compound with a non-aromatic carboxylic acid anhydride. Examples of the commercially available product thereof include M-510 and M-520 as polybasic acid-modified acrylic oligomers which are manufactured by Toagosei Co., Ltd.

The acid value of the radical crosslinking agent having an acid group is preferably 0.1 to 300 mgKOH/g, and particularly preferably 1 to 100 mgKOH/g. In a case where the acid value of the radical crosslinking agent is within the above-described range, excellent manufacturing handleability is exhibited, and furthermore, excellent developability is exhibited. In addition, good polymerization properties are exhibited. The acid value is measured according to the description of JIS K 0070: 1992.

In addition, the radical crosslinking agent is also preferably a radical crosslinking agent having at least one selected from the group consisting of a urea bond and a urethane bond (hereinafter, also referred to as a "crosslinking agent U").

In the present invention, the urea bond is a bond represented by *-NR$^N$-C(=O)-NR$^N$-*, where R$^N$'s each independently represent a hydrogen atom or a monovalent organic group, and *'s each represent a bonding site to a carbon atom.

In the present invention, the urethane bond is a bond represented by *-O-C(=O)-NR$^N$-*, where R$^N$ represents a hydrogen atom or a monovalent organic group, and *'s each represent a bonding site to a carbon atom.

In a case where the resin composition contains a crosslinking agent U, chemical resistance, resolution, and the like may be improved.

The mechanism by which the above-described effect is obtained is not revealed; however, it is considered that, for example, a part of the crosslinking agent U undergoes thermal decomposition during curing by heating or the like to generate an amine or the like, and the amine or the like accelerates the cyclization of the precursor of the cyclization resin such as the polyimide precursor.

The crosslinking agent U may have only one urea bond or urethane bond, may have one or more urea bonds and one or more urethane bonds, may have two or more urea bonds without having a urethane bond, or may have two or more

urethane bonds without having a urea bond.

The total number of urea bonds and urethane bonds in the crosslinking agent U is 1 or more, and it is preferably 1 to 10, more preferably 1 to 4, and still more preferably 1 or 2.

In addition, in a case where the crosslinking agent U does not have a urethane bond, the number of urea bonds in the crosslinking agent U is 1 or more, and it is preferably 1 to 10, more preferably 1 to 4, and still more preferably 1 or 2.

In addition, in a case where the crosslinking agent U does not have a urea bond, the number of urethane bonds in the crosslinking agent U is 1 or more, and it is preferably 1 to 10, more preferably 1 to 4, and still more preferably 1 or 2.

The radically polymerizable group in the crosslinking agent U is not particularly limited; however, examples thereof include a vinyl group, an allyl group, a (meth)acryloyl group, a (meth)acryloxy group, a (meth)acrylamide group, a vinylphenyl group, and a maleimide group, where a (meth)acryloxy group, a (meth)acrylamide group, a vinylphenyl group, or a maleimide group is preferable, and a (meth)acryloxy group is more preferable.

In a case where the crosslinking agent U has two or more radically polymerizable groups, the structures of the respective radically polymerizable groups may be the same or different from each other.

The number of radically polymerizable groups in the crosslinking agent U may be only one or may be two or more, and it is preferably 1 to 10, more preferably 1 to 6, and particularly preferably 1 to 4.

The radically polymerizable group value (the mass of the compound per 1 mol of the radically polymerizable group) in the crosslinking agent U is preferably 150 to 400 g/mol.

The lower limit of the above-described radically polymerizable group value is more preferably 200 g/mol or more, still more preferably 210 g/mol or more, even still more preferably 220 g/mol or more, even further still more preferably 230 g/mol or more, particularly preferably 240 g/mol or more, and most preferably 250 g/mol or more.

The upper limit of the above-described radically polymerizable group value is more preferably 350 g/mol or less, still more preferably 330 g/mol or less, and particularly preferably 300 g/mol or less.

In a case where the radically polymerizable group value is equal to or smaller than the above-described lower limit, the chemical resistance of the cured substance tends to be favorable, and in a case where the radically polymerizable group value is equal to or larger than the above-described upper limit value, the developability tends to be favorable.

Among the above, the polymerizable group value of the crosslinking agent U is preferably 210 to 400 g/mol and more preferably 220 to 400 g/mol.

The crosslinking agent U has preferably, for example, a structure represented by Formula (U-1).

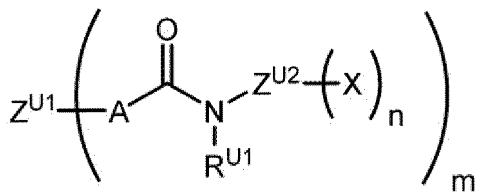

(U-1)

In Formula (U-1), $R^{U1}$ is a hydrogen atom or a monovalent organic group, A is -O- or - $NR^N$-, $R^N$ is a hydrogen atom or a monovalent organic group, $Z^{U1}$ is an m-valent organic group, $Z^{U2}$ is an n+1-valent organic group, X is a radically polymerizable group, n is an integer of 1 or more, and m is an integer of 1 or more.

In Formula (U-1), $R^{U1}$ is preferably a hydrogen atom, an alkyl group, or an aromatic hydrocarbon group, and more preferably a hydrogen atom.

In Formula (U-1), $R^N$ is preferably a hydrogen atom, an alkyl group, or an aromatic hydrocarbon group, and more preferably a hydrogen atom.

In Formula (U-1), $Z^{U1}$ is preferably a hydrocarbon group, -O-, -C(=O)-, -S-, $-S(=O)_2-$, $-NR^N-$, or a group in which two or more of these are bonded, and more preferably a hydrocarbon group or a group in which a hydrocarbon group is bonded to at least one group selected from the group consisting of -O-, -C(=O)-, -S-, $-S(=O)_2-$, and $-NR^N-$.

As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. In addition, examples of the above-described hydrocarbon group include a saturated aliphatic hydrocarbon group, an aromatic hydrocarbon group, and a group obtained by bonding of these groups. $R^N$ represents a hydrogen atom or a monovalent organic group, and it is preferably a hydrogen atom or a hydrocarbon group, more preferably a hydrogen atom or an alkyl group, and still more preferably a hydrogen atom or a methyl group.

In Formula (U-1), $Z^{U2}$ is preferably a hydrocarbon group, -O-, -C(=O)-, -S-, $-S(=O)_2-$, $-NR^N-$, or a group in which two or more of these are bonded, and more preferably a hydrocarbon group or a group in which a hydrocarbon group is bonded to at least one group selected from the group consisting of -O-, -C(=O)-, -S-, $-S(=O)_2-$, and $-NR^N-$.

As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. In addition, examples of the above-described hydrocarbon group include a saturated

aliphatic hydrocarbon group, an aromatic hydrocarbon group, and a group obtained by bonding of these groups.

In Formula (U-1), X is not particularly limited; however, examples thereof include a vinyl group, an allyl group, a (meth)acryloyl group, a (meth)acryloxy group, a (meth)acrylamide group, a vinylphenyl group, and a maleimide group, where a (meth)acryloxy group, a (meth)acrylamide group, a vinylphenyl group, or a maleimide group is preferable, and a (meth)acryloxy group is more preferable.

In Formula (U-1), n is preferably an integer of 1 to 10, more preferably an integer of 1 to 4, still more preferably 1 or 2, and particularly preferably 1.

In Formula (U-1), m is preferably an integer of 1 to 10, more preferably an integer of 1 to 4, and still more preferably 1 or 2.

It is also preferable that the crosslinking agent U has at least one of a hydroxy group, an alkyleneoxy group, an amide group, or a cyano group.

From the viewpoint of the chemical resistance of the cured substance to be obtained, the hydroxy group may be an alcoholic hydroxy group or a phenolic hydroxy group; however, it is preferably an alcoholic hydroxy group.

From the viewpoint of the chemical resistance of the cured substance to be obtained, the alkyleneoxy group is preferably an alkyleneoxy group having 2 to 20 carbon atoms, more preferably an alkyleneoxy group having 2 to 10 carbon atoms, still more preferably an alkyleneoxy group having 2 to 4 carbon atoms, still more preferably an ethylene group or a propylene group, and particularly preferably an ethylene group.

The alkyleneoxy group may be contained in the crosslinking agent U as a polyalkyleneoxy group. The number of repetitions of the alkyleneoxy group in this case is preferably 2 to 10 and more preferably 2 to 6.

The amide group refers to a bond represented by -C(=O)-NR$^N$-. R$^N$ is as described above. In a case where the crosslinking agent U has an amide group, the crosslinking agent U can include, for example, a group represented by R-C(=O)-NR$^N$-* or a group represented by *-C(=O)-NR$^N$-R. R represents a hydrogen atom or a monovalent substituent, and it is preferably a hydrogen atom or a hydrocarbon group and more preferably a hydrogen atom, an alkyl group, or an aromatic hydrocarbon group.

The crosslinking agent U may have, in the molecule, two or more structures selected from the group consisting of a hydroxy group, an alkyleneoxy group (however, a polyalkyleneoxy group in a case of constituting a polyalkyleneoxy group), an amide group, and a cyano group; however, an aspect of having only one structure in the molecule is also one of the preferred aspects of the present invention.

The hydroxy group, the alkyleneoxy group, the amide group, and the cyano group may be present at any position of the crosslinking agent U; however, from the viewpoint of chemical resistance, such a crosslinking agent U in which at least one selected from the group consisting of the hydroxy group, the alkyleneoxy group, the amide group, and the cyano group, and at least one radically polymerizable group contained in the crosslinking agent U are linked by a linking group (hereinafter, also referred to as a "linking group L2-1") including a urea bond or a urethane bond is also one of the preferred aspects of the present invention.

In particular, in a case where the crosslinking agent U contains only one radically polymerizable group, it is preferable that the radically polymerizable group contained in the crosslinking agent U and at least one selected from the group consisting of a hydroxy group, an alkyleneoxy group, an amide group, and a cyano group are linked by a linking group including a urea bond or a urethane bond (hereinafter, also referred to as a "linking group L2-2").

In a case where the crosslinking agent U contains an alkyleneoxy group (however, a polyalkyleneoxy group in a case of constituting a polyalkyleneoxy group) and has the above-described linking group L2-1 or the above-described linking group L2-2, a structure that is bonded to a side of the alkyleneoxy group (however, a polyalkyleneoxy group in a case of constituting a polyalkyleneoxy group) opposite to the linking group L2-1 or the linking group L2-2 is not particularly limited; however, it is preferably a hydrocarbon group, a radically polymerizable group, or a group represented by a combination thereof. As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. In addition, examples of the above-described hydrocarbon group include a saturated aliphatic hydrocarbon group, an aromatic hydrocarbon group, and a group obtained by bonding of these groups. In addition, the preferred aspect of the radically polymerizable group is the same as the preferred aspect of the radically polymerizable group in the above-described crosslinking agent U.

In a case where the crosslinking agent U contains an amide group and has the linking group L2-1 or the linking group L2-2, a structure that is bonded to a side of the amide group opposite to the linking group L2-1 or the linking group L2-2 is not particularly limited; however, it is preferably a hydrocarbon group, a radically polymerizable group, or a group represented by a combination thereof. As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. In addition, examples of the above-described hydrocarbon group include a saturated aliphatic hydrocarbon group, an aromatic hydrocarbon group, and a group obtained by bonding of these groups. In addition, the preferred aspect of the radically polymerizable group is the same as the preferred aspect of the radically polymerizable group in the above-described crosslinking agent U. In addition, in the above aspect, a carbon

atom side of the amide group may be bonded to the linking group L2-1 or the linking group L2-2, or a nitrogen atom side of the amide group may be bonded to the linking group L2-1 or the linking group L2-2.

Among these, from the viewpoint of the adhesiveness to the base material, the chemical resistance, and the Cu void suppression, the crosslinking agent U preferably has a hydroxy group.

From the viewpoint of the compatibility with the specific resin and the like, the crosslinking agent U preferably contains an aromatic group.

The aromatic group is preferably directly bonded to a urea bond or a urethane bond contained in the crosslinking agent U. In a case where the crosslinking agent U contains two or more urea bonds or two or more urethane bonds, it is preferable that one of the urea bonds or urethane bonds is directly bonded to the aromatic group.

The aromatic group may be an aromatic hydrocarbon group or an aromatic heterocyclic group and may have a structure in which these groups form a fused ring; however, an aromatic hydrocarbon group is preferable.

The aromatic hydrocarbon group is preferably an aromatic hydrocarbon group having 6 to 30 carbon atoms, more preferably an aromatic hydrocarbon group having 6 to 20 carbon atoms, and still more preferably a group obtained by removing two or more hydrogen atoms from a benzene ring structure.

The aromatic heterocyclic group is preferably a 5-membered or 6-membered aromatic heterocyclic group. Examples of the aromatic heterocyclic ring in such an aromatic heterocyclic group include pyrrole, imidazole, triazole, tetrazole, pyrazole, furan, thiophene, oxazole, isoxazole, thiazole, pyridine, pyrazine, pyrimidine, pyridazine, and triazine. These rings may be further fused with another ring, for example, as in the case of indole or benzimidazole.

In addition, the heteroatom contained in the aromatic heterocyclic group is preferably a nitrogen atom, an oxygen atom, or a sulfur atom.

It is preferable that the aromatic group is included in, for example, a linking group that links two or more radically polymerizable groups and links a linking group having a urea bond or a urethane bond, or at least one selected from the group consisting of a hydroxy group, an alkyleneoxy group, an amide group, and a cyano group, to at least one radically polymerizable group contained in the crosslinking agent U.

The number of atoms (linking chain length) between the urea bond or urethane bond and the radically polymerizable group in the crosslinking agent U is not particularly limited; however, it is preferably 30 or less, more preferably 2 to 20, and still more preferably 2 to 10.

In a case where the crosslinking agent U contains two or more urea bonds or urethane bonds, the minimum number of atoms (linking chain length) between the urea bond or urethane bond and the radically polymerizable group is sufficient to be within the above-described range in a case where the crosslinking agent U contains two or more radically polymerizable groups, or in a case where the crosslinking agent U contains two or more urea bonds or two or more urethane bonds and two or more radically polymerizable groups,

In the present specification, the phrase "number of atoms (linking chain length) between the urea bond or urethane bond and the polymerizable group" refers to the smallest number of atoms (minimum number of atoms) for linking targets among the number of atoms for atomic chains on a path that links two atoms or atomic groups between the linking targets. For example, in a structure represented by the following formula, the number of atoms (the linking chain length) between the urea bond and the radically polymerizable group (methacryloyloxy group) is 2.

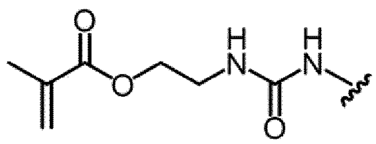

[Symmetry axis]

It is also preferable that the crosslinking agent U is a compound having a structure which does not have a symmetry axis.

The fact that the crosslinking agent U does not have a symmetry axis refers to that the crosslinking agent U is a left-right asymmetric compound which does not have an axis that generates the same molecule as the original molecule in a case where the entire compound is rotated. In addition, in a case where the structural formula of the crosslinking agent U is shown on the paper surface, the fact that the crosslinking agent U does not have a symmetry axis refers to that the structural formula of the crosslinking agent U cannot be shown in a form having a symmetry axis.

It is considered that the aggregation of the crosslinking agents U is suppressed in the composition film in a case where the crosslinking agent U does not have a symmetry axis.

[Molecular weight]

The molecular weight of the crosslinking agent U is preferably 100 to 2,000, preferably 150 to 1,500, and more preferably 200 to 900.

A manufacturing method for the crosslinking agent U is not particularly limited; however, the crosslinking agent U can be obtained, for example, by reacting a radically polymerizable compound with a compound having an isocyanate group and a compound having at least one of a hydroxy group or an amino group.

Specific examples of the crosslinking agent U are shown below; however, the crosslinking agent U is not limited thereto.

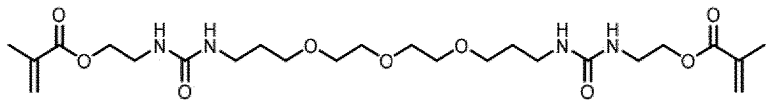

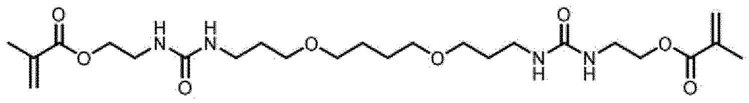

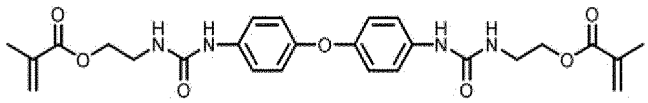

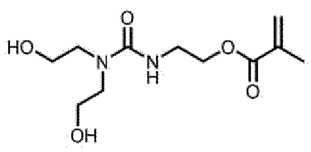

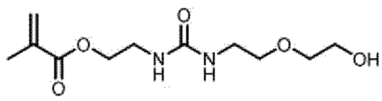

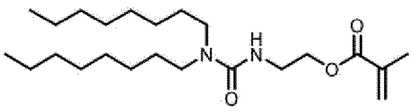

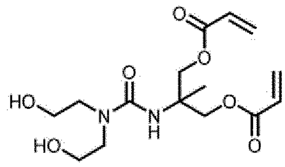

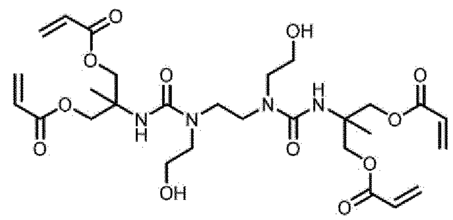

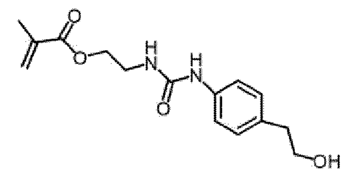

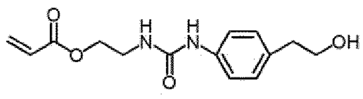

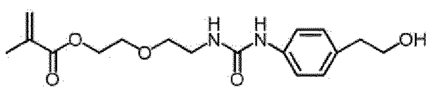

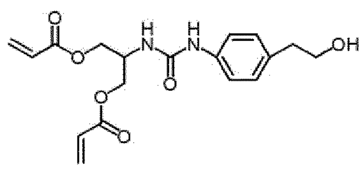

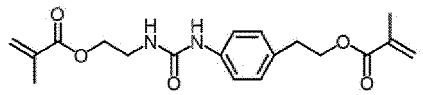
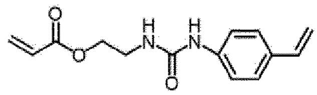

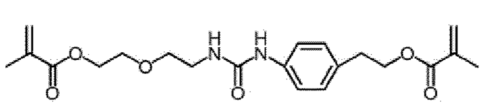
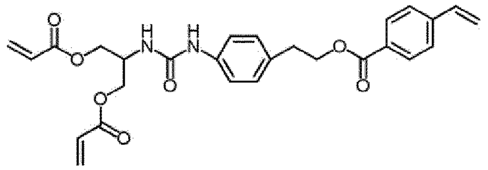

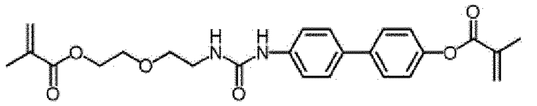
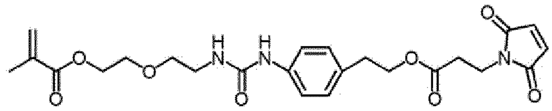

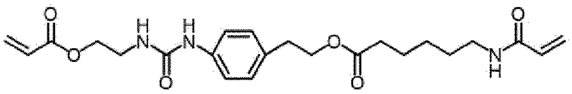

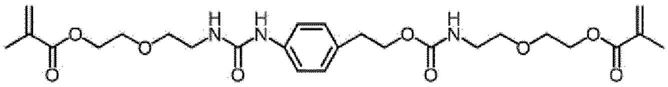

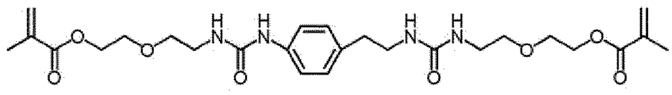

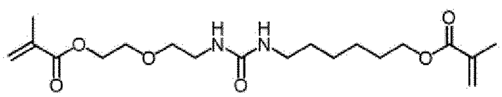
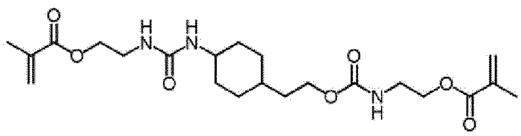

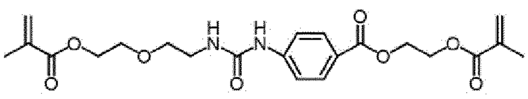
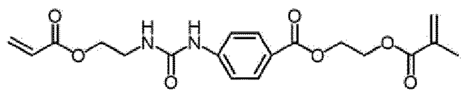

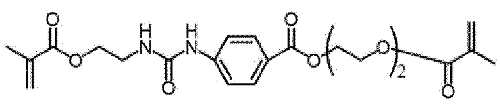
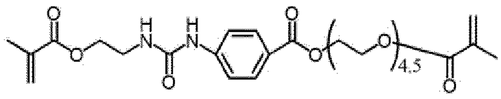

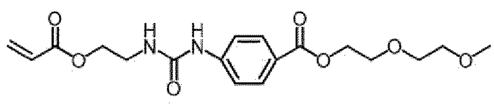
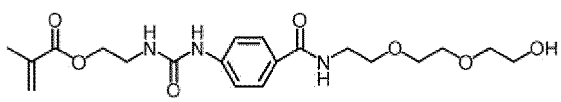

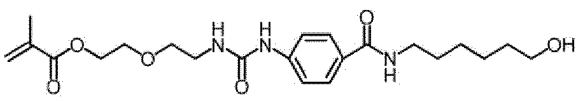

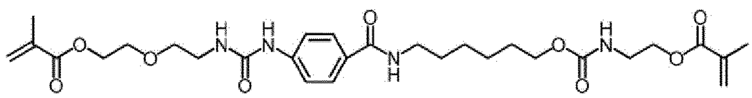

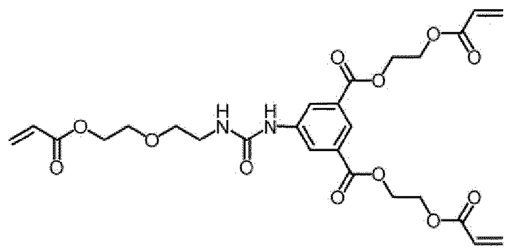

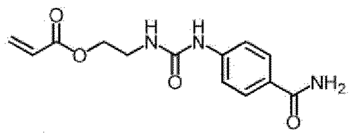 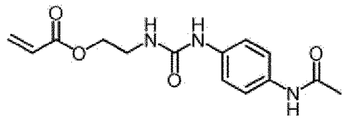

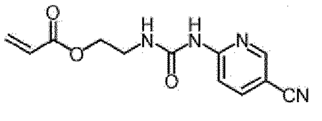 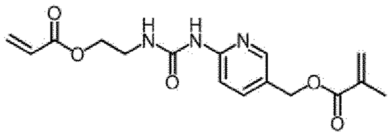

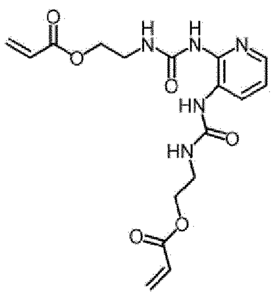 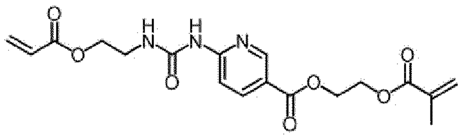

In the resin composition, it is preferable to use difunctional methacrylate or acrylate from the viewpoint of pattern resolution and film elasticity.

As the specific compound, the following compound can be used; triethylene glycol diacrylate, triethylene glycol dimethacrylate, tetraethylene glycol dimethacrylate, tetraethylene glycol diacrylate, polyethylene glycol (PEG) 200 diacrylate, PEG 200 dimethacrylate, PEG 600 diacrylate, PEG 600 dimethacrylate, polytetraethylene glycol diacrylate, polytetraethylene glycol dimethacrylate, dipropylene glycol diacrylate, tripropylene glycol diacrylate, neopentyl glycol diacrylate, neopentyl glycol dimethacrylate, 3-methyl-1, 5-pentanediol diacrylate, 1,6-hexanediol diacrylate, 1,6-hexanediol dimethacrylate, dimethylol-tricyclodecanediacrylate, dimethylol-tricyclodecanedimethacrylate, a diacrylate of an ethylene oxide (EO) adduct of bisphenol A, a dimethacrylate of an EO adduct of bisphenol A, a diacrylate of a propylene oxide (PO) adduct of bisphenol A, a dimethacrylate of a PO adduct of bisphenol A, 2-hydroxy-3-acryloyloxypropyl methacrylate, isocyanuric acid EO-modified diacrylate, isocyanuric acid-modified dimethacrylate, another difunctional acrylate having a urethane bond, and difunctional methacrylate having a urethane bond. As necessary, two or more of these can be mixedly used.

It is noted that, for example, the PEG 200 diacrylate refers to a polyethylene glycol diacrylate having a polyethylene glycol chain formula weight of about 200.

In the photocurable resin composition according to the embodiment of the present invention, a monofunctional radical crosslinking agent can be preferably used as the radical crosslinking agent from the viewpoint of suppressing warping associated with the control of the elastic modulus of the pattern (cured substance). As the monofunctional radical crosslinking agent, (meth)acrylic acid derivatives such as n-butyl (meth)acrylate, 2-ethylhexyl (meth)acrylate, 2-hydroxyethyl (meth)acrylate; butoxyethyl (meth)acrylate, carbitol (meth)acrylate, cyclohexyl (meth)acrylate, benzyl (meth) acrylate, phenoxyethyl (meth)acrylate, N-methylol (meth)acrylamide, glycidyl (meth)acrylate, polyethylene glycol mono(meth)acrylate, and polypropylene glycol mono(meth)acrylate, N-vinyl compounds such as N-vinylpyrrolidone and N-vinylcaprolactam, allyl glycidyl ethers, and the like are preferably used. As the monofunctional radical crosslinking agent, a compound having a boiling point of 100°C or higher under normal pressure is also preferable in order to suppress volatilization before exposure.

In addition, examples of the difunctional or higher functional radical crosslinking agent include allyl compounds

such as diallyl phthalate and triallyl trimellitate.

In a case where a radical crosslinking agent is contained, the content thereof is preferably more than 0% by mass and 60% by mass or less with respect to the total solid content of the photocurable resin composition according to the embodiment of the present invention. The lower limit thereof is more preferably 5% by mass or more. The upper limit thereof is more preferably 50% by mass or less and still more preferably 30% by mass or less.

One kind of radical crosslinking agent may be used alone, or two or more kinds thereof may be mixedly used. In a case where two or more kinds thereof are used in combination, the total amount thereof is preferably in the above range.

[Another crosslinking agent]

The photocurable resin composition according to the embodiment of the present invention also preferably contains another crosslinking agent different from the radical crosslinking agent described above.

In the present invention, the other crosslinking agent refers to a crosslinking agent other than the above-described radical crosslinking agent, where it is preferably a compound having a plurality of groups, in the molecule, which accelerates a reaction of forming a covalent bond between other compounds in the composition or reaction products thereof, by the photosensitization of the above-described photoacid generator photobase generator, and it is preferably a compound having a plurality of groups, in the molecule, which accelerates a reaction of forming a covalent bond between other compounds in the composition or reaction products thereof, by the action of the acid or the base.

The acid or base is preferably an acid or base generated from a photoacid generator or a photobase generator in the exposure step.

The other crosslinking agent is preferably a compound having at least one group selected from the group consisting of an acyloxymethyl group, a methylol group, an ethylol group, and an alkoxymethyl group, and more preferably a compound having a structure in which at least one group selected from the group consisting of an acyloxymethyl group, a methylol group, an ethylol group, and an alkoxymethyl group is directly bonded to a nitrogen atom.

Examples of the other crosslinking agent include a compound having a structure in which formaldehyde, or formaldehyde and alcohol are reacted with an amino group-containing compound such as melamine, glycoluril, urea, an alkylene urea, or benzoguanamine to substitute a hydrogen atom of the amino group with an acyloxymethyl group, a methylol group, an ethylol group, or an alkoxymethyl group. The production method for these compounds is not particularly limited, and any compound having the same structure as the compound produced by the above method may be used. In addition, oligomers formed by the self-fusion of the methylol groups of these compounds may be used.

As the above amino group-containing compound, the crosslinking agent in which melamine is used is referred to as a melamine-based crosslinking agent, the crosslinking agent in which glycoluril, urea, or an alkylene urea is used is referred to a urea-based crosslinking agent, the crosslinking agent in which an alkylene urea is used is referred to as an alkylene urea-based crosslinking agent, and the crosslinking agent in which benzoguanamine is used is referred to as a benzoguanamine-based crosslinking agent.

Among these, the photocurable resin composition according to the embodiment of the present invention preferably contains at least one compound selected from the group consisting of a urea-based crosslinking agent and a melamine-based crosslinking agent and more preferably contains at least one compound selected from the group consisting of a glycoluril-based crosslinking agent described later and a melamine-based crosslinking agent.

Examples of the compound containing at least one of the alkoxymethyl group or the acyloxymethyl group in the present invention include, as a structural example, a compound in which an alkoxymethyl group or an acyloxymethyl group is directly substituted on an aromatic group or the nitrogen atom of the following urea structure, or on triazine.

The alkoxymethyl group or acyloxymethyl group contained in the above compound preferably has 2 to 5 carbon atoms, preferably 2 or 3 carbon atoms, and more preferably 2 carbon atoms.

The total number of alkoxymethyl groups and acyloxymethyl groups contained in the above compound is preferably 1 to 10, more preferably 2 to 8, and particularly preferably 3 to 6.

The molecular weight of the above compound is preferably 1,500 or less and preferably 180 to 1,200.

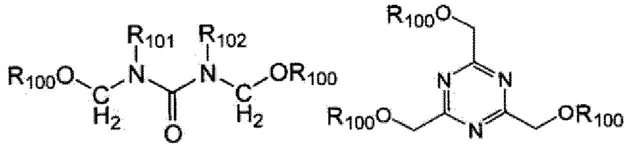

$R_{100}$ represents an alkyl group or an acyl group.

$R_{101}$ and $R_{102}$ each independently represent a monovalent organic group, and they may be bonded to each other to form a ring.

Examples of the compound in which an alkoxymethyl group or an acyloxymethyl group is directly substituted on

an aromatic group include compounds such as those represented by the following general formulae.

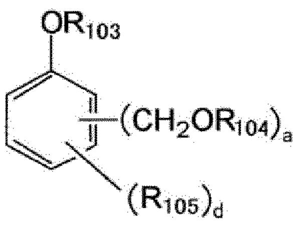

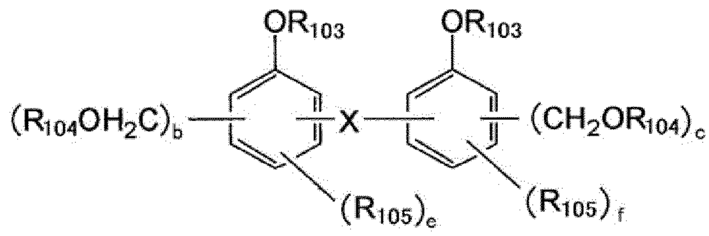

In the formula, X represents a single-bond or a divalent organic group, $R_{104}$'s each independently represent an alkyl group or an acyl group, and $R_{103}$ represents a hydrogen atom, an alkyl group, an alkenyl group, an aryl group, an aralkyl group, or a group that decomposes under the action of acid and generates an alkali-soluble group (for example, a group that is eliminated by under the action of acid, a group represented by $-C(R^4)_2COOR^5$ (each $R^4$ independently represents a hydrogen atom or an alkyl group having 1 to 4 carbon atoms, and $R^5$ represents a group eliminated under the action of acid)).

$R_{105}$'s each independently represents an alkyl group or an alkenyl group, a, b, and c are each independently 1 to 3, d is 0 to 4, e is 0 to 3, and f is 0 to 3, where a + d is 5 or less, b + e is 4 or less, and c + f is 4 or less.

Examples of $R^5$ in the group that decomposes under the action of an acid to generate an alkali-soluble group, a group that is eliminated under the action of acid, and a group represented by $-C(R^4)_2COOR^5$, include $-C(R_{36})(R_{37})(R_{38})$, $-C(R_{36})(R_{37})(OR_{39})$, and $- C(R_{01})(R_{02})(OR_{39})$.

In the formula, $R_{36}$ to $R_{39}$ each independently represent an alkyl group, a cycloalkyl group, an aryl group, an aralkyl group, or an alkenyl group. $R_{36}$ and $R_{37}$ may be bonded to each other to form a ring.

The alkyl group is preferably an alkyl group having 1 to 10 carbon atoms and more preferably an alkyl group having 1 to 5 carbon atoms.

The alkyl group may be either linear or branched.

The cycloalkyl group is preferably a cycloalkyl group having 3 to 12 carbon atoms and more preferably a cycloalkyl group having 3 to 8 carbon atoms.

The cycloalkyl group may have a monocyclic structure or a polycyclic structure such as a fused ring.

The aryl group is preferably an aromatic hydrocarbon group having 6 to 30 carbon atoms and more preferably a phenyl group.

As the aralkyl group, an aralkyl group having 7 to 20 carbon atoms is preferable, and an aralkyl group having 7 to 16 carbon atoms is more preferable.

The above-described aralkyl group is intended to be an aryl group substituted with an alkyl group, and preferred aspects of these alkyl group and aryl group are respectively the same as the above-described preferred aspects of the alkyl group and the aryl group.

The alkenyl group is preferably an alkenyl group having 3 to 20 carbon atoms and more preferably an alkenyl group having 3 to 16 carbon atoms.

Further, these groups may further have a publicly known substituent within the scope in which the effect of the present invention is obtained.

$R_{01}$ and $R_{02}$ each independently represent a hydrogen atom, an alkyl group, a cycloalkyl group, an aryl group, an aralkyl group, or an alkenyl group.

The group that decomposes under the action of an acid to generate an alkali-soluble group or the group that is eliminated under the action of an acid is preferably a tertiary alkyl ester group, an acetal group, a cumyl ester group, an enol ester group, or the like. It is more preferably a tertiary alkyl ester group or an acetal group.

In addition, a compound having at least one group selected from the group consisting of a urea bond and a urethane bond is also preferable as the compound having at least one group selected from the group consisting of an acyloxymethyl group, a methylol group, an ethylol group, and an alkoxymethyl group. A preferred aspect of the above-described compound is the same as the preferred aspect of the crosslinking agent U described above, except that the polymerizable group is not a radically polymerizable group but at least one group selected from the group consisting of an acyloxymethyl group, a methylol group, an ethylol group, and an alkoxymethyl group.

Specific examples of the compound having at least one group selected from the group consisting of an acyloxymethyl group, a methylol group, and an ethylol group include the following structures. Examples of the compound having an acyloxymethyl group include compounds in which the alkoxymethyl group of the following compounds is changed to an acyloxymethyl group. Examples of the compound having an alkoxymethyl group or acyloxymethyl in the molecule include; however, are not limited to, the following compounds.

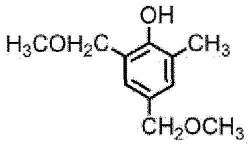
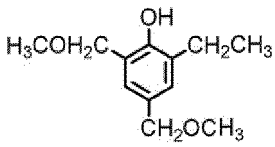
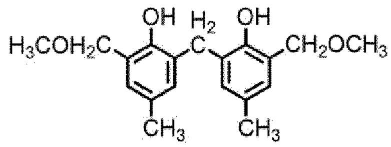

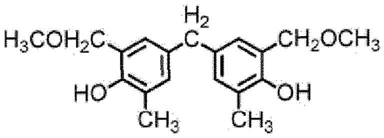
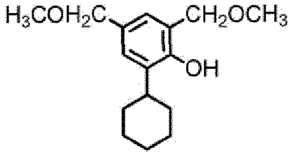
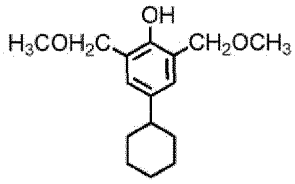

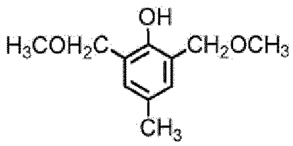
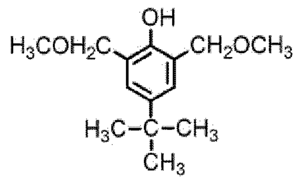
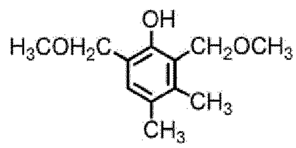

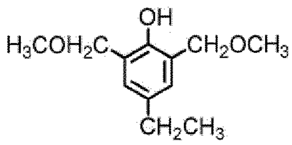
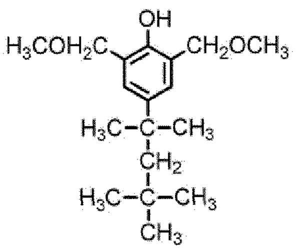
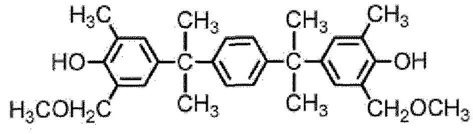

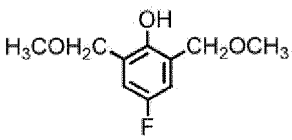
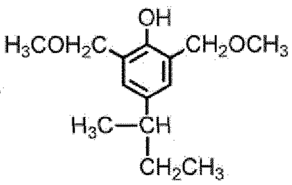
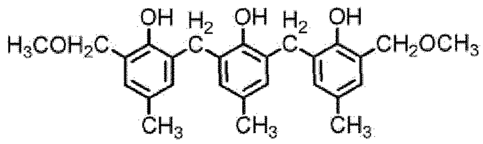

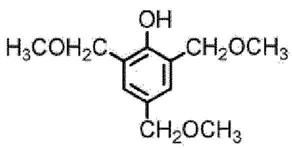
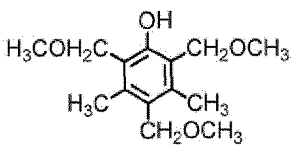
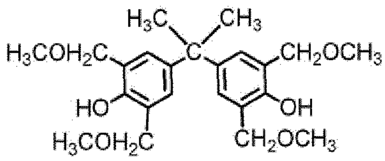

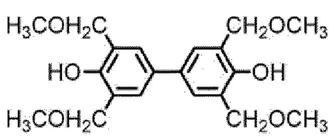
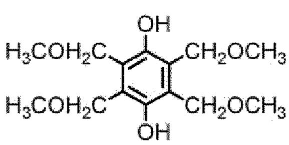
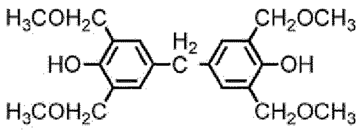

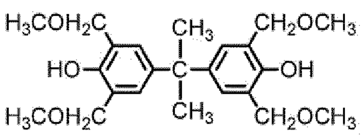
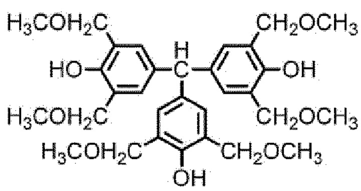
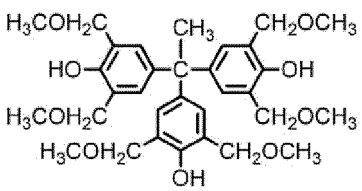

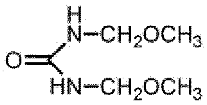
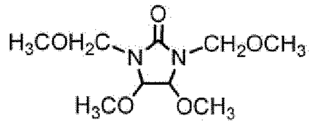
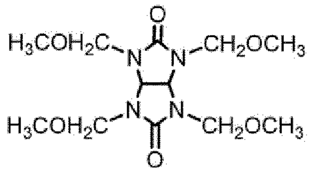

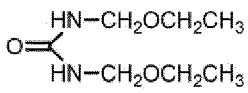
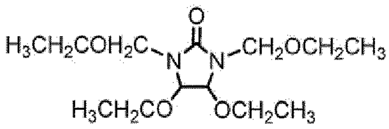
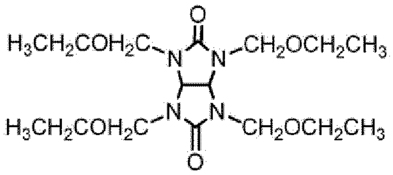

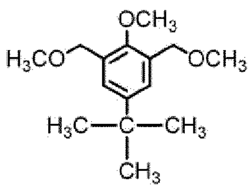
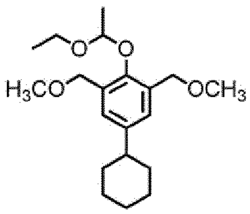
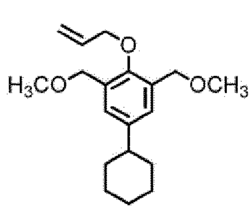
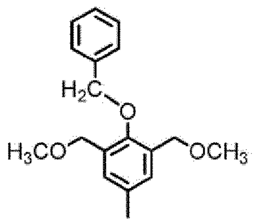

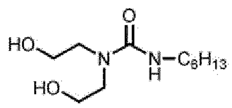
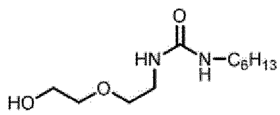
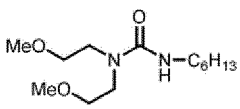

As the compound containing at least one of an alkoxymethyl group and an acyloxymethyl group, a commercially available compound may be used, or a compound synthesized by a publicly known method may be used.

From the viewpoint of heat resistance, a compound in which an alkoxymethyl group or an acyloxymethyl group is directly substituted on an aromatic ring or a triazine ring is preferable.

Specific examples of the melamine-based crosslinking agent include hexamethoxymethylmelamine, hexaethoxymethylmelamine, hexapropoxymethylmelamine, and hexabutoxybutylmelamine.

Specific examples of the urea-based crosslinking agent include glycoluril-based crosslinking agents such as monohydroxymethylated glycoluril, dihydroxymethylated glycoluril, trihydroxymethylated glycoluril, tetrahydroxymethylated glycoluril, monomethoxymethylated glycoluril, dimethoxymethylated glycoluril, trimethoxymethylated glycoluril, tetramethoxymethylated glycoluril, monoethoxymethylated glycoluril, diethoxymethylated glycoluril, triethoxymethylated glycoluril, tetraethoxymethylated glycoluril, monopropoxymethylated glycoluril, dipropoxymethylated glycoluril, tripropoxymethylated glycoluril, tetrapropoxymethylated glycoluril, monobutoxymethylated glycoluril, dibutoxymethylated glycoluril, tributoxymethylated glycoluril, and tetrabutoxymethylated glycoluril,

urea-based crosslinking agents such as bismethoxymethylurea, bisethoxymethylurea, bispropoxymethylurea, and bisbutoxymethylurea,

ethyleneurea-based crosslinking agents such as monohydroxymethylated ethylene urea or dihydroxymethylated ethylene urea, monomethoxymethylated ethylene urea, dimethoxymethylated ethylene urea, monoethoxymethylated ethylene urea, diethoxymethylated ethylene urea, monopropoxymethylated ethylene urea, dipropoxymethylated ethylene urea, monobutoxymethylated ethylene urea, and dibutoxymethylated ethylene urea,

propylene urea-based crosslinking agents such as monohydroxymethylated propylene urea, dihydroxymethylated propylene urea, monomethoxymethylated propylene urea, dimethoxymethylated propylene urea, monoethoxymethylated propylene urea, diethoxymethylated propylene urea, monopropoxymethylated propylene urea, dipropoxymethylated propylene urea, monobutoxymethylated propylene urea, and dibutoxymethylated propylene urea, and

1,3-di(methoxymethyl)-4,5-dihydroxy-2-imidazolidinone, and 1,3-di(methoxymethyl)-4,5-dimethoxy-2-imidazolidinone.

Specific examples of the benzoguanamine-based crosslinking agent include monohydroxymethylated benzoguanamine, dihydroxymethylated benzoguanamine, trihydroxymethylated benzoguanamine, tetrahydroxymethylated

benzoguanamine, monomethoxymethylated benzoguanamine, dimethoxymethylated benzoguanamine, trimethoxymethylated benzoguanamine, tetramethoxymethylated benzoguanamine, monoethoxymethylated benzoguanamine, diethoxymethylated benzoguanamine, triethoxymethylated benzoguanamine, tetraethoxymethylated benzoguanamine, monopropoxymethylated benzoguanamine, dipropoxymethylated benzoguanamine, tripropoxymethylated benzoguanamine, tetrapropoxymethylated benzoguanamine, monobutoxymethylated benzoguanamine, dibutoxymethylated benzoguanamine, tributoxymethylated benzoguanamine, and tetrabutoxymethylated benzoguanamine.

In addition, as the compound having at least one group selected from the group consisting of a methylol group and an alkoxymethyl group, a compound in which at least one group selected from the group consisting of a methylol group and an alkoxymethyl group is directly bonded to an aromatic ring (preferably a benzene ring) can also be suitably used.

Specific examples of such compounds include benzenedimethanol, bis(hydroxymethyl)cresol, bis(hydroxymethyl)dimethoxybenzene, bis(hydroxymethyl)diphenyl ether, bis(hydroxymethyl)benzophenone, hydroxymethylphenyl hydroxymethylbenzoate, bis(hydroxymethyl)biphenyl, dimethylbis(hydroxymethyl)biphenyl, bis(methoxymethyl)benzene, bis(methoxymethyl)cresol, bis(methoxymethyl)dimethoxybenzene, bis(methoxymethyl)diphenyl ether, bis(methoxymethyl)benzophenone, methoxymethylphenyl methoxymethylbenzoate, bis(methoxymethyl)biphenyl, dimethylbis(methoxymethyl)biphenyl, 4,4',4"-ethylidenetris[2,6-bis(methoxymethyl)phenol], 5,5'-[2,2,2-trifluoro-1-(trifluoromethyl)ethylidene]bis[2-hydroxy-1,3-benzenedimethanol], and 3,3',5,5'-tetrakis(methoxymethyl)-1,1'-biphenyl-4,4'-diol.

As the other crosslinking agent, a commercially available product may be used, and examples of the suitable commercially available product include 46DMOC and 46DMOEP (all of which are manufactured by ASAHI YUKIZAI Corporation), DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DMLBisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (all of which are manufactured by Honshu Chemical Industry Co., Ltd.), and NIKALAC (registered trade name, the same applies hereinafter) MX-290, NIKALAC MX-280, NIKALAC MX-270, NIKALAC MX-279, NIKALAC MW-100LM, and NIKALAC MX-750LM (all of which are manufactured by Sanwa Chemical Co., Ltd.).

In addition, the resin composition according to the embodiment of the present invention preferably contains, as the other crosslinking agent, at least one compound selected from the group consisting of an epoxy compound, an oxetane compound, and a benzoxazine compound.

- Epoxy compound (compound having epoxy group) -

The epoxy compound is preferably a compound having two or more epoxy groups in one molecule. Since the epoxy group undergoes a crosslinking reaction at 200°C or lower and a dehydration reaction derived from crosslinking does not occur, film shrinkage hardly occurs. Therefore, containing an epoxy compound is effective for the low-temperature curing of the resin composition according to the embodiment of the present invention and the suppression of warping.

The epoxy compound preferably contains a polyethylene oxide group. As a result, it is possible to further decrease the elastic modulus and suppress the warping. The polyethylene oxide group means a group in which the number of repeating units of ethylene oxide is 2 or higher, and the number of repeating units is preferably 2 to 15.

Examples of the epoxy compound include a bisphenol A type epoxy resin; a bisphenol F type epoxy resin; an alkylene glycol type epoxy resin or a polyhydric alcohol hydrocarbon type epoxy resin, such as propylene glycol diglycidyl ether, neopentyl glycol diglycidyl ether, ethylene glycol diglycidyl ether, butylene glycol diglycidyl ether, hexamethylene glycol diglycidyl ether, or trimethylolpropane triglycidyl ether; a polyalkylene glycol type epoxy resin such as polypropylene glycol diglycidyl ether; and an epoxy group-containing silicone such as polymethyl (glycidyloxypropyl)siloxane; however, the epoxy compound is not limited thereto. Specific examples thereof include EPICLON (registered trade name) 850-S, EPICLON (registered trade name) HP-4032, EPICLON (registered trade name) HP-7200, EPICLON (registered trade name) HP-820, EPICLON (registered trade name) HP-4700, EPICLON (registered trade name) HP-4770, EPICLON (registered trade name) $EX^{A}$-830LVP, EPICLON (registered trade name) $EX^{A}$-8183, EPICLON (registered trade name) $EX^{A}$-8169, EPICLON (registered trade name) N-660, EPICLON (registered trade name) N-665-EXP-S, EPICLON (registered trade name) N-740 (all of which are product names, manufactured by DIC Corporation); RIKARESIN (registered trade name) BEO-20E, RIKARESIN (registered trade name) BEO-60E, RIKARESIN (registered trade name) HBE-100, RIKARESIN (registered trade name) DME-100, and RIKARESIN (registered trade name) L-200 (product name, manufactured by New Japan Chemical Co., Ltd.); EP-4003S, EP-4000S, EP-4088S, EP-3950S (all of which are product names, manufactured by ADEKA Corporation); CELLOXIDE (registered trade name) 2021P, CELLOXIDE (registered trade name) 2081, CELLOXIDE (registered trade name) 2000, EHPE3150, EPOLEAD (registered trade name) GT401, EPOLEAD (registered trade name) PB4700, EPOLEAD (registered trade name) PB3600 (all of which are product names,

manufactured by Daicel Corporation); and NC-3000, NC-3000-L, NC-3000-H, NC-3000-FH-75M, NC-3100, CER-3000-L, NC-2000-L, XD-1000, NC-7000L, NC-7300L, EPPN-501H, EPPN-501HY, EPPN-502H, EOCN-1020, EOCN-102S, EOCN-103S, EOCN-104S, CER-1020, EPPN-201, BREN-S, and BREN-10S (all of which are product names, manufactured by Nippon Kayaku Co., Ltd.). In addition, the following compounds are also suitably used.

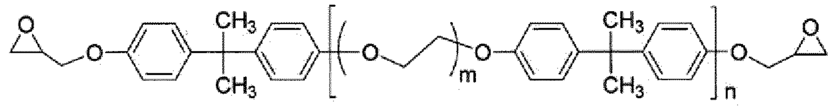

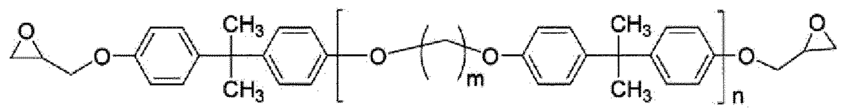

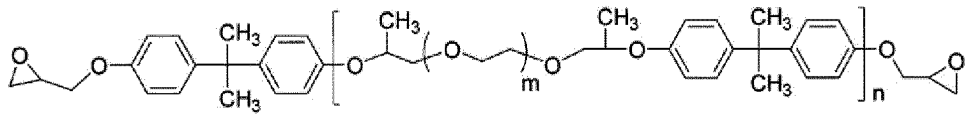

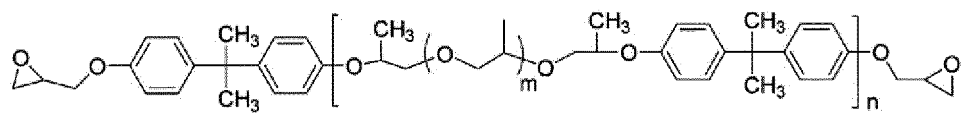

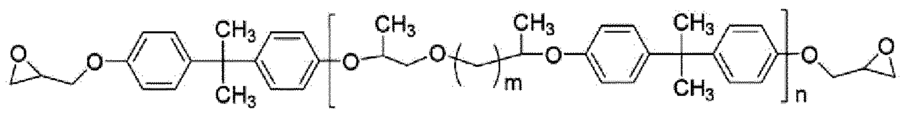

In the formulae, n is an integer of 1 to 5, and m is an integer of 1 to 20.

Among the above structures, n is preferably 1 to 2, and m is preferably 3 to 7 from the viewpoint of achieving both heat resistance and improvement in elongation.

- Oxetane compound (compound having oxetanyl group) -

Examples of the oxetane compound include a compound having two or more oxetane rings in one molecule, 3-ethyl-3-hydroxymethyloxetane, 1,4-bis{[(3-ethyl-3-oxetanyl)methoxy]methyl}benzene, 3-ethyl-3-(2-ethylhexylmethyl) oxetane, and 1,4-benzenedicarboxylic acid-bis[(3-ethyl-3-oxetanyl)methyl]ester. As specific examples thereof, ARON OXETANE series (for example, OXT-121 and OXT-221) manufactured by Toagosei Co., Ltd., can be suitably used, and these can be used alone or two or more thereof may be mixedly used.

- Benzoxazine compound (compound having benzoxazolyl group) -

Due to a crosslinking reaction derived from a ring-opening addition reaction, the benzoxazine compound does not result in degassing during curing and results in decreased thermal contraction, and thus the occurrence of warping is suppressed, which is preferable.

Preferred examples of the benzoxazine compound include P-d type benzoxazine, F-a type benzoxazine (product names, all of which are manufactured by Shikoku Chemicals Corporation), a benzoxazine adduct of polyhydroxystyrene resin, and a phenol novolac type dihydrobenzoxazine compound. These may be used alone, or two or more thereof may be mixed and used.

The content of the other crosslinking agent is preferably 0.1% to 30% by mass, more preferably 0.1% to 20% by mass, still more preferably 0.5% to 15% by mass, and particularly preferably 1.0% to 10% by mass, with respect to the total solid content of the resin composition according to the embodiment of the present invention. One kind of the other crosslinking agent may be contained, or two or more kinds thereof may be contained. In a case where two or more kinds of the other crosslinking agents are contained, the total thereof is preferably within the above-described range.

[Polymerization initiator]

The resin composition according to the embodiment of the present invention preferably contains a polymerization initiator that is capable of initiating polymerization by light and/or heat. In particular, it is preferable to contains a photopolymerization initiator.

The photopolymerization initiator is preferably a photoradical polymerization initiator. The photoradical polymerization initiator is not particularly limited and can be appropriately selected from publicly known photoradical polymerization initiators. For example, a photoradical polymerization initiator having photosensitivity to rays ranging from an ultraviolet ray range to a visible light range is preferable. In addition, the photoradical polymerization initiator may be an activator that produces an active radical by some kind of action with a photo-excited sensitizing agent.

The photoradical polymerization initiator preferably contains at least one compound having a molar absorption coefficient of at least about 50 $L \cdot mol^{-1} \cdot cm^{-1}$ within a range of a wavelength of about 240 to 800 nm (preferably 330 to 500 nm). The molar absorption coefficient of a compound can be measured using a well-publicly known method. For example, it is preferable to carry out a measurement at a concentration of 0.01 g/L using an ethyl acetate solvent with an ultraviolet-visible spectrophotometer (Cary-5 spectrophotometer manufactured by Varian Medical Systems, Inc.).

As a photoradical polymerization initiator, well-publicly known compounds can be optionally used. Examples thereof include a halogenated hydrocarbon derivative (for example, a compound having a triazine skeleton, a compound having an oxadiazole skeleton, or a compound having a trihalomethyl group), an acylphosphine compound such as an acylphosphine oxide, hexaarylbiimidazole, an oxime compound such as an oxime derivative, an organic peroxide, a thio compound, a ketone compound, an aromatic onium salt, a keto oxime ether, an $\alpha$-amino ketone compound such as aminoacetophenone, an $\alpha$-hydroxy ketone compound such as hydroxyacetophenone, an azo-based compound, an azide compound, a metallocene compound, an organic boron compound, and an iron arene complex. With regard to details thereof, reference can be made to the description of paragraphs 0165 to 0182 of JP2016-027357A and paragraphs 0138 to 0151 ofWO2015/199219A, the contents of which are incorporated in the present specification. In addition, examples thereof include the compounds described in paragraphs 0065 to 0111 of JP2014-130173A and JP6301489B, the peroxide-based photopolymerization initiator described in MATERIAL STAGE 37 to 60 p, vol. 19, No. 3, 2019, the photopolymerization initiator described in WO2018/221177A, the photopolymerization initiator described in WO2018/110179A, the photopolymerization initiator described in JP2019-043864A, the photopolymerization initiator described in JP2019-044030A, and the peroxide-based initiator described in JP2019-167313A, the contents of which are also incorporated in the present specification.

Examples of the ketone compound include compounds described in paragraph 0087 of JP2015-087611A, the content of which is incorporated in the present specification. As a commercially available product thereof, KAYACURE DETX-S (manufactured by Nippon Kayaku Co., Ltd.) is also suitably used.

In one embodiment of the present invention, a hydroxyacetophenone compound, an aminoacetophenone compound, and an acylphosphine compound can be suitably used as the photoradical polymerization initiator. More specifically, for example, the aminoacetophenone-based initiator described in JP1998-291969A (JP-H10-291969A) and the acylphosphine oxide-based initiator described in JP4225898B can be used, the contents of which are incorporated in the present specification.

As the $\alpha$-hydroxy ketone-based initiator, Omnirad 184, Omnirad 1173, Omnirad 2959, Omnirad 127 (all of which manufactured by IGM Resins B.V), IRGACURE 184 (IRGACURE is a registered trade name), DAROCUR 1173, IRGACURE 500, IRGACURE-2959, and IRGACURE 127 (product names: all of which manufactured by BASF SE) can be used.

As the $\alpha$-amino ketone-based initiator, Omnirad 907, Omnirad 369, Omnirad 369E, Omnirad 379EG (all of which are manufactured by IGM Resins B.V), IRGACURE 907, IRGACURE 369, and IRGACURE 379 (product names: all of which are manufactured by BASF SE) can be used.

As the aminoacetophenone-based initiator, the acylphosphine oxide-based initiator, and the metallocene compound, it is also possible to suitably use, for example, the compounds described in paragraphs 0161 to 0163 of WO2021/112189A. The content thereof is incorporated in the present specification.

Examples of the more preferred photoradical polymerization initiator include an oxime compound. In a case where an oxime compound is used, exposure latitude can be more effectively improved. The oxime compound is particularly preferable since the oxime compound has a wide exposure latitude (a wide exposure margin) and also works as a photocuring accelerator.

Specific examples of the oxime compound include the compounds described in JP2001-233842A, the compounds described in JP2000-080068A, the compounds described in JP2006-342166A, the compounds described in J. C. S. Perkin II (1979, pp. 1653-1660), the compounds described in J. C. S. Perkin II (1979, pp. 156-162), the compounds described in Journal of Photopolymer Science and Technology (1995, pp. 202-232), the compounds described in JP2000-066385A, the compounds described in JP2004-534797A, the compounds described in JP2017-019766A, the compounds described in JP6065596B, the compounds described in WO2015/152153A, the compounds described in

WO2017/051680A, the compounds described in JP2017-198865A, the compounds described in paragraph Nos. 0025 to 0038 of WO2017/164127A, and the compounds described in WO2013/167515A, the content of which is incorporated in the present specification.

Examples of the preferred oxime compound include compounds having the following structures, 3-(benzoyloxy(imino))butan-2-one, 3-(acetoxy(imino))butan-2-one, 3-(propionyloxy(imino))butan-2-one, 2-(acetoxy(imino))pentan-3-one, 2-(acetoxy(imino))-1-phenylpropan-1 -one, 2-(benzoyloxy(imino))-1 -phenylpropan-1 -one, 3-((4-toluenesulfonyloxy)imino)butan-2-one, and 2-(ethoxycarbonyloxy(imino))-1-phenylpropan-1-one. In the resin composition, it is particularly preferable to use an oxime compound (an oxime-based photoradical polymerization initiator) as the photoradical polymerization initiator. The oxime-based photoradical polymerization initiator has a linking group of >C=N-O-C(=O)-in the molecule.

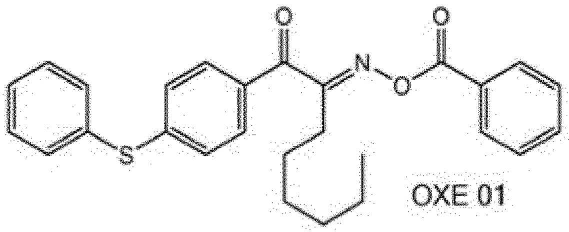
OXE 01

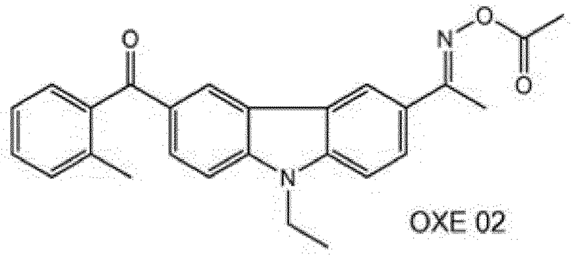
OXE 02

As commercially available products, IRGACURE OXE 01, IRGACURE OXE 02, IRGACURE OXE 03, IRGACURE OXE 04 (all of which are manufactured by BASF SE), ADEKA OPTOMERN-1919 (manufactured by ADEKA Corporation, the photoradical polymerization initiator 2 described in JP2012-014052A) are also suitably used. In addition, TR-PBG-304 and TR-PBG-305 (manufactured by Changzhou Tronly New Electronic Materials Co., Ltd.), ADEKA ARKLS NCI-730, NCI-831, and ADEKAARKLS NCI-930 (manufactured by ADEKA Corporation) can also be used. In addition, DFI-091 (manufactured by DAITO CHEMIX Co., Ltd.) and SpeedCure PDO (manufactured by SARTOMER ARKEMA) can be used. In addition, oxime compounds having the following structures can also be used.

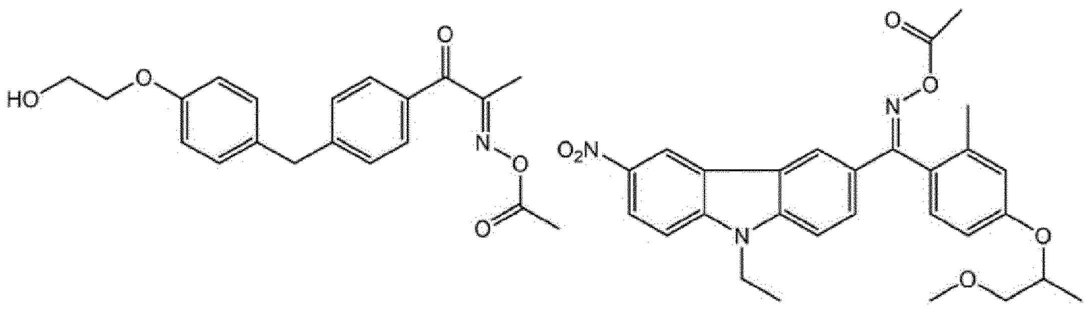

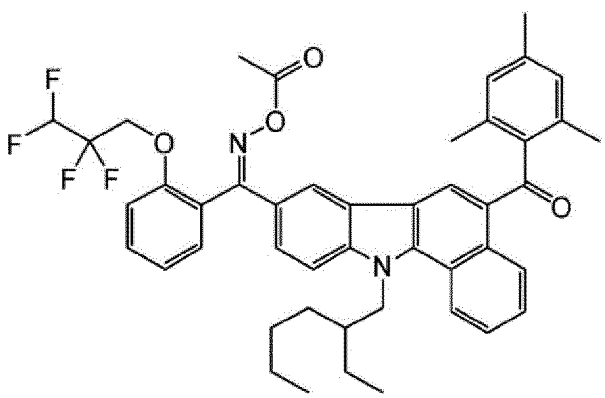

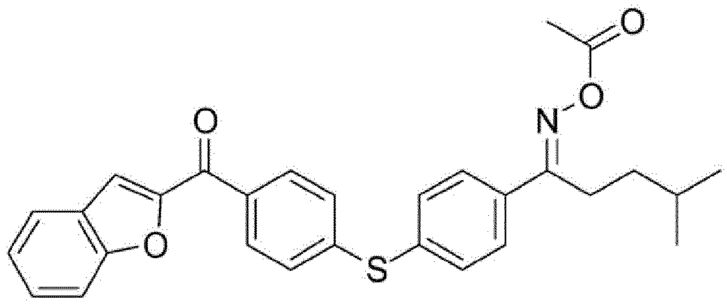

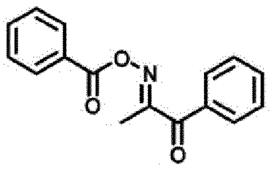

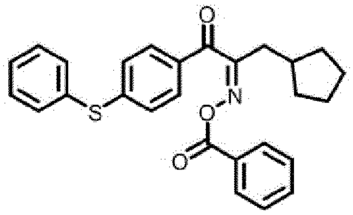

As the photoradical polymerization initiator, it is also possible to use, for example, the oxime compounds having a fluorene ring, which are described in paragraphs 0169 to 0171 of WO2021/112189A, an oxime compound having a skeleton in which at least one benzene ring of a carbazole ring is a naphthalene ring, or an oxime compound having a fluorine atom. The contents thereof are incorporated in the present specification.

In addition, as the photopolymerization initiator, it is also possible to use the oxime compounds having a nitro group, which are described in paragraphs 0208 to 0210 of WO2021/020359A, an oxime compound having a benzofuran skeleton, or an oxime compound in which a substituent having a hydroxy group is bonded to a carbazole skeleton. The contents thereof are incorporated in the present specification.

As the photopolymerization initiator, an oxime compound having an aromatic ring group $Ar^{OX1}$ in which an electron withdrawing group is introduced into an aromatic ring (hereinafter, also referred to as an oxime compound OX) can also be used. Examples of the electron withdrawing group contained in the aromatic ring group $Ar^{OX1}$ include an acyl group, a nitro group, a trifluoromethyl group, an alkylsulfinyl group, an arylsulfinyl group, an alkylsulfonyl group, an arylsulfonyl group, and a cyano group. Here, an acyl group or a nitro group is preferable, and due to the reason that a film having excellent light resistance is easily formed, an acyl group is more preferable, and a benzoyl group is still more preferable. The benzoyl group may have a substituent. The substituent is preferably a halogen atom, a cyano group, a nitro group, a hydroxy group, an alkyl group, an alkoxy group, an aryl group, an aryloxy group, a heterocyclic group, a heterocyclic oxy group, an alkenyl group, an alkylsulfanyl group, an arylsulfanyl group, an acyl group, or an amino group, more preferably an alkyl group, an alkoxy group, an aryl group, an aryloxy group, a heterocyclic oxy group, an alkylsulfanyl group, an arylsulfanyl group, or an amino group, and still more preferably an alkoxy group, an alkylsulfanyl group, or an amino group.

The oxime compound OX is preferably at least one selected from a compound represented by Formula ($OX^1$) or a compound represented by Formula ($OX^2$), and more preferably a compound represented by Formula ($OX^2$).

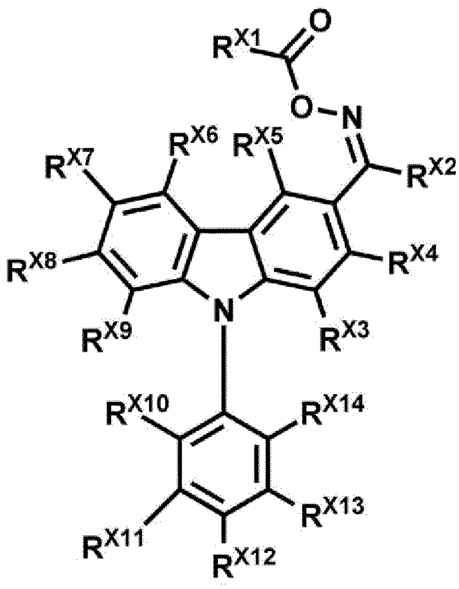

(OX1)

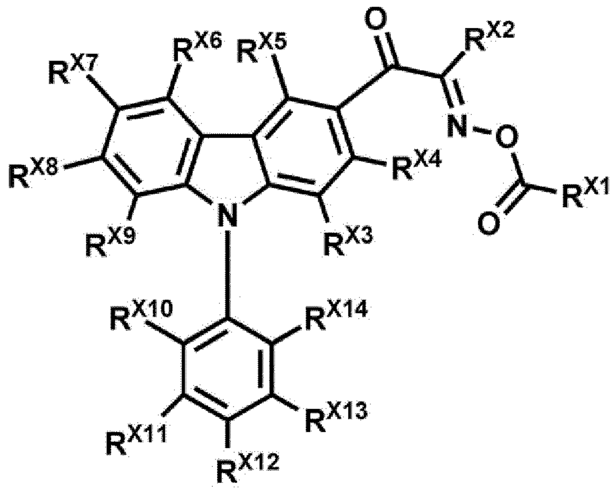

(OX2)

In the formulae, $R^{X1}$ represents an alkyl group, an alkenyl group, an alkoxy group, an aryl group, an aryloxy group, a heterocyclic group, a heterocyclic oxy group, an alkylsulfanyl group, an arylsulfanyl group, an alkylsulfinyl group, an arylsulfinyl group, an alkylsulfonyl group, an arylsulfonyl group, an acyl group, an acyloxy group, an amino group, a phosphinoyl group, a carbamoyl group, or a sulfamoyl group,

$R^{X2}$ represents an alkyl group, an alkenyl group, an alkoxy group, an aryl group, an aryloxy group, a heterocyclic group, or a heterocyclic oxy group, an alkylsulfanyl group, an arylsulfanyl group, an alkylsulfinyl group, an arylsulfinyl group, an alkylsulfonyl group, an arylsulfonyl group, an acyloxy group, or an amino group, and $R^{X3}$ to $R^{X14}$ each independently represent a hydrogen atom or a substituent.

However, at least one of $R^{X10}$, ..., or $R^{X14}$ is an electron withdrawing group.

In the formulae, it is preferable that $R^{X12}$ is an electron withdrawing group and $R^{X10}$, $R^{X11}$, $R^{X13}$, and $R^{X14}$ are a hydrogen atom.

Specific examples of the oxime compound OX include the compounds described in paragraph Nos. 0083 to 0105 of JP4600600B, the content of which is incorporated in the present specification.

Examples of the most preferred oxime compound include the oxime compound having a specific substituent described in JP2007-269779A and the oxime compound having a thioaryl group described in JP2009-191061A, the contents of which are incorporated in the present specification.

From the viewpoint of exposure sensitivity, the photoradical polymerization initiator is preferably a compound selected from the group consisting of a trihalomethyltriazine compound, a benzyl dimethyl ketal compound, an $\alpha$-hydroxy ketone compound, an $\alpha$-amino ketone compound, an acylphosphine compound, a phosphine oxide compound, a metallocene compound, an oxime compound, a triaryl imidazole dimer, an onium salt compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.

The photoradical polymerization initiator is more preferably a trihalomethyltriazine compound, an $\alpha$-amino ketone compound, an acylphosphine compound, a phosphine oxide compound, a metallocene compound, an oxime compound, a triaryl imidazole dimer, an onium salt compound, a benzophenone compound, or an acetophenone compound, still more preferably at least one compound selected from the group consisting of a trihalomethyltriazine compound, an $\alpha$-amino ketone compound, a metallocene compound, an oxime compound, a triaryl imidazole dimer, and a benzophenone compound. A metallocene compound or an oxime compound is even still more preferably used.

In addition, as the photoradical polymerization initiator, it is also possible to use the compounds described in paragraphs 0175 to 0179 of WO2021/020359A. The content thereof is incorporated in the present specification.

In addition, as the photoradical polymerization initiator, the compounds described in paragraphs 0048 to 0055 of WO2015/125469A can also be used, the content of which is incorporated in the present specification.

As the photoradical polymerization initiator, a photoradical polymerization initiator which is difunctional or trifunctional or higher functional may be used. In a case where such a photoradical polymerization initiator is used,

two or more radicals are generated from one molecule of the photoradical polymerization initiator, and thus good sensitivity is obtained. Further, in a case where a compound having an asymmetric structure is used, the crystallinity is reduced, the solubility in a solvent or the like is improved, and the compound is hardly precipitated over time, and the temporal stability of the resin composition can be improved. Specific examples of the photoradical polymerization initiator which is difunctional or trifunctional or higher functional include dimers of the oxime compounds described in JP2010-527339A, JP2011-524436A, WO2015/004565A, paragraph Nos. 0407 to 0412 of JP2016-532675A, and paragraph Nos. 0039 to 0055 of WO2017/033680A, the compound (E) and compound (G) described in JP2013-522445A, Cmpd 1 to 7 described in WO2016/034963A, the oxime ester photoinitiators described in paragraph No. 0007 of JP2017-523465A, the photoinitiators described in paragraph Nos. 0020 to 0033 of JP2017-167399A, the photopolymerization initiator (A) described in paragraph Nos. 0017 to 0026 of JP2017-151342A, and the oxime ester photoinitiator described in JP6469669B, the contents of which are incorporated in the present specification.

In a case where a photopolymerization initiator is contained, the content thereof is preferably 0.1% to 30% by mass, more preferably 0.1% to 20% by mass, still more preferably 0.5% to 15% by mass, and even still more preferably 1.0% to 10% by mass, with respect to the total solid content of the resin composition according to the embodiment of the present invention. Only one kind of photopolymerization initiator may be contained, or two or more kinds thereof may be contained. In a case where two or more kinds of photopolymerization initiators are contained, the total amount thereof is preferably within the above-described range.

It is noted that since the photopolymerization initiator may also function as a thermal polymerization initiator, crosslinking with the photopolymerization initiator may be further allowed to proceed by heating an oven, a hot plate, or the like.

[Sensitizing agent]

The resin composition may contain a sensitizing agent. The sensitizing agent absorbs a specific radioactive ray to be in an electronically excited state. The sensitizing agent in the electronically excited state is brought into contact with a thermal radical polymerization initiator, a photoradical polymerization initiator, or the like, to cause actions such as electron migration, energy transfer, and heat generation. As a result, the thermal radical polymerization initiator the photoradical polymerization initiator undergoes a chemical change and decomposes to generate a radical, an acid, or a base.

In addition, as a usable sensitizing agent, a benzophenone-based, a Michler's ketone-based, a coumarin-based, a pyrazole azo-based, an anilino azo-based, a triphenylmethane-based, an anthraquinone-based, an anthracene-based, an anthrapylidene-based, a benzylidene-based, an oxonol-based, a pyrazolotriazole azo-based, a pyridone azo-based, a cyanine-based, a phenothiazine-based, a pyrrolopyrazole azomethine-based, a xanthene-based, a phthalocyanine-based, a benzopyran-based, and an indigo-based compound can be used.

Examples of the sensitizing agent include, Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylidene indanone, p-dimethylamino benzylidene indanone, 2-(p-dimethylaminophenylbiphenylene)-benzothiazole, 2-(p-dimethylaminophenylvinylene)benzothiazole, 2-(p-dimethylaminophenylvinylene)isonaphtothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin (ethyl 7-(diethylamino)coumarin-3-carboxylate), N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzothiazole, 2-(p-dimethylaminostyryl)naphtho (1,2-d)thiazole, 2-(p-dimethylaminobenzoyl)styrene, diphenylacetamide, benzanilide, N-methylacetanilide, and 3',4'-dimethylacetanilide.

In addition, other sensitizing dyes may be used.

For details of the sensitizing dye, reference can be made to the description in paragraphs 0161 to 0163 of JP2016-027357A, the content of which is incorporated in the present specification.

In a case where the resin composition contains a sensitizing agent, the content of the sensitizing agent is preferably 0.01% to 20% by mass, more preferably 0.1% to 15% by mass, and still more preferably 0.5% to 10% by mass, with respect to the total solid content of the resin composition. One kind of sensitizing agent may be used alone, or two or more kinds thereof may be used in combination.

[Chain transfer agent]

The resin composition according to the embodiment of the present invention may contain a chain transfer agent. The chain transfer agent is defined, for example, in Polymer Dictionary, 3rd Edition, pp. 683 to 684 (edited by The Society of

Polymer Science, 2005). As the chain transfer agent, for example, the following compound is used; a group of compounds having -S-S-, $-SO_2-S-$, -N-O-, SH, PH, SiH, or GeH in the molecule, or a dithiobenzoate compound, a trithiocarbonate compound, dithiocarbamate, or a xanthate compound, which has a thiocarbonylthio group that is used for the reversible addition fragmentation chain transfer (RAFT) polymerization. These can donate hydrogen to a low active radical to generate a radical or can be oxidized and then deprotonated to generate a radical. In particular, a thiol compound can be preferably used.

In addition, as the chain transfer agent, the compounds described in paragraphs 0152 and 0153 of WO2015/199219A can also be used, the content of which is incorporated in the present specification.

In a case where the resin composition according to the embodiment of the present invention has a chain transfer agent, the content of the chain transfer agent is preferably 0.01 to 20 parts by mass, more preferably 0.1 to 10 parts by mass, and still more preferably 0.5 to 5 parts by mass, with respect to 100 parts by mass of the total solid content of the resin composition according to the embodiment of the present invention. One kind of chain transfer agent may be used, or two or more kinds thereof may be used. In a case where two or more kinds of chain transfer agents are used, the total thereof is preferably within the above-described range.

<Base generator>

The resin composition according to the embodiment of the present invention may contain a base generator. Here, the base generator is a compound that is capable of generating a base under a physical or chemical action. Examples of the preferred base generator for the resin composition according to the embodiment of the present invention include a thermal-base generator and a photobase generator.

In particular, in a case where the resin composition contains a precursor of a cyclization resin, it is preferable that the resin composition contains a base generator. In a case where the resin composition contains a thermal-base generator, it is possible to, for example, accelerate the cyclization reaction of the precursor by heating, whereby the mechanical characteristics and chemical resistance of the cured substance are improved and for example, the performance as an interlayer insulating film for a re-distribution layer, included in a semiconductor package, is improved.

The base generator may be an ionic base generator a nonionic base generator. Examples of the base that is generated from the base generator include a secondary amine and a tertiary amine.

The base generator according to the embodiment of the present invention is not particularly limited, and a publicly known base generator can be used. It is possible to use a publically publicly known base generator, for example, a carbamoyloxime compound, a carbamoylhydroxylamine compound, a carbamic acid compound, a formamide compound, an acetamide compound, a carbamate compound, a benzylcarbamate compound, a nitrobenzylcarbamate compound, a sulfonamide compound, an imidazole derivative compound, an aminimide compound, a pyridine derivative compound, an α-aminoacetophenone derivative compound, a quaternary ammonium salt derivative compound, a pyridinium salt, an α-lactone ring derivative compound, an aminimide compound, a phthalimide derivative compound, or an acyloxyimino compound.

The nonionic base generator is, for example, preferably the compounds represented by Formula (B1) or Formula (B2), which are described in paragraphs 0275 to 0285 of WO2021/112189A, or the compounds represented by Formula (N1), which is described in paragraphs 0102 to 00162 of WO2020/066416A, and the base generators is preferably the thermal-base generators described in paragraphs 0013 to 0041 of WO2020/054226A.

The contents thereof are incorporated in the present specification.

In a case where the resin composition according to the embodiment of the present invention contains a base generator, the content of the base generator is preferably 0.1 to 50 parts by mass with respect to 100 parts by mass of the resin in the resin composition according to the embodiment of the present invention. The lower limit thereof is preferably 0.3 parts by mass or more and more preferably 0.5 parts by mass or more. The upper limit thereof is more preferably 30 parts by mass or less, still more preferably 20 parts by mass or less, and even still more preferably 10 parts by mass or less, and it may be 5 parts by mass or less or may be 4 parts by mass or less.

One kind or two or more kinds of base generators can be used. In a case where two or more kinds thereof are used, the total amount is preferably within the above-described range.

<Solvent>

The resin composition according to the embodiment of the present invention preferably contains a solvent.

As the solvent, any publicly known solvent can be used. The solvent is preferably an organic solvent. Examples of the organic solvent include compounds such as esters, ethers, ketones, cyclic hydrocarbons, sulfoxides, amides, ureas, and alcohols.

Suitable examples of the esters include ethyl acetate, n-butyl acetate, isobutyl acetate, hexyl acetate, amyl formate, isoamyl acetate, butyl propionate, isopropyl butyrate, ethyl butyrate, butyl butyrate, methyl lactate, ethyl lactate,

γ-butyrolactone, ε-caprolactone, δ-valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, ethyl 2-oxobutanoate, ethyl hexanoate, ethyl heptanoate, dimethyl malonate, and diethyl malonate.

Suitable examples of ethers include ethylene glycol dimethyl ether, diethylene glycol dimethyl ether, diethylene glycol diethyl ether, diethylene glycol ethyl methyl ether, diethylene glycol butyl methyl ether, triethylene glycol dimethyl ether, tetraethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol dimethyl ether, propylene glycol monomethyl ether acetate, propylene glycol monoethyl ether acetate, ethylene glycol monobutyl ether, ethylene glycol monobutyl ether acetate, diethylene glycol ethyl methyl ether, propylene glycol monopropyl ether acetate, and dipropylene glycol dimethyl ether.

Suitable examples of the ketones include methyl ethyl ketone, cyclohexanone, cyclopentanone, 2-heptanone, 3-heptanone, 3-methylcyclohexanone, levoglucosenone, and dihydrolevoglucosenone.

Suitable examples of the cyclic hydrocarbon include aromatic hydrocarbons such as toluene, xylene, and anisole, and cyclic terpenes such as limonene.

Suitable examples of the sulfoxides include dimethyl sulfoxide.

Suitable examples of the amide include N-methyl-2-pyrrolidone, N-ethyl-2-pyrrolidone, N-cyclohexyl-2-pyrrolidone, N,N-dimethylacetamide, N,N-dimethylformamide, N,N-dimethylisobutylamide, 3-methoxy-N,N-dimethylpropionamide, 3-butoxy-N,N-dimethylpropionamide, N-formylmorpholine, and N-acetylmorpholine.

Suitable examples of the urea include N,N,N',N'-tetramethylurea and 1,3-dimethyl-2-imidazolidinone.

Examples of the alcohols include methanol, ethanol, 1-propanol, 2-propanol, 1-butanol, 1-pentanol, 1-hexanol, benzyl alcohol, ethylene glycol monomethyl ether, 1-methoxy-2-propanol, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol, and diacetone alcohol.

From the viewpoint of improving the properties of a coated surface or the like, it is also preferable to mix two or more kinds of solvents.

In the present invention, the solvent is preferably one solvent selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, γ- valerolactone, 3-methoxy-N,N-dimethylpropionamide, toluene, dimethyl sulfoxide, ethyl carbitol acetate, butyl carbitol acetate, N-methyl-2-pyrrolidone, propylene glycol methyl ether, and propylene glycol methyl ether acetate, as well as levoglucosenone and dihydrolevoglucosenone, or a mixed solvent composed of two or more of these. A combined use of dimethyl sulfoxide and γ-butyrolactone, a combined use of dimethyl sulfoxide and γ-valerolactone, a combined use of 3-methoxy-N,N-dimethylpropionamide and γ-butyrolactone, a combined use of 3-methoxy-N,N-dimethylpropionamide, γ-butyrolactone, and dimethyl sulfoxide, or a combined use of N-methyl-2-pyrrolidone and ethyl lactate is particularly preferable. In addition, an aspect in which an amount of about 1% to 10% by mass of toluene with respect to the total mass of the solvent is further added to these combinedly used solvents is also one of the preferred aspects of the present invention.

In particular, from the viewpoint of the storage stability of the resin composition, an aspect in which γ-valerolactone is included as the solvent is also one of the preferred aspects of the present invention. In such an aspect, the content of γ-valerolactone with respect to the total mass of the solvent is preferably 50% by mass or more, more preferably 60% by mass or more, and still more preferably 70% by mass or more. In addition, the upper limit of the above-described content is not particularly limited, and it may be 100% by mass. The above-described content may be determined in consideration of the solubility or the like of the component contained in the resin composition, such as the specific resin.

In addition, in a case where dimethyl sulfoxide and γ-valerolactone are used in combination, with respect to the total mass of the solvent, it is preferable to contain 60% to 90% by mass of γ-valerolactone and 10% to 40% by mass of dimethyl sulfoxide, it is more preferable to contain 70% to 90% by mass of γ-valerolactone and 10% to 30% by mass of dimethyl sulfoxide, and it is still more preferable to contain 75% to 85% by mass of γ-valerolactone and 15% to 25% by mass

of dimethyl sulfoxide.

From the viewpoint of coatability, the content of the solvent is such that the concentration of the total solid contents of the resin composition according to the embodiment of the present invention is preferably 5% to 80% by mass, more preferably 5% to 75% by mass, still more preferably 10% to 70% by mass, and even still more preferably 20% to 70% by mass. The content of the solvent may be adjusted depending on the desired thickness of the coating film and the coating method.

The resin composition according to the embodiment of the present invention may contain only one kind of solvent or two or more kinds thereof. In a case where two or more kinds of solvents are contained, the total thereof is preferably within the above-described range.

<Metal adhesiveness improving agent>

The resin composition according to the embodiment of the present invention preferably contains a metal adhesiveness improving agent for improving adhesiveness to a metal material used for an electrode or a wire. Examples of the metal adhesiveness improving agent include a silane coupling agent having an alkoxysilyl group, an aluminum-based auxiliary adhesive agent, a titanium-based auxiliary adhesive agent, a compound having a sulfonamide structure and a compound having a thiourea structure, a phosphoric acid derivative compound, a β-ketoester compound, and an amino compound.

[Silane coupling agent]

Examples of the silane coupling agent include the compounds described in paragraph 0316 of WO2021/112189A and the compounds described in paragraphs 0067 to 0078 of JP2018-173573A, the contents of which are incorporated in the present specification. In addition, it is also preferable to use two or more kinds of different silane coupling agents as described in paragraphs 0050 to 0058 of JP2011-128358A. In addition, as the silane coupling agent, the following compounds are also preferably used. In the following formulae, Me represents a methyl group, and Et represents an ethyl group. In addition, examples of R shown below include a structure derived from a blocking agent in a blocked isocyanate group. The blocking agent may be selected depending on the desorption temperature; however, examples thereof include an alcohol compound, a phenol compound, a pyrazole compound, a triazole compound, a lactam compound, and an active methylene compound. It is preferably caprolactam or the like, for example, from the viewpoint of setting the desorption temperature to 160°C to 180°C. Examples of the commercially available product of such a compound include X-12-1293 (manufactured by Shin-Etsu Chemical Co., Ltd.).

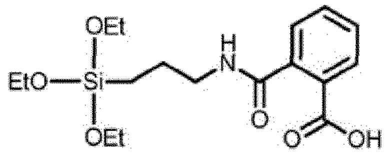
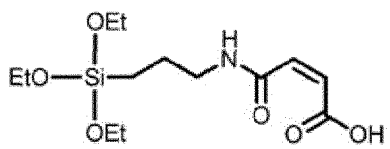

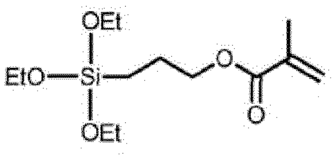
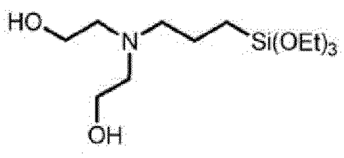
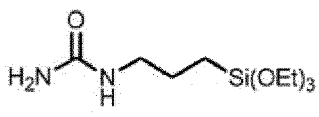

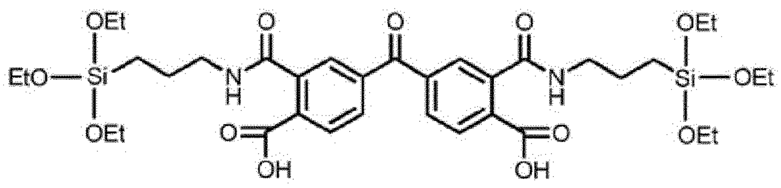

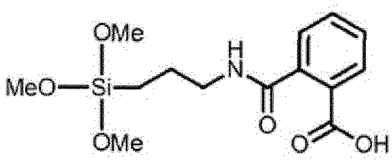
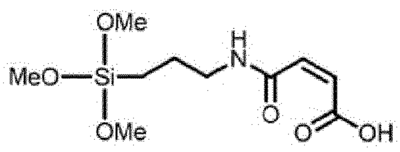

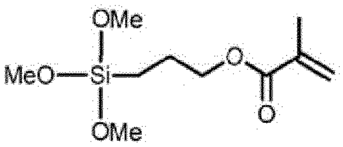
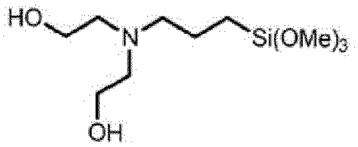
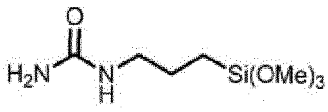

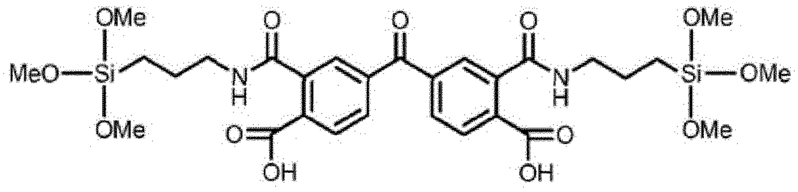

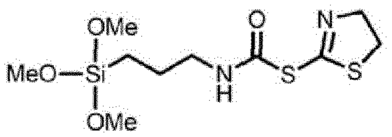
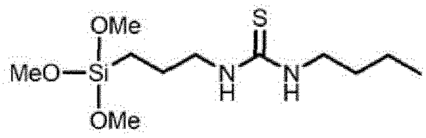

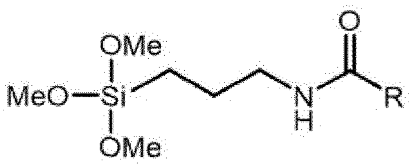
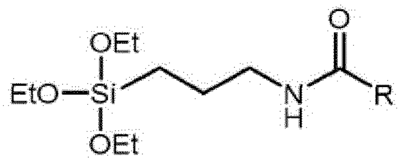

Examples of the other silane coupling agent include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, tris-(trimethoxysilylpropyl)isocyanurate, 3-ureidopropyltrialkoxysilane, 3-mercaptopropylmethyldimethoxysilane, 3-mercaptopropyltrimethoxysilane, 3-isocyanatepropyltriethoxysilane, and 3-trimethoxysilylpropylsuccinic acid anhydride. Such products can be used alone or in combination of two or more kinds thereof.

In addition, an oligomer type compound having a plurality of alkoxysilyl groups can also be used as the silane coupling agent.

Examples of such an oligomer type compound include a compound containing a repeating unit represented by Formula (S-1).

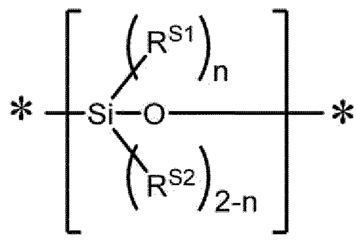

(S-1)

In Formula (S-1), $R^{S1}$ represents a monovalent organic group, $R^{S2}$ represents a hydrogen atom, a hydroxy group, or an alkoxy group, and n represents an integer of 0 to 2.

$R^{S1}$ preferably has a structure including a polymerizable group. Examples of the polymerizable group include a group having an ethylenically unsaturated bond, an epoxy group, an oxetanyl group, a benzoxazolyl group, a blocked isocyanate group, and an amino group. Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, and a (meth)acrylamide group, a (meth)acryloyloxy group, where a vinylphenyl group, a (meth)acrylamide group, or a (meth)acryloyloxy group is preferable, a vinylphenyl group or a (meth) acryloyloxy group is more preferable, and a (meth)acryloyloxy group is still more preferable.

$R^{S2}$ is preferably an alkoxy group, and more preferably a methoxy group or an ethoxy group.

n represents an integer of 0 to 2, and it is preferably 1.

Here, structures of a plurality of repeating units represented by Formula (S-1) may be the same, where the plurality of repeating units are contained in the oligomer type compound.

Here, among a plurality of repeating units represented by Formula (S-1), which are contained in the oligomer type compound, it is preferable that at least one repeating unit has n of 1 or 2, it is more preferable that at least two repeating units have n of 1 or 2, and it is still more preferable that at least two repeating units have n of 1.

As such an oligomer type compound, a commercially available product can be used, and examples thereof include KR-513 (manufactured by Shin-Etsu Chemical Co., Ltd.).

[Aluminum-based auxiliary adhesive agent]

Examples of the aluminum-based auxiliary adhesive agent include aluminum tris(ethyl acetoacetate), aluminum tris(acetyl acetate), and ethyl acetoacetate aluminum diisopropylate.

In addition, as another metal adhesiveness improving agent, the compounds described in paragraphs 0046 to 0049 of JP2014-186186A, and the sulfide-based compounds described in paragraphs 0032 to 0043 of JP2013-072935A can also be used, the contents of which are incorporated in the present specification.

The content of the metal adhesiveness improving agent is preferably 0.01 to 30 parts by mass, more preferably in a range of 0.1 to 10 parts by mass, and still more preferably in a range of 0.5 to 5 parts by mass, with respect to 100 parts by mass of the specific resin. In a case where the content is set to be equal to or higher than the above lower limit value, good adhesiveness between a pattern and a metal layer is exhibited, and in a case where the content is set to be equal to or lower than the above upper limit value, good heat resistance of the pattern and good mechanical characteristics are exhibited. One kind of metal adhesiveness improving agent may be used, or two or more kinds thereof may be used. In a case where two or more kinds thereof are used, the total content thereof is preferably within the above-described range.

<Migration suppressing agent>

The resin composition according to the embodiment of the present invention preferably further contains a migration suppressing agent. The incorporation of the migration suppressing agent makes it possible to effectively inhibit the movement of metal ions derived from a metal layer (a metal wire) into a film.

The migration suppressing agent is not particularly limited; however, examples thereof include a compound having a heterocyclic ring (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, or a triazine ring), a compound having thioureas and a sulfanyl group, a hindered phenol-based compound, a salicylic acid derivative-based compound, and a hydrazide derivative-based compound. In particular, it is possible to preferably use a triazole-based compound such as 1,2,4-triazole, benzotriazole, 3-amino-1,2,4-triazole, or 3,5-diamino-1,2,4-triazole, or a tetrazole-based compound such as 1H-tetrazole, 5-phenyltetrazole or 5-amino-1H-tetrazole.

Alternatively, an ion trapping agent that captures an anion such as a halogen ion can also be used.

Examples of another migration suppressing agent include the compounds described in paragraph 0304 of WO2021/112189A. The content thereof is incorporated in the present specification.

Specific examples of the migration suppressing agent include the following compounds.

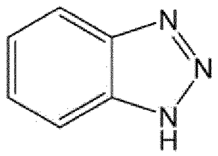 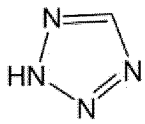 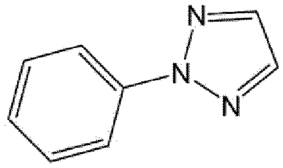 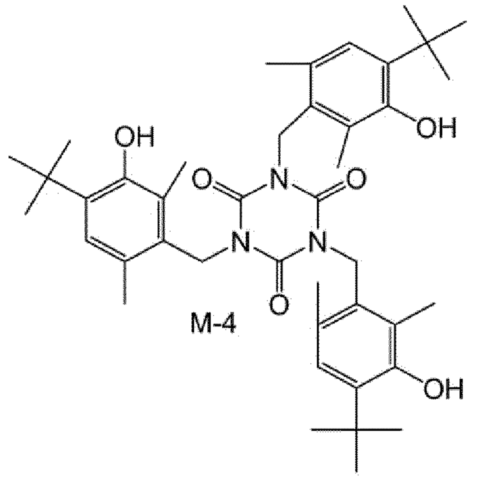

M-1 M-2 M-3 M-4

In a case where the resin composition according to the embodiment of the present invention contains the migration suppressing agent, the content of the migration suppressing agent is preferably 0.01% to 5.0% by mass, more preferably 0.05% to 2.0% by mass, and still more preferably 0.1% to 1.0% by mass, with respect to the total solid content of the resin composition according to the embodiment of the present invention.

One kind of migration suppressing agent may be used alone, or two or more kinds thereof may be used. In a case where two or more kinds of migration suppressing agents are used, the total thereof is preferably within the above-described range.

<Polymerization Inhibitor>

The resin composition according to the embodiment of the present invention preferably contains a polymerization inhibitor. Examples of the polymerization inhibitor include a phenol-based compound, a quinone-based compound, an amino-based compound, an N-oxyl-free radical-based compound, a nitro-based compound, a nitroso-based compound, a heteroaromatic ring-based compound, and a metal compound.

Specific examples of the polymerization inhibitor include the compounds described in paragraph 0310 of WO2021/112189A, p-hydroquinone, o-hydroquinone, a 4-hydroxy-2,2,6,6-tetramethylpiperidine-1-oxyl free radical, phenoxazine, and 1,4,4-trimethyl-2,3-diazabicyclo[3.2.2]nona-2-en-N,N-dioxide. The content thereof is incorporated in the present specification.

In a case where the resin composition according to the embodiment of the present invention has a polymerization inhibitor, the content of the polymerization inhibitor is preferably 0.01% to 20% by mass, more preferably 0.02% to 15% by mass, and still more preferably 0.05% to 10% by mass, with respect to the total solid content of the resin composition according to the embodiment of the present invention.

One kind of polymerization inhibitor may be used, or two or more kinds thereof may be used. In a case where two or more kinds of polymerization inhibitors are used, the total thereof is preferably within the above-described range.

<Other additives>

The resin composition according to the embodiment of the present invention can be blended with various additives as necessary, for example, a surfactant, a higher fatty acid derivative, a thermal polymerization initiator, inorganic particles, an ultraviolet absorbing agent, an organic titanium compounds, an antioxidant, an aggregation preventing agent, a phenol-based compound, another polymer compound, a plasticizer, and other auxiliary agents (for example, an antifoaming agent, and a flame retardant) within the scope in which the effect of the present invention is obtained. In addition, the resin composition according to the embodiment of the present invention may further contain another component such as a urea compound. By appropriately containing these components, properties such as film properties can be adjusted. The details of the components can be found in, for example, paragraphs 0183 and later of JP2012-003225A (corresponding to paragraph 0237 of US2013/0034812A) and paragraphs 0101 to 0104 and 0107 to 0109 of JP2008-250074A, the contents of which are incorporated in the present specification. In a case where these additives are blended, the total blending amount thereof is preferably 3% by mass or less of the solid content of the resin composition according to the embodiment of the present invention.

[Surfactant]

As the surfactant, various surfactants such as a fluorine-based surfactant, a silicone-based surfactant, and a hydrocarbon-based surfactant can be used. The surfactant may be a nonionic surfactant, a cationic surfactant, or an anionic surfactant.

In a case where a surfactant is contained in the photosensitive resin composition according to the embodiment of the present invention, the liquid characteristics (particularly, the fluidity) in a case of being prepared as a coating liquid are further improved, and thus the uniformity of the coating thickness and the liquid saving property can be further improved. That is, in a case where a film is formed using a coating liquid to which a composition containing a surfactant is applied, the interfacial tension between a surface to be coated and a coating liquid is reduced, the wettability to the surface to be coated is improved, and thus the coatability to the surface to be coated is improved. Therefore, a film having a uniform thickness with reduced unevenness in thickness can be formed more suitably.

Examples of the fluorine-based fluorine-based surfactant include the compounds described in paragraph 0328 of WO2021/112189A. The content thereof is incorporated in the present specification.

As the fluorine-based surfactant, a fluorine-containing polymer compound containing a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used, and examples of the fluorine-based surfactant that is used in the present invention include the following compounds as well.

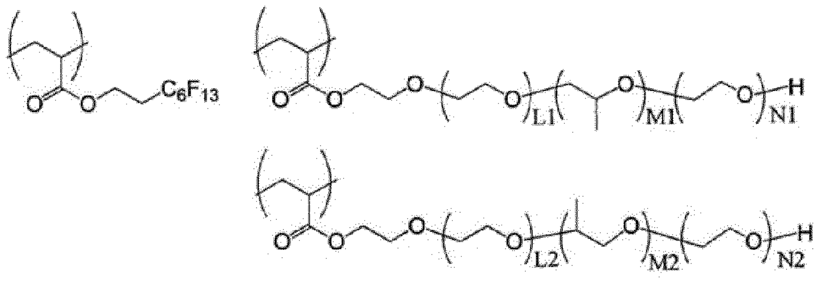

L1+N1+L2+N2=14
M1+M2=17

62% 38%

The weight-average molecular weight of the compounds is preferably 3,000 to 50,000 and more preferably 5,000 to 30,000.

Regarding the fluorine-based surfactant, a fluorine-containing polymer having an ethylenically unsaturated group in the side chain can also be used as the fluorine-based surfactant. Specific examples thereof include the compounds described in paragraphs 0050 to 0090 and 0289 to 0295 of JP2010-164965A, the content of which is incorporated in the present specification. Further, examples of the commercially available product thereof include MEGAFACE RS-101, RS-102, and RS-718K, all manufactured by DIC Corporation.

The fluorine content in the fluorine-based surfactant is suitably 3 to 40% by mass, more preferably 5 to 30% by mass, and particularly preferably 7 to 25% by mass. The fluorine-based surfactant in which the fluorine content is in the above-described range is effective from the viewpoints of the uniformity in the thickness of the coating film and liquid saving properties, and the solubility thereof in the composition is also excellent.

Examples of each of the silicone-based surfactant, the hydrocarbon-based surfactant, the nonionic surfactant, the cationic surfactant, and the anionic surfactant include the compounds described in paragraphs 0329 to 0334 of WO2021/112189A. The content thereof is incorporated in the present specification.

Only one kind of surfactant may be used, or two or more kinds thereof may be used in combination.

The content of the surfactant is preferably 0.001% to 2.0% by mass and more preferably 0.005% to 1.0% by mass with respect to the total solid content of the composition.

[Higher fatty acid derivative]

In the resin composition according to the embodiment of the present invention, in order to prevent polymerization inhibition due to oxygen, a higher fatty acid derivative such as behenic acid or behenic acid amide may be added and be caused to be present at a higher density on the surface of the resin composition according to the embodiment of the present invention in the process of drying after coating.

In addition, as the higher fatty acid derivative, the compounds described in paragraph 0155 of WO2015/199219A can also be used, the content of which is incorporated in the present specification.

In a case where the resin composition according to the embodiment of the present invention has a higher fatty acid derivative, the content of the higher fatty acid derivative is preferably 0.1% to 10% by mass with respect to the total solid content of the resin composition according to the embodiment of the present invention. One kind of higher fatty acid derivative may be used, or two or more kinds thereof may be used. In a case where two or more kinds of higher fatty acid derivatives are used, the total thereof is preferably within the above-described range.

[Thermal polymerization initiator]

The resin composition according to the embodiment of the present invention may contain a thermal polymerization initiator and particularly may contain a thermal radical polymerization initiator. The thermal radical polymerization initiator is a compound that generates a radical by heat energy and initiates or accelerates a polymerization reaction of a compound having polymerization properties. In a case where a thermal radical polymerization initiator is added, the polymerization reaction of the resin and the polymerizable compound can be allowed to proceed, and thus the solvent resistance can be further improved. In addition, there is a case where the above-described photopolymerization initiator also has a function of initiating polymerization by heat, and thus there is a case where it can be added as a thermal polymerization initiator.

Specific examples of thermal radical polymerization initiator include compounds described in paragraphs 0074 to 0118 of JP2008-063554A, the content of which is incorporated in the present specification.

In a case where thermal polymerization initiator is contained, the content thereof is preferably 0.1% to 30% by mass, with respect to the total solid content of the resin composition according to the embodiment of the present invention, more preferably 0.1% to 20% by mass, and still more preferably 0.5% to 15% by mass. Only one kind of thermal polymerization initiator may be contained, or two or more kinds thereof may be contained. In a case where two or more kinds of thermal polymerization initiators are contained, the total amount thereof is preferably within the above-described range.

[Inorganic particle]

The resin composition according to the embodiment of the present invention may contain inorganic particles. Specific examples of the inorganic particle include calcium carbonate, calcium phosphate, silica, kaolin, talc, titanium dioxide, alumina, barium sulfate, calcium fluoride, lithium fluoride, zeolite, molybdenum sulfide, and glass.

The average particle diameter of the inorganic particles is preferably 0.01 to 2.0 μm, more preferably 0.02 to 1.5 μm, still more preferably 0.03 to 1.0 μm, and particularly preferably 0.04 to 0.5 μm.

The average particle diameter of the inorganic particles is the primary particle diameter and the volume average particle diameter. The volume average particle diameter can be measured by a dynamic light scattering method with Nanotrac WAVE II EX-150 (manufactured by Nikkiso Co., Ltd.). In a case where the above measurement is difficult, the measurement can also be carried out by a centrifugal sedimentation light transmission method, an X-ray transmission method, or a laser diffraction/light scattering method.

[Ultraviolet absorbing agent]

The composition according to the embodiment of the present invention may contain an ultraviolet absorbing agent. As the ultraviolet absorbing agent, an ultraviolet absorbing agent such as a salicylate-based, a benzophenone-based, a benzotriazole-based, a substituted acrylonitrile-based, or a triazine-based ultraviolet absorbing agent can be used.

Specific examples of the ultraviolet absorbing agent include the compounds described in paragraphs 0341 and 0342 of WO2021/112189A. The content thereof is incorporated in the present specification.

In the present invention, the above-described various ultraviolet absorbing agents may be used alone, or two or more thereof may be used in combination.

The composition according to the embodiment of the present invention may contain or may not contain an ultraviolet absorbing agent. However, in a case of being contained, the content of the ultraviolet absorbing agent is preferably 0.001% by mass or more and 1% by mass or less, and more preferably 0.01% by mass or more and 0.1% by mass or less, with respect to the total solid content mass of the composition according to the embodiment of the present invention.

[Organic titanium compound]

The resin composition of the present embodiment may contain an organic titanium compound. In a case where the resin composition contains an organic titanium compound, it is possible to form a resin layer having excellent chemical

resistance even in a case where curing is carried out at a low temperature.

Examples of the usable organic titanium compound include those in which an organic group is bonded to a titanium atom through a covalent bond or an ionic bond.

Specific examples of the organic titanium compound are described in I) to VII) below.

I) Titanium chelate compounds: among them, a titanium chelate compound having two or more alkoxy groups is more preferable since the resin composition has good storage stability and a good curing pattern can be obtained. Specific examples thereof include titanium bis(triethanolamine)diisopropoxide, titanium di(n-butoxide) bis(2,4-pentanedionate), titanium diisopropoxide bis(2,4-pentanedionate), titanium diisopropoxide bis(tetramethylheptandionate), and titanium diisopropoxide bis(ethyl acetoacetate).

II) Tetraalkoxytitanium compounds: examples thereof include titanium tetra(n-butoxide), titanium tetraethoxide, titanium tetra(2-ethylhexoxide), titanium tetraisobutoxide, titanium tetraisopropoxide, titanium tetramethoxide, titanium tetramethoxypropoxide, titanium tetramethylphenoxide, titanium tetra(n-nonyloxide), titanium tetra(n-propoxide), titanium tetrastearyloxide, and titanium tetrakis[bis{2,2-(aryloxymethyl)butoxide}].

III) Titanocene compounds: examples thereof include pentamethylcyclopentadienyl titanium trimethoxide, bis(η5-2,4-cyclopentadien-1-yl)bis(2,6-difluorophenyl)titanium, and bis(η5-2,4-cyclopentadien-1-yl)bis(2,6-difluoro-3-(1H-pyrrol-1-yl)phenyl)titanium.

IV) Monoalkoxytitanium compounds: examples thereof include titanium tris(dioctyl phosphate)isopropoxide, and titanium tris(dodecylbenzene sulfonate)isopropoxide.

V) Titanium oxide compounds: examples thereof include titanium oxide bis(pentanedionate), titanium oxide bis(tetramethylheptandionate), and phthalocyanine titanium oxide.

VI) Titanium tetraacetylacetonate compounds: examples thereof include titanium tetraacetylacetonate.

VII) Titanate coupling agents: examples thereof include isopropyltridodecylbenzenesulfonyl titanate.

Among them, it is preferable that the organic titanium compound is at least one compound selected from the group consisting of the above-described I) titanium chelate compound, II) tetraalkoxytitanium compound, and III) titanocene compound, from the viewpoint that better chemical resistance is exhibited. In particular, titanium diisopropoxide bis(ethyl acetoacetate), titanium tetra(n-butoxide), or bis(η5-2,4-cyclopentadiene-1-yl) bis(2,6-difluoro-3-(1H-pyrrole-1-yl)phenyl)titanium is preferable.

In a case where an organic titanium compound is blended, the blending amount thereof is preferably 0.05 to 10 parts by mass and more preferably 0.1 to 2 parts by mass with respect to 100 parts by mass of the specific resin. In a case where the blending amount is 0.05 parts by mass or more, good heat resistance, good moisture resistance, and good chemical resistance are more effectively exhibited in the curing pattern to be obtained. On the other hand, in a case where it is 10 parts by mass or less, the storage stability of the composition is more excellent.

[Antioxidant]

The composition according to the embodiment of the present invention may contain an antioxidant. In a case where an antioxidant is contained as an additive, it is possible to improve the elongation characteristics of the film after curing and the adhesiveness to the metal material. Examples of the antioxidant include a phenol compound, a phosphorous acid ester compound, and a thioether compound. Specific examples of the antioxidant include the compounds described in paragraphs 0348 to 0357 of WO2021/112189A. The content thereof is incorporated in the present specification.

The adding amount of the antioxidant is preferably 0.1 to 10 parts by mass and more preferably 0.5 to 5 parts by mass with respect to the resin. In a case where the adding amount is set to 0.1 parts by mass or more, the effect of improving the elongation characteristics and the adhesiveness to the metal material can be easily obtained even in a high temperature and high humidity environment, and in a case where the adding amount is set to 10 parts by mass or less, the sensitivity of the resin composition is improved, for example, by the interaction with the photosensitizing agent. In the present invention, the antioxidant may be used singly or in a combination of two or more kinds thereof. In a case where two or more kinds thereof are used, the total amount thereof is preferably within the above-described range.

[Aggregation preventing agent]

The resin composition of the present embodiment may contain an aggregation preventing agent, as necessary. Examples of the aggregation preventing agent include sodium polyacrylate.

In the present invention, one kind of aggregation preventing agent may be used alone, or two or more thereof may be used in combination.

The composition according to the embodiment of the present invention may contain or may not contain an

aggregation preventing agent. However, in a case of being contained, the content of the aggregation preventing agent is preferably 0.01% by mass or more and 10% by mass or less, and more preferably 0.02% by mass or more and 5% by mass or less, with respect to the total solid content mass of the composition according to the embodiment of the present invention.

[Phenol-based compound]

The resin composition of the present embodiment may contain a phenol-based compound, as necessary. Examples of the phenol-based compound include Bis-Z, BisP-EZ, TekP-4HBPA, TrisP-HAP, TrisP-PA, BisOCHP-Z, BisP-MZ, BisP-PZ, BisP-IPZ, BisOCP-IPZ, BisP-CP, BisRS-2P, BisRS-3P, BisP-OCHP, Methylene tris-FR-CR, BisRS-26X (all, product names, manufactured by Honshu Chemical Industry Co., Ltd.), BIP-PC, BIR-PC, BIR-PTBP, and BIR-BIPC-F (all, product names, manufactured by ASAHI YUKIZAI Corporation).
In the present invention, one kind of phenol-based compound may be used alone, or two or more thereof may be used in combination.
The composition according to the embodiment of the present invention may contain or may not contain a phenol-based compound. However, in a case of being contained, the content of the phenol-based compound is preferably 0.01% by mass or more and 30% by mass or less, and more preferably 0.02% by mass or more and 20% by mass or less, with respect to the total solid content mass of the composition according to the embodiment of the present invention.

[Polymer compound A]

Examples of the other polymer compound include a siloxane resin, a (meth)acrylic polymer obtained by copolymerizing (meth)acrylic acid, a novolac resin, a resol resin, a polyhydroxystyrene resin, and a copolymer thereof. The other polymer compound may be a modified polymer into which a crosslinking group such as a methylol group, an alkoxymethyl group, or an epoxy group has been introduced.
In the present invention, one kind of the other polymer compound may be used alone, or two or more thereof may be used in combination.
The composition according to the embodiment of the present invention may contain or may not contain another polymer compound. However, in a case of being contained, the content of the other polymer compound is preferably 0.01% by mass or more and 30% by mass or less, and more preferably 0.02% by mass or more and 20% by mass or less, with respect to the total solid content mass of the composition according to the embodiment of the present invention.

<Characteristics of resin composition>

The viscosity of the resin composition according to the embodiment of the present invention can be adjusted by adjusting the concentration of solid contents of the resin composition. From the viewpoint of the coating film thickness, it is preferably 1,000 $mm^2/s$ to 12,000 $mm^2/s$, more preferably 2,000 $mm^2/s$ to 10,000 $mm^2/s$, and still more preferably 2,500 $mm^2/s$ to 8,000 $mm^2/s$. Within the above range, it is easy to obtain a coating film having high uniformity. In a case of being 1,000 $mm^2/s$ or more, it is easy to carry out coating at a film thickness to be required as, for example, an insulating film for re-distribution of a wiring line, and in a case of being 12,000 $mm^2/s$ or less, a coating film having an excellent coating surface shape is obtained.
The maximum value of the absorbance of the resin composition according to the embodiment of the present invention at a wavelength of 400 to 800 nm is preferably 0.8 Abs or less, more preferably 0.4 Abs or less, and particularly preferably 0.2 Abs or less. The lower limit of the above-described absorbance is not particularly limited and may be 0 Abs. However, the absorbance at the specific wavelength can be measured by dissolving 20 mg of the resin composition in 200 mL of dimethyl sulfoxide and using an ultraviolet-visible-infrared spectrophotometer (UH4150, manufactured by Hitachi High-Tech Science Corporation). Abs represents a value of $\log_{10}(1/T)$ in a case where light transmittance is denoted as T, and T is a ratio ($I/I_0$) of the intensity I of the transmitted light to the intensity $I_0$ of the incident light in a case where an optical path length is set to 1 cm.

<Restrictions on substances contained in resin composition>

The moisture content of the resin composition according to the embodiment of the present invention is preferably less than 2.0% by mass, more preferably less than 1.5% by mass, and still more preferably less than 1.0% by mass. In a case of being less than 2.0%, the storage stability of the resin composition is improved.
Examples of the method of maintaining the water content include adjusting the humidity under storage conditions and reducing the void volume of the storage container during storage.
From the viewpoint of insulating properties, the metal content of the resin composition according to the

embodiment of the present invention is preferably less than 5 parts per million (ppm) by mass, more preferably less than 1 ppm by mass, and still more preferably less than 0.5 ppm by mass. Examples of the metal include sodium, potassium, magnesium, calcium, iron, copper chromium, and nickel, however, a metal contained as a complex of an organic compound and a metal is excluded. In a case where a plurality of metals are contained, the total of these metals is preferably within the above-described range.

In addition, as a method of reducing metal impurities which are unintentionally contained in the resin composition according to the embodiment of the present invention, a method of selecting a raw material containing a low metal content as the raw material that constitutes the resin composition according to the embodiment of the present invention, a method of filtering a raw material constituting the resin composition according to the embodiment of the present invention, a method of distilling under the conditions in which the inside of the device is lined with polytetrafluoroethylene or the like to suppress the contamination as little as possible, and the like can be mentioned.

In the resin composition according to the embodiment of the present invention, in a case of considering the use application as a semiconductor material, the content of halogen atoms is preferably less than 500 ppm by mass, more preferably less than 300 ppm by mass, and still more preferably less than 200 ppm by mass, from the viewpoint of wire corrosiveness. Among these, in a case of being present in a halogen ion state, the content is preferably less than 5 ppm by mass, more preferably less than 1 ppm by mass, and still more preferably less than 0.5 ppm by mass. Examples of the halogen atom include a chlorine atom and a bromine atom. It is preferable that the total content of the chlorine atom and the bromine atom, or the total content of the chlorine ion and the bromine ion is within the above-described range.

Preferred examples of the method of adjusting the content of halogen atoms include ion exchange treatment.

A storage container publicly known in the related art can be used as a storage container for the resin composition according to the embodiment of the present invention. In addition, as the storage container, for the intended purpose of suppressing the incorporation of impurities into the raw materials and the resin composition according to the embodiment of the present invention, a multilayer bottle in which an inner wall of a container is composed of six kinds of six layers of resin, and a bottle with six kinds of resin being made as a seven-layer structure are preferably used. Examples of such a container include the container described in JP2015-123351A.

<Cured substance of resin composition>

In a case of curing the resin composition according to the embodiment of the present invention, it is possible to obtain a cured substance of this resin composition.

The cured substance according to the embodiment of the present invention is a cured substance formed by curing the resin composition according to the embodiment of the present invention.

The curing of the resin composition is preferably by heating, more preferably by heating at a heating temperature within a range of 120°C to 400°C, still more preferably by heating at a heating temperature within a range of 140°C to 380°C, and particularly preferably by heating at a heating temperature within a range of 170°C to 350°C. The form of the cured substance of the resin composition is not particularly limited and can be selected depending on the use application, where the form includes a film shape, a rod shape, a spherical shape, a pellet shape. In the present invention, the cured substance preferably has a film shape. In addition, the shape of this cured substance can also be selected depending on the use application by the pattern processing of the resin composition, where the use application includes formation of a protective film on a wall surface, formation of via holes for conduction, adjustment of impedance, electrostatic capacity, or internal stress, and impartment of heat radiation function. The film thickness of the cured substance (the film consisting of the cured substance) is preferably 0.5 μm or more and 150 μm or less.

The shrinkage ratio of the resin composition according to the embodiment of the present invention after curing is preferably 50% or less, more preferably 45% or less, and still more preferably 40% or less. Here, the shrinkage ratio refers to a percentage of a change in the volume of the resin composition before and after curing, and it can be calculated according to the following expression.

$$\text{Shrinkage ratio [\%]} = 100 - (\text{volume after curing}/\text{volume before curing}) \times 100$$

<Characteristics of cured substance of resin composition>

In a case where the polyimide or polyimide precursor described above is used as the resin, the imidization reaction rate (the imidization rate) of the cured substance of the resin composition according to the embodiment of the present invention is preferably 70% or more, more preferably 80% or more, and still more preferably 90% or more. In a case where the imidization reaction rate thereof is 70% or more, a cured substance having excellent mechanical characteristics may be obtained, and the upper limit value thereof is not particularly limited.

The breaking elongation of the cured substance of the resin composition according to the embodiment of the present invention of the

present invention is preferably 30% or more, more preferably 40% or more, still more preferably 50% or more, even still more preferably 60% or more, and most preferably 65% or more. The breaking elongation of the cured substance is not particularly limited since the larger the numerical value thereof is, the more excellent the breaking elongation is.

The glass transition temperature (Tg) of the cured substance of the resin composition according to the embodiment of the present invention is preferably 180°C or higher, more preferably 210°C or higher, and still more preferably 230°C or higher.

The maximum value of the absorbance of the cured substance according to the embodiment of the present invention at a wavelength of 400 to 800 nm is preferably 0.8 Abs or less, more preferably 0.4 Abs or less, and particularly preferably 0.2 Abs or less. The lower limit of the above-described absorbance is not particularly limited and may be 0 Abs. However, the absorbance at the specific wavelength can be determined by forming a film of the resin composition on a glass substrate so that the film thickness after curing is 10 μm, and then carrying out measurement using an ultraviolet-visible-infrared spectrophotometer (UH4150, manufactured by Hitachi High-Tech Science Corporation).

For example, for the measurement of the absorbance at the specific wavelength, the measurement can be carried out using a sample (film) formed on a glass substrate according to the following method. A spin coating method is applied onto a substrate of 10 cm square glass (manufactured by Corning Inc.) and drying is carried out at 100°C for 5 minutes to form a photosensitive film. Then, the entire surface exposure is carried out using a stepper (NSR1505 i6, manufactured by Nikon Corporation) at a wavelength of 365 nm and a light amount of 400 $mJ/cm^2$.

Next, the temperature is raised at a temperature rising rate of 10 °C/min in a nitrogen atmosphere, and after reaching 230°C, the temperature is maintained at 230°C for 180 minutes to form a film.

The content of the specific metal complex is preferably 0.05% to 20% by mass with respect to the total mass of the cured substance. The lower limit thereof is more preferably 0.10% by mass or more, still more preferably 0.2% by mass or more, particularly preferably 0.5% by mass or more, and most preferably 1% by mass or more. The upper limit thereof is more preferably 15% by mass or less, still more preferably 10% by mass or less, and particularly preferably 8% by mass or less.

It is noted that in a case where two or more kinds of specific metal complexes are contained, the total value of the contents thereof is preferably within the above-described range.

<Preparation of resin composition>

The resin composition according to the embodiment of the present invention can be prepared by mixing the above-described components. The mixing method is not particularly limited, and mixing can be carried out by methods publicly known in the related art.

For mixing, it is possible to employ mixing with a stirring blade, mixing with a ball mill, mixing by rotating the tank itself, or the like.

The temperature during the mixing is preferably 10°C to 30°C, and more preferably 15°C to 25°C.

In addition, for the intended purpose of removing foreign substances such as dust and fine particles in the resin composition according to the embodiment of the present invention, it is preferable to carry out filtration using a filter. Examples of the pore diameter of the filter include an aspect of 5 μm or less, and the pore diameter thereof is preferably 1 μm or less, more preferably 0.5 μm or less, and still more preferably 0.1 μm or less. The material of the filter is preferably polytetrafluoroethylene, polyethylene, or nylon. In a case where the material of the filter is polyethylene, it is more preferable to use high density polyethylene (HDPE). As the filter, a filter which has been washed with an organic solvent in advance may be used. In the filtration step using the filter, a plurality of kinds of filters may be connected in series or in parallel and used. In a case where a plurality of kinds of filters are used, filters having different pore diameters or different materials may be used in combination. Examples of the connection aspect include an aspect in which an HDPE filter having a pore diameter of 1 μm is connected in series as the first stage and an HDPE filter having a pore diameter of 0.2 μm is connected in series as the second stage. In addition, various materials may be filtered a plurality of times. In a case of being filtered a plurality of times, circulation filtration may be used. In addition, filtration may be carried out under pressure. In a case where filtration is carried out under pressure, an aspect in which the pressure to be applied is, for example, 0.01 MPa or more and 1.0 MPa or less is mentioned, and the pressure is preferably 0.03 MPa or more and 0.9 MPa or less, more preferably 0.05 MPa or more and 0.7 MPa or less, and still more preferably 0.05 MPa or more and 0.5 MPa or less.

In addition to filtration using a filter, impurity removal treatment using an adsorbing material may be carried out. The filtration using a filter and the impurity removal treatment using an adsorbing material may be combined. As the adsorbing material, a publicly known adsorbing material can be used. Examples thereof include an inorganic adsorbing material such as silica gel and zeolite and an organic adsorbing material such as activated carbon.

Furthermore, after filtration using a filter, a step of placing a bottle filled with the resin composition under reduced pressure to carry out degassing may be provided.

(Manufacturing method for cured substance)

The manufacturing method for a cured substance according to the embodiment of the present invention preferably includes a film forming step of applying a resin composition onto a base material to form a film.
In addition, the manufacturing method for a cured substance according to the embodiment of the present invention more preferably includes the above-described film forming step, an exposure step of selectively exposing the film formed by the film forming step, and a development step of developing the film exposed by the exposure step with a developer to form a pattern.
It is particularly preferable that the manufacturing method for a cured substance according to the embodiment of the present invention includes the film forming step, the exposure step, the development step, and at least one of a heating step of heating a pattern obtained by the development step or a post-development exposure step of exposing the pattern obtained by the development step.
In addition, it is also preferable that the manufacturing method according to the embodiment of the present invention includes the film forming step and a step of heating the film.
Hereinafter, details of each step will be described.

<Film forming step>

The resin composition according to the embodiment of the present invention can be applied onto a base material, thereby being used in a film forming step of forming a film.
The manufacturing method for a cured substance according to the embodiment of the present invention preferably includes a film forming step of applying a resin composition onto a base material to form a film.

[Base material]

The kind of base material can be appropriately determined depending on the use application, and examples thereof are a base material for semiconductor production, such as silicon, silicon nitride, polysilicon, silicon oxide, or amorphous silicon, quartz, glass, an optical film, a ceramic material, a vapor-deposited film, a magnetic film, a reflective film, a metal base material (for example, it may be any one of a base material formed from a metal or a base material having a metal layer formed by plating, vapor deposition, or the like) such as Ni, Cu, Cr, or Fe, paper, spin-on-glass (SOG), a thin film transistor (TFT) array base material, a mold base material, and an electrode plate of a plasma display panel (PDP), which are not particularly limited. In the present invention, in particular, a base material for semiconductor production is preferable, and a silicon base material, a Cu base material, or a mold base material is more preferable.
In addition, a layer such as an intimate attachment layer made of hexamethyl disilazane (HMDS) or the like, or an oxide layer may be provided on the surface of these base materials.
In addition, the shape of the base material is not particularly limited, and it may be a circular shape or may be a rectangular shape.
Regarding the size of the base material, for example in a case of a circular shape, the diameter thereof is 100 to 450 mm and preferably 200 to 450 mm. In a case where the shape is rectangular, for example, the length of the short side is 100 to 1,000 mm and preferably 200 to 700 mm.
Further, as the base material, for example, a base material having a plate shape and preferably a base material (a substrate) having a panel shape are used.
In a case where the resin composition is applied to form a film on a surface of a resin layer (for example, a layer consisting of a cured substance) or on a surface of a metal layer, the resin layer or the metal layer serves as the base material.
The means for applying the resin composition according to the embodiment of the present invention onto a base material is preferably coating.
Specific examples of the means for application include a dip coating method, an air knife coating method, a curtain coating method, a wire bar coating method, a gravure coating method, an extrusion coating method, a spray coating method, a spin coating method, a slit coating method, and an ink jet method. From the viewpoint of the uniformity of the film thickness, the spin coating method, the slit coating method, the spray coating method, or the inkjet method is more preferable, and from the viewpoint of the uniformity of the film thickness and the viewpoint of productivity, a spin coating method or a slit coating method is preferable. A film having a desired thickness can be obtained by adjusting the concentration of solid contents of the resin composition and application conditions according to the method. In addition, the coating method can be appropriately selected depending on the shape of the base material. In a case where a circular base material such as a wafer is used, the spin coating method, the spray coating method, the inkjet method, and the like are preferable, and in a case where a rectangular base material is used, the slit coating method, the spray coating method, the inkjet method, and the like are preferable. For example, the spin coating method can be applied at a rotation speed of 500 to

3,500 rpm for about 10 seconds to 3 minutes.

In addition, it is also possible to apply a method of transferring a coating film formed in advance on a temporary support by the above-described coating method, onto a base material.

Regarding the transfer method, the production methods described in paragraphs 0023 and 0036 to 0051 of JP2006-023696A and paragraphs 0096 to 0108 of JP2006-047592A can also be suitably used in the present invention.

In addition, a step of removing an unnecessary film at the end part of the base material may be carried out. Examples of such a step include edge bead rinsing (EBR) and back rinsing.

Further, a pre-wetting step of applying various solvents onto the base material before applying the resin composition onto the base material to improve the wettability of the base material and then applying the resin composition may be adopted.

<Drying Step>

The above film may be subjected to a step (a drying step) of drying the film (or the layer) formed for removing the solvent, after the film forming step (the layer forming step).

That is, the manufacturing method for a cured substance according to the embodiment of the present invention may include a drying step of drying the film formed by the film forming step.

In addition, it is preferable that the drying step is carried out after the film forming step and before the exposure step.

The drying temperature of the film in the drying step is preferably 50°C to 150°C, more preferably 70°C to 130°C, and still more preferably 90°C to 110°C. In addition, the drying may be carried out by reducing the pressure. Examples of the drying time include 30 seconds to 20 minutes, and the drying time is preferably 1 minute to 10 minutes and more preferably 2 minutes to 7 minutes.

<Exposure step>

The film may be subjected to an exposure step of selectively exposing the film.

That is, the manufacturing method for a cured substance according to the embodiment of the present invention may include an exposure step of selectively exposing the film formed by the film forming step.

The selective exposure means that a part of the film is exposed. In addition, by selectively exposing the film, an exposed region (an exposed portion) and an unexposed region (a non-exposed portion) are formed in the film.

The exposure amount is not particularly set as long as the resin composition according to the embodiment of the present invention can be cured; however, it is, for example, preferably 50 to 10,000 $mJ/cm^2$ and more preferably 200 to 8,000 $mJ/cm^2$ in terms of conversion of exposure energy at a wavelength of 365 nm.

The exposure wavelength can be appropriately determined in a range of 190 to 1,000 nm and preferably in a range of 240 to 550 nm.

Examples of the exposure wavelength, which are mentioned in the relationship with the light source, include (1) a semiconductor laser (wavelength: 830 nm, 532 nm, 488 nm, 405 nm, 375 nm, 355 nm, or the like); (2) a metal halide lamp; (3) a high-pressure mercury lamp, a g-line (wavelength: 436 nm), an h-line (wavelength: 405 nm), an i-line (wavelength: 365 nm), or Broad (three wavelengths of the g, h, and i-line); (4) an excimer laser, a KrF excimer laser (wavelength: 248 nm), an ArF excimer laser (wavelength: 193 nm), or an $F_2$ excimer laser (wavelength: 157 nm); (5) an extreme ultraviolet ray: EUV (wavelength: 13.6 nm); (6) an electron beam; and (7) a second harmonic wave of 532 nm and a third harmonic wave of 355 nm of a YAG laser. Regarding the resin composition according to the embodiment of the present invention, the exposure with a high-pressure mercury lamp is particularly preferable, and the exposure with an i-line is particularly preferable. In this case, particularly high exposure sensitivity can be obtained.

In addition, the exposure method is not particularly limited as long as at least a part of the film consisting of the resin composition according to the embodiment of the present invention is exposed; however, examples thereof include exposure using a photo mask and exposure by a laser direct imaging method.

<Post-exposure heating step>

The film may be subjected to a step of carrying out heating after the exposure (a post-exposure heating step).

That is, the manufacturing method for a cured substance according to the embodiment of the present invention may include a post-exposure heating step of heating the film exposed in the exposure step.

The post-exposure heating step can be carried out after the exposure step and before the development step.

The heating temperature in the post-exposure heating step is preferably 50°C to 140°C and more preferably 60°C to 120°C.

The heating time in the post-exposure heating step is preferably 30 seconds to 300 minutes and more preferably

1 minute to 10 minutes.

In the post-exposure heating step, the temperature rising rate from the temperature at the start of heating to the maximum heating temperature is preferably 1 to 12 °C/min, more preferably 2 to 10 °C/min, and still more preferably 3 to 10 °C/min.

In addition, the temperature rising rate may be appropriately changed during heating.

The heating means in the post-exposure heating step is not particularly limited, and a publicly known hot plate, oven, infrared heater, or the like can be used.

In addition, it is also preferable to carry out the heating in an atmosphere having a low oxygen concentration by allowing an inert gas such as nitrogen, helium, argon, or the like to flow.

<Development Step>

The exposed film may be subjected to a development step of carrying out development using a developer to form a pattern.

That is, the manufacturing method for a cured substance according to the embodiment of the present invention may include a development step of developing the film exposed in the exposure step using a developer to form a pattern.

By carrying out the development, one of the exposed portion and the non-exposed portion of the film is removed, and a pattern is formed.

Here, the development in which the non-exposed portion of the film is removed by the development step is referred to as negative-tone development, and the development in which the exposed portion of the film is removed by the development step is referred to as positive-tone development.

[Developer]

Examples of the developer that is used in the development step include a developer containing an alkaline aqueous solution or an organic solvent.

In a case where the developer is an alkaline aqueous solution, examples of the basic compound that can be contained in the alkaline aqueous solution include inorganic alkalis, primary amines, secondary amines, tertiary amines, and a quaternary ammonium salt. The basic compound is preferably tetramethylammonium hydroxide (TMAH), potassium hydroxide, sodium carbonate, sodium hydroxide, sodium silicate, sodium metasilicate, ammonia, ethylamine, n-propylamine, diethylamine, di-n-butylamine, triethylamine, methyldiethylamine, dimethylethanolamine, triethanolamine, tetraethylammonium hydroxide, tetrapropylammonium hydroxide, tetrabutylammonium hydroxide, tetrapentylammonium hydroxide, tetrahexylammonium hydroxide, tetraoctylammonium hydroxide, ethyltrimethylammonium hydroxide, butyltrimethylammonium hydroxide, methyltriamylammonium hydroxide, dibutyldipentylammonium hydroxide, dimethylbis(2-hydroxyethyl)ammonium hydroxide, trimethylphenylammonium hydroxide, trimethylbenzylammonium hydroxide, triethylbenzylammonium hydroxide, pyrrole, or piperidine, and it is more preferably TMAH. For example, in a case where TMAH is used, the content of the basic compound in the developer is preferably 0.01% to 10% by mass, more preferably 0.1% to 5% by mass, and still more preferably 0.3% to 3% by mass with respect to the total mass of the developer.

In a case where the developer contains an organic solvent, the compounds described in paragraph 0387 of WO2021/112189A can be used as the organic solvent. The content thereof is incorporated in the present specification. In addition, suitable examples of the alcohols include methanol, ethanol, propanol, isopropanol, butanol, pentanol, octanol, diethylene glycol, propylene glycol, methyl isobutyl carbinol, and triethylene glycol, and suitable examples of the amides include N-methylpyrrolidone, N-ethylpyrrolidone, and dimethylformamide.

In a case where the developer contains an organic solvent, one kind of organic solvent can be used, or two or more kinds thereof can be mixedly used. In the present invention, in particular, a developer containing at least one selected from the group consisting of cyclopentanone, γ-butyrolactone, dimethyl sulfoxide, N-methyl-2-pyrrolidone, and cyclohexanone is preferable, a developer containing at least one selected from the group consisting of cyclopentanone, γ-butyrolactone, and dimethyl sulfoxide is more preferable, and a developer containing cyclopentanone is most preferable.

In a case where the developer contains an organic solvent, the content of the organic solvent with respect to the total mass of the developer is preferably 50% by mass or more, more preferably 70% by mass or more, still more preferably 80% by mass or more, and particularly preferably 90% by mass or more. In addition, the above content may be 100% by mass.

The developer may further contain another component.

Examples of the other component include a publicly known surfactant and a publicly known anti-foaming agent.

[Method of supplying developer]

The method of supplying a developer is not particularly limited as long as a desired pattern can be formed, and it

includes a method of immersing a base material on which a film has been formed in a developer, puddle development of supplying a developer to a film formed on a base material using a nozzle, and a method of continuously supplying a developer. The kind of nozzle is not particularly limited, and examples thereof include a straight nozzle, a shower nozzle, and a spray nozzle.

From the viewpoint of the permeability of the developer, the removability of the non-image area, and the manufacturing efficiency, a method of supplying a developer with a straight nozzle or a method of continuously supplying a developer with a spray nozzle is preferable, and from the viewpoint of the permeability of the developer into the image area, a method of supplying a developer with a spray nozzle is more preferable.

In addition, after the continuous supply by a straight nozzle, the base material is spun to remove the developer from the base material, and then the developer is continuously supplied by the straight nozzle again after the spin drying, a step of spinning the base material to remove the developer from the base material may be adopted, and this step may be repeated a plurality of times.

In addition, in the method of supplying a developer in the development step, a step of continuously supplying a developer to a base material, a step of keeping a developer in a substantially stationary state on a base material, a step of vibrating a developer on a base material by ultrasonic waves or the like, and a step obtained by combining these steps can be adopted.

The development time is preferably 10 seconds to 10 minutes and more preferably 20 seconds to 5 minutes. The temperature of the developer during the development is not particularly set; however, rinsing can be preferably carried out at 10°C to 45°C and more preferably 18°C to 30°C.

In the development step, washing (rinsing) of the pattern with a rinsing liquid may be further carried out after the treatment with the developer. In addition, a method such as supplying a rinsing liquid before the developer which is in contact with the pattern is completely dried may be adopted.

[Rinsing liquid]

In a case where the developer is an alkaline aqueous solution, it is possible to use, for example, water as the rinsing liquid. In a case where the developer is a developer containing an organic solvent, it is possible to use as the rinsing liquid, for example, a solvent (for example, water, an organic solvent different from the organic solvent contained in the developer) different from the solvent contained in the developer.

Examples of the organic solvent in a case where the rinsing liquid contains an organic solvent include the same organic solvents as the organic solvents exemplified in the above-described case where the developer contains an organic solvent.

In addition, the organic solvent contained in the rinsing liquid is preferably an organic solvent different from the organic solvent contained in the developer, and it is more preferably an organic solvent having a solubility of the pattern, which is lower than that of the organic solvent contained in the developer.

In a case where the rinsing liquid contains an organic solvent, one kind of organic solvent can be used, or two or more kinds thereof can be mixedly used. In the present invention, cyclopentanone, γ-butyrolactone, dimethyl sulfoxide, N-methylpyrrolidone, cyclohexanone, PGMEA, or PGME is particularly preferable, cyclopentanone, γ-butyrolactone, dimethyl sulfoxide, PGMEA, or PGME is more preferable, and cyclohexanone or PGMEA is still more preferable.

In a case where the rinsing liquid contains an organic solvent, the content of the organic solvent in the rinsing liquid is preferably 50% by mass or more, the content of the organic solvent is more preferably 70% by mass or more, and the content of the organic solvent is still more preferably 90% by mass or more. In addition, 100% by mass of the rinsing liquid may be an organic solvent.

In addition, the rinsing liquid may contain at least one of a basic compound or a base generator.

Although not particularly limited, in a case where the developer contains an organic solvent, an aspect in which the rinsing liquid contains an organic solvent and a base is also one of the preferred aspects of the present invention.

The basic compound is preferably an organic base from the viewpoint of the reliability in a case of being remained in the cured film (the adhesiveness to the base material in a case where the cured substance is further heated).

In addition, the basic compound is preferably a basic compound having an amino group and preferably a primary amine, a secondary amine, a tertiary amine, an ammonium salt, a tertiary amide, or the like. However, in order to accelerate the imidization reaction, it is preferably a primary amine, a secondary amine, a tertiary amine, or an ammonium salt, more preferably a secondary amine, a tertiary amine, or an ammonium salt, still more preferably a secondary amine or a tertiary amine, and particularly preferably a tertiary amine.

From the viewpoint of mechanical characteristics (the breaking elongation) of the cured substance, it is preferable that the basic compound hardly remains in the cured film (the obtained cured substance), and from the viewpoint of accelerating cyclization, it is preferable that the residual amount of the basic compound hardly decreases due to vaporization or the like before heating.

Therefore, the boiling point of the basic compound is preferably 30°C to 350°C, more preferably 80°C to 270°C,

and still more preferably 100°C to 230°C at normal pressure (101,325Pa).

In addition, the boiling point of the basic compound is preferably higher than the temperature obtained by subtracting 20°C from the boiling point of the organic solvent contained in the rinsing liquid, and it is more preferably higher than the boiling point of the organic solvent contained in the rinsing liquid.

For example, in a case where the boiling point of the organic solvent is 100°C, the basic compound to be used preferably has a boiling point of 80°C or higher and more preferably a boiling point of 100°C or higher.

The rinsing liquid may contain only one kind of basic compound having an amide group or may contain two or more kinds thereof.

Specific examples of the basic compound include ethanolamine, diethanolamine, triethanolamine, ethylamine, diethylamine, triethylamine, hexylamine, dodecylamine, cyclohexylamine, cyclohexylmethylamine, cyclohexyldimethylamine, aniline, N-methylaniline, N,N-dimethylaniline, diphenylamine, pyridine, butylamine, isobutylamine, dibutylamine, tributylamine, dicyclohexylamine, diazabicycloundecene (DBU), 1,4-diazabicyclo[2.2.2]octane (DABCO), N,N-diisopropylethylamine, tetramethylammonium hydroxide, tetrabutylammonium hydroxide, ethylenediamine, butanediamine, 1,5-diaminopentane, N-methylhexylamine, N-methyldicyclohexylamine, trioctylamine, N-ethylethylenediamine, N,N-diethylethylenediamine, N,N,N',N'-tetrabutyl-1,6-hexanediamine, spermidine, diaminocyclohexane, bis(2-methoxyethyl) amine, piperidine, methylpiperidine, dimethylpiperidine, piperazine, tropane, N-phenylbenzylamine, 1,2-dianilinoethane, 2-aminoethanol, toluidine, aminophenol, hexylaniline, phenylene diamine, phenylethylamine, dibenzylamine, pyrrole, N-methylpyrrole, N,N,N,N-tetramethylethylenediamine, and N,N,N,N-tetramethyl-1,3-propanediamine.

The preferred aspect of the base generator is the same as the preferred aspect of the base generator contained in the above-described composition. In particular, the base generator is preferably a thermal-base generator.

The basic compound and the base generator, which are contained in the rinsing liquid, may be selected in consideration of the solubility in the solvent in the rinsing liquid.

In a case where the rinsing liquid contains at least one of a basic compound or a base generator, the content of the compound corresponding to at least one of the basic compound or the base generator is preferably 10% by mass or less and more preferably 5% by mass or less with respect to the total mass of the rinsing liquid. The lower limit of the content is not particularly limited; however, it is, for example, preferably 0.1% by mass or more.

In addition, in a case where at least one of the basic compound or the base generator is a solid in an environment where the rinsing liquid is used, the content of the compound corresponding to at least one of the basic compound or the base generator is also preferably 70% to 100% by mass with respect to the total solid content of the rinsing liquid.

In a case where the rinsing liquid contains at least one of a basic compound or a base generator, the rinsing liquid may contain only one kind of the basic compound or the base generator, or may contain two or more kinds thereof. In a case where at least one of the basic compound or the base generator is two or more kinds, the total thereof is preferably within the above-described range.

The rinsing liquid may further contain another component.

Examples of the other component include a publicly known surfactant and a publicly known anti-foaming agent.

[Method of supplying rinsing liquid]

The method of supplying a rinsing liquid is not particularly limited as long as a desired pattern can be formed and includes a method of immersing a base material in a rinsing liquid, a method of supplying a rinsing liquid to a base material by liquid filling, a method of supplying a rinsing liquid to a base material with a shower, and a method of continuously supplying a rinsing liquid to a base material by means such as a straight nozzle.

From the viewpoint of the permeability of the rinsing liquid, the removability of non-image area, and the manufacturing efficiency, there is a method of supplying a rinsing liquid with a shower nozzle, a straight nozzle, a spray nozzle, or the like, and a method of continuously supplying a rinsing liquid with a spray nozzle is preferable. From the viewpoint of the permeability of the rinsing liquid into the image area, a method of supplying a rinsing liquid with a spray nozzle is more preferable. The kind of nozzle is not particularly limited, and examples thereof include a straight nozzle, a shower nozzle, and a spray nozzle.

That is, the rinsing step is preferably a step of supplying, with a straight nozzle, or continuously supplying a rinsing liquid to the film after the exposure, and it is more preferably a step of supplying a rinsing liquid with a spray nozzle.

In addition, in the method of supplying a rinsing liquid in the rinsing step, a step of continuously supplying a rinsing liquid to a base material, a step of keeping a rinsing liquid in a substantially stationary state on a base material, a step of vibrating a rinsing liquid on the base material by ultrasonic waves or the like, and a step obtained by combining these steps can be adopted.

The rinsing time is preferably 10 seconds to 10 minutes and more preferably 20 seconds to 5 minutes. The temperature of the rinsing liquid during rinsing is not particularly set; however, rinsing can be preferably carried out at 10°C to 45°C and more preferably 18°C to 30°C.

The development step may include a step of bringing the treatment liquid into contact with the pattern after the

treatment using the developer or after the pattern is washed with the rinsing liquid. In addition, such a method of supplying a treatment liquid before the developer or rinsing liquid which is in contact with the pattern is completely dried may be adopted.

Examples of the treatment liquid include a treatment liquid containing at least one of water or an organic solvent and at least one of a basic compound or a base generator.

The preferred aspects of the organic solvent and at least one of the basic compound or the base generator are the same as the preferred aspects of the organic solvent and at least one of the basic compound or the base generator, which are used in the above-described rinsing liquid.

In addition, as a method of supplying the treatment liquid to the pattern, the same method as the above-described method of supplying the rinsing liquid can be used, and the same applies to the preferred aspect thereof.

In the treatment liquid, the content of the compound corresponding to at least one of the basic compound or the base generator is preferably 10% by mass or less and more preferably 5% by mass or less with respect to the total mass of the treatment liquid. The lower limit of the content is not particularly limited; however, it is, for example, preferably 0.1% by mass or more.

In addition, in a case where at least one of the basic compound or the base generator is a solid in an environment where the treatment liquid is used, the content of the compound corresponding to at least one of the basic compound or the base generator is also preferably 70% to 100% by mass with respect to the total solid content of the treatment liquid.

In a case where the treatment liquid contains at least one of a basic compound or a base generator, the treatment liquid may contain only one kind of the basic compound or the base generator, or may contain two or more kinds thereof. In a case where at least one of the basic compound or the base generator is two or more kinds, the total thereof is preferably within the above-described range.

<Heating step>

The pattern obtained by the development step (a pattern after the rinsing in a case where the rinsing step is carried out) may be subjected to a heating step of heating the pattern obtained by the development.

That is, the manufacturing method for a cured substance according to the embodiment of the present invention may include a heating step of heating the pattern obtained by the development step.

In addition, the manufacturing method for a cured substance according to the embodiment of the present invention may include a pattern obtained by another method without carrying out the development step, or a heating step of heating a film obtained by the film forming step.

In the heating step, the resin such as the polyimide precursor is cyclized to become a resin such as polyimide.

In addition, the crosslinking of unreacted crosslinkable groups in the specific resin or a crosslinking agent other than the specific resin also proceeds.

The heating temperature (the maximum heating temperature) in the heating step is preferably 50°C to 450°C, more preferably 150°C to 350°C, still more preferably 150°C to 250°C, even still more preferably 160°C to 250°C, and particularly preferably 160°C to 230°C.

The heating step is preferably a step of accelerating the cyclization reaction of the polyimide precursor in the pattern under the action of the base or the like generated from the base generator by heating.

The heating in the heating step is preferably carried out at a temperature rising rate of 1 to 12°C/min from the temperature at the start of heating to the maximum heating temperature. The temperature rising rate is more preferably 2 to 10 °C/min and still more preferably 3 to 10 °C/min. In a case where the above temperature rising rate is set to 1 °C/min or higher, the excessive volatilization of the acid or solvent can be prevented while securing productivity, and in a case where the above temperature rising rate is to 12 °C/min or lower, the residual stress of the cured substance can be relaxed.

In addition, in a case of an oven that enables rapid heating, the heating is preferably carried out at a temperature rising rate of 1 to 8°C/sec from the temperature at the start of heating to the maximum heating temperature, more preferably 2 to 7 °C/sec, and still more preferably 3 to 6 °C/sec.

The temperature at the start of heating is preferably 20°C to 150°C, more preferably 20°C to 130°C, and still more preferably 25°C to 120°C. The temperature at the start of heating refers to a temperature at which the step of heating to the maximum heating temperature is started. For example, in a case where the resin composition according to the embodiment of the present invention is applied on a base material and then dried, the temperature at the start of heating is the temperature of the film (the layer) after drying, and for example, it is preferable to raise the temperature from a temperature lower by 30°C to 200°C than the boiling point of the solvent contained in the resin composition according to the embodiment of the present invention.

The heating time (the heating time at the maximum heating temperature) is preferably 5 to 360 minutes, more preferably 10 to 300 minutes, and still more preferably 15 to 240 minutes.

In particular, in a case of forming a multilayered laminate, the heating temperature is preferably 30°C or higher, more preferably 80°C or higher, still more preferably 100°C or higher, and particularly preferably 120°C or higher, from the

viewpoint of adhesiveness between layers.

The upper limit of the heating temperature is preferably 350°C or lower, more preferably 250°C or lower, and still more preferably 240°C or lower.

The heating may be carried out stepwise. For example, a step in which the temperature is raised from 25°C to 120°C at 3 °C/min, held at 120°C for 60 minutes, raised from 120°C to 180°C at 2 °C/min, and held at 180°C for 120 minutes, may be carried out. In addition, it is also preferable to carry out the treatment while carrying out irradiation with ultraviolet rays as described in US9159547B. By such a pretreatment step, it is possible to improve the properties of the film. The pretreatment step may be carried out for a short time of about 10 seconds to 2 hours and more preferably 15 seconds to 30 minutes. The pretreatment may be carried out as a step of two or more stages, for example, a first stage pretreatment step may be carried out in a range of 100°C to 150°C, and then a second stage pretreatment step may be carried out in a range of 150°C to 200°C.

Further, cooling may be carried out after heating, and the cooling rate, in this case, is preferably 1 to 5 °C/min.

From the viewpoint of preventing the decomposition of the specific resin, it is preferable that the heating step is carried out in an atmosphere of a low oxygen concentration, for example, by allowing an inert gas such as nitrogen, helium, argon, or the like to flow, or carrying out heating under reduced pressure. The oxygen concentration is preferably 50 ppm (volume ratio) or lower, and more preferably 20 ppm (volume ratio) or lower.

The heating means in the heating step is not particularly limited; however, examples thereof include a hot plate, an infrared furnace, an electric heating oven, a hot air oven, and an infrared oven.

<Post-development exposure step>

The pattern obtained by the development step (a pattern after the rinsing in a case where the rinsing step is carried out) may be subjected to a post-development exposure step of exposing the pattern after the development step, instead of the heating step or in addition to the heating step.

That is, the manufacturing method for a cured substance according to the embodiment of the present invention may include a post-development exposure step of exposing the pattern obtained by the development step. The manufacturing method for a cured substance according to the embodiment of the present invention may include the heating step and the post-development exposure step or may include only one of the heating step and the post-development exposure step.

In the post-development exposure step, it is possible to accelerate, for example, a reaction in which the cyclization of a polyimide precursor or the like proceeds by photosensitization of a photobase generator, a reaction in which the elimination of an acid-decomposable group proceeds by photosensitization of a photoacid generator.

In the post-development exposure step, it is sufficient that at least a part of the pattern obtained in the development step is exposed; however, it is preferable that the whole of the above pattern is exposed.

The exposure amount in the post-development exposure step is preferably 50 to 20,000 $mJ/cm^2$ and more preferably 100 to 15,000 $mJ/cm^2$ in terms of conversion of exposure energy at the wavelength at which the photosensitive compound has a sensitivity.

The post-development exposure step can be carried out using, for example, the light source in the above-described exposure step, and it is preferable to use broadband light.

<Metal layer forming step>

The pattern (preferably a pattern that has been subjected to at least one of the heating step or the post-development exposure step) obtained by the development step may be subjected to a metal layer forming step of forming a metal layer on the pattern.

That is, it is preferable that the manufacturing method for a cured substance according to the embodiment of the present invention includes a metal layer forming step of forming a metal layer on the pattern (preferably a pattern that has been subjected to at least one of the heating step or the post-development exposure step) obtained by the development step.

For the metal layer, existing metal kinds can be used without particular limitations. Examples thereof include copper, aluminum, nickel, vanadium, titanium, chromium, cobalt, gold, tungsten, tin, silver, and an alloy including these metals, preferred examples thereof are copper and aluminum, and a more preferred example thereof is copper.

The forming method for the metal layer is not particularly limited, and the existing method can be applied. For example, the methods described in JP2007-157879A, JP2001-521288A, JP2004-214501A, JP2004-101850A, US7888181B2, and US9177926B2 can be used. For example, photolithography, physical vapor deposition method (PVD), chemical vapor phase growth method (CVD), lift-off, electrolytic plating, electroless plating, etching, printing, and a method obtained by combining these may be conceivable. More specific examples of the forming method for the metal layer include a patterning method obtained by combining sputtering, photolithography, and etching, and a patterning

method combining photolithography and electrolytic plating. Examples of the preferred aspect of the plating include electrolytic plating using a copper sulfate plating liquid or a copper cyanide plating liquid.

The thickness of the metal layer at the thickest portion is preferably 0.01 to 50 μm and more preferably 1 to 10 μm.

<Use application>

As a field to which the manufacturing method for a cured substance according to the embodiment of the present invention or the cured substance according to the embodiment of the present invention can be applied, an insulating film of an electronic device, an interlayer insulating film for a re-distribution layer, a stress buffer film, and the like are mentioned. In addition, a sealing film, a substrate material (a base film or cover lay of a flexible print substrate, an interlayer insulating film), or an insulating film applicable for mounting as described above, which is patterned by etching is mentioned. For these use applications, for example, Science & Technology Co., Ltd., "High functionality and applied technology of polyimide" April 2008, Technical library CMC TL "Basics and development of polyimide materials" supervised by Masaaki Kakimoto, published in November 2011, "Latest Polyimide Basics and Applications" edited by Japan Polyimide & Aromatic Polymers Study Group, NTS Inc., August 2010, or the like can be referred to.

In addition, the manufacturing method for a cured substance according to the embodiment of the present invention and the cured substance according to the embodiment of the present invention can also be used for the production of board surfaces such as an offset board surface or a screen board surface, for etching of molded parts, for the production of protective lacquers and dielectric layers in electronics, in particular, microelectronics.

(Laminate and manufacturing method for laminate)

A laminate according to the embodiment of the present invention refers to a structure having a plurality of layers consisting of the cured substance according to the embodiment of the present invention.

The laminate according to the embodiment of the present invention is a laminate including two or more layers consisting of a cured substance, and it may be a laminate in which three or more layers are laminated.

At least one of the two or more layers consisting of a cured substance, which are included in the laminate, is a layer consisting of the cured substance according to the embodiment of the present invention, and from the viewpoint of suppressing the shrinkage of the cured substance or the deformation of the cured substance due to the shrinkage, it is also preferable that all the layers consisting of a cured substance which are included in the laminate are layers consisting of the cured substance according to the embodiment of the present invention.

That is, it is preferable that the manufacturing method for a laminate according to the embodiment of the present invention includes the manufacturing method for a cured substance according to the embodiment of the present invention, and it is more preferable to include repeating, a plurality of times, the manufacturing method for a cured substance according to the embodiment of the present invention.

In the laminate according to the aspect of the present invention, an aspect in which two or more layers of layers consisting of a cured substance are included and a metal layer is provided between any of the layers consisting of the cured substance is preferable. The metal layer is preferably formed in the metal layer forming step.

That is, it is preferable that the manufacturing method for a laminate according to the embodiment of the present invention further includes a metal layer forming step of forming a metal layer on a layer consisting of the cured substance, between the manufacturing methods for a cured substance which are carried out a plurality of times. The preferred aspect of the metal layer forming step is as described above.

Examples of the preferred laminate include a laminate including at least a layer structure in which three layers of a layer consisting of a first cured substance, a metal layer, and a layer consisting of a second cured substance are laminated in order.

It is preferable that both the layer consisting of the first cured substance and the layer consisting of the second cured substance are layers consisting of the cured substance according to the embodiment of the present invention. The resin composition according to the embodiment of the present invention which is used for forming a layer consisting of the first cured substance and the resin composition according to the embodiment of the present invention which is used for forming a layer consisting of the second cured substance may have the same composition or may have compositions different from each other. The metal layer in the laminate according to the embodiment of the present invention is preferably used as the metal wire of the re-distribution layer or the like.

<Laminating step>

The manufacturing method for a laminate according to the embodiment of the present invention preferably further includes a laminating step.

The laminating step is a series of steps including carrying out again, in the following order on the surface of the

pattern (the resin layer) or the metal layer, at least one of (a) the film forming step (the layer forming step), (b) the exposure step, (c) the development step, or (d) the heating step and the post-development exposure step. However, the aspect thereof may be such that at least one of (a) the film forming step or (d) the heating step and the post-development exposure step is repeated. In addition, (e) the metal layer forming step may be included after at least one of the heating step or the post-development exposure step of (d). The laminating step may further include appropriately the above-described drying step.

In a case where another laminating step is further carried out after the laminating step, a surface activation treatment step may be further carried out after the exposure step, the heating step, or the metal layer forming step. Examples of the surface activation treatment include plasma treatment. Details of the surface activation treatment will be described later.

The laminating step is preferably carried out 2 to 20 times and more preferably 2 to 9 times.

For example, a configuration having resin layers of 2 or more layers and 20 or less layers, such as a resin layer/a metal layer/a resin layer/a metal layer/a resin layer/a metal layer, is preferable, and a configuration having resin layers of 2 or more layers and 9 or less layers is more preferable.

In the above layers, the compositions, shapes, film thicknesses, and the like may be the same or may be different from each other.

In the present invention, an aspect in which a metal layer is provided, and then furthermore, a cured substance (a resin layer) of the resin composition according to the aspect of the present invention is formed to cover the metal layer is particularly preferable. Specific examples thereof include an aspect in which (a) the film forming step, (b) the exposure step, (c) the development step, (d) at least one of the heating step or the post-development exposure step, (e) the metal layer forming step are repeated in this order, and an aspect in which (a) the film forming step, (d) at least one of the heating step or the post-development exposure step, and (e) the metal layer forming step are repeated in order. By alternately carrying out the laminating step of laminating the resin composition layer (the resin layer) of the present invention and the metal layer forming step, the resin composition layer (the resin layer) according to the embodiment of the present invention and the metal layer can be alternately laminated.

(Surface activation treatment step)

The manufacturing method for a laminate according to the embodiment of the present invention preferably includes a surface activation treatment step of subjecting at least a part of the metal layer or a part of the resin composition layer to a surface activation treatment.

The surface activation treatment step is usually carried out after the metal layer forming step (preferably, after at least one of the heating step or the post-development exposure step). However, after the development step, the metal layer forming step may be carried out after the resin composition layer is subjected to the surface activation treatment step.

At least a part of the metal layer may be subjected to the surface activation treatment, at least a part of the resin composition layer after the exposure may be subjected to the surface activation treatment, or both at least a part of the metal layer and at least a part of the resin composition layer after the exposure may be subjected to the surface activation treatment. It is preferable to carry out the surface activation treatment on at least a part of the metal layer, and it is preferable to carry out the surface activation treatment on a part or whole of the region of the metal layer having a surface on which the resin composition layer is formed. In a case where a surface of the metal layer is subjected to the surface activation treatment in this manner, it is possible to improve the adhesiveness to the resin composition layer (film) to be provided on the surface thereof.

In addition, it is preferable that the surface activation treatment is carried out on a part or whole of the resin composition layer (the resin layer) after the exposure. In a case where a surface of the resin composition layer is subjected to the surface activation treatment in this manner, it is possible to improve the adhesiveness to a metal layer or a resin layer to be provided on the surface that has been subjected to the surface activation treatment. In particular, in a case where the resin composition layer is cured, such as in a case where negative-tone development is carried out, it is less likely to be damaged by the surface treatment, and thus the adhesiveness is likely to be improved.

The surface activation treatment can be carried out, for example, by the method described in paragraph 0415 of WO2021/112189A. The content thereof is incorporated in the present specification.

(Semiconductor device and manufacturing method therefor)

In addition, the present invention also discloses a semiconductor device, which includes the cured substance according to the embodiment of the present invention or the laminate according to the embodiment of the present invention.

In addition, the present invention also discloses a manufacturing method for a semiconductor device, which includes the manufacturing method for a cured substance according to the embodiment of the present invention or the

manufacturing method for a laminate according to the embodiment of the present invention.

As the specific examples of the semiconductor device using the resin composition according to the embodiment of the present invention for forming an interlayer insulating film for a re-distribution layer, the description in paragraphs 0213 to 0218 and the description of Fig. 1 of JP2016-027357A can be referred to, the content of which is incorporated in the present specification.

## Examples

Hereinafter, the present invention will be described in detail using examples. Materials, using amounts, proportions, treatment details, treatment content, and the like shown in the following examples can be appropriately changed without departing from the gist of the present invention. Accordingly, the scope of the present invention is not limited to the following specific examples. Unless otherwise specified, "parts" and "%" are based on mass.

<Manufacturing method for precursor of cyclization resin>

[Synthesis Example 1: Synthesis of precursor (resin 1) of cyclization resin]

23.48 g of 4,4'-oxydiphthalic acid dianhydride (ODPA) and 22.27 g of bisphthalic acid dianhydride (BPDA) were placed in a separable flask, 39.69 g of 2-hydroxyethyl methacrylate (HEMA) and 136.83 g of tetrahydrofuran were placed therein, the resultant mixture was stirred at room temperature (25°C), and 24.66 g of pyridine was added thereto while stirring to obtain a reaction mixture. After the heat generation due to the reaction was stopped, the mixture was allowed to cool to room temperature and left to stand for 16 hours.

Next, Next, under ice-cooling, a solution obtained by dissolving 62.46 g of dicyclohexylcarbodiimide (DCC) in 61.57 g of tetrahydrofuran was added to the reaction mixture over 40 minutes with stirring, and subsequently a suspension obtained by suspending 27.42 g of 4,4'-diaminodiphenyl ether (DADPE) in 119.73 g of tetrahydrofuran was added thereto over 60 minutes with stirring. After further carrying out stirring at room temperature for 2 hours, ethyl alcohol (7.17 g) was added thereto, and the resultant mixture was stirred for 1 hour, and then 136.83 g of tetrahydrofuran was added thereto. The precipitate formed in the reaction mixture was removed by filtration to obtain a reaction solution.

The obtained reaction solution was added to 716.21 g of ethyl alcohol to generate a precipitate consisting of a crude polymer. The generated crude polymer was filtered out and then dissolved in 403.49 g of tetrahydrofuran to obtain a crude polymer solution. The obtained crude polymer solution was added dropwise to 8470.26 g of water to precipitate the polymer, and the obtained precipitate was filtered out and then subjected to vacuum drying to obtain 80.3 g of a powdered resin 1. As a result of measuring the molecular weight of the resin 1 by gel permeation chromatography (in terms of standard polystyrene equivalent value), the weight-average molecular weight (Mw) was 20,000. It is presumed that the structure of the resin 1 is a structure represented by Formula (P-1).

[Synthesis Example 2: Synthesis of precursor (resin 2) of cyclization resin]

21.2 g of 4,4'-oxydiphthalic acid dianhydride, 18.0 g of 2-hydroxyethyl methacrylate, 23.9 g of pyridine, and 250 mL of diglyme (diethylene glycol dimethyl ether) were mixed and stirred at a temperature of 60°C for 4 hours to synthesize a diester of 4,4'-oxydiphthalic acid and 2-hydroxyethyl methacrylate. Next, the reaction mixture was cooled to -10°C, and 17.0 g of thionyl chloride was added thereto over 60 minutes while maintaining the temperature at - 10°C $\pm$ 5°C. After dilution with 50 mL of N-methylpyrrolidone, a solution obtained by dissolving 12.6 g of 4,4'-diaminodiphenyl ether in 100 mL of N-methylpyrrolidone was added dropwise to the reaction mixture over 60 minutes at -10 $\pm$ 5°C, and the resultant mixture was stirred at room temperature for 2 hours. Then, 10.0 g of ethanol was added thereto, and the resultant mixture was stirred at room temperature for 1 hour.

Next, 6,000 g of water was added to precipitate the polyimide precursor, and the precipitate (a water-polyimide precursor mixture) was stirred for 15 minutes. The precipitate (the solid of the polyimide precursor) after stirring was collected by filtration and dissolved in 500 g of tetrahydrofuran. 6,000 g of water (poor solvent) was added to the obtained solution to precipitate the polyimide precursor, and the precipitate (a water-polyimide precursor mixture) was stirred for 15 minutes. The precipitate (the solid of the polyimide precursor) after stirring was filtered again and dried at 45°C for 3 days under reduced pressure.

After dissolving 46.6 g of the powder after drying in 419.6 g of tetrahydrofuran, 2.3 g of triethylamine was added thereto, and the resultant mixture was stirred at room temperature for 35 minutes. Then, 3,000 g of ethanol was added thereto, and the precipitate was collected by filtration. The obtained precipitate was dissolved in 281.8 g of tetrahydrofuran. 17.1 g of water and 46.6 g of an ion exchange resin UP6040 (manufactured by AmberTec) were added thereto, and the resultant mixture was stirred for 4 hours. Thereafter, the ion exchange resin was removed by filtration, and the obtained polymer solution was added to 5,600 g of water to obtain a precipitate. The precipitate was collected by filtration and dried

at 45°C under reduced pressure for 24 hours to obtain 45.1 g of a resin 2.

It is presumed that the structure of the resin 2 is a structure represented by Formula (P-2). As a result of measuring the molecular weight of the resin 2 by gel permeation chromatography (in terms of standard polystyrene equivalent value), the weight-average molecular weight (Mw) was 20,000. In addition, the equivalent of 4,4'-diaminodiphenyl ether was appropriately adjusted to synthesize each of a resin 2 having an Mw of 5,000, a resin 2 having an Mw of 10,000, and a resin 2 having an Mw of 30,000.

[Synthesis Examples 3 to 8: Synthesis of precursors (resin 3 to resin 8) of cyclization resin]

Resin 3 to resin 9 having a structure represented by any of Formulae (P-3) to (P-8) were synthesized according to the same method as in Synthesis Example 2, except that the compounds used were appropriately changed.

The Mw of the resin 3 was 20,000, the Mw of the resin 4 was 20,000, the Mw of the resin 5 was 20,000, the Mw of the resin 6 was 20,000, the Mw of the resin 7 was 20,000, and the Mw of the resin 8 was 20,000.

[Synthesis Example 9: Synthesis of precursor (resin 9) of cyclization resin]

294 g (1.0 mol) of 3,3',4,4'-biphenyltetracarboxylic acid dianhydride (BPDA) was placed in a separable flask having a capacity of 4 liters, 270 g (0.4 mol) of 2-hydroxyethyl methacrylate (HEMA) and 800 ml of γ-butyrolactone were added thereto and stirred at room temperature, and then 158.2 g of pyridine was added thereto while stirring to obtain a reaction mixture. After the heat generation due to the reaction was stopped, the reaction mixture was allowed to be cooled to room temperature and then allowed to stand for 16 hours.

Next, under ice-cooling, a solution obtained by dissolving 406 g of dicyclohexylcarbodiimide (DCC) in 400 ml of γ-butyrolactone was added to the reaction mixture over 40 minutes with stirring, and subsequently, a suspension in which 188 g (0.88 mol) of 2,2'-dimethyl-4,4-diaminobiphenyl (mTB: m-tolidine) was suspended in 560 ml of γ-butyrolactone was added thereto over 60 minutes with stirring. After further stirring at room temperature for 4 hours, 80 ml of ethyl alcohol was added thereto, the mixture was stirred for 1 hour, and then 2 L of γ-butyrolactone was added thereto. The precipitate formed in the reaction mixture was removed by filtration to obtain a reaction solution.

The obtained reaction solution was added to 8 liters of ethyl alcohol to form a precipitate consisting of a crude polymer. The generated crude polymer was filtered out and then dissolved in 5.0 liters of tetrahydrofuran to obtain a crude polymer solution. The obtained crude polymer solution was added dropwise to 60 liters of water to precipitate the polymer, and the obtained precipitate was filtered out and then subjected to vacuum drying to obtain a powdery polymer (a resin 9). As a result of measuring the molecular weight of the resin 9 by gel permeation chromatography (in terms of standard polystyrene equivalent value), the weight-average molecular weight (Mw) was 25,000. It is presumed that the structure of the resin 9 is a structure represented by Formula (P-9).

P-1

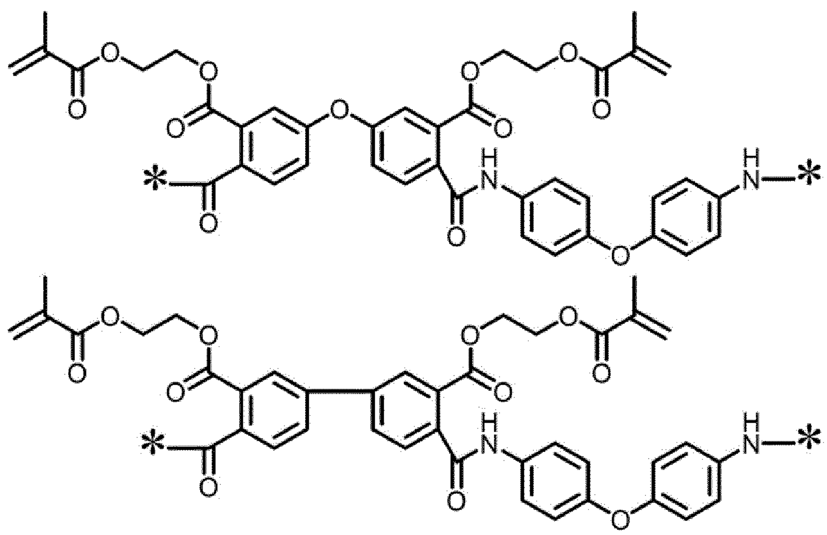

*A mixture having a molar ratio = 50 50 between skeletons derived from two kinds of acid anhydrides

P-2

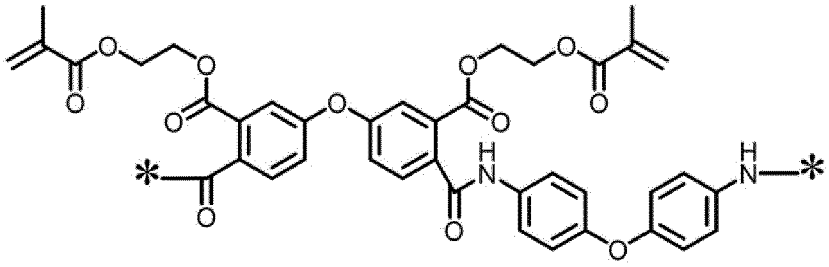

P-3

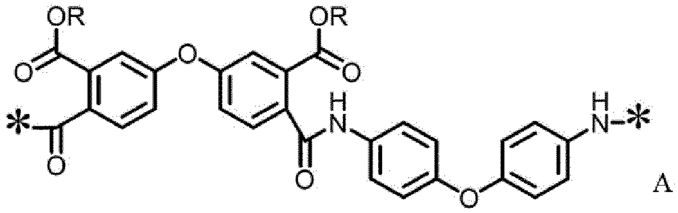

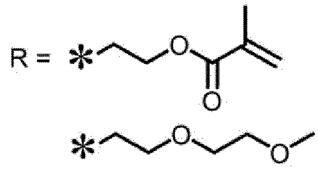

A mixture having a molar ratio = 50:50

P-4

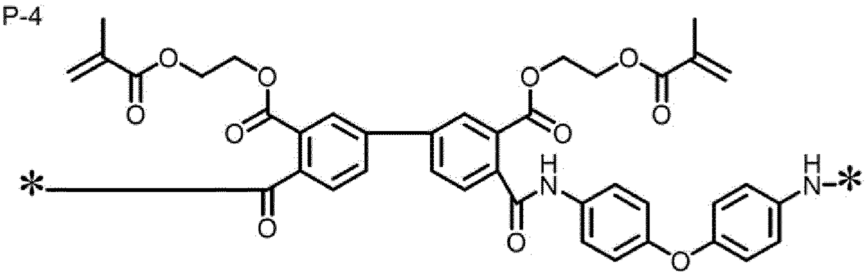

P-5

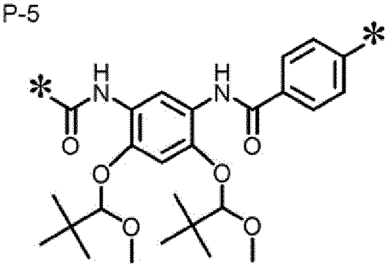

P-6

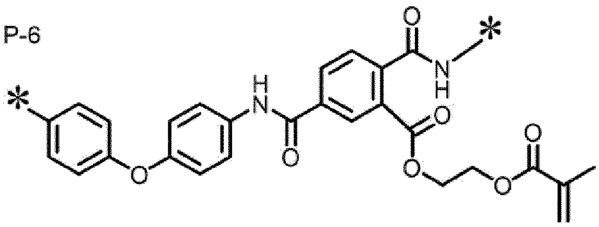

P-7

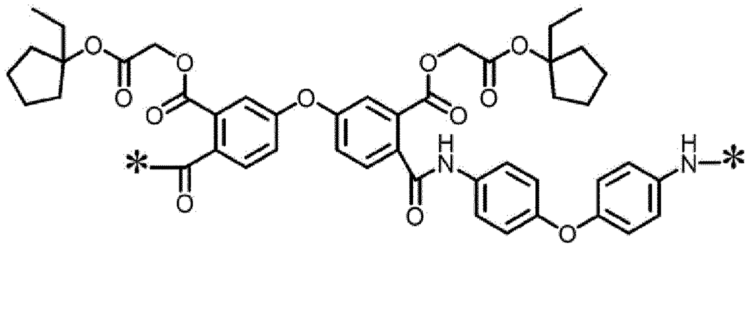

P-8

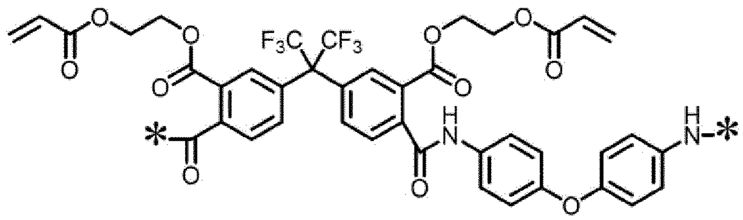

P-9

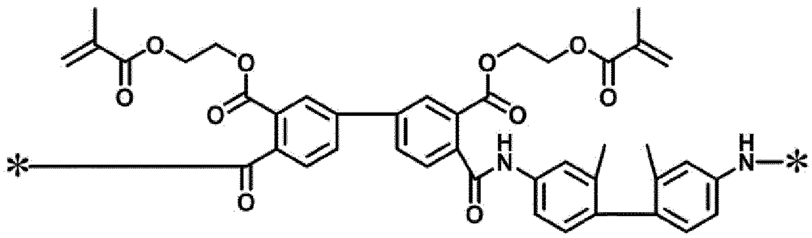

[Synthesis Example 10: Synthesis of resin 10]

A reaction was carried out in the same manner as in the method described in Synthesis Example 9 described above to obtain a resin 10, except that 164 g (0.70 mol) of pyromellitic acid anhydride (PMDA) and 78 g of 4,4'-oxydiphthalic acid dianhydride (ODPA) were used instead of 294 g of BPDA of Synthesis Example 9, and 142 g (0.66 mol) of mTB and 72 g (0.22 mol) of 2,2'-bis(trifluoromethyl)-4,4-diaminobiphenyl (TFMB) were used instead of 188 g of mTB. As a result of measuring the molecular weight of the resin 10 by gel permeation chromatography (in terms of standard polystyrene equivalent value), the weight-average molecular weight (Mw) was 32,000.

It is presumed that the structure of the resin 10 is a structure represented by a combination of four repeating units represented by Formula (P-10).

P-10

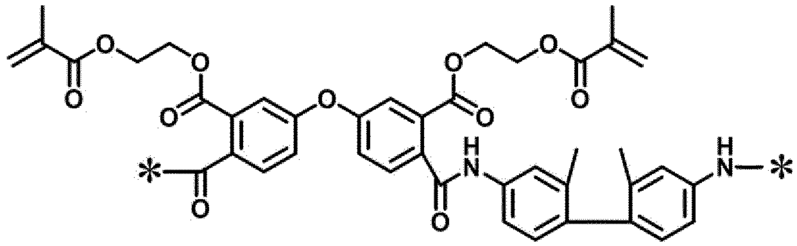

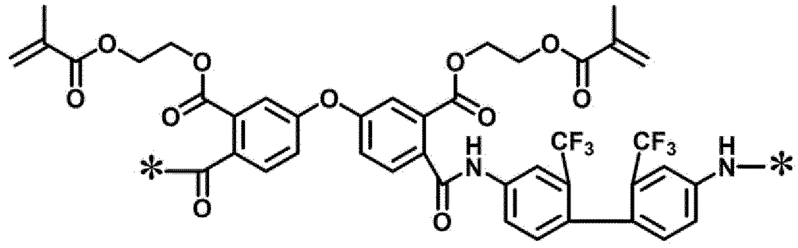

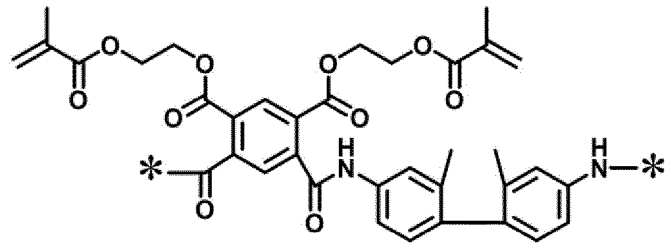

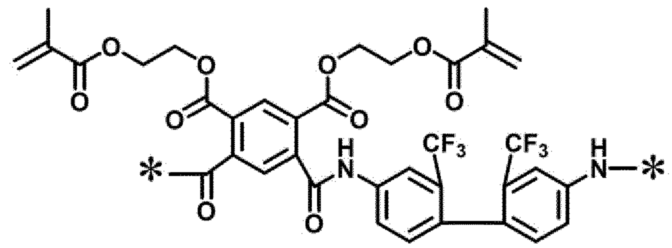

[Synthesis Examples 11 and 12: Synthesis of precursors (resin 11 and resin 12) of cyclization resin]

Resin 11 and resin 12 having a structure represented by any of Formulae (P-11) and (P-12) were synthesized according to the same method as in Synthesis Example 2, except that the compounds used were appropriately changed.

The Mw of the resin 11 was 20,000, and the Mw of the resin 12 was 20,000.

P-11

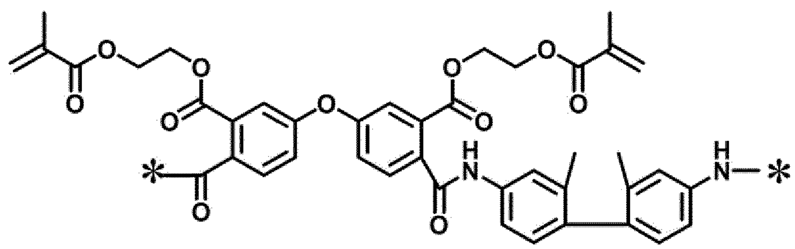

P-12

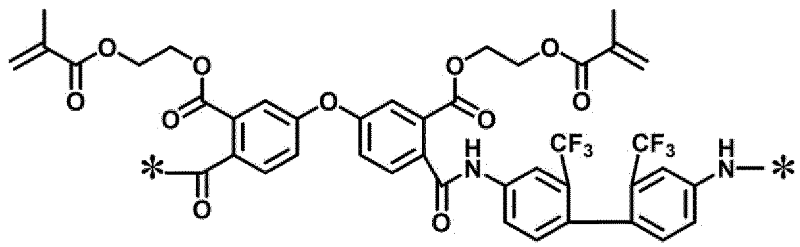

<Examples and Comparative Examples>

In each of Examples, the components shown in the table below were mixed to obtain each of the resin compositions. Further, in each of Comparative Examples, components shown in the following table were mixed to obtain a comparative composition.

Specifically, the content (blending amount) of each component described in the table other than the solvent was set to the amount (in terms of parts by mass) described in the column of "Parts by mass" of each column of the table.

The content (blending amount) of the solvent was such that the concentration of solid contents of the composition was set to the value (% by mass) of "Concentration of solid contents" in the table, and the ratio (mass ratio) of the content of each solvent with respect to the total mass of the solvent was set to be the ratio described in the column of "Ratio" in the table.

The obtained resin composition and the comparative composition were filtered under pressure using a filter made of polytetrafluoroethylene, having a micropore width of 0.8 μm.

In addition, in the table, the description of "-" indicates that the corresponding component is not contained in the composition.

In addition, the acid value of each resin was measured according to the above-described method, and the measurement results are shown in the table.

[Table 1]

| | | | Example 1 | Comparative Example 1 | Comparative Example 2 | Example 2 | Example 3 | Example 4 | Example 5 | Example 6 | Example 7 | Example 8 | Example 9 | Example 10 | Example 11 | Example 12 | Example 13 | Example 14 |
|---|---|---|---|---|---|---|---|---|---|---|---|---|---|---|---|---|---|---|
| Composition | Resin | Kind | Resin 1 | Resin 1 | Resin 1 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 |
| | | Mw | 20000 | 20000 | 20000 | 20000 | 20000 | 20000 | 20000 | 20000 | 20000 | 20000 | 20000 | 20000 | 20000 | 20000 | 20000 | 20000 |
| | | Acid value | 0.04 | 0.04 | 0.04 | 0.18 | 0.18 | 0.18 | 0.18 | 0.18 | 0.18 | 0.18 | 0.18 | 0.18 | 0.18 | 0.18 | 0.18 | 0.18 |
| | | Parts by mass | 35.5 | 35.5 | 35.7 | 35.5 | 35.5 | 35.5 | 35.5 | 35.5 | 35.5 | 35.5 | 35.5 | 35.5 | 35.5 | 35.5 | 35.5 | 35.5 |
| | Polymerizable compound | Kind | M-1 | M-1 | M-1 | M-1 | M-1 | M-1 | M-1 | M-1 | M-1 | M-1 | M-1 | M-1 | M-1 | M-1 | M-1 | M-1 |
| | | Parts by mass | 6 | 6 | 6 | 6 | 6 | 6 | 6 | 6 | 6 | 6 | 6 | 6 | 6 | 6 | 6 | 6 |
| | | Kind | - | - | - | - | - | - | - | - | - | - | - | - | - | - | - | - |
| | | Parts by mass | - | - | - | - | - | - | - | - | - | - | - | - | - | - | - | - |
| | Polymerization initiator | Kind | O-1 | O-1 | O-1 | O-1 | O-1 | O-1 | O-1 | O-1 | O-1 | O-1 | O-1 | O-1 | O-1 | O-1 | O-1 | O-1 |
| | | Parts by mass | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 |
| | Polymerization inhibitor | Kind | B-2 | B-2 | B-2 | B-1 | B-1 | B-1 | B-1 | B-1 | B-1 | B-1 | B-1 | B-1 | B-1 | B-1 | B-1 | B-1 |
| | | Parts by mass | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Silane coupling agent | Kind | C-2 | C-2 | C-2 | C-1 | C-1 | C-1 | C-1 | C-1 | C-1 | C-1 | C-1 | C-1 | C-1 | C-1 | C-1 | C-1 |
| | | Parts by mass | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 |
| | Migration suppressing agent | Kind | D-1 | D-1 | D-1 | D-1 | D-1 | D-1 | D-1 | D-1 | D-1 | D-1 | D-1 | D-1 | D-1 | D-1 | D-1 | D-1 |
| | | Parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| | Metal complex | Kind | A-1 | AR-1 | - | A-1 | A-2 | A-3 | A-4 | A-5 | A-6 | A-7 | A-8 | A-9 | A-10 | A-11 | A-12 | A-13 |
| | | Parts by mass | 1.2 | 1.2 | - | 1.2 | 1.2 | 1.2 | 1.2 | 1.2 | 1.2 | 1.2 | 1.2 | 1.2 | 1.2 | 1.2 | 1.2 | 1.2 |
| | | Kind | - | - | - | - | - | - | - | - | - | - | - | - | - | - | - | - |
| | | Parts by mass | - | - | - | - | - | - | - | - | - | - | - | - | - | - | - | - |
| | Additive | Kind | | | | | | | | | | | | | | | | |
| | | Parts by mass | - | - | - | - | - | - | - | - | - | - | - | - | - | - | - | - |
| | | Kind | - | - | - | - | - | - | - | - | - | - | - | - | - | - | - | - |
| | | Parts by mass | - | - | - | - | - | - | - | - | - | - | - | - | - | - | - | - |
| | Solvent | Kind | NMP | NMP | NMP | GBL | GBL | GBL | GBL | GBL | GBL | GBL | GBL | GBL | GBL | GBL | GBL | GBL |
| | | Ratio | 44 | 44 | 44 | 44 | 44 | 44 | 44 | 44 | 44 | 44 | 44 | 44 | 44 | 44 | 44 | 44 |
| | | Kind | EL | EL | EL | DMSO | DMSO | DMSO | DMSO | DMSO | DMSO | DMSO | DMSO | DMSO | DMSO | DMSO | DMSO | DMSO |
| | | Ratio | 11 | 11 | 11 | 11 | 11 | 11 | 11 | 11 | 11 | 11 | 11 | 11 | 11 | 11 | 11 | 11 |
| | Concentration of solid contents | | 42 | 42 | 42 | 42 | 42 | 42 | 42 | 42 | 42 | 42 | 42 | 42 | 42 | 42 | 42 | 42 |
| Process | Film thickness (μm) | | 20 | 20 | 20 | 20 | 20 | 20 | 20 | 20 | 20 | 20 | 20 | 20 | 20 | 20 | 20 | 20 |
| | Exposure wavelength (nm) | | 365 | 365 | 365 | 365 | 365 | 365 | 365 | 365 | 365 | 365 | 365 | 365 | 365 | 365 | 365 | 365 |
| | Exposure condition | | M | M | M | M | M | M | M | M | M | M | M | M | M | M | M | M |
| | Developer | | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone |
| | Cure temperature (°C) | | 230 | 230 | 230 | 230 | 230 | 230 | 230 | 230 | 230 | 230 | 230 | 230 | 230 | 230 | 230 | 230 |
| | Cure time (min) | | 180 | 180 | 180 | 180 | 180 | 180 | 180 | 180 | 180 | 180 | 180 | 180 | 180 | 180 | 180 | 180 |
| Evaluation | Chemical resistance | | A | B | C | A | A | A | A | A | A | A | A | A | A | A | A | A |
| | Heat resistance | | A | B | C | A | A | A | A | A | A | A | A | A | A | A | A | A |
| | Moisture resistance | | A | B | C | A | A | A | A | A | A | A | A | A | A | A | A | A |
| | Breaking elongation | | A | A | C | A | A | A | A | A | A | D | E | D | A | A | D | C |
| | Storage stability | | A | D | A | A | A | A | A | A | A | A | F | E | A | A | A | A |

[Table 2]

| | | | Example 15 | Example 16 | Example 17 | Example 18 | Example 19 | Example 20 | Example 21 | Example 22 | Example 23 | Example 24 | Example 25 | Example 26 | Example 27 | Example 28 | Example 29 | Example 30 | Example 31 | Example 32 | Example 33 | Example 34 |
|---|---|---|---|---|---|---|---|---|---|---|---|---|---|---|---|---|---|---|---|---|---|---|
| Composition | Resin | Kind | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 |
| | | Mw | 20000 | 20000 | 20000 | 20000 | 20000 | 20000 | 20000 | 20000 | 20000 | 20000 | 20000 | 20000 | 20000 | 20000 | 20000 | 20000 | 20000 | 20000 | 20000 | 20000 |
| | | Acid value | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 |
| | | Parts by mass | 35.5 | 35.5 | 35.5 | 35.5 | 35.5 | 35.5 | 35.5 | 35.5 | 35.5 | 35.5 | 35.5 | 35.5 | 35.5 | 35.5 | 35.5 | 35.5 | 35.5 | 35.5 | 35.5 | 35.5 |
| | Polymerizable compound | Kind | M-1 | M-1 | M-1 | M-1 | M-1 | M-1 | M-1 | M-1 | M-1 | M-1 | M-1 | M-1 | M-1 | M-1 | M-1 | M-1 | M-1 | M1 | M-1 | M1 |
| | | Parts by mass | 6 | 6 | 6 | 6 | 6 | 6 | 6 | 6 | 6 | 6 | 6 | 6 | 6 | 6 | 6 | 6 | 6 | 6 | 6 | 6 |
| | | Kind | - | - | - | - | - | - | - | - | - | - | - | - | - | - | - | - | - | - | - | - |
| | | Parts by mass | - | - | - | - | - | - | - | - | - | - | - | - | - | - | - | - | - | - | - | - |
| | Polymerization initiator | Kind | G-1 | G-1 | G-1 | G-1 | G-1 | G-1 | G-1 | G-1 | G-1 | G-1 | G-1 | G-1 | G-1 | G-1 | G-1 | G-1 | G-1 | G-1 | G-1 | G-1 |
| | | Parts by mass | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 |
| | Polymerization inhibitor | Kind | B-1 | B-1 | B-1 | B-1 | B-1 | B-1 | B-1 | B-1 | B-1 | B-1 | B-1 | B-1 | B-1 | B-1 | B-1 | B-1 | B-1 | B-1 | B-1 | B-1 |
| | | Parts by mass | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Silane coupling agent | Kind | C-1 | C-1 | C-1 | C-1 | C-1 | C-1 | C-1 | C-1 | C-1 | C-1 | C-1 | C-1 | C-1 | C-1 | C-1 | C-1 | C-1 | C-1 | C-1 | C-1 |
| | | Parts by mass | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 |
| | Migration suppressing agent | Kind | D-1 | D-1 | D-1 | D-1 | D-1 | D-1 | D-1 | D-1 | D-1 | D-1 | D-1 | D-1 | D-1 | D-1 | D-1 | D-1 | D-1 | D-1 | D-1 | D-1 |
| | | Parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| | Metal complex | Kind | A-14 | A-15 | A-16 | A-17 | A-18 | A-19 | A-20 | A-21 | A-22 | A-23 | A-24 | A-25 | A-26 | A-27 | A-28 | A-29 | A-30 | A-31 | A-32 | A-33 |
| | | Parts by mass | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 |
| | | Kind | - | - | - | - | - | - | - | - | - | - | - | - | - | - | - | - | - | - | - | - |
| | | Parts by mass | - | - | - | - | - | - | - | - | - | - | - | - | - | - | - | - | - | - | - | - |
| | Additive | Kind | - | - | - | - | - | - | - | - | - | - | - | - | - | - | - | - | - | - | - | - |
| | | Parts by mass | - | - | - | - | - | - | - | - | - | - | - | - | - | - | - | - | - | - | - | - |
| | | Kind | - | - | - | - | - | - | - | - | - | - | - | - | - | - | - | - | - | - | - | - |
| | | Parts by mass | - | - | - | - | - | - | - | - | - | - | - | - | - | - | - | - | - | - | - | - |
| | Solvent | Kind | GBL | GBL | GBL | GBL | GBL | GBL | GBL | GBL | GBL | GBL | GBL | GBL | GBL | GBL | GBL | GBL | GBL | GBL | GBL | GBL |
| | | Ratio | 44 | 44 | 44 | 44 | 44 | 44 | 44 | 44 | 44 | 44 | 44 | 44 | 44 | 44 | 44 | 44 | 44 | 44 | 44 | 44 |
| | | Kind | DMSO | DMSO | DMSO | DMSO | DMSO | DMSO | DMSO | DMSO | DMSO | DMSO | DMSO | DMSO | DMSO | DMSO | DMSO | DMSO | DMSO | DMSO | DMSO | DMSO |
| | | Ratio | 11 | 11 | 11 | 11 | 11 | 11 | 11 | 11 | 11 | 11 | 11 | 11 | 11 | 11 | 11 | 11 | 11 | 11 | 11 | 11 |
| | Concentration of solid contents | | 42 | 42 | 42 | 42 | 42 | 42 | 42 | 42 | 42 | 42 | 42 | 42 | 42 | 42 | 42 | 42 | 42 | 42 | 42 | 42 |
| Process | Film thickness (μm) | | 20 | 20 | 20 | 20 | 20 | 20 | 20 | 20 | 20 | 20 | 20 | 20 | 20 | 20 | 20 | 20 | 20 | 20 | 20 | 20 |
| | Exposure wavelength (nm) | | 365 | 365 | 365 | 365 | 365 | 365 | 365 | 365 | 365 | 365 | 365 | 365 | 365 | 365 | 365 | 365 | 365 | 365 | 365 | 365 |
| | Exposure condition | | M | M | M | M | M | M | M | M | M | M | M | M | M | M | M | M | M | M | M | M |
| | Developer | | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone |
| | Cure temperature (°C) | | 230 | 230 | 230 | 230 | 230 | 230 | 230 | 230 | 230 | 230 | 230 | 230 | 230 | 230 | 230 | 230 | 230 | 230 | 230 | 230 |
| | Cure time (min) | | 180 | 180 | 180 | 180 | 180 | 180 | 180 | 180 | 180 | 180 | 180 | 180 | 180 | 180 | 180 | 180 | 180 | 180 | 180 | 180 |
| Evaluation | Chemical resistance | | A | A | A | A | A | A | A | A | A | A | A | A | A | A | A | A | A | A | A | A |
| | Heat resistance | | A | A | A | A | A | A | A | A | A | A | A | A | A | A | A | A | A | A | A | A |
| | Moisture resistance | | A | A | A | A | A | A | A | A | A | A | A | A | A | A | A | A | A | A | A | A |
| | Breaking elongation | | A | A | A | A | A | A | A | A | A | A | A | A | A | A | A | B | B | A | A | A |
| | Storage stability | | A | A | A | A | A | A | A | A | A | A | A | A | A | A | A | B | B | A | A | A |

[Table 3]

| | | | Example 35 | Example 36 | Example 37 | Example 38 | Example 39 | Example 40 | Example 41 | Example 42 | Example 43 | Example 44 | Example 45 | Example 46 | Example 47 | Example 48 | Example 49 | Example 50 |
|---|---|---|---|---|---|---|---|---|---|---|---|---|---|---|---|---|---|---|
| Composition | Resin | Kind | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 |
| | | Mw | 20000 | 20000 | 20000 | 20000 | 20000 | 20000 | 20000 | 20000 | 20000 | 20000 | 20000 | 20000 | 20000 | 20000 | 20000 | 20000 |
| | | Acid value | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 |
| | | Parts by mass | 35.5 | 35.5 | 35.5 | 35.5 | 35.5 | 35.5 | 35.5 | 35.5 | 35.5 | 35.5 | 35.5 | 35.5 | 35.5 | 35.5 | 35.5 | 35.5 |
| | Polymerizable compound | Kind | M-1 | M-1 | M-1 | M-1 | M-1 | M-1 | M-1 | M-1 | M-1 | M-1 | M-1 | M-1 | M-1 | M-1 | M-1 | M-1 |
| | | Parts by mass | 6 | 6 | 6 | 6 | 6 | 6 | 6 | 6 | 6 | 6 | 6 | 6 | 6 | 6 | 6 | 6 |
| | | Kind | - | - | - | - | - | - | - | - | - | - | - | - | - | - | - | - |
| | | Parts by mass | - | - | - | - | - | - | - | - | - | - | - | - | - | - | - | - |
| | Polymerization initiator | Kind | G-1 | G-1 | G-1 | G-1 | G-1 | G-1 | G-1 | G-1 | G-1 | G-1 | G-1 | G-1 | G-1 | G-1 | G-1 | G-1 |
| | | Parts by mass | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 |
| | Polymerization inhibitor | Kind | B-1 | B-1 | B-1 | B-1 | B-1 | B-1 | B-1 | B-1 | B-1 | B-1 | B-1 | B-1 | B-1 | B-1 | B-1 | B-1 |
| | | Parts by mass | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Silane coupling agent | Kind | C-1 | C-1 | C-1 | C-1 | C-1 | C-1 | C-1 | C-1 | C-1 | C-1 | C-1 | C-1 | C-1 | C-1 | C-1 | C-1 |
| | | Parts by mass | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 |
| | Migration suppressing agent | Kind | D-1 | D-1 | D-1 | D-1 | D-1 | D-1 | D-1 | D-1 | D-1 | D-1 | D-1 | D-1 | D-1 | D-1 | D-1 | D-1 |
| | | Parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| | Metal complex | Kind | A-34 | A-35 | A-36 | A-37 | A-38 | A-39 | A-40 | A-41 | A-42 | A-43 | A-44 | A-45 | A-46 | A-47 | A-48 | A-49 |
| | | Parts by mass | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 |
| | | Kind | - | - | - | - | - | - | - | - | - | - | - | - | - | - | - | - |
| | | Parts by mass | - | - | - | - | - | - | - | - | - | - | - | - | - | - | - | - |
| | Additive | Kind | - | - | - | - | - | - | - | - | - | - | - | - | - | - | - | - |
| | | Parts by mass | - | - | - | - | - | - | - | - | - | - | - | - | - | - | - | - |
| | | Kind | - | - | - | - | - | - | - | - | - | - | - | - | - | - | - | - |
| | | Parts by mass | - | - | - | - | - | - | - | - | - | - | - | - | - | - | - | - |
| | Solvent | Kind | GBL | GBL | GBL | GBL | GBL | GBL | GBL | GBL | GBL | GBL | GBL | GBL | GBL | GBL | GBL | GBL |
| | | Ratio | 44 | 44 | 44 | 44 | 44 | 44 | 44 | 44 | 44 | 44 | 44 | 44 | 44 | 44 | 44 | 44 |
| | | Kind | DMSO | DMSO | DMSO | DMSO | DMSO | DMSO | DMSO | DMSO | DMSO | DMSO | DMSO | DMSO | DMSO | DMSO | DMSO | DMSO |
| | | Ratio | 11 | 11 | 11 | 11 | 11 | 11 | 11 | 11 | 11 | 11 | 11 | 11 | 11 | 11 | 11 | 11 |
| | Concentration of solid contents | | 42 | 42 | 42 | 42 | 42 | 42 | 42 | 42 | 42 | 42 | 42 | 42 | 42 | 42 | 42 | 42 |
| Process | Film thickness (µm) | | 20 | 20 | 20 | 20 | 20 | 20 | 20 | 20 | 20 | 20 | 20 | 20 | 20 | 20 | 20 | 20 |
| | Exposure wavelength (nm) | | 365 | 365 | 365 | 365 | 365 | 365 | 365 | 365 | 365 | 365 | 365 | 365 | 365 | 365 | 365 | 365 |
| | Exposure condition | | M | M | M | M | M | M | M | M | M | M | M | M | M | M | M | M |
| | Developer | | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone |
| | Cure temperature (°C) | | 230 | 230 | 230 | 230 | 230 | 230 | 230 | 230 | 230 | 230 | 230 | 230 | 230 | 230 | 230 | 230 |
| | Cure time (min) | | 180 | 180 | 180 | 180 | 180 | 180 | 180 | 180 | 180 | 180 | 180 | 180 | 180 | 180 | 180 | 180 |
| Evaluation | Chemical resistance | | A | A | A | A | A | A | A | A | A | A | A | A | A | A | A | A |
| | Heat resistance | | A | A | A | A | A | A | A | A | A | A | A | A | A | A | A | A |
| | Moisture resistance | | A | A | A | A | A | A | A | A | A | A | A | A | A | A | A | A |
| | Breaking elongation | | A | A | A | A | A | A | A | A | A | A | A | A | A | A | A | A |
| | Storage stability | | B | A | A | A | A | A | A | A | A | A | A | A | A | A | A | A |

[Table 4]

| | | | Example 51 | Example 52 | Example 53 | Example 54 | Example 55 | Example 56 | Example 57 | Example 58 | Example 59 | Example 60 | Example 61 | Example 62 | Example 63 | Example 64 | Example 65 |
|---|---|---|---|---|---|---|---|---|---|---|---|---|---|---|---|---|---|
| Composition | Resin | Kind | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 |
| | | Mw | 20000 | 20000 | 20000 | 20000 | 20000 | 20000 | 20000 | 20000 | 20000 | 20000 | 20000 | 20000 | 20000 | 20000 | 20000 |
| | | Acid value | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 |
| | | Parts by mass | 35.5 | 35.5 | 35.5 | 35.5 | 35.5 | 35.5 | 35.5 | 35.5 | 35.5 | 35.5 | 35.5 | 35.5 | 35.5 | 36.1 | 36.1 |
| | Polymerizable compound | Kind | M-1 | M-1 | M-1 | M-1 | M-1 | M-1 | M-1 | M-1 | M-1 | M-1 | M-1 | M-1 | M-1 | M-1 | M-1 |
| | | Parts by mass | 6 | 6 | 6 | 6 | 6 | 6 | 6 | 6 | 6 | 6 | 6 | 6 | 6 | 6 | 6 |
| | | Kind | - | - | - | - | - | - | - | - | - | - | - | - | - | - | - |
| | | Parts by mass | - | - | - | - | - | - | - | - | - | - | - | - | - | - | - |
| | Polymerization initiator | Kind | G-1 | G-1 | G-1 | G-1 | G-1 | G-1 | G-1 | G-1 | G-1 | G-1 | G-1 | G-1 | G-1 | G-1 | G-1 |
| | | Parts by mass | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 |
| | Polymerization inhibitor | Kind | B-1 | B-1 | B-1 | B-1 | B-1 | B-1 | B-1 | B-1 | B-1 | B-1 | B-1 | B-1 | B-1 | B-1 | B-1 |
| | | Parts by mass | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Silane coupling agent | Kind | C-1 | C-1 | C-1 | C-1 | C-1 | C-1 | C-1 | C-1 | C-1 | C-1 | C-1 | C-1 | C-1 | C-1 | C-1 |
| | | Parts by mass | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 |
| | Migration suppressing agent | Kind | D-1 | D-1 | D-1 | D-1 | D-1 | D-1 | D-1 | D-1 | D-1 | D-1 | D-1 | D-1 | D-1 | D-1 | D-1 |
| | | Parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| | Metal complex | Kind | A-50 | A-51 | A-52 | A-53 | A-54 | A-55 | A-56 | A-57 | A-58 | A-59 | A-60 | A-61 | A-62 | A-63 | A-64 |
| | | Parts by mass | 1.2 | 1.2 | 1.2 | 1.2 | 1.2 | 1.2 | 1.2 | 1.2 | 1.2 | 1.2 | 1.2 | 1.2 | 1.2 | 0.6 | 0.6 |
| | | Kind | - | - | - | - | - | - | - | - | - | - | - | - | - | A-14 | A-15 |
| | | Parts by mass | - | - | - | - | - | - | - | - | - | - | - | - | - | 0.6 | 0.6 |
| | Additive | Kind | - | - | - | - | - | - | - | - | - | - | - | - | - | - | - |
| | | Parts by mass | - | - | - | - | - | - | - | - | - | - | - | - | - | - | - |
| | | Kind | - | - | - | - | - | - | - | - | - | - | - | - | - | - | - |
| | | Parts by mass | - | - | - | - | - | - | - | - | - | - | - | - | - | - | - |
| | Solvent | Kind | GBL | GBL | GBL | GBL | GBL | GBL | GBL | GBL | GBL | GBL | GBL | GBL | GBL | GBL | GBL |
| | | Ratio | 44 | 44 | 44 | 44 | 44 | 44 | 44 | 44 | 44 | 44 | 44 | 44 | 44 | 44 | 44 |
| | | Kind | DMSO | DMSO | DMSO | DMSO | DMSO | DMSO | DMSO | DMSO | DMSO | DMSO | DMSO | DMSO | DMSO | DMSO | DMSO |
| | | Ratio | 11 | 11 | 11 | 11 | 11 | 11 | 11 | 11 | 11 | 11 | 11 | 11 | 11 | 11 | 11 |
| | Concentration of solid contents | | 42 | 42 | 42 | 42 | 42 | 42 | 42 | 42 | 42 | 42 | 42 | 42 | 42 | 42 | 42 |
| Process | Film thickness (μm) | | 20 | 20 | 20 | 20 | 20 | 20 | 20 | 20 | 20 | 20 | 20 | 20 | 20 | 20 | 20 |
| | Exposure wavelength (nm) | | 365 | 365 | 365 | 365 | 365 | 365 | 365 | 365 | 365 | 365 | 365 | 365 | 365 | 365 | 365 |
| | Exposure condition | | M | M | M | M | M | M | M | M | M | M | M | M | M | M | M |
| | Developer | | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone |
| | Cure temperature (°C) | | 230 | 230 | 230 | 230 | 230 | 230 | 230 | 230 | 230 | 230 | 230 | 230 | 230 | 230 | 230 |
| | Cure time (min) | | 180 | 180 | 180 | 180 | 180 | 180 | 180 | 180 | 180 | 180 | 180 | 180 | 180 | 180 | 180 |
| Evaluation | Chemical resistance | | A | A | A | A | A | A | A | A | A | A | A | A | A | A | A |
| | Heat resistance | | A | A | A | A | A | A | A | A | A | A | A | A | A | A | A |
| | Moisture resistance | | A | A | A | A | A | A | A | A | A | A | A | A | A | A | A |
| | Breaking elongation | | A | A | A | A | A | A | A | A | A | A | A | A | A | A | A |
| | Storage stability | | A | A | A | A | A | A | A | A | A | A | A | A | A | A | A |

[Table 5]

| | | | Example 66 | Example 67 | Example 68 | Example 69 | Example 70 | Example 71 | Example 72 | Example 73 | Example 74 | Example 75 | Example 76 | Example 77 | Example 78 | Example 79 | Example 80 | Example 81 |
|---|---|---|---|---|---|---|---|---|---|---|---|---|---|---|---|---|---|---|
| Composition | Resin | Kind | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 |
| | | Mw | 20000 | 20000 | 20000 | 20000 | 20000 | 20000 | 20000 | 20000 | 20000 | 20000 | 20000 | 20000 | 20000 | 20000 | 20000 | 20000 |
| | | Acid value | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 |
| | | Parts by mass | 35.5 | 35.5 | 35.5 | 35.5 | 35.5 | 35.5 | 35.5 | 35.5 | 35.5 | 36.1 | 36.1 | 36.1 | 36.1 | 34.6 | 34.6 | 34.6 |
| | Polymerizable compound | Kind | M-1 | M-1 | M-1 | M-1 | M-1 | M-1 | M-1 | M-1 | M-1 | M-1 | M-1 | M-1 | M-1 | M-1 | M-1 | M-1 |
| | | Parts by mass | 6 | 6 | 6 | 6 | 6 | 6 | 6 | 6 | 6 | 6 | 6 | 6 | 6 | 6 | 6 | 6 |
| | | Kind | - | - | - | - | - | - | - | - | - | - | - | - | - | - | - | - |
| | | Parts by mass | - | - | - | - | - | - | - | - | - | - | - | - | - | - | - | - |
| | Polymerization initiator | Kind | G-1 | G-1 | G-1 | G-1 | G-1 | G-1 | G-1 | G-1 | G-1 | G-1 | G-1 | G-1 | G-1 | G-1 | G-1 | G-1 |
| | | Parts by mass | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 |
| | Polymerization inhibitor | Kind | B-1 | B-1 | B-1 | B-1 | B-1 | B-1 | B-1 | B-1 | B-1 | B-1 | B-1 | B-1 | B-1 | B-1 | B-1 | B-1 |
| | | Parts by mass | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Silane coupling agent | Kind | C-1 | C-1 | C-1 | C-1 | C-1 | C-1 | C-1 | C-1 | C-1 | C-1 | C-1 | C-1 | C-1 | C-1 | C-1 | C-1 |
| | | Parts by mass | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 |
| | Migration suppressing agent | Kind | D-1 | D-1 | D-1 | D-1 | D-1 | D-1 | D-1 | D-1 | D-1 | D-1 | D-1 | D-1 | D-1 | D-1 | D-1 | D-1 |
| | | Parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| | Metal complex | Kind | A-65 | A-66 | A-67 | A-68 | A-69 | A-70 | A-71 | A-72 | A-73 | A-5 | A-5 | A-1 | A-1 | A-1 | A-1 | A-1 |
| | | Parts by mass | 1.2 | 1.2 | 1.2 | 1.2 | 1.2 | 1.2 | 1.2 | 1.2 | 1.2 | 0.6 | 0.6 | 0.6 | 0.6 | 1.2 | 1.2 | 1.2 |
| | | Kind | - | - | - | - | - | - | - | - | - | A-14 | A-15 | A-2 | A-8 | - | - | - |
| | | Parts by mass | - | - | - | - | - | - | - | - | - | 0.6 | 0.6 | 0.6 | 0.6 | - | - | - |
| | Additive | Kind | - | - | - | - | - | - | - | - | - | - | - | - | - | T-1 | T-2 | T-3 |
| | | Parts by mass | - | - | - | - | - | - | - | - | - | - | - | - | - | 0.9 | 0.9 | 0.9 |
| | | Kind | - | - | - | - | - | - | - | - | - | - | - | - | - | - | - | - |
| | | Parts by mass | - | - | - | - | - | - | - | - | - | - | - | - | - | - | - | - |
| | Solvent | Kind | GBL | GBL | GBL | GBL | GBL | GBL | GBL | GBL | GBL | GBL | GBL | GBL | GBL | GBL | GBL | GBL |
| | | Ratio | 44 | 44 | 44 | 44 | 44 | 44 | 44 | 44 | 44 | 44 | 44 | 44 | 44 | 44 | 44 | 44 |
| | | Kind | DMSO | DMSO | DMSO | DMSO | DMSO | DMSO | DMSO | DMSO | DMSO | DMSO | DMSO | DMSO | DMSO | DMSO | DMSO | DMSO |
| | | Ratio | 11 | 11 | 11 | 11 | 11 | 11 | 11 | 11 | 11 | 11 | 11 | 11 | 11 | 11 | 11 | 11 |
| | Concentration of solid contents | | 42 | 42 | 42 | 42 | 42 | 42 | 42 | 42 | 42 | 42 | 42 | 42 | 42 | 42 | 42 | 42 |
| Process | Film thickness (µm) | | 20 | 20 | 20 | 20 | 20 | 20 | 20 | 20 | 20 | 20 | 20 | 20 | 20 | 20 | 20 | 20 |
| | Exposure wavelength (nm) | | 365 | 365 | 365 | 365 | 365 | 365 | 365 | 365 | 365 | 365 | 365 | 365 | 365 | 365 | 365 | 365 |
| | Exposure condition | | M | M | M | M | M | M | M | M | M | M | M | M | M | M | M | M |
| | Developer | | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone |
| | Cure temperature (°C) | | 230 | 230 | 230 | 230 | 230 | 230 | 230 | 230 | 230 | 230 | 230 | 230 | 230 | 230 | 230 | 230 |
| | Cure time (min) | | 180 | 180 | 180 | 180 | 180 | 180 | 180 | 180 | 180 | 180 | 180 | 180 | 180 | 180 | 180 | 180 |
| Evaluation | Chemical resistance | | A | A | A | A | A | A | A | A | A | A | A | A | A | A | A | A |
| | Heat resistance | | A | A | A | A | A | A | A | A | A | A | A | A | A | A | A | A |
| | Moisture resistance | | A | A | A | A | A | A | A | A | A | A | A | A | A | A | A | A |
| | Breaking elongation | | A | A | A | A | A | A | A | A | A | A | A | A | A | A | A | A |
| | Storage stability | | A | A | A | A | A | A | A | A | A | A | A | A | A | A | A | A |

[Table 6]

| | | | Example 82 | Example 83 | Example 84 | Example 85 | Example 86 | Example 87 | Example 88 | Example 89 | Example 90 | Example 91 | Example 92 | Example 93 | Example 94 | Example 95 | Example 96 |
|---|---|---|---|---|---|---|---|---|---|---|---|---|---|---|---|---|---|
| Composition | Resin | Kind | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 |
| | | Mw | 20000 | 20000 | 20000 | 20000 | 20000 | 20000 | 20000 | 20000 | 20000 | 20000 | 20000 | 20000 | 20000 | 20000 | 20000 |
| | | Acid value | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 |
| | | Parts by mass | 35.5 | 34.6 | 35.5 | 34.6 | 35.5 | 34.6 | 35.5 | 34.6 | 35.5 | 34.6 | 35.5 | 34.6 | 35.5 | 34.6 | 35.5 |
| | Polymerizable compound | Kind | M-1 | M-1 | M-1 | M-1 | M-1 | M-1 | M-1 | M-1 | M-1 | M-1 | M-1 | M-1 | M-1 | M-1 | M-1 |
| | | Parts by mass | 6 | 6 | 6 | 6 | 6 | 6 | 6 | 6 | 6 | 6 | 6 | 6 | 6 | 6 | 6 |
| | | Kind | - | - | - | - | - | - | - | - | - | - | - | - | - | - | - |
| | | Parts by mass | - | - | - | - | - | - | - | - | - | - | - | - | - | - | - |
| | Polymerization initiator | Kind | G-1 | G-1 | G-1 | G-1 | G-1 | G-1 | G-1 | G-1 | G-1 | G-1 | G-1 | G-1 | G-1 | G-1 | G-1 |
| | | Parts by mass | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 |
| | Polymerization inhibitor | Kind | B-3 | B-3 | B-4 | B-4 | B-5 | B-5 | B-1 | B-1 | B-1 | B-1 | B-1 | B-1 | B-1 | B-1 | B-1 |
| | | Parts by mass | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Silane coupling agent | Kind | C-1 | C-1 | C-1 | C-1 | C-1 | C-1 | C-3 | C-3 | C-4 | C-4 | C-5 | C-5 | C-1 | C-1 | C-1 |
| | | Parts by mass | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 |
| | Migration suppressing agent | Kind | D-1 | D-1 | D-1 | D-1 | D-1 | D-1 | D-1 | D-1 | D-1 | D-1 | D-1 | D-1 | D-3 | D-3 | D-4 |
| | | Parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| | Metal complex | Kind | A-1 | A-1 | A-1 | A-1 | A-1 | A-1 | A-1 | A-1 | A-1 | A-1 | A-1 | A-1 | A-1 | A-1 | A-1 |
| | | Parts by mass | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 |
| | | Kind | - | - | - | - | - | - | - | - | - | - | - | - | - | - | - |
| | | Parts by mass | - | - | - | - | - | - | - | - | - | - | - | - | - | - | - |
| | Additive | Kind | - | T-1 | - | T-1 | - | T-1 | | T-1 | - | T-1 | - | T-1 | - | T-1 | |
| | | Parts by mass | - | 0.9 | - | 0.9 | - | 0.9 | | 0.9 | - | 0.9 | - | 0.9 | - | 0.9 | |
| | | Kind | - | - | - | - | - | - | - | - | - | - | - | - | - | - | - |
| | | Parts by mass | - | - | - | - | - | - | - | - | - | - | - | - | - | - | - |
| | Solvent | Kind | GBL | GBL | GBL | GBL | GBL | GBL | GBL | GBL | GBL | GBL | GBL | GBL | GBL | GBL | GBL |
| | | Ratio | 44 | 44 | 44 | 44 | 44 | 44 | 44 | 44 | 44 | 44 | 44 | 44 | 44 | 44 | 44 |
| | | Kind | DMSO | DMSO | DMSO | DMSO | DMSO | DMSO | DMSO | DMSO | DMSO | DMSO | DMSO | DMSO | DMSO | DMSO | DMSO |
| | | Ratio | 11 | 11 | 11 | 11 | 11 | 11 | 11 | 11 | 11 | 11 | 11 | 11 | 11 | 11 | 11 |
| | Concentration of solid contents | | 42 | 42 | 42 | 42 | 42 | 42 | 42 | 42 | 42 | 42 | 42 | 42 | 42 | 42 | 42 |
| Process | Film thickness (µm) | | 20 | 20 | 20 | 20 | 20 | 20 | 20 | 20 | 20 | 20 | 20 | 20 | 20 | 20 | 20 |
| | Exposure wavelength (nm) | | 365 | 365 | 365 | 365 | 365 | 365 | 365 | 365 | 365 | 365 | 365 | 365 | 365 | 365 | 365 |
| | Exposure condition | | M | M | M | M | M | M | M | M | M | M | M | M | M | M | M |
| | Developer | | Cyclopen tanone | Cyclopen tanone | Cyclopen tanone | Cyclopen tanone | Cyclopen tanone | Cyclopen tanone | Cyclopen tanone | Cyclopen tanone | Cyclopen tanone | Cyclopen tanone | Cyclopen tanone | Cyclopen tanone | Cyclopen tanone | Cyclopen tanone | Cyclopent anone |
| | Cure temperature (°C) | | 230 | 230 | 230 | 230 | 230 | 230 | 230 | 230 | 230 | 230 | 230 | 230 | 230 | 230 | 230 |
| | Cure time (min) | | 180 | 180 | 180 | 180 | 180 | 180 | 180 | 180 | 180 | 180 | 180 | 180 | 180 | 180 | 180 |
| Evaluation | Chemical resistance | | A | A | A | A | A | A | A | A | A | A | A | A | A | A | A |
| | Heat resistance | | A | A | A | A | A | A | A | A | A | A | A | A | A | A | A |
| | Moisture resistance | | A | A | A | A | A | A | A | A | A | A | A | A | A | A | A |
| | Breaking elongation | | A | A | A | A | A | A | A | A | A | A | A | A | A | A | A |
| | Storage stability | | A | A | A | A | A | A | A | A | A | A | A | A | A | A | A |

[Table 7]

| | | | Example 97 | Example 98 | Example 99 | Example 100 | Example 101 | Example 102 | Example 103 | Example 104 | Example 105 | Example 106 | Example 107 | Example 108 | Example 109 | Example 110 | Example 111 | Example 112 |
|---|---|---|---|---|---|---|---|---|---|---|---|---|---|---|---|---|---|---|
| Composition | Resin | Kind | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 |
| | | Mw | 20000 | 20000 | 20000 | 20000 | 20000 | 20000 | 20000 | 20000 | 20000 | 20000 | 20000 | 20000 | 20000 | 20000 | 20000 | 20000 |
| | | Acid value | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 |
| | | Parts by mass | 34.6 | 35.4 | 34.5 | 35.4 | 34.5 | 35.4 | 34.5 | 35.5 | 34.6 | 35.5 | 34.6 | 35.76 | 35.8 | 35.8 | 35.8 | 35.5 |
| | Polymerizable compound | Kind | M-1 | M-1 | M-1 | M-1 | M-1 | M-1 | M-1 | M-2 | M-2 | M-3 | M-3 | M-1 | M-1 | M-1 | M-1 | M-1 |
| | | Parts by mass | 6 | 6 | 6 | 6 | 6 | 6 | 6 | 6 | 6 | 6 | 6 | 6 | 6 | 6 | 6 | 6 |
| | | Kind | - | - | - | - | - | - | - | - | - | - | - | - | - | - | - | - |
| | | Parts by mass | - | - | - | - | - | - | - | - | - | - | - | - | - | - | - | - |
| | Polymerization initiator | Kind | G-1 | G-1 | G-1 | G-1 | G-1 | G-1 | G-1 | G-1 | G-1 | G-1 | G-1 | G-1 | G-1 | G-1 | G-1 | G-2 |
| | | Parts by mass | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 |
| | Polymerization inhibitor | Kind | B-1 | B-1 | B-1 | B-1 | B-1 | B-1 | B-1 | B-1 | B-1 | B-1 | B-1 | B-1 | B-1 | B-1 | B-1 | B-1 |
| | | Parts by mass | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Silane coupling agent | Kind | C-1 | C-1 | C-1 | C-1 | C-1 | C-1 | C-1 | C-1 | C-1 | C-1 | C-1 | C-1 | C-1 | C-1 | C-1 | C-1 |
| | | Parts by mass | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 |
| | Migration suppressing agent | Kind | D-4 | D-1 | D-1 | D-1 | D-1 | D-1 | D-1 | D-1 | D-1 | D-1 | D-1 | D-1 | D-1 | D-1 | D-1 | D-1 |
| | | Parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| | Metal complex | Kind | A-1 | A-1 | A-1 | A-1 | A-1 | A-1 | A-1 | A-1 | A-1 | A-1 | A-1 | A-1 | A-1 | A-1 | A-1 | A-1 |
| | | Parts by mass | 1.2 | 1.2 | 1.2 | 1.2 | 1.2 | 1.2 | 1.2 | 1.2 | 1.2 | 1.2 | 1.2 | 0.04 | 0.6 | 1.2 | 2.4 | 1.2 |
| | | Kind | - | - | - | - | - | - | - | - | - | - | - | - | - | - | - | - |
| | | Parts by mass | - | - | - | - | - | - | - | - | - | - | - | - | - | - | - | - |
| | Additive | Kind | T-1 | - | T-1 | - | T-1 | - | T-1 | - | T-1 | - | T-1 | - | - | - | - | - |
| | | Parts by mass | 0.9 | - | 0.9 | - | 0.9 | - | 0.9 | - | 0.9 | - | 0.9 | - | - | - | - | - |
| | | Kind | - | E-1 | E-1 | E-2 | E-2 | F-1 | F-1 | - | - | - | - | - | - | - | - | - |
| | | Parts by mass | - | 0.1 | 0.1 | 0.1 | 0.1 | 0.1 | 0.1 | - | - | - | - | - | - | - | - | - |
| | Solvent | Kind | GBL | GBL | GBL | GBL | GBL | GBL | GBL | GBL | GBL | GBL | GBL | GBL | GBL | GBL | GBL | GBL |
| | | Ratio | 44 | 44 | 44 | 44 | 44 | 44 | 44 | 44 | 44 | 44 | 44 | 44 | 44 | 44 | 44 | 44 |
| | | Kind | DMSO | DMSO | DMSO | DMSO | DMSO | DMSO | DMSO | DMSO | DMSO | DMSO | DMSO | DMSO | DMSO | DMSO | DMSO | DMSO |
| | | Ratio | 11 | 11 | 11 | 11 | 11 | 11 | 11 | 11 | 11 | 11 | 11 | 11 | 11 | 11 | 11 | 11 |
| | Concentration of solid contents | | 42 | 42 | 42 | 42 | 42 | 42 | 42 | 42 | 42 | 42 | 42 | 42 | 42 | 42 | 42 | 42 |
| Process | Film thickness (μm) | | 20 | 20 | 20 | 20 | 20 | 20 | 20 | 20 | 20 | 20 | 20 | 20 | 20 | 20 | 20 | 20 |
| | Exposure wavelength (nm) | | 365 | 365 | 365 | 365 | 365 | 365 | 365 | 365 | 365 | 365 | 365 | 365 | 365 | 365 | 365 | 365 |
| | Exposure condition | | M | M | M | M | M | M | M | M | M | M | M | M | M | M | M | M |
| | Developer | | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone |
| | Cure temperature (°C) | | 230 | 230 | 230 | 230 | 230 | 230 | 230 | 230 | 230 | 230 | 230 | 230 | 230 | 230 | 230 | 230 |
| | Cure time (min) | | 180 | 180 | 180 | 180 | 180 | 180 | 180 | 180 | 180 | 180 | 180 | 180 | 180 | 180 | 180 | 180 |
| Evaluation | Chemical resistance | | A | A | A | A | A | A | A | A | A | A | A | A | A | A | A | A |
| | Heat resistance | | A | A | A | A | A | A | A | A | A | A | A | B | A | A | A | A |
| | Moisture resistance | | A | A | A | A | A | A | A | A | A | A | A | B | A | A | A | A |
| | Breaking elongation | | A | A | A | A | A | A | A | A | A | A | A | A | A | A | A | A |
| | Storage stability | | A | A | A | A | A | A | A | A | A | A | A | A | A | A | A | A |

[Table 8]

| | | | Example 113 | Example 114 | Example 115 | Example 116 | Example 117 | Example 118 | Example 119 | Example 120 | Example 121 | Example 122 | Example 123 | Example 124 | Example 125 | Example 126 | Example 127 | Example 128 |
|---|---|---|---|---|---|---|---|---|---|---|---|---|---|---|---|---|---|---|
| Composition | Resin | Kind | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 | Resin 2 |
| | | Mw | 20000 | 20000 | 20000 | 20000 | 20000 | 20000 | 20000 | 20000 | 20000 | 20000 | 20000 | 20000 | 20000 | 20000 | 20000 | 20000 |
| | | Acid value | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 | 0.18 |
| | | Parts by mass | 34.6 | 35.5 | 34.6 | 35.5 | 34.6 | 34.1 | 33.2 | 34.1 | 33.2 | 34.1 | 33.2 | 35.8 | 35.8 | 35.8 | 35.8 | 35.8 |
| | Polymerizable compound | Kind | M-1 | M-1 | M-1 | M-1 | M-1 | M-1 | M-1 | M-1 | M-1 | M-1 | M-1 | M-1 | M-1 | M-1 | M-1 | M-1 |
| | | Parts by mass | 6 | 6 | 6 | 6 | 6 | 6 | 6 | 6 | 6 | 6 | 6 | 6 | 6 | 6 | 6 | 6 |
| | | Kind | - | - | - | - | - | U-1 | U-1 | U-2 | U-2 | U-3 | U-3 | - | - | - | - | - |
| | | Parts by mass | - | - | - | - | - | 1.4 | 1.4 | 1.4 | 1.4 | 1.4 | 1.4 | - | - | - | - | - |
| | Polymerization initiator | Kind | G-2 | G-3 | G-3 | G-4 | G-4 | G-1 | G-1 | G-1 | G-1 | G-1 | G-1 | G-1 | G-1 | G-1 | G-4 | G-1 |
| | | Parts by mass | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 |
| | Polymerization inhibitor | Kind | B-1 | B-1 | B-1 | B-1 | B-1 | B-1 | B-1 | B-1 | B-1 | B-1 | B-1 | B-1 | B-1 | B-1 | B-1 | B-1 |
| | | Parts by mass | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Silane coupling agent | Kind | C-1 | C-1 | C-1 | C-1 | C-1 | C-1 | C-1 | C-1 | C-1 | C-1 | C-1 | C-1 | C-1 | C-1 | C-1 | C-1 |
| | | Parts by mass | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 |
| | Migration suppressing agent | Kind | D-1 | D-1 | D-1 | D-1 | D-1 | D-1 | D-1 | D-1 | D-1 | D-1 | D-1 | D-1 | D-1 | D-1 | D-1 | D-1 |
| | | Parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| | Metal complex | Kind | A-1 | A-1 | A-1 | A-1 | A-1 | A-1 | A-1 | A-1 | A-1 | A-1 | A-1 | A-1 | A-1 | A-1 | A-1 | A-1 |
| | | Parts by mass | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 |
| | | Kind | - | - | - | - | - | - | - | - | - | - | - | - | - | - | - | - |
| | | Parts by mass | - | - | - | - | - | - | - | - | - | - | - | - | - | - | - | - |
| | Additive | Kind | T-1 | - | T-1 | - | T-1 | - | T-1 | - | T-1 | - | T-1 | - | - | - | - | - |
| | | Parts by mass | 0.9 | - | 0.9 | - | 0.9 | - | 0.9 | - | 0.9 | - | 0.9 | - | - | - | - | - |
| | | Kind | - | - | - | - | - | - | - | - | - | - | - | - | - | - | - | - |
| | | Parts by mass | - | - | - | - | - | - | - | - | - | - | - | - | - | - | - | - |
| | Solvent | Kind | GBL | GBL | GBL | GBL | GBL | GBL | GBL | GBL | GBL | GBL | GBL | GBL | GBL | GBL | GBL | GBL |
| | | Ratio | 44 | 44 | 44 | 44 | 44 | 44 | 44 | 44 | 44 | 44 | 44 | 44 | 44 | 44 | 44 | 44 |
| | | Kind | DMSO | DMSO | DMSO | DMSO | DMSO | DMSO | DMSO | DMSO | DMSO | DMSO | DMSO | DMSO | DMSO | DMSO | DMSO | DMSO |
| | | Ratio | 11 | 11 | 11 | 11 | 11 | 11 | 11 | 11 | 11 | 11 | 11 | 11 | 11 | 11 | 11 | 11 |
| | Concentration of solid contents | | 42 | 42 | 42 | 42 | 42 | 42 | 42 | 42 | 42 | 42 | 42 | 30 | 50 | 42 | 42 | 42 |
| Process | Film thickness (µm) | | 20 | 20 | 20 | 20 | 20 | 20 | 20 | 20 | 20 | 20 | 20 | 10 | 30 | 20 | 20 | 20 |
| | Exposure wavelength (nm) | | 365 | 365 | 365 | 365 | 365 | 365 | 365 | 365 | 365 | 365 | 365 | 365 | 365 | 405 | 405 | 365 |
| | Exposure condition | | M | M | M | M | M | M | M | M | M | M | M | M | M | D | D | M |
| | Developer | | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone |
| | Cure temperature (°C) | | 230 | 230 | 230 | 230 | 230 | 230 | 230 | 230 | 230 | 230 | 230 | 230 | 230 | 230 | 230 | 180 |
| | Cure time (min) | | 180 | 180 | 180 | 180 | 180 | 180 | 180 | 180 | 180 | 180 | 180 | 180 | 180 | 180 | 180 | 120 |
| Evaluation | Chemical resistance | | A | A | A | A | A | A | A | A | A | A | A | A | A | A | A | A |
| | Heat resistance | | A | A | A | A | A | A | A | A | A | A | A | A | A | A | A | A |
| | Moisture resistance | | A | A | A | A | A | A | A | A | A | A | A | A | A | A | A | A |
| | Breaking elongation | | A | A | A | A | A | A | A | A | A | A | A | A | A | A | A | A |
| | Storage stability | | A | A | A | A | A | A | A | A | A | A | A | A | A | A | A | A |

[Table 9]

| | | | Example 129 | Example 130 | Example 131 | Example 132 | Example 133 | Example 134 | Example 135 | Example 136 | Example 137 | Example 138 | Example 139 | Example 140 | Example 141 | Example 142 | Example 143 |
|---|---|---|---|---|---|---|---|---|---|---|---|---|---|---|---|---|---|
| Composition | Resin | Kind | Resin 2 | Resin 3 | Resin 4 | Resin 5 | Resin 6 | Resin 7 | Resin 8 | Resin 9 | Resin 10 | Resin 11 | Resin 12 | Resin 2 | Resin 2 | Resin 2 | Resin 2 |
| | | Mw | 20000 | 20000 | 20000 | 20000 | 20000 | 20000 | 20000 | 25000 | 32000 | 20000 | 20000 | 5000 | 10000 | 30000 | 20000 |
| | | Acid value | 0.18 | 0.18 | 0.18 | 0.18 | 0.18 | 0.18 | 0.18 | 0.04 | 0.04 | 0.18 | 0.18 | 0.18 | 0.18 | 0.18 | 0.18 |
| | | Parts by mass | 35.8 | 35.5 | 35.5 | 35.5 | 35.5 | 35.5 | 35.5 | 35.5 | 35.5 | 35.5 | 35.5 | 35.5 | 35.5 | 35.5 | 36.5 |
| | Polymerizable compound | Kind | M-1 | M-1 | M-1 | M-1 | M-1 | M-1 | M-1 | M-1 | M-1 | M-1 | M-1 | M-1 | M-1 | M-1 | M-1 |
| | | Parts by mass | 6 | 6 | 6 | 6 | 6 | 6 | 6 | 6 | 6 | 6 | 6 | 6 | 6 | 6 | 6 |
| | | Kind | - | - | - | - | - | - | - | - | - | - | - | - | - | - | - |
| | | Parts by mass | - | - | - | - | - | - | - | - | - | - | - | - | - | - | - |
| | Polymerization initiator | Kind | G-1 | G-1 | G-1 | G-1 | G-1 | G-1 | G-1 | G-1 | G-1 | G-1 | G-1 | G-1 | G-1 | G-1 | G-1 |
| | | Parts by mass | 1.3 | 1.3 | 1.3 | 1.3 | 1.3 | 1.3 | 1.3 | 1.3 | 1.3 | 1.3 | 1.3 | 1.3 | 1.3 | 1.3 | 1.3 |
| | Polymerization inhibitor | Kind | B-1 | B-1 | B-1 | B-1 | B-1 | B-1 | B-1 | B-1 | B-1 | B-1 | B-1 | B-1 | B-1 | B-1 | - |
| | | Parts by mass | 0.1 | 0.1 | 0.1 | 0.1 | 0.1 | 0.1 | 0.1 | 0.1 | 0.1 | 0.1 | 0.1 | 0.1 | 0.1 | 0.1 | - |
| | Silane coupling agent | Kind | C-1 | C-1 | C-1 | C-1 | C-1 | C-1 | C-1 | C-1 | C-1 | C-1 | C-1 | C-1 | C-1 | C-1 | - |
| | | Parts by mass | 0.7 | 0.7 | 0.7 | 0.7 | 0.7 | 0.7 | 0.7 | 0.7 | 0.7 | 0.7 | 0.7 | 0.7 | 0.7 | 0.7 | - |
| | Migration suppressing agent | Kind | D-1 | D-1 | D-1 | D-1 | D-1 | D-1 | D-1 | D-1 | D-1 | D-1 | D-1 | D-1 | D-1 | D-1 | - |
| | | Parts by mass | 0.2 | 0.2 | 0.2 | 0.2 | 0.2 | 0.2 | 0.2 | 0.2 | 0.2 | 0.2 | 0.2 | 0.2 | 0.2 | 0.2 | - |
| | Metal complex | Kind | A-1 | A-1 | A-1 | A-1 | A-1 | A-1 | A-1 | A-1 | A-1 | A-1 | A-1 | A-1 | A-1 | A-1 | A-1 |
| | | Parts by mass | 1.2 | 1.2 | 1.2 | 1.2 | 1.2 | 1.2 | 1.2 | 1.2 | 1.2 | 1.2 | 1.2 | 1.2 | 1.2 | 1.2 | 1.2 |
| | Additive | Kind | - | - | - | - | - | - | - | - | - | - | - | - | - | - | - |
| | | Parts by mass | - | - | - | - | - | - | - | - | - | - | - | - | - | - | - |
| | | Kind | - | - | - | - | - | - | - | - | - | - | - | - | - | - | - |
| | | Parts by mass | - | - | - | - | - | - | - | - | - | - | - | - | - | - | - |
| | | Kind | - | - | - | - | - | - | - | - | - | - | - | - | - | - | - |
| | | Parts by mass | - | - | - | - | - | - | - | - | - | - | - | - | - | - | - |
| | Solvent | Kind | GBL | GBL | GBL | GBL | GBL | GBL | GBL | GBL | GBL | G6L | GBL | GBL | GBL | GBL | GBL |
| | | Ratio | 44 | 44 | 44 | 44 | 44 | 44 | 44 | 44 | 44 | 44 | 44 | 44 | 44 | 44 | 44 |
| | | Kind | DMSO | DMSO | DMSO | DMSO | DMSO | DMSO | DMSO | DMSO | DMSO | DMSO | DMSO | DMSO | DMSO | DMSO | DMSO |
| | | Ratio | 11 | 11 | 11 | 11 | 11 | 11 | 11 | 11 | 11 | 11 | 11 | 11 | 11 | 11 | 11 |
| | Concentration of solid contents | | 42 | 42 | 42 | 42 | 42 | 42 | 42 | 42 | 42 | 42 | 42 | 42 | 42 | 42 | 42 |
| Process | Film thickness (μm) | | 20 | 20 | 20 | 20 | 20 | 20 | 20 | 20 | 20 | 20 | 20 | 20 | 20 | 20 | 20 |
| | Exposure wavelength (nm) | | 365 | 365 | 365 | 365 | 365 | 365 | 365 | 365 | 365 | 365 | 365 | 365 | 365 | 365 | 365 |
| | Exposure condition | | M | M | M | M | M | M | M | M | M | M | M | M | M | M | M |
| | Developer | | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone | Cyclopentanone |
| | Cure temperature (°C) | | IR | 230 | 230 | 230 | 230 | 230 | 230 | 230 | 230 | 230 | 230 | 230 | 230 | 230 | 230 |
| | Cure time (min) | | 180 | 180 | 180 | 180 | 180 | 180 | 180 | 180 | 180 | 180 | 180 | 180 | 180 | 180 | 180 |
| Evaluation | Chemical resistance | | A | A | A | A | A | A | A | A | A | A | A | A | A | A | A |
| | Heat resistance | | A | A | A | A | A | A | A | A | A | A | A | A | A | A | A |
| | Moisture resistance | | A | A | A | A | A | A | A | A | A | A | A | A | A | A | A |
| | Breaking elongation | | A | A | A | A | A | A | A | A | A | A | A | A | A | A | A |
| | Storage stability | | A | A | A | A | A | A | A | A | A | A | A | A | A | A | A |

Details of each of the components listed in the table are as follows.

[Resin]

· Resin 1 to resin 12: Resin 1 to resin 12, which are obtained in the above Synthesis Examples

[Polymerizable compound]

· M-1 to M-3: Compounds having the following structures, where the subscripts in parentheses represent the number of repetitions.
· U-1 to U-3: Compounds having the following structures

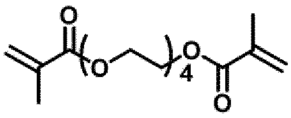
M-1

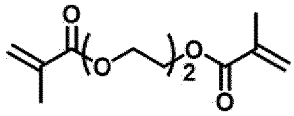
M-2

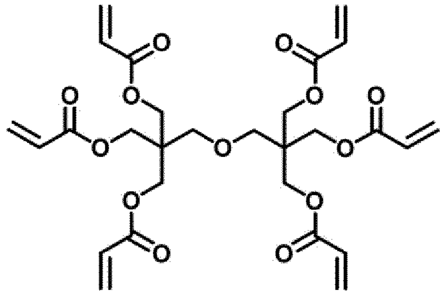
M-3

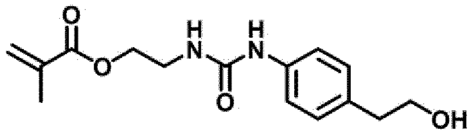
U-1

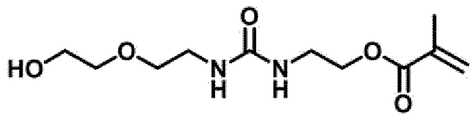
U-2

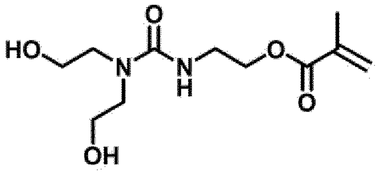
U-3

[Polymerization initiator]

· · G-1 to G-4: Compounds having the following structures

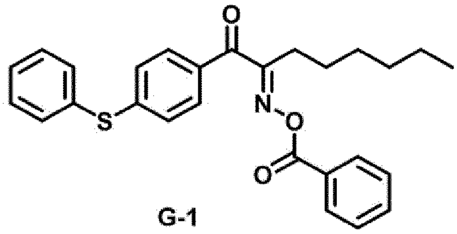
G-1

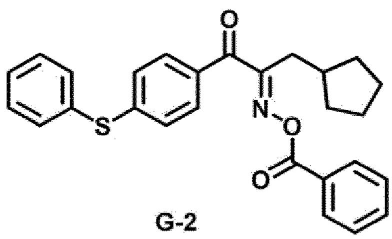
G-2

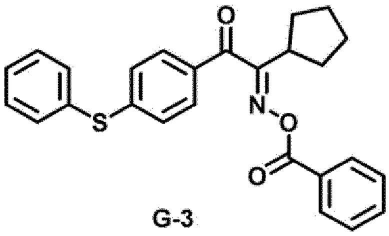

G-3

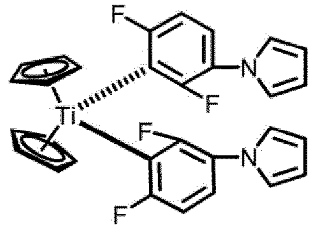

G-4

[Polymerization inhibitor]

· ·B-1 to B-5: Compounds having the following structures

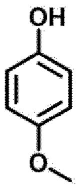

B-1

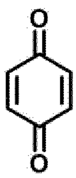

B-2

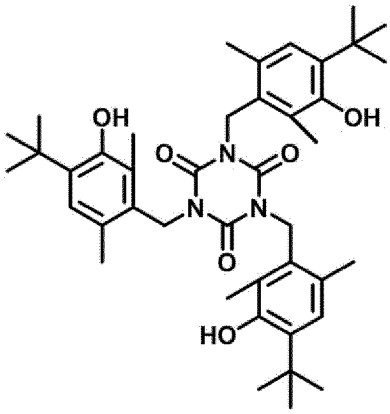

B-3

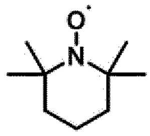

B-4

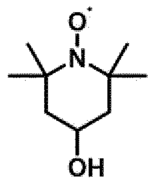

B-5

[Silane coupling agent (metal adhesiveness improving agent)]

· · C-1 to C-5: Compounds having the following structures. In the present specification, Me represents a methyl group, Et represents an ethyl group, and iPr represents an isopropyl group, unless otherwise specified.

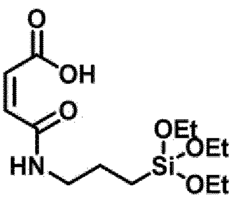

C-1

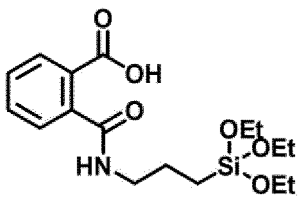

C-2

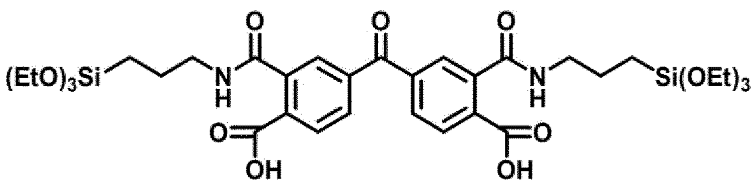

C-3

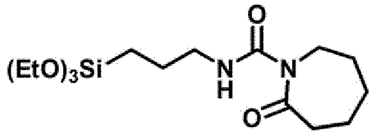
C-4

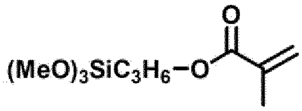
C-5

[Migration suppressing agent]

· ·D-1 to D-4: Compounds having the following structures

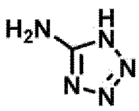
D-1

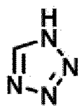
D-2

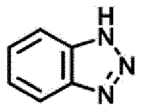
D-3

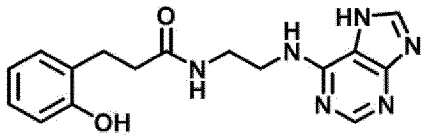
D-4

[Metal complex]

· · A-1 to A-65: Compounds having the following structures
· · AR-1: A compound having the following structure. AR-1 is a compound that does not correspond to the specific metal complex.

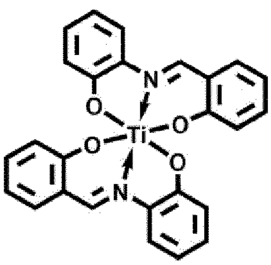
A-1

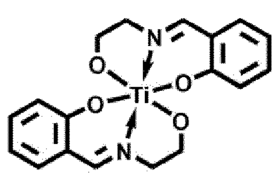
A-2

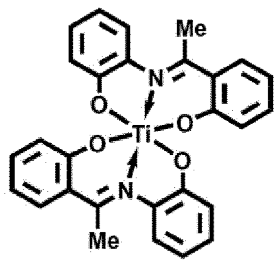
A-3

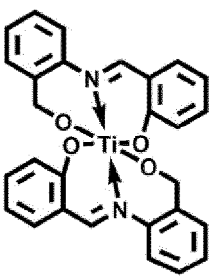
A-4

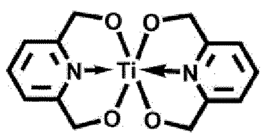
A-5

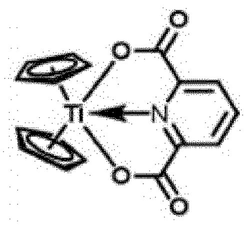
A-6

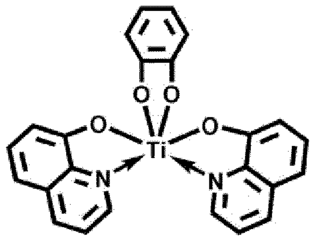

A-7

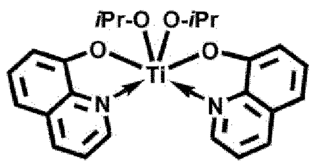

A-8

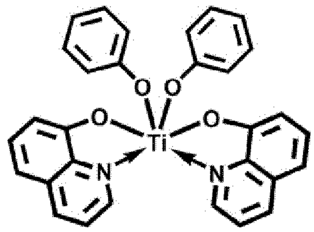

A-9

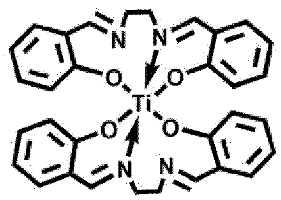

A-10

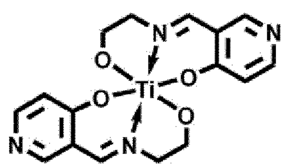

A-11

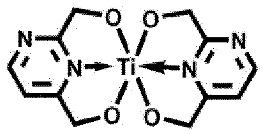

A-12

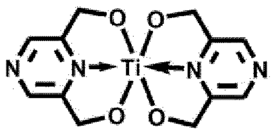

A-13

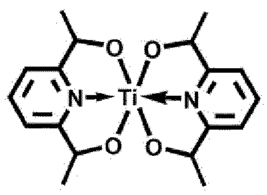

A-14

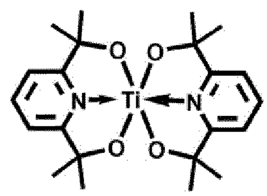

A-15

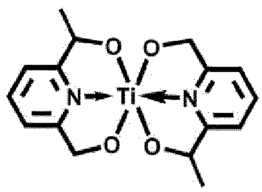

A-16

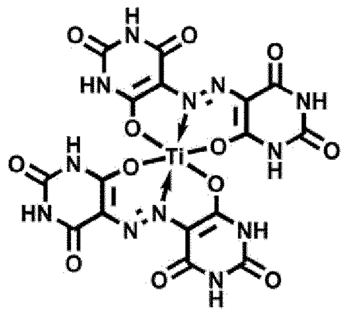

A-17

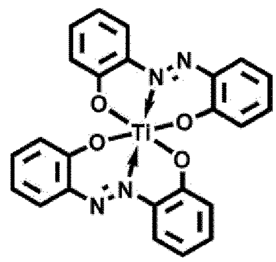

A-18

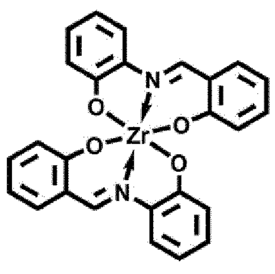

A-19

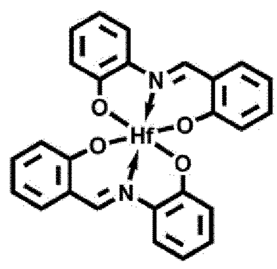

A-20

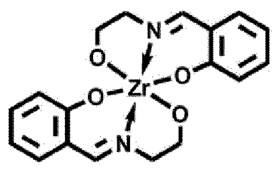

A-21

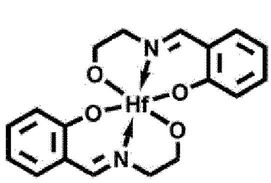

A-22

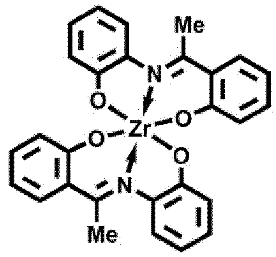

A-23

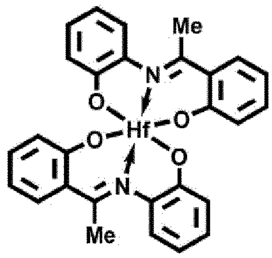

A-24

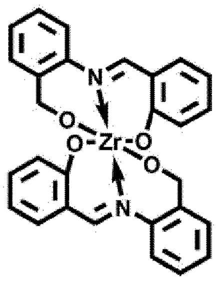

A-25

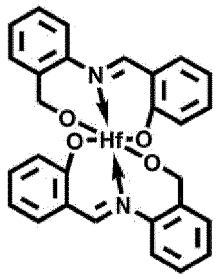

A-26

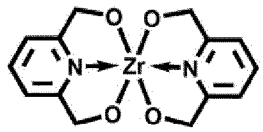

A-27

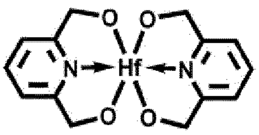

A-28

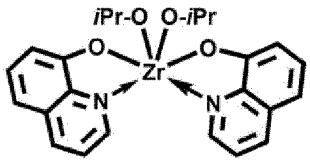

A-29

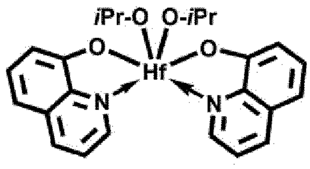

A-30

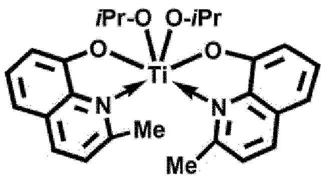

A-31

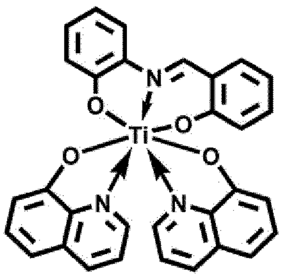

A-32

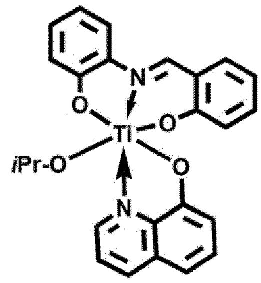

A-33

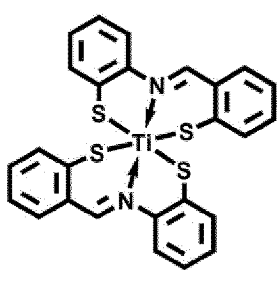

A-34

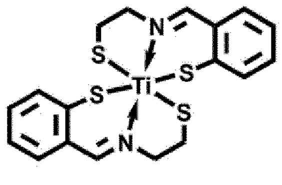

A-35

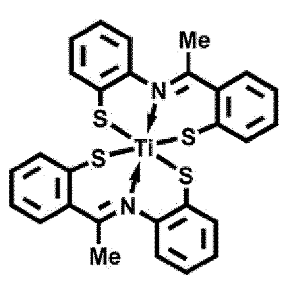

A-36

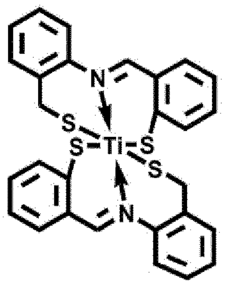
A-37

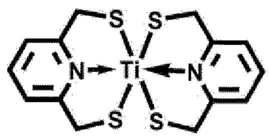
A-38

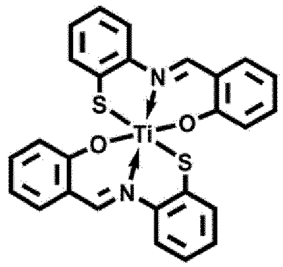
A-39

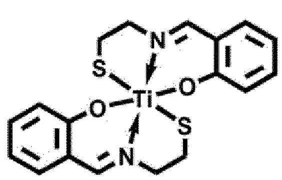
A-40

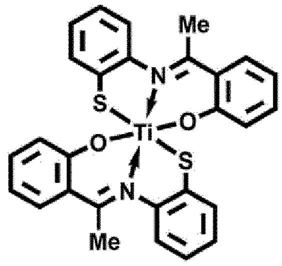
A-41

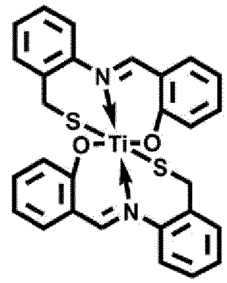
A-42

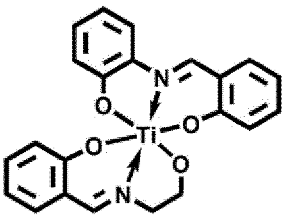
A-43

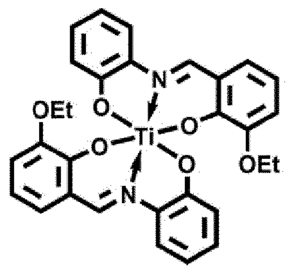
A-44

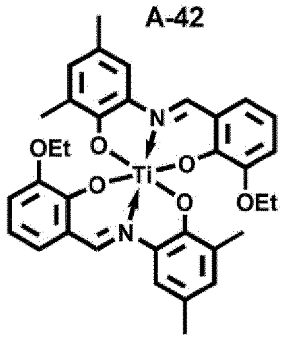
A-45

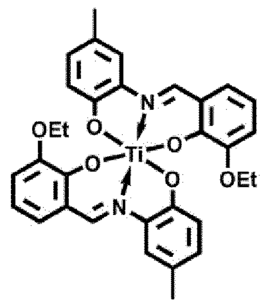
A-46

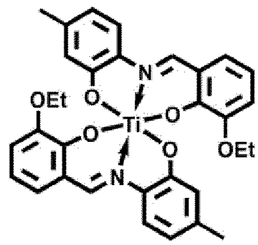
A-47

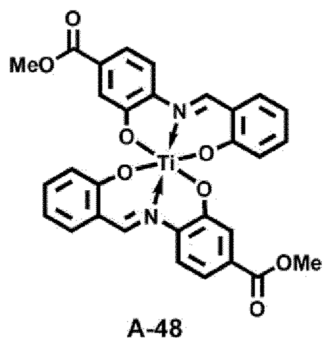
A-48

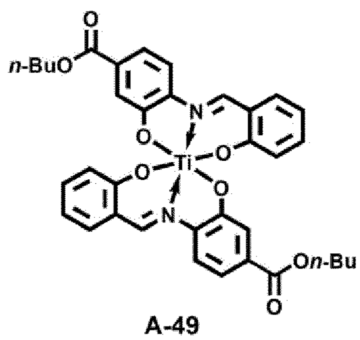
A-49

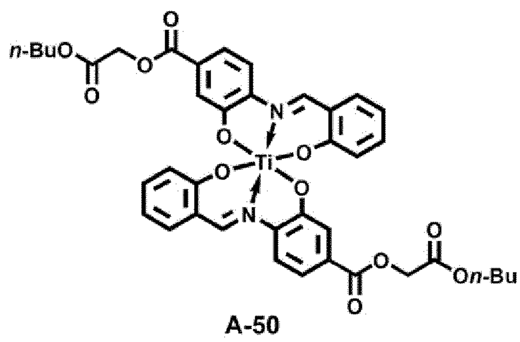
A-50

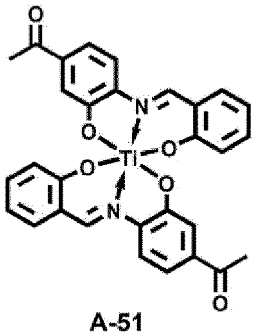

A-51

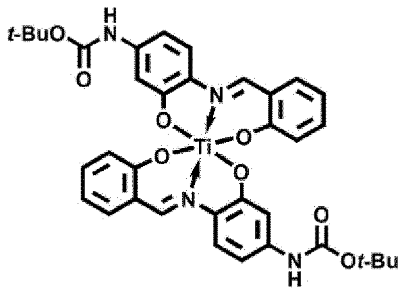

A-52

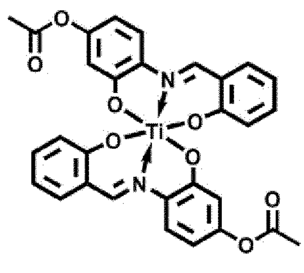

A-53

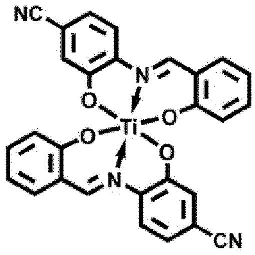

A-54

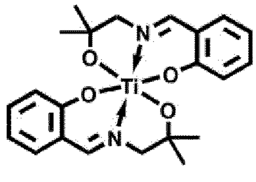

A-55

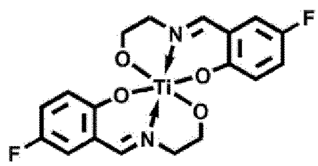

A-56

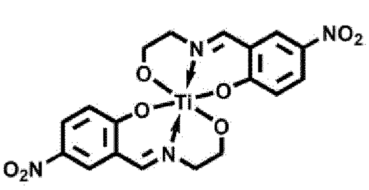

A-57

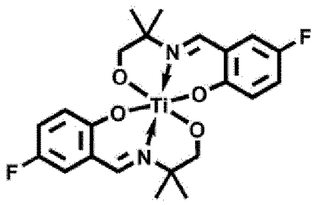

A-58

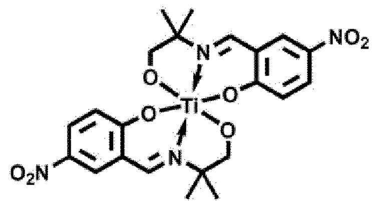

A-59

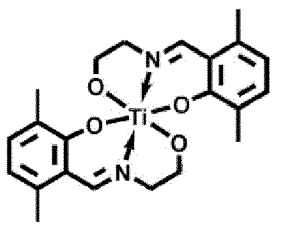

A-60

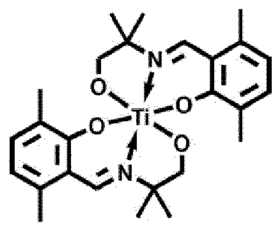

A-61

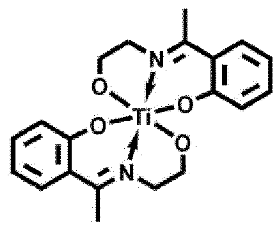

A-62

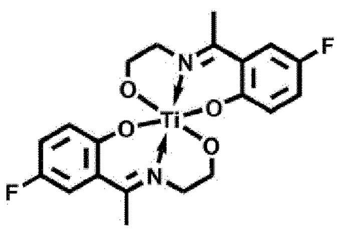

A-63

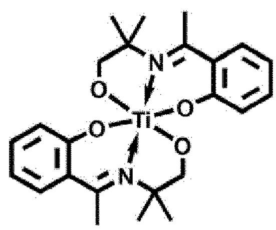

A-64

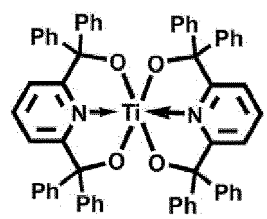

A-65

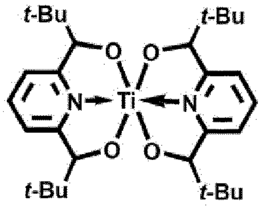

A-66

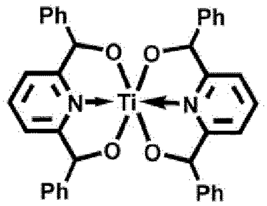

A-67

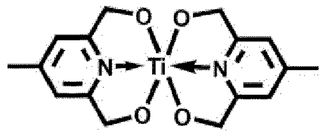

A-68

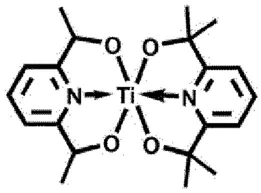

A-69

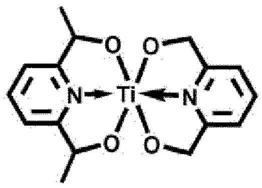

A-70

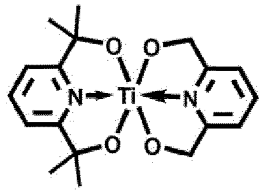

A-71

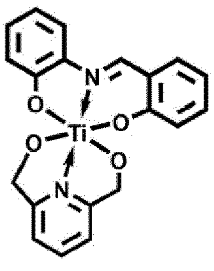

A-72

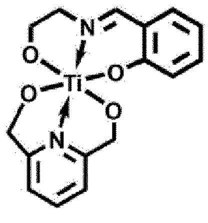

A-73

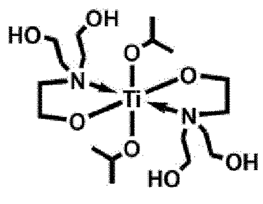

AR-1

ORGATIX TC-400

- Synthesis of A-1 -

Salicylaldehyde (100 mmol) and 2-hydroxyaniline (100 mmol) were dissolved in MeOH (500 mL) and stirred under reflux with heating for 1 hour. The reaction solution was concentrated, and the residue was washed with cooled MeOH to obtain 2-salicylideneaminophenol (95 mmol).

The following reactions were carried out in an $N_2$ atmosphere. 2-salicylideneaminophenol (95 mmol) obtained in the first step was dissolved in MeOH (2,000 mL), $Ti(OiPr)_4$ (47 mmol) was slowly added dropwise thereto, and the resultant mixture was stirred at room temperature for 2 hours. After completion of the reaction, the reaction solution was filtered, and the obtained crude crystals were washed with MeOH to obtain A-1 (47 mmol).

MeOH represents methanol, and $Ti(OiPr)_4$ represents tetraisopropyl orthotitanate.

In addition, A-2 to A-5 and A-7 to A-73 were also synthesized according to the same synthesis method as that for A-1.

- Synthesis of -A-6 -

The following reaction was carried out in an $N_2$ atmosphere. 2,6-pyridinedicarboxylic acid (6.0 mmol) was dissolved in 150 mL of tetrahydrofuran, dimethyltitanocene (6.0 mmol, 5.0% by mass in tetrahydrofuran/toluene) was slowly added dropwise thereto, and the resultant mixture was stirred at room temperature for 2 hours. After completion of the reaction, 50 mL of toluene was added to the reaction solution. Then, hexane was slowly added thereto to precipitate crystals, and the crystals were filtered to obtain A-6 (5.0 mmol).

[Additive]

- E-1 and E-2: Compounds having the following structures
- F-1: A compound having the following structure

· T-1 to T-3: Compounds having the following structures

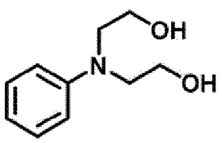

E-1

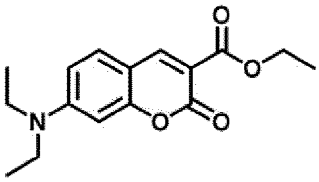

E-2

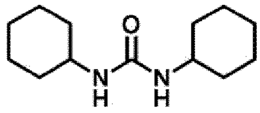

F-1

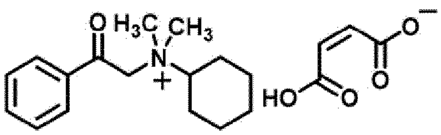

T-1

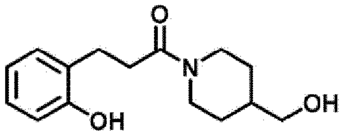

T-2

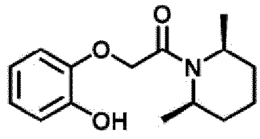

T-3

[Solvent]

· NMP: N-methyl-2-pyrrolidone
· EL: Ethyl lactate · DMSO: dimethyl sulfoxide
· GBL: γ-butyrolactone

<Evaluation>

[Chemical resistance]

The resin composition or comparative composition prepared in each Example or Comparative Example was applied onto a silicon wafer by a spin coating method. The silicon wafer was dried on a hot plate at 100°C for 5 minutes to form, on the silicon wafer, a resin composition layer having a uniform thickness, which is the thickness described in the column of "Film thickness (μm)'' in the table.

In an example in which the exposure condition was described as "M", the resin composition layer on the silicon wafer was exposed using a stepper. The entire surface of the photosensitive film was exposed using light having a wavelength described in "Exposure wavelength (nm)" in the table without using a photomask. The exposure amount was set to 500 mJ/$cm^2$.

In an example in which the exposure condition was described as "D", the exposure was carried out using a direct exposure device (ADTEC DE-6UH III). The entire surface of the photosensitive film was exposed using light having a wavelength described in "Exposure wavelength (nm)" in the table. The exposure amount was set to 500 mJ/$cm^2$.

Next, in an example in which a numerical value was described in the column of "Cure temperature (°C)", the temperature of the resin film obtained in each of Examples or Comparative Examples was raised using a hot plate at a temperature rising rate of 10 °C/min in a nitrogen atmosphere, and after reaching the temperature described in "Cure temperature (°C)" in the table, the temperature thereof was maintained for the time described in "Cure time (min)" to form a cured substance.

In an example in which "IR" was described in the column of "Cure temperature (°C)", the temperature of the resin film obtained in each Example was raised at a temperature rising rate of 10 °C/min under a nitrogen atmosphere using an infrared lamp heating device (RTP-6, manufactured by ADVANCE RIKO, Inc.), and after reaching 230°C, the temperature thereof was maintained for the time described in "Cure time (min)" to form a cured substance.

The obtained cured substance was immersed in the following chemical under the following conditions, and the dissolution rate was calculated.

Chemical: A 90:10 (mass ratio) mixture of dimethyl sulfoxide (DMSO) and an aqueous solution containing 25% by mass of tetramethylammonium hydroxide (TMAH).

Evaluation conditions: The above-described cured substance was immersed in the chemical at 75°C for 15 minutes, the film thicknesses of the cured substance before and after immersion were compared, and then the dissolution rate (nm/min) was calculated.

The obtained value of the dissolution rate was evaluated according to the following evaluation standard, and the results are described in the column of "Chemical resistance". It can be said that the lower the dissolution rate is, the more excellent the chemical resistance is.

- Evaluation standards -

A: The dissolution rate was less than 250 nm/min.
B: The dissolution rate was 250 nm/min or more and less than 500 nm/min.
C: The dissolution rate was 500 nm/min or more.

[Evaluation of heat resistance (breaking elongation after heat resistance test)]

Each of the resin compositions or comparative compositions prepared in Examples and Comparative Examples was applied onto a silicon wafer by a spin coating method to form a resin composition layer.

The silicon wafer on which the obtained resin composition layer was formed was dried on a hot plate at 100°C for 5 minutes, and a photosensitive film having a film thickness described in the column of "Film thickness (μm)'' in the table was formed. Then, in an example in which "M" was described in the column of "Exposure condition", the entire surface of the photosensitive film was exposed at a wavelength described in the column of "Exposure wavelength (nm)" in the table by using a stepper (NSR1505 i6, manufactured by Nikon Corporation). In an example in which "D" was described in the column of the exposure condition, the exposure was carried out at a wavelength described in the column of "Exposure wavelength (nm)" in the table by using a direct exposure device (ADTEC DE-6UH III) as a light source. After the above-described exposure, development was carried out for 2 minutes with a developer described in the column of "Developer" in the table, and rinsing was carried out with PGMEAfor 30 seconds.

Next, in an example in which a numerical value was described in the column of "Cure temperature" in the table, the temperature was raised at a temperature rising rate of 10°C/min under a nitrogen atmosphere, and after reaching the temperature described in "Cure temperature (°C)" in the table the temperature was maintained for the time described in the column of "Cure time (min)" in the table to form a resin composition layer. In an example in which "IR" was described in the column of "Cure temperature (°C)", the temperature of the resin film obtained in each Example was raised at a temperature rising rate of 10 °C/min under a nitrogen atmosphere using an infrared lamp heating device (RTP-6, manufactured by ADVANCE RIKO, Inc.), and after reaching 230°C, the temperature was maintained for a period of "Cure time (min)" in the table to form a resin composition layer.

The obtained resin composition layer was subjected to a heat resistance test (held for 500 hours in an environment of a temperature of 175°C).

The resin composition layer (cured substance) after the heat resistance test was immersed in an aqueous solution of 4.9% by mass hydrofluoric acid solution, and the cured substance was peeled off from the silicon wafer. The peeled cured substance was punched out using a punching machine to prepare a test piece having a sample width of 3 mm and a sample length of 30 mm. The elongation rate of the obtained test piece in the longitudinal direction was measured in accordance with JIS-K7161 (2014) using a tensile tester (Tensilon) at a crosshead speed of 5 mm/min, 25°C, and in an environment of 65% RH (relative humidity). The measurement was carried out five times, and the arithmetic average value of the elongation rates (breaking elongation rates) in a case where the test piece was broken in the five measurements was used as the index value.

The evaluation was carried out according to the following evaluation standards, and the evaluation results are described in the column of "Heat resistance" in the table. It can be said that the larger the index value is, the more excellent the film hardness of the cured substance is.

- Evaluation standards -

A: The index value was 50% or more.
B: The index value was 45% or more and less than 50%.
C: The index value was less than 45%.

[Moisture resistance]

Each of the resin compositions or comparative compositions prepared in Examples and Comparative Examples

was applied onto a silicon wafer by a spin coating method to form a resin composition layer.

The silicon wafer on which the obtained resin composition layer was formed was dried on a hot plate at 100°C for 5 minutes, and a photosensitive film having a film thickness described in the column of "Film thickness (μm)'' in the table was formed. Then, in an example in which "M" was described in the column of "Exposure condition", the entire surface of the photosensitive film was exposed at a wavelength described in the column of "Exposure wavelength (nm)" in the table by using a stepper (NSR1505 i6, manufactured by Nikon Corporation). In an example in which "D" was described in the column of the exposure condition, the exposure was carried out at a wavelength described in the column of "Exposure wavelength (nm)" in the table by using a direct exposure device (ADTEC DE-6UH III) as a light source. After the exposure, development was carried out with cyclopentanone for 2 minutes, and rinsing was carried out with PGMEA for 30 seconds.

Next, in an example in which a numerical value was described in the column of "Cure temperature" in the table, the temperature was raised at a temperature rising rate of 10°C/min under a nitrogen atmosphere, and after reaching the temperature described in "Cure temperature (°C)" in the table the temperature was maintained for the time described in the column of "Cure time (min)" in the table to form a resin composition layer. In an example in which "IR" was described in the column of "Cure temperature (°C)", the temperature of the resin film obtained in each Example was raised at a temperature rising rate of 10 °C/min under a nitrogen atmosphere using an infrared lamp heating device (RTP-6, manufactured by ADVANCE RIKO, Inc.), and after reaching 230°C, the temperature was maintained for a period of "Cure time (min)" in the table to form a resin composition layer. The obtained resin composition layer was subjected to a humidity test (held for 250 hours in an environment of a temperature of 121°C and a relative humidity of 100%).

The resin composition layer (cured substance) after the humidity test was immersed in an aqueous solution of 4.9% by mass hydrofluoric acid solution, and the cured substance was peeled off from the silicon wafer. The peeled cured substance was punched out using a punching machine to prepare a test piece having a sample width of 3 mm and a sample length of 30 mm. The elongation rate of the obtained test piece in the longitudinal direction was measured in accordance with JIS-K7161 (2014) using a tensile tester (Tensilon) at a crosshead speed of 5 mm/min, 25°C, and in an environment of 65% RH (relative humidity). The measurement was carried out five times, and the arithmetic average value of the elongation rates (breaking elongation rates) in a case where the test piece was broken in the five measurements was used as the index value.

The evaluation was carried out according to the following evaluation standards, and the evaluation results are described in the column of "Moisture resistance" in the table. It can be said that the larger the index value is, the more excellent the moisture resistance of the cured substance is.

- Evaluation standards -

A: The index value was 50% or more.
B: The index value was 45% or more and less than 50%.
C: The index value was less than 45%.

[Breaking elongation]

Each of the resin compositions or comparative compositions prepared in Examples and Comparative Examples was applied onto a silicon wafer by a spin coating method to form a resin composition layer.

The silicon wafer on which the obtained resin composition layer was formed was dried on a hot plate at 100°C for 5 minutes, thereby obtaining a resin composition layer having a uniform thickness on the silicon wafer, the thickness being described in the column of "Film thickness (μm)'' in the table.

The entire surface of the resin composition layer on the silicon wafer was exposed with an exposure energy of 500 $mJ/cm^2$. The exposure wavelength is described in "Exposure wavelength (nm)" in the table.

In an example in which "M" was described in the column of the exposure condition, exposure was carried out using a stepper as a light source.

In an example in which "D" was described in the column of the exposure condition, exposure was carried out using a direct exposure device (ADTEC DE-6UH III) as a light source.

In an example in which a numerical value was described in the column of "Cure temperature (°C)", the temperature of the resin composition layer (resin film) after the exposure was raised at a temperature rising rate of 10 °C/min using a hot plate in a nitrogen atmosphere, and after the temperature reached the temperature described in the column of "Cure temperature (°C)" in the table, the temperature was maintained for a period of "Cure time (min)" in the table.

In an example in which "IR" was described in the column of "Cure temperature (°C)", the temperature of the resin film obtained in each Example was raised at a temperature rising rate of 10 °C/min under a nitrogen atmosphere using an

infrared lamp heating device (RTP-6, manufactured by ADVANCE RIKO, Inc.), and after reaching 230°C, the temperature was maintained for a period of "Cure time (min)" in the table.

The resin composition layer (cured substance) after the curing was immersed in an aqueous solution of 4.9% by mass hydrofluoric acid solution, and the cured substance was peeled off from the silicon wafer. The peeled cured substance was punched out using a punching machine to prepare a test piece having a sample width of 3 mm and a sample length of 30 mm. The elongation rate of the obtained test piece in the longitudinal direction was measured in accordance with JIS-K6251 (2017) using a tensile tester (Tensilon) at a crosshead speed of 300 mm/min, 25°C, and in an environment of 65% RH (relative humidity). The measurement was carried out five times, and the arithmetic average value of the elongation rates (breaking elongation rates) in a case where the test piece was broken in the five measurements was used as the index value.

The evaluation was carried out according to the following evaluation standards, and the evaluation results are described in the column of "Breaking elongation" in the table. It can be said that the larger the index value is, the more excellent the film hardness of the cured substance is.

- Evaluation standards -

A: The index value was 65% or more.
B: The index value was 60% or more and less than 65%.
C: The index value was less than 60%.

[Storage stability]

The composition prepared in each of Examples or Comparative Examples was subjected to an accelerated test (the conditions of the accelerated test were such that the composition was allowed to be left at 38°C for 3 days in a light shielded state). After the composition had been allowed to be left, the viscosity was measured using a viscometer (RE-85L, manufactured by TOKI SANGYO Co., Ltd.), and the rate of change in viscosity after the accelerated test was evaluated such that as compared with the initial state (before the composition was allowed to be left), a case where the rate of change in viscosity was $\pm$ 8% or less was evaluated as A, a case where the rate of change in viscosity was more than $\pm$ 8% and $\pm$ 15% or less was evaluated as B, a case where the rate of change in viscosity was more than $\pm$ 15% and $\pm$ 20% or less was evaluated as C, and a case where the rate of change in viscosity was more than $\pm$ 20% was evaluated as D. The evaluation results are described in the column of "Storage stability" in the table. The rate of change in viscosity was calculated according to the following expression. It can be said that the smaller the rate of change in viscosity, the better the storage stability.

Rate of change in viscosity (%) = (viscosity after allowing composition to be left - viscosity before allowing composition to be left)/(viscosity before allowing composition to be left) $\times$ 100

From the above results, it can be seen that the resin composition according to the embodiment of the present invention has excellent storage stability, and the cured substance obtained from the resin composition according to the embodiment of the present invention has excellent chemical resistance.

The comparative composition according to Comparative Example 1 contains the specific metal complex; however, the specific metal complex thereof does not have a $\pi$-conjugated moiety containing a nitrogen atom and does not correspond to the compound represented by Formula (2-1). It can be seen that such a comparative composition is inferior in the storage stability of the composition.

The comparative composition according to Comparative Example 2 does not contain the specific metal complex. It can be seen that such a comparative composition is inferior in poor chemical resistance.

<Example 101>

The resin composition used in Example 1 was applied onto a surface of a thin copper layer of the resin base material on the surface of which the thin copper layer was formed, by a spin coating method, dried at 100°C for 5 minutes, and after forming a photosensitive film having a film thickness of 20 $\mu$m, exposure was carried out using a stepper (NSR1505 i6, manufactured by Nikon Corporation). Exposure was carried out through a mask (a binary mask in which the pattern is a pattern of 1:1 line and space and the line width is 10 $\mu$m) at a wavelength of 365 nm. After the exposure, development was carried out with cyclohexanone for 2 minutes and rinsing was carried out with PGMEA for 30 seconds to

obtain a layer pattern.

Next, the temperature was raised at a temperature rising rate of 10 °C/min in a nitrogen atmosphere, and after the temperature reached 230°C, the temperature was maintained at 230°C for 180 minutes, thereby forming an interlayer insulating film for a re-distribution layer. This interlayer insulating film for a re-distribution layer was excellent in insulating properties.

In addition, in a case where a semiconductor device was manufactured using this interlayer insulating film for a re-distribution layer, it has been confirmed that the semiconductor device operates without any problem.

## Claims

**1.** A resin composition comprising:

a resin; and
a metal complex which has one or more π-conjugated moieties comprising a nitrogen atom.

**2.** The resin composition according to claim 1,

wherein the metal complex comprises a partial structure represented by Formula (1-1) as a structure comprising the π-conjugated moiety comprising the nitrogen atom:

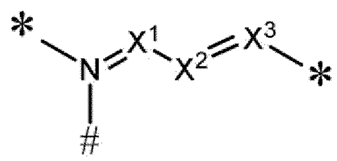

(1-1)

in Formula (1-1), $X^1$ to $X^3$ each independently represent -C(-*)= or -N=, *'s each represent a bonding site to another structure, and # represents a bonding site to a metal atom.

**3.** The resin composition according to claim 1 or 2,
wherein the metal complex is a compound having, on the same ligand, the π-conjugated moiety comprising the nitrogen atom and at least one group selected from the group consisting of a hydroxy group, a mercapto group, and a carboxy group.

**4.** The resin composition according to any one of claims 1 to 3,

wherein the metal complex comprises a partial structure represented by Formula (3-1) as a structure comprising the π-conjugated moiety comprising the nitrogen atom:

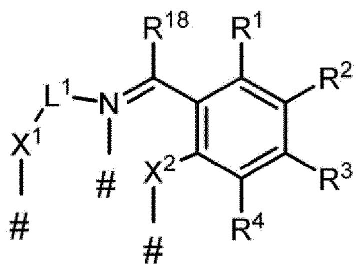

(3-1)

in Formula (3-1), $R^1$ to $R^4$ and $R^{18}$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$; $R^{101}$ and $R^{102}$ each independently represent a hydrogen atom, an alkyl group, or an aryl group; $R^{101}$ and $R^{102}$ may be bonded to each other to form a ring; $R^{103}$ to $R^{109}$ each independently represent an alkyl group or an aryl group; $L^1$ represents a group represented by Formula (L-1) or Formula (L-2); X1 and X2 each independently represent -O- or -S-; and #

represents a bonding site to a metal atom;

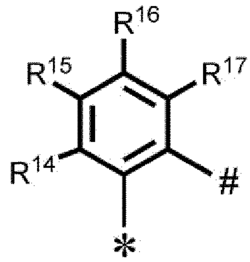

(L-1)

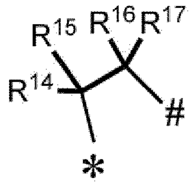

(L-2)

in Formula (L-1) and Formula (L-2), $R^{14}$ to $R^{17}$ each independently represent a hydrogen atom, an alkyl group, an alkoxy group, an aryloxy group, an acyl group, a phenyl group, an acyloxy group, an ester group, a halogen atom, a nitro group, a cyano group, - $NR^{101}R^{102}$ , $-SR^{103}$, $-SO_2NR^{104}R^{105}$, $-CONR^{106}R^{107}$, or $-NR^{108}COR^{109}$; $R^{101}$ and $R^{102}$ each independently represent a hydrogen atom, an alkyl group, or an aryl group; $R^{101}$ and $R^{102}$ may be bonded to each other to form a ring; $R^{103}$ to $R^{109}$ each independently represent an alkyl group or an aryl group; * represents a bonding site to $X^1$ in Formula (3-1); and # represents a bonding site to the nitrogen atom in Formula (3-1).

**5.** The resin composition according to claim 4,

wherein $L^1$ is a group represented by Formula (L-2),
$R^{18}$ is a hydrogen atom,
at least one of $R^1$, $R^2$, $R^3$, $R^4$, $R^{14}$, $R^{15}$, $R^{16}$, or $R^{17}$ represents a methyl group, an alkoxy group, an aryloxy group, a phenyl group, an acyloxy group, an acyl group, an ester group, a halogen atom, a nitro group, a cyano group, $-NR^{101}R^{102}$, $-SR^{103}$, $-SO_2NR^{104}R^{105}$, - $CONR^{106}R^{107}$, or $-NR^{108}COR^{109}$,
$R^{101}$ and $R^{102}$ each independently represent a hydrogen atom, an alkyl group, or an aryl group,
$R^{101}$ and $R^{102}$ may be bonded to each other to form a ring, and
$R^{103}$ to $R^{109}$ each independently represent an alkyl group or an aryl group.

**6.** The resin composition according to any one of claims 1 to 5,

wherein the metal complex comprises a partial structure represented by Formula (4-1) as a structure comprising the $\pi$-conjugated moiety comprising the nitrogen atom:

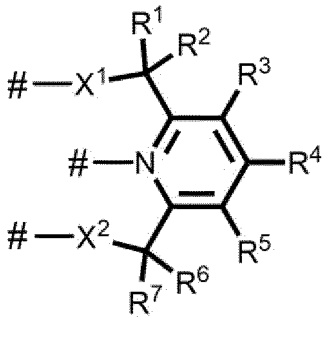

(4-1)

in Formula (4-1), $R^1$ to $R^7$ each independently represent a hydrogen atom, an alkyl group, an alkoxy group, an aryloxy group, an acyl group, a phenyl group, an acyloxy group, an ester group, a halogen atom, a nitro group, a cyano group, $-NR^{101}R^{102}$, $-SR^{103}$, $-SO_2NR^{104}R^{105}$, $-CONR^{106}R^{107}$, or $-NR^{108}COR^{109}$; $R^{101}$ and $R^{102}$ each independently represent a hydrogen atom, an alkyl group, or an aryl group; $R^{101}$ and $R^{102}$ may be bonded to each other to form a ring: $R^{103}$ to $R^{109}$ each independently represent an alkyl group or an aryl group; $X^1$ and $X^2$ each independently represent -O- or -S-; and # represents a bonding site to a metal atom.

7. The resin composition according to claim 6, wherein at least one of $R^1$, $R^2$, $R^6$, or $R^7$ is a group other than a hydrogen atom.

8. A resin composition comprising:

a resin; and
a compound represented by Formula (2-1):

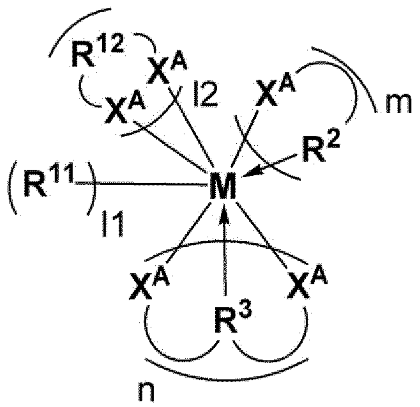

(2-1)

in Formula (2-1), M is titanium, zirconium, or hafnium; 11 is an integer of 0 to 2; l2 is 0 or 1; l1 + l2 $\times$ 2 is an integer of 0 to 2; m is an integer of 0 to 4; n is an integer of 0 to 2; 11 + l2 + m + n $\times$ 2 = 4 is satisfied; $R^{11}$'s are each independently a substituted or unsubstituted cyclopentadienyl group, a substituted or unsubstituted alkoxy group, or a substituted or unsubstituted phenoxy group; $R^{12}$ is a substituted or unsubstituted hydrocarbon group; $R^2$'s are each independently a group comprising a structure represented by Formula (2-2); $R^3$'s are each independently a group comprising a structure represented by Formula (2-2); and $X^A$'s are each independently an oxygen atom or a sulfur atom;

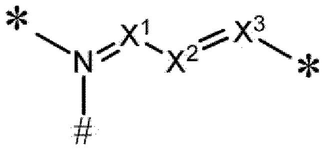

(2-2)

in Formula (2-2), $X^1$ to $X^3$ each independently represent -C(-*)= or -N=; *'s each represent a bonding site to another structure; and # represents a bonding site to a metal atom.

9. The resin composition according to claim 8, wherein in Formula (2-1), l1 and l2 are 0, and m is 0, 2, or 4.

10. The resin composition according to any one of claims 1 to 9, wherein the resin is at least one resin selected from the group consisting of a cyclization resin and a precursor thereof.

11. The resin composition according to any one of claims 1 to 10, wherein the resin is a polyimide or a polyimide precursor.

12. The resin composition according to any one of claims 1 to 11, further comprising a polymerizable compound.

13. The resin composition according to any one of claims 1 to 12, further comprising a photopolymerization initiator.

14. The resin composition according to any one of claims 1 to 13, wherein the resin composition comprises, as the resin, a cyclization resin or a precursor thereof and is used for forming an interlayer insulating film for a re-distribution layer.

15. A cured substance obtained by curing the resin composition according to any one of claims 1 to 14.

**16.** A laminate comprising:

two or more layers consisting of the cured substance according to claim 15; and
a metal layer provided between any of the layers consisting of the cured substance.

**17.** A manufacturing method for a cured substance, comprising a film forming step of applying the resin composition according to any one of claims 1 to 14 onto a base material to form a film.

**18.** The manufacturing method for a cured substance according to claim 17, further comprising:

an exposure step of selectively exposing the film;
a development step of developing the film using a developer to form a pattern; and
a heating step of heating the film at 50° to 450°C.

**19.** A manufacturing method for a laminate, comprising the manufacturing method for a cured substance according to claim 17 or 18.

**20.** A manufacturing method for a semiconductor device, comprising the manufacturing method for a cured substance according to claim 17 or 18.

**21.** A semiconductor device comprising the cured substance according to claim 15.

# INTERNATIONAL SEARCH REPORT

International application No.
**PCT/JP2023/004117**

**A. CLASSIFICATION OF SUBJECT MATTER**

***G03F 7/004***(2006.01)i; ***C08F 290/14***(2006.01)i; ***C08G 73/10***(2006.01)i; ***C08K 5/56***(2006.01)i; ***C08L 79/08***(2006.01)i; ***C08L 101/00***(2006.01)i; ***G03F 7/027***(2006.01)i; ***G03F 7/029***(2006.01)i; ***G03F 7/031***(2006.01)i; ***G03F 7/037***(2006.01)i; ***G03F 7/20***(2006.01)i; ***G03F 7/40***(2006.01)i; ***H01L 21/312***(2006.01)i
FI: G03F7/004 501; C08F290/14; C08G73/10; C08K5/56; C08L79/08; G03F7/004 503Z; G03F7/027 502; G03F7/027 514; G03F7/029; G03F7/031; G03F7/037; G03F7/037 501; G03F7/20 521; G03F7/40 501; H01L21/312 B; C08L101/00

According to International Patent Classification (IPC) or to both national classification and IPC

**B. FIELDS SEARCHED**

Minimum documentation searched (classification system followed by classification symbols)

G03F7/004-G03F7/40

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | WO 2021/215133 A1 (FUJIFILM CORPORATION) 28 October 2021 (2021-10-28) paragraphs [0019]-[0030], [0267]-[0333] | 1-5, 8-21 |
| A | paragraphs [0019]-[0030], [0267]-[0333] | 6-7 |
| X | WO 2020/241712 A1 (JSR CORPORATION) 03 December 2020 (2020-12-03) paragraphs [0022]-[0028], [0170]-[0220] | 1, 6-7, 10-21 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **05 April 2023** | **18 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/004117**

| Patent document cited in search report | Publication date (day/month/year) | Patent family member(s) | Publication date (day/month/year) |
|---|---|---|---|
| WO 2021/215133 A1 | 28 October 2021 | CN 115427517 A<br>paragraphs [0079]-[0103], [0463]-[0705] | |
| WO 2020/241712 A1 | 03 December 2020 | US 2022/0075267 A1<br>paragraphs [0027]-[0033], [0257]-[0340] | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014122279 A
- WO 2017170600 A
- WO 2017038598 A
- JP 2013256506 A
- WO 2018025738 A
- JP 2016027357 A
- WO 2021112189 A
- JP 48041708 B
- JP 51037193 A
- JP 2032293 B
- JP H02032293 B
- JP 2016765 B
- JP H02016765 B
- JP 58049860 B
- JP 56017654 B
- JP 62039417 B
- JP 62039418 B
- JP 63277653 A
- JP S63277653 A
- JP 63260909 A
- JP 1105238 A
- JP H01105238 A
- JP 2014130173 A
- JP 6301489 B
- WO 2018221177 A
- WO 2018110179 A
- JP 2019 A
- JP 043864 A
- JP 2019044030 A
- JP 2019167313 A
- JP 2015087611 A
- JP 10291969 A
- JP H10291969 A
- JP 4225898 B
- JP 2001 A
- JP 233842 A
- JP 2000080068 A
- JP 2006 A
- JP 342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- JP 2012014052 A
- WO 2021020359 A
- JP 4600600 B
- JP 2007269779 A
- JP 2009191061 A
- WO 2015125469 A
- JP 2010 A
- JP 527339 A
- JP 2011524436 A
- WO 2015004565 A
- JP 2016 A
- JP 532675 A
- WO 2017033680 A
- JP 2013522445 A
- WO 2016034963 A
- JP 2017523465 A
- JP 2017167399 A
- JP 2017151342 A
- JP 6469669 B
- WO 2015199219 A
- WO 2020066416 A
- WO 2020054226 A
- JP 2018 A
- JP 173573 A
- JP 2011128358 A
- JP 2014186186 A
- JP 2013072935 A
- JP 2012003225 A
- US 20130034812 A
- JP 2008250074 A
- JP 2010164965 A
- JP 2008063554 A
- JP 2015 A
- JP 123351 A
- JP 2006023696 A
- JP 2006047592 A
- US 9159547 B
- JP 2007157879 A
- JP 521288 A
- JP 2004214501 A
- JP 2004101850 A
- US 7888181 B2
- US 9177926 B2

**Non-patent literature cited in the description**


- Handbook of Chemistry, Pure Chemistry, 5th Edition. Chemical Society of Japan
- **H. L. HOY**. *Journal of Painting*, 1970, vol. 42, 76-118
- *MATERIAL STAGE*, 2019, vol. 19 (3)
- *J. C. S. Perkin II*, 1979, 1653-1660
- *J. C. S. Perkin II*, 1979, 156-162
- *Journal of Photopolymer Science and Technology*, 1995, 202-232
- Polymer Dictionary. 2005, 683-684
- High functionality and applied technology of polyimide. Science & Technology Co., Ltd, April 2008
- Basics and development of polyimide materials. Technical library CMC TL, November 2011
- Latest Polyimide Basics and Applications. NTS Inc., August 2010